(19) Europäisches Patentamt
European Patent Office
Office européen des brevets

(11) EP 4 339 259 A1

(12) EUROPEAN PATENT APPLICATION

(43) Date of publication:
**20.03.2024 Bulletin 2024/12**

(21) Application number: **23195511.3**

(22) Date of filing: **05.09.2023**

(51) International Patent Classification (IPC):
***C09K 11/06*** *(2006.01)* ***C07F 5/02*** *(2006.01)*
***C07F 1/12*** *(2006.01)* ***H10K 85/30*** *(2023.01)*

(52) Cooperative Patent Classification (CPC):
**C07F 5/027; C09K 11/06; H10K 85/371**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.09.2022 US 202263407263 P**

(71) Applicants:
- **Versitech Limited**
  **Hong Kong (HK)**
- **Hong Kong Quantum AI Lab Limited**
  **Hong Kong (HK)**

(72) Inventors:
- **CHE, Chi-Ming**
  **The University of Hong Kong, Pokfulam Road, Hong Kong (HK)**
- **CAI, Siyuan**
  **The University of Hong Kong, Pokfulam Road, Hong Kong (HK)**
- **LAM, Tsz-Lung**
  **Units 909,17W,17 Science Park Ave,HK Science Park,Pak Shek Kok (HK)**
- **CHENG, Gang**
  **Units 909,17W,17 Science Park Ave,HK Science Park,Pak Shek Kok (HK)**

(74) Representative: **HGF**
**HGF Limited**
**1 City Walk**
**Leeds LS11 9DX (GB)**

# (54) METAL-ASSISTED MULTI-RESONANCE THERMALLY-ACTIVATED DELAYED-FLUORESCENCE EMITTERS FOR OLED APPLICATIONS

(57) Described are multi-resonance-thermally-activated delay-fluorescence compounds containing (i) a polycyclic aromatic/heteroaromatic ligand in which a plurality aromatic/heteroaromatic rings are linked by boron and nitrogen atoms and (ii) an N-heterocyclic carbene ligand, with both ligands coordinated to a metal atom/ion that has a high spin-orbit coupling. The use of the high spin-orbit coupling of metals and/or metal ions facilitates the intersystem crossing and/or reversed intersystem crossing processes of MR-TADF emitters, thereby largely accelerating the rate of TADF and substantially shortening the lifetime of deleterious triplet excitons. The MR-TADF emitters can be used to fabricate blue to green emitting OLEDs.

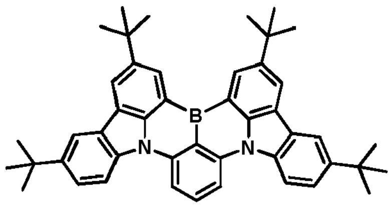

FIG. 1A

EP 4 339 259 A1

## Description

### CROSS-REFERENCE TO RELATED APPLICATIONS

This application claims benefit of and priority to U.S.S.N. 63/407,263, filed September 16, 2022, which is incorporated herein by reference in its entirety.

### FIELD OF THE INVENTION

The disclosed invention is generally in the field of emitter complexes, particularly complexes containing (i) a polycyclic aromatic/heteroaromatic ligand in which a plurality aromatic/heteroaromatic rings are linked by boron and nitrogen atoms and (ii) an N-heterocyclic carbene ligand, with both ligands coordinated to a metal atom/ion that has a high spin-orbit coupling, such as 3d-, 4d-, or Sd-transition metal atoms/ions.

### BACKGROUND OF THE INVENTION

Pure organic multi-resonance-thermally activated delayed fluorescence (MR-TADF) luminogens embedded with a combination of boron and nitrogen/oxygen atoms have emerged as one of the most promising TADF emitters in OLED applications by virtue of their ultra-high color purity, extraordinary external quantum efficiency, and good color tunability. Nonetheless, this class of emitters is bound to have small spin-orbit couplings (SOCs) and suffers from moderate intersystem crossing and slow reversed intersystem crossing required to recycle the long-lived triplet excitons for light emission. The small SOCs result in a predominant prompt fluorescence contribution, while the slow reversed intersystem crossing renders the maintenance of high efficiency at high luminance and/or the attainment of prolonged device lifetime a great challenge.

Accordingly, there remains a need to develop improved TADF, such as improved MR-TADF luminogens/emitters for OLED applications.

Therefore, it is an object of the present invention to provide new and/or improved TADF emitter complexes.

It is another object of the present invention to provide new and/or improved TADF emitter complexes containing (i) a polycyclic aromatic/heteroaromatic ligand in which a plurality aromatic/heteroaromatic rings are linked by a boron and a nitrogen atom and (ii) an N-heterocyclic carbene ligand, both ligands coordinated to a metal atom/ion, such as one that has a high spin-orbit coupling.

It is also an object of the present invention to provide new and/or improved MR-TADF emitter complexes.

It is a further object of the present invention to provide new and/or improved MR-TADF emitter complexes containing (i) a polycyclic aromatic/heteroaromatic ligand in which a plurality aromatic/heteroaromatic rings are linked by a boron and a nitrogen atom and (ii) an N-heterocyclic carbene ligand, both ligands coordinated to a metal atom/ion, such as one that has a high spin-orbit coupling.

### SUMMARY OF THE INVENTION

Described are MR-TADF complexes/compounds containing (i) a polycyclic aromatic/heteroaromatic ligand in which a plurality aromatic/heteroaromatic rings are linked by boron and nitrogen atoms and (ii) an N-heterocyclic carbene ligand, with both ligands coordinated to a metal atom/ion. The metal atom or metal ion has a high spin-orbit coupling, including 3d-, 4d-, or Sd-transition metal atoms/ions, such as gold, silver, or copper. Without wishing to be bound by theory, it is believed that the use of the high spin-orbit coupling of metals and/or metal ions facilitates the intersystem crossing and/or reversed intersystem crossing processes of MR-TADF emitters, thereby largely accelerating the rate of TADF and substantially shortening the lifetime of deleterious triplet excitons. Significant reductions in the radiative lifetime of the disclosed MR-TADF complexes compared to pure organic or boron-based organic MR-TADF compounds without a high spin-orbit coupling metal and N-heterocyclic ligand can give rise to (i) a marked delay of efficiency roll-off and/or (ii) practical device lifetimes.

The disclosed compounds have a structure:

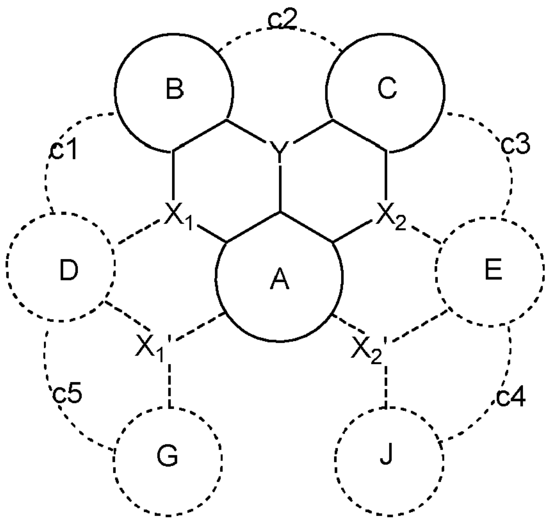

Formula I

wherein:

the compound has an overall neutral, negative, or positive charge,
the dashed linear lines in Formula I denote the presence or absence of a bond,
preferably, $X_1$, Y, and $X_2$ are, respectively: nitrogen, boron, and nitrogen; oxygen, boron, and oxygen; oxygen, boron, and nitrogen; sulfur, boron, and nitrogen; selenium, boron, and nitrogen; boron, nitrogen, and boron;
preferably, A, B, and C are independently substituted aryl, unsubstituted aryl,
preferably, D, E, G, and J are independently absent, substituted aryl, unsubstituted aryl,
preferably, substituted in Formula I means substituted with unsubstituted $C_1$-$C_5$alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted; heteroaryl, CN-, substituted amine (such as $C_1$-$C_5$ dialkylamine, such as $(Me)_2$N-diarylamine, such as (4-methylphenyl)$_2$N-, or unsubstituted amine,
preferably, $X_1$' and $X_2$' are independently absent or nitrogen,
preferably, c1, c2, c3, c4, and c5 are independently absent, single bond, - O-, -S-, -Se-, substituted $C_1$-$C_5$ alkyl (such as -C(Me)$_2$-), or unsubstituted $C_1$-$C_5$ alkyl, and
preferably at least one of A, B, C, D, and E is datively bonded to a moiety having a structure:

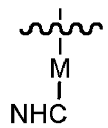

Formula II

wherein:

the dative bond involves M,
NHC has a structure:

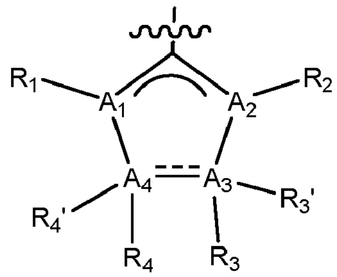

Formula IIa

preferably, M is gold, copper, or silver,

preferably, $A_1$, $A_2$, $A_3$, and $A_4$ are independently carbon or nitrogen, preferably wherein at least one of $A_1$, $A_2$, $A_3$, and $A_4$ is nitrogen and at least one of the other of $A_1$, $A_2$, $A_3$, and $A_4$ is carbon, and $A_1$, $A_2$, $A_3$, and $A_4$ are bonded to none, one, or two hydrogen atoms according to valency,

preferably, $R_1$, $R_2$, $R_3$, $R_3$', $R_4$, and $R_4$' are independently hydrogen, substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), or fused combinations thereof; substituted alkyl, or unsubstituted alkyl (such as unsubstituted $C_1$-$C_5$ alkyl); or $A_2$ and $R_2$ together form a substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, or unsubstituted $C_1$-$C_{20}$ heterocyclyl; or $A_3$, $R_3$, $R_3$', $A_4$, $R_4$, and $R_4$', together form substituted aryl, unsubstituted aryl, substituted heteroaryl, unsubstituted heteroaryl, or fused combinations thereof; preferably, substituted in Formula IIa means substituted with unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, *etc.*), substituted aryl (1,1'-biphenyl-2-yl, 1,1'-biphenyl-3-yl, 1,1'-biphenyl-4-yl, 2,6-dimethylphenyl), unsubstituted aryl (phenyl), and

when the dashed line between $A_3$ and $A_4$ is a single bond, $R_3$' and $R_4$' are absent.

Preferably, the MR-TADF compounds described are photoluminescent and/or electroluminescent, and are preferably, photo-stable, thermally stable, and/or are emissive at room temperatures, low temperatures, or a combination thereof. The MR-TADF compounds described can emit light in response to (i) the passage of an electric current or (ii) to an electric field, and may do so independent of concentration. The emissive properties of the MR-TADF compounds described can be tuned by way of the selection of substituents. The MR-TADF compounds described may emit exclusively or predominantly in the blue to green wavelength range of the visible spectrum.

The MR-TADF compounds can be incorporated into organic electronic components including, but not limited to, OLEDs or a light-emitting electrochemical cell (LEEC). Such OLEDs can be used in commercial applications such smart phones, televisions, monitors, digital cameras, tablet computers, lighting fixtures that usually operate at room temperatures, a fixed visual display unit, mobile visual display unit, illumination unit, keyboard, clothes, ornaments, garment accessary, wearable devices, medical monitoring devices, wall paper, tablet PC, laptop, advertisement panel, panel display unit, household appliances, and office appliances.

Exemplary compounds include:

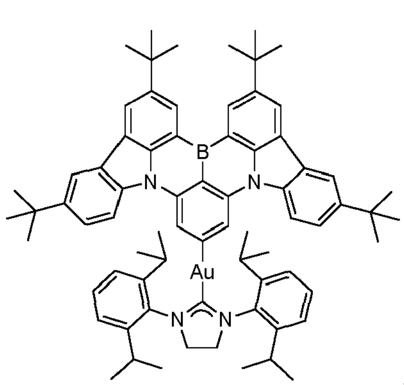 ,

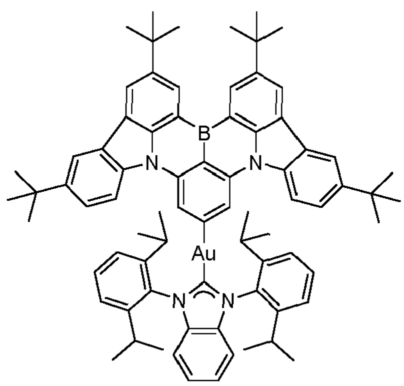 ,

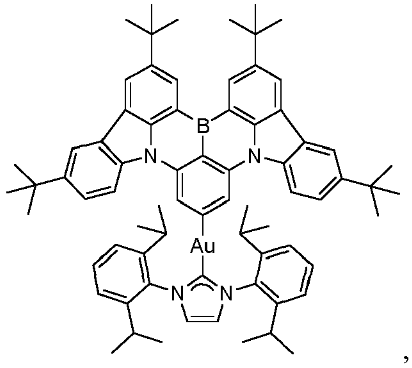

,

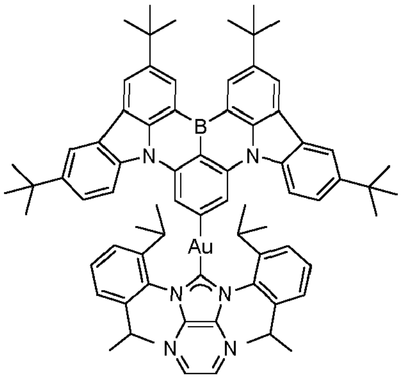

,

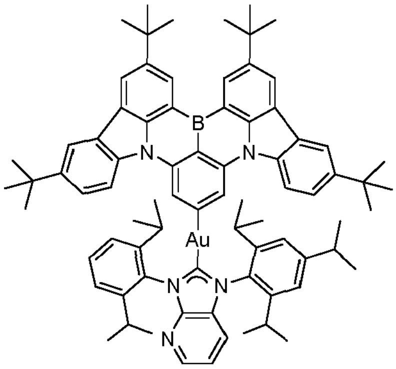

, and

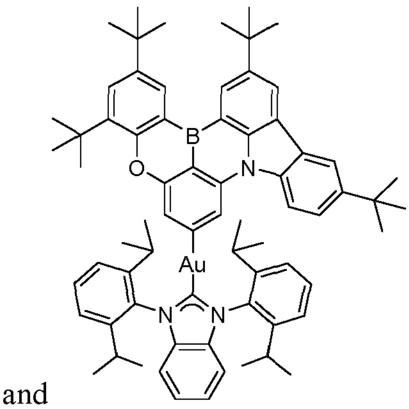

.

Additional exemplary compounds include:

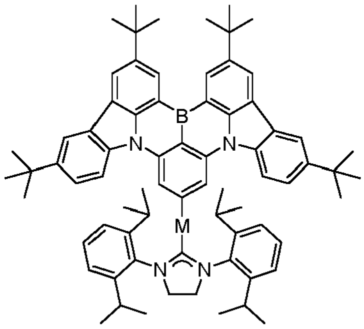

,

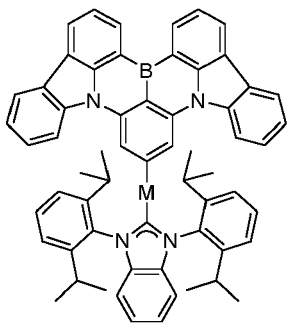

,

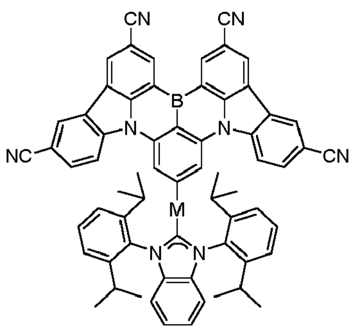

,

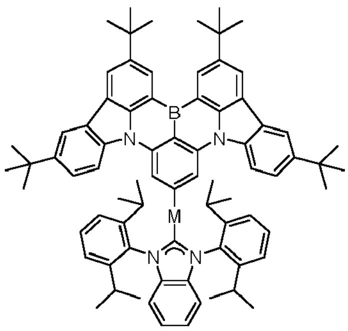

,

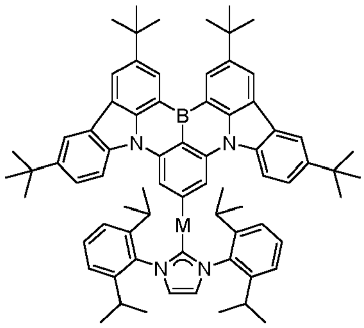
,
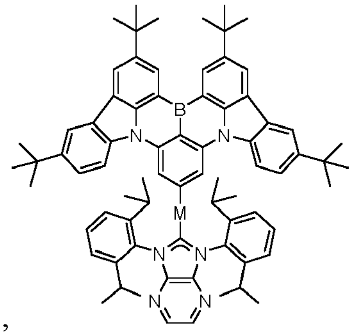
,
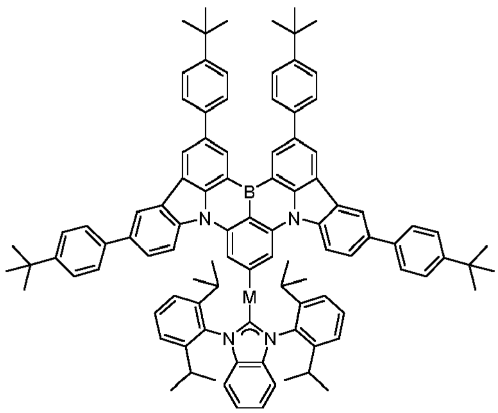
,
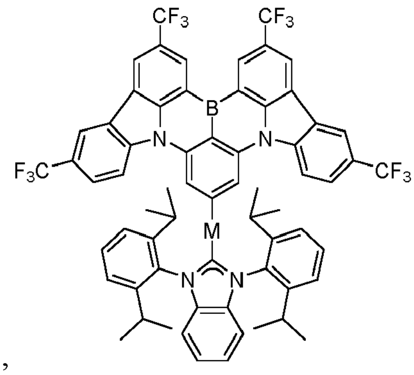
,
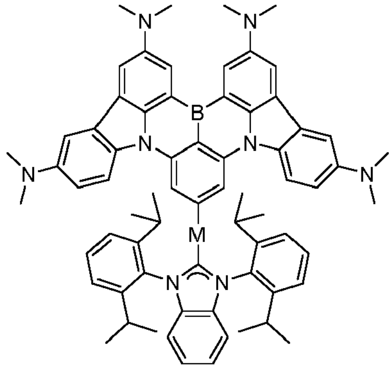
,
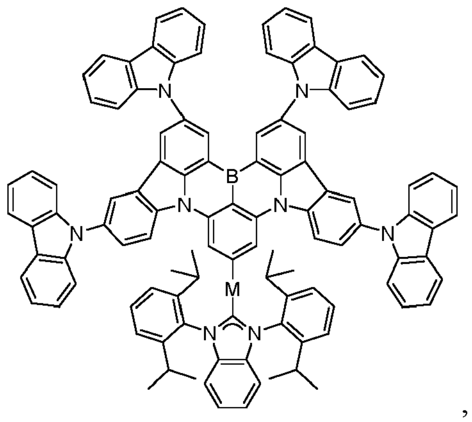
,
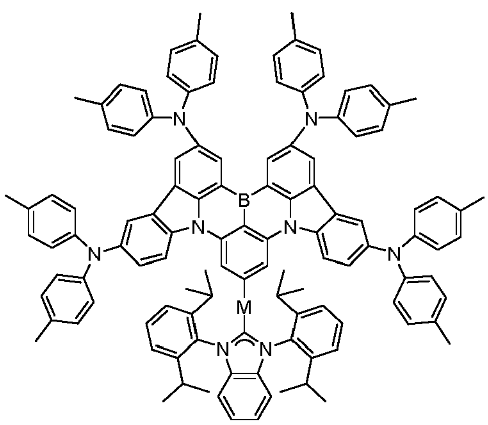
,
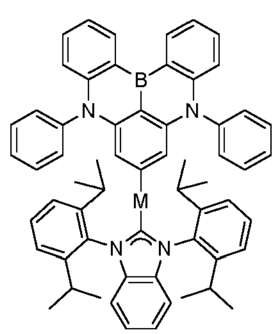
,

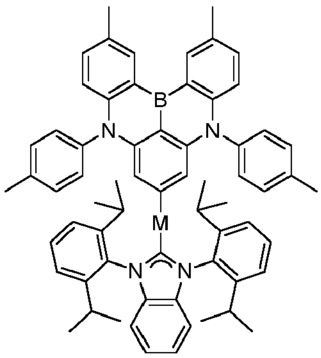
,
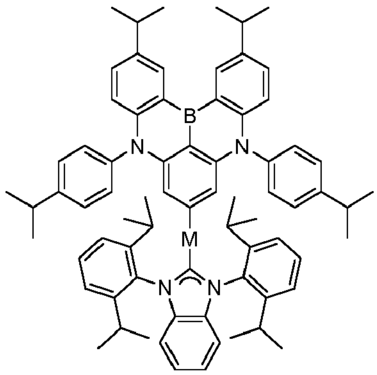
,

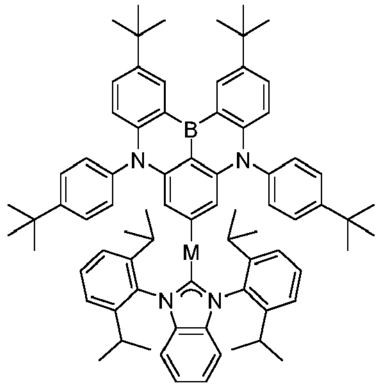
,
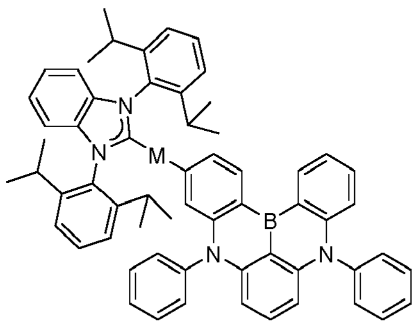
,

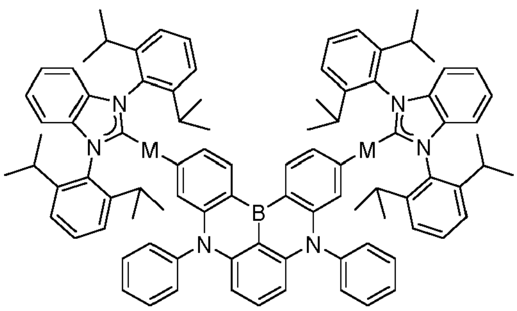
,
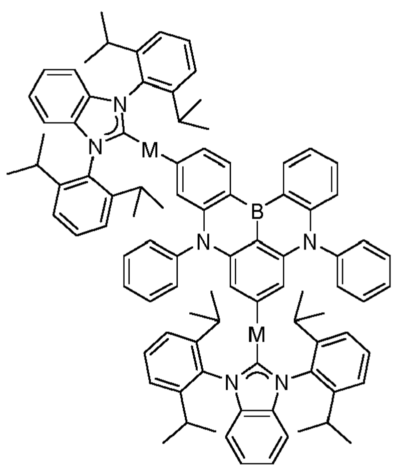
,

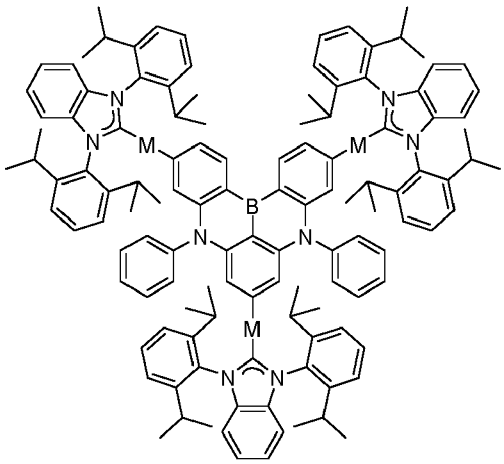

,

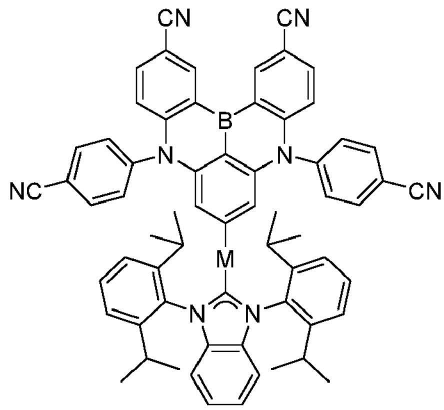

,

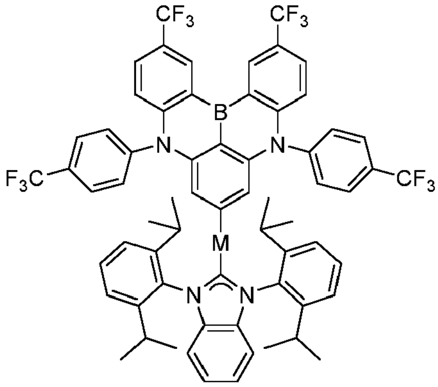

,

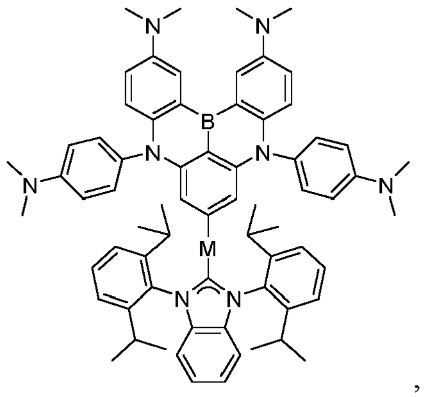

,

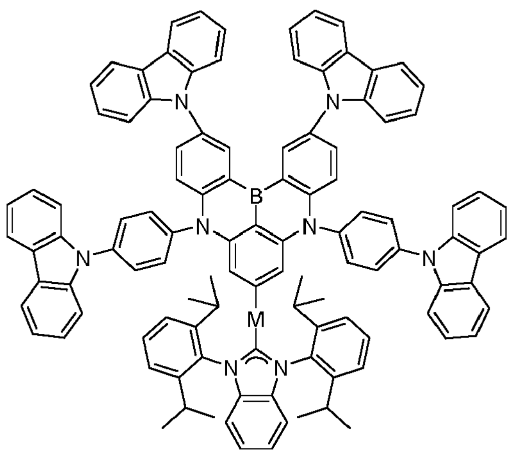

,

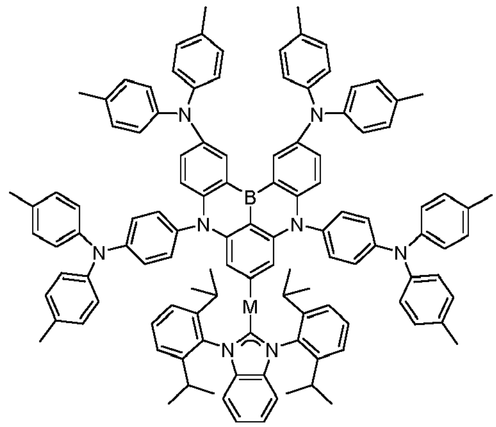
,
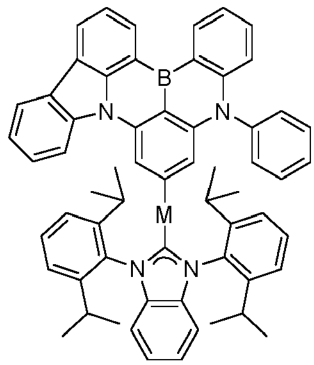
,

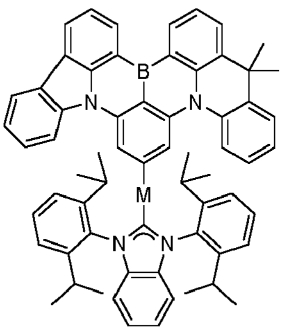
,
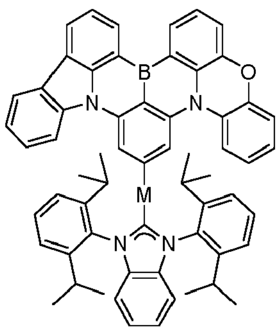
,
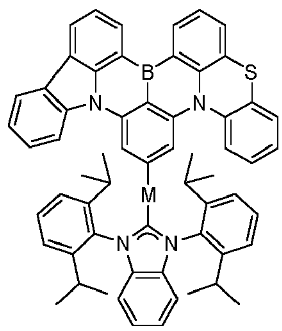
,

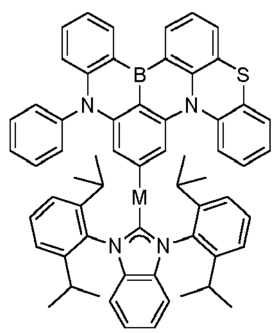
,
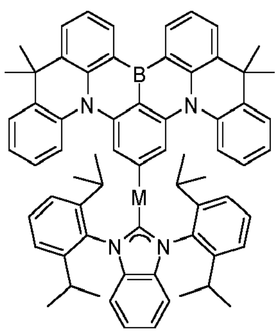
,
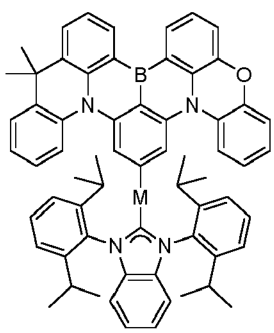
,

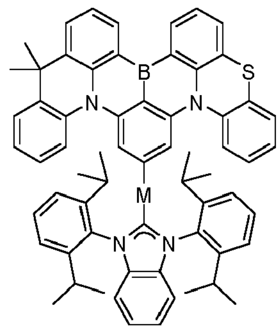
,
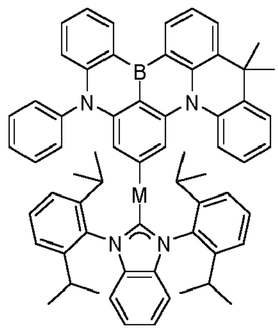
,
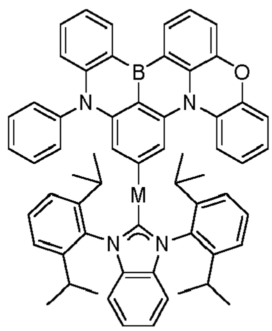
,

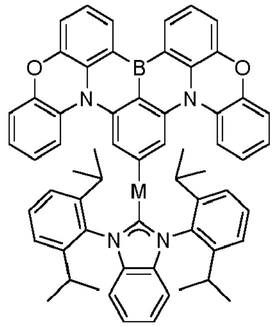,
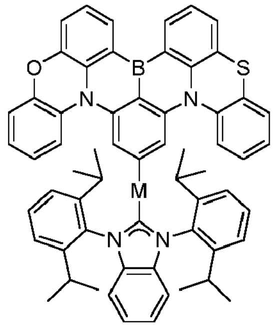,
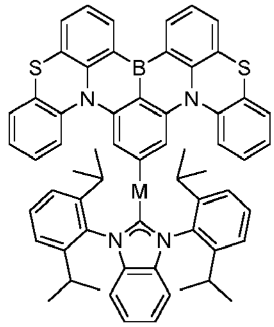,

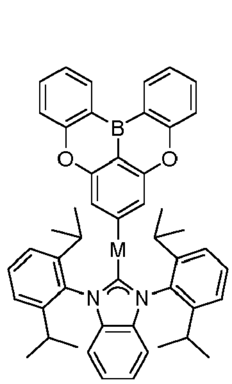,
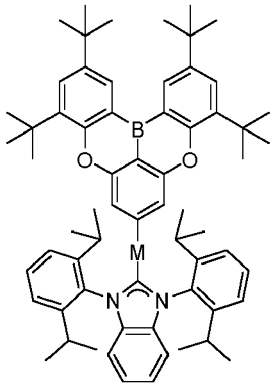,

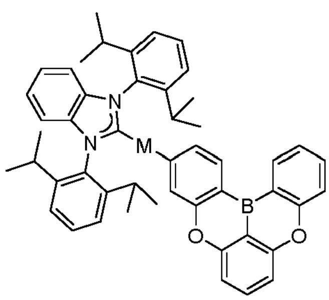,
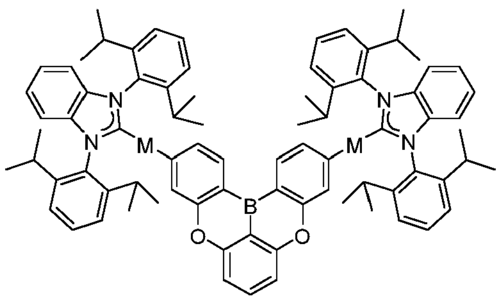,

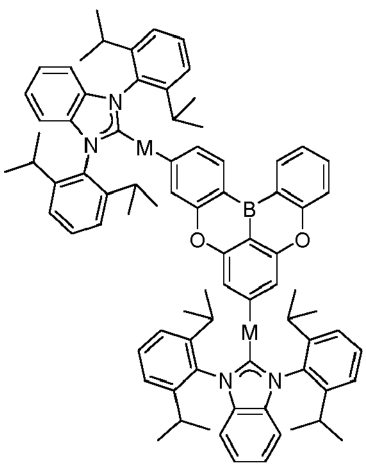,
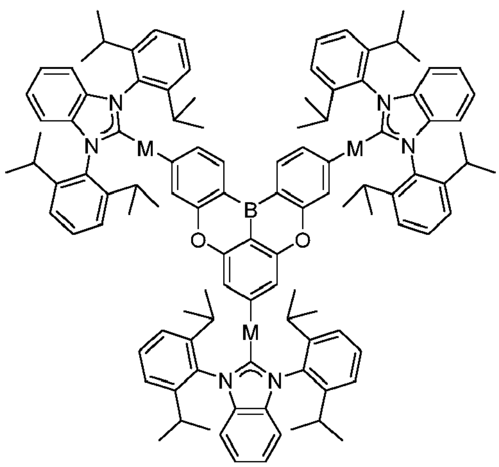,

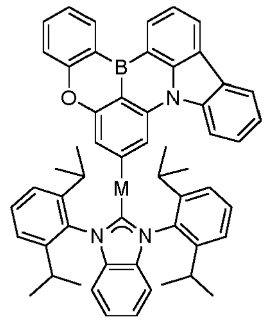

,

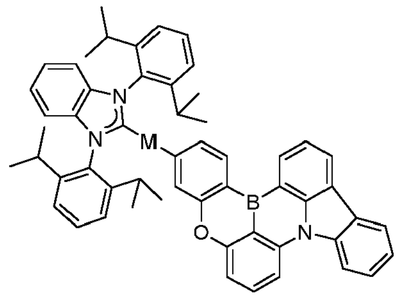

,

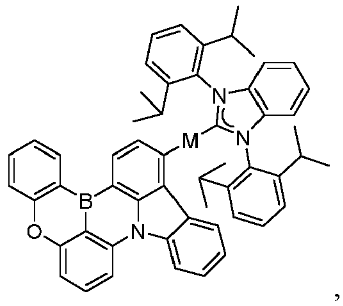

,

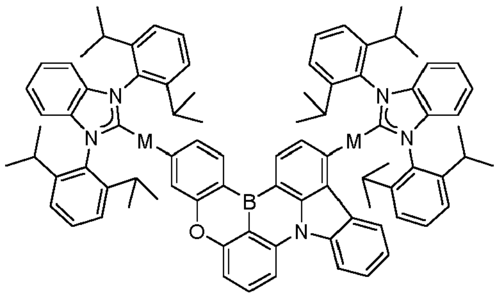

,

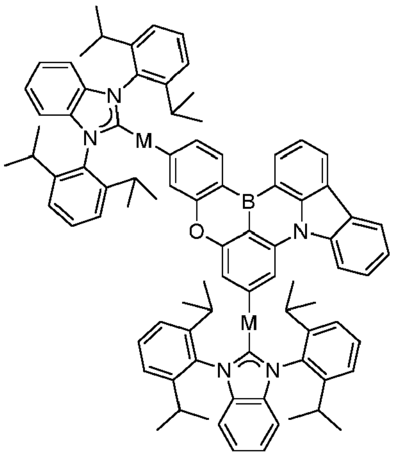

,

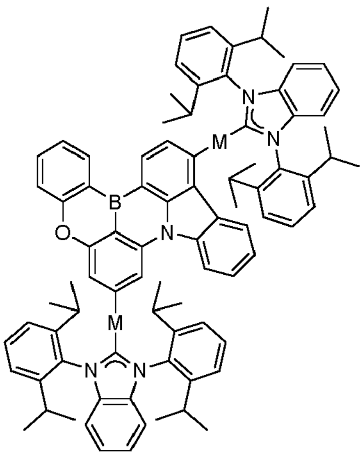

,

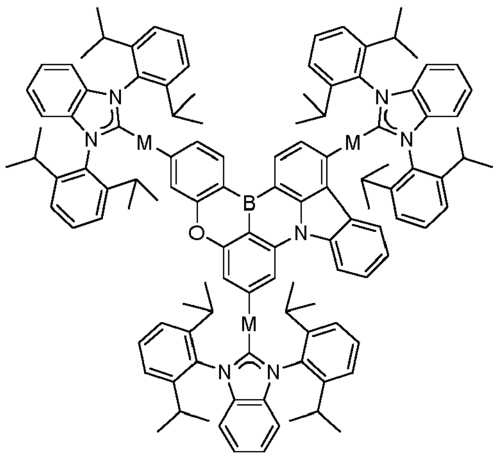

,

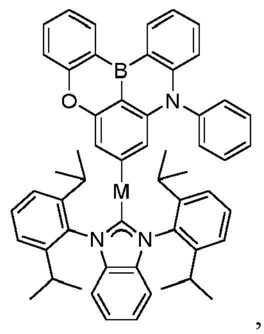

,

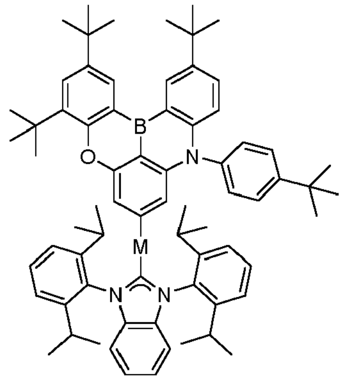
,
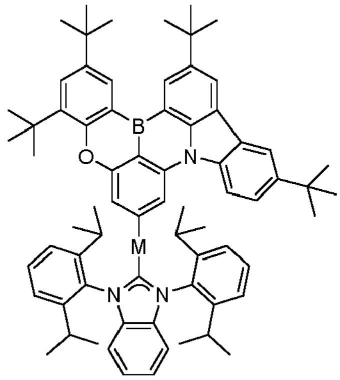
,
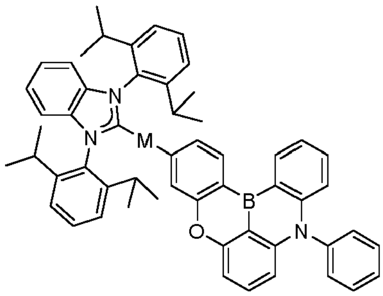
,
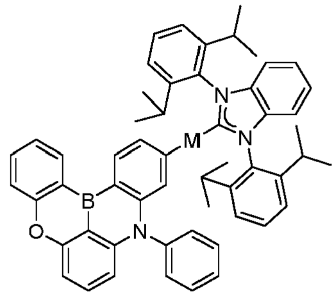
,
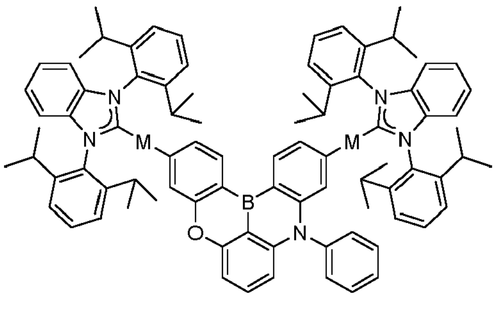
,
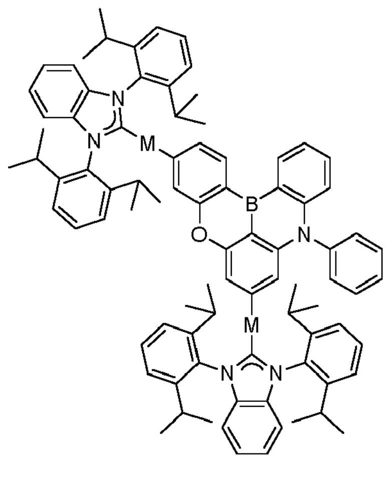
,
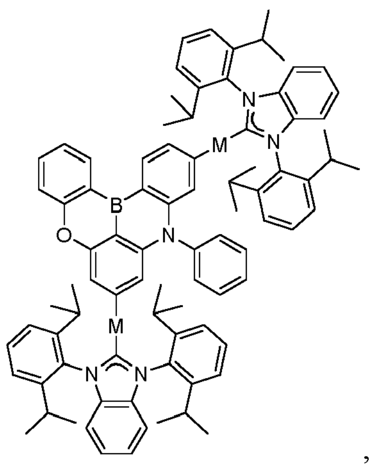
,
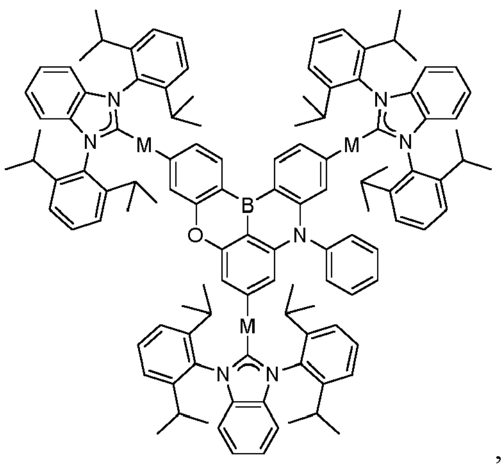
,

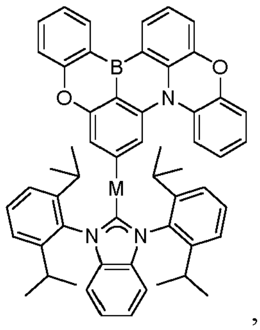
,
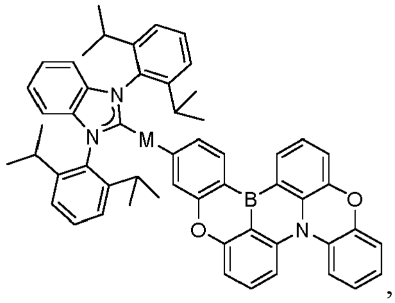
,
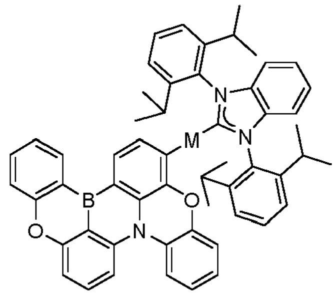
,

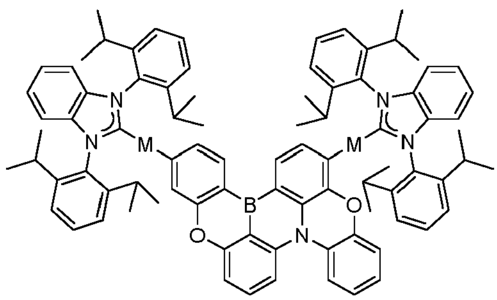
,
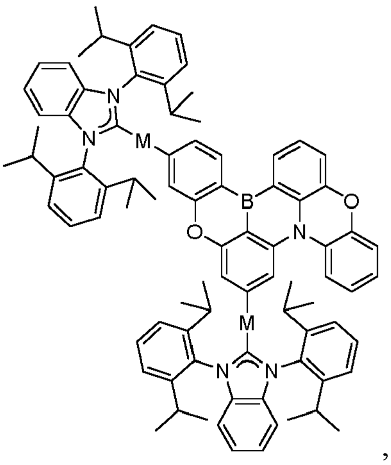
,

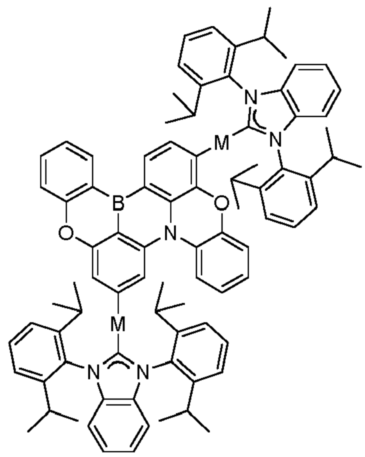
,
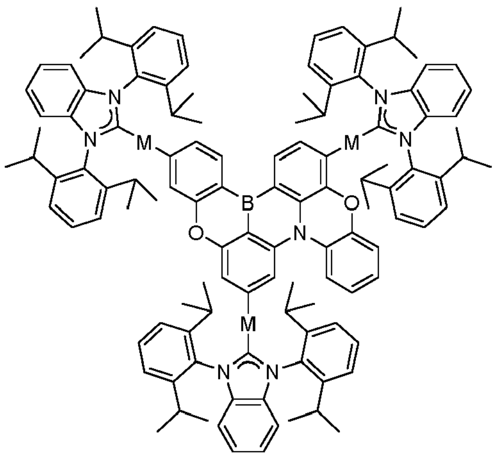
,

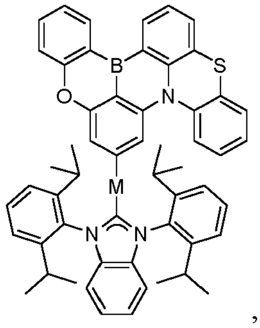
,
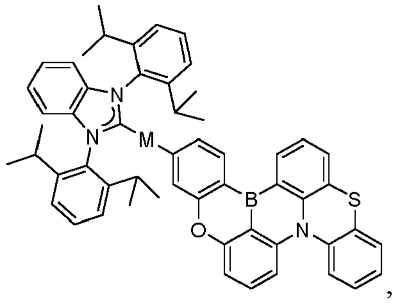
,
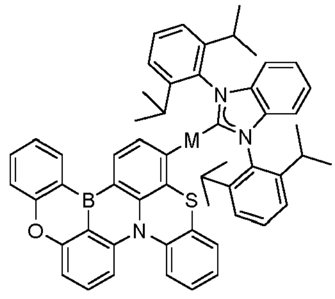
,

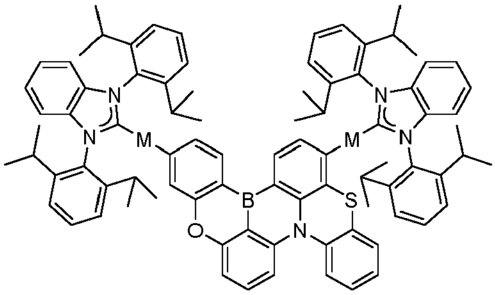

,

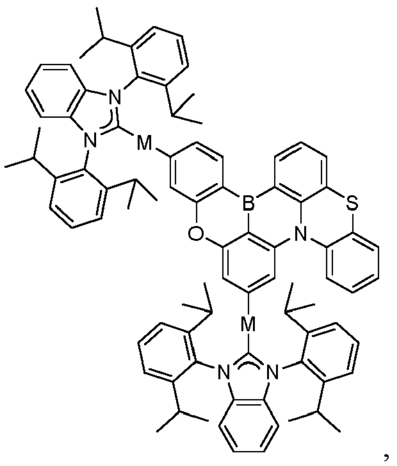

,

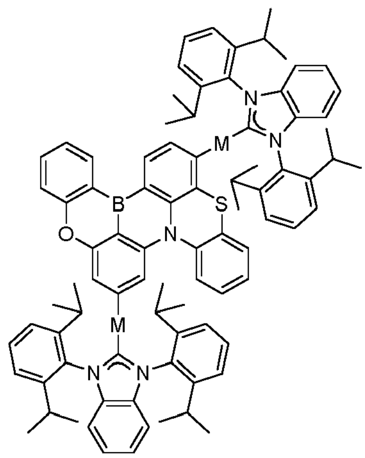

,

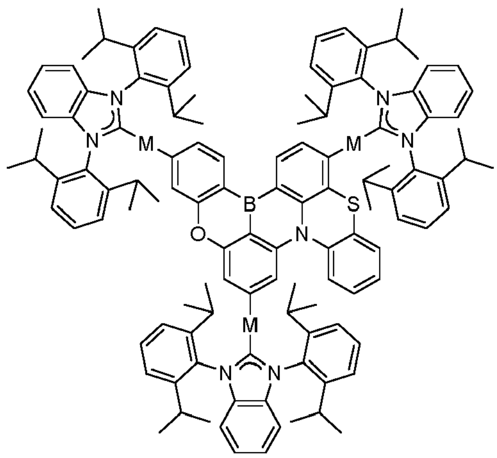

,

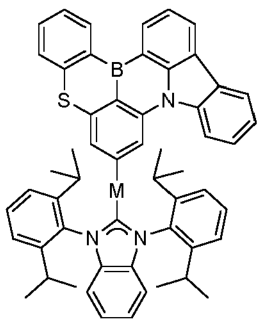

,

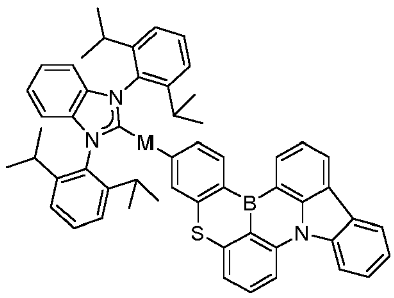

,

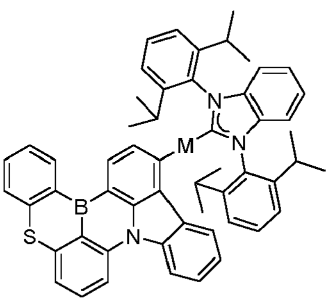

,

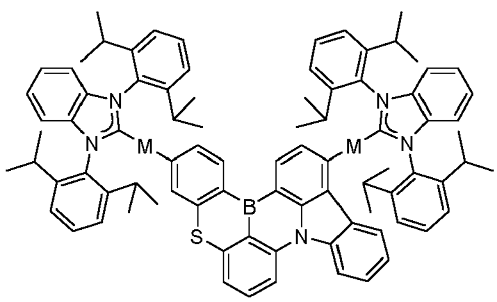

,

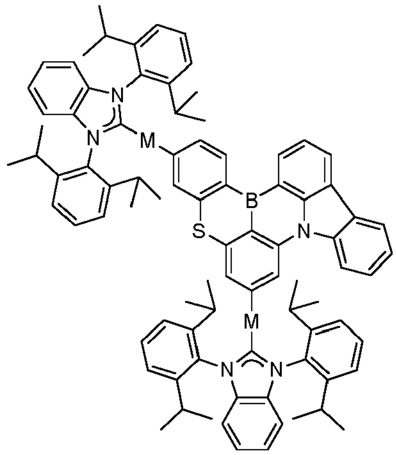,

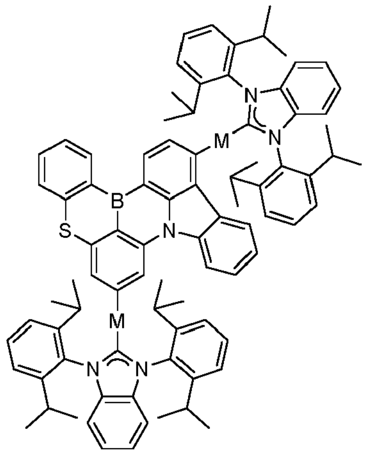,

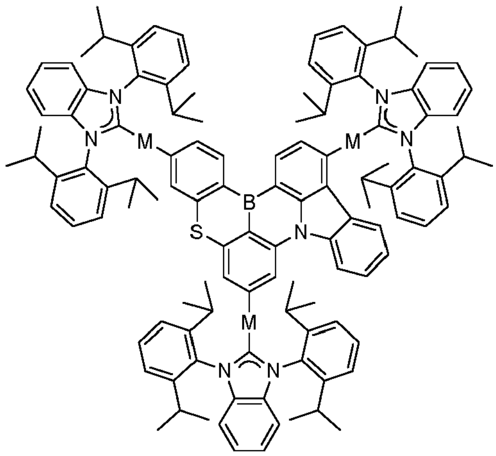,

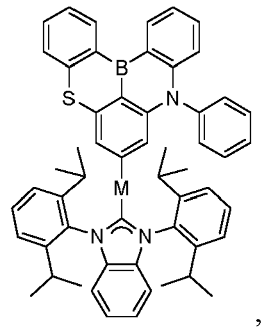,

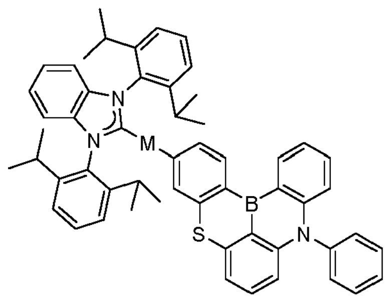,

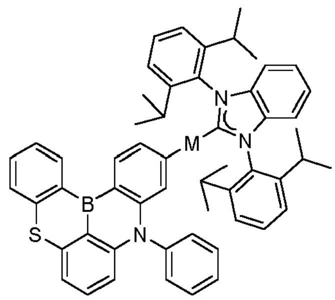,

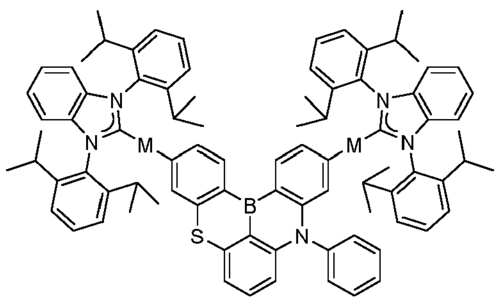,

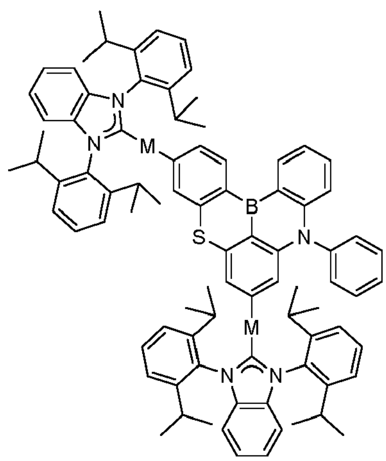,

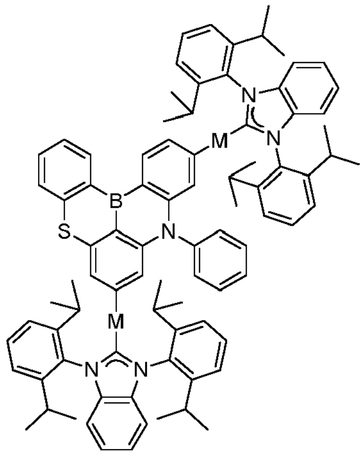

,

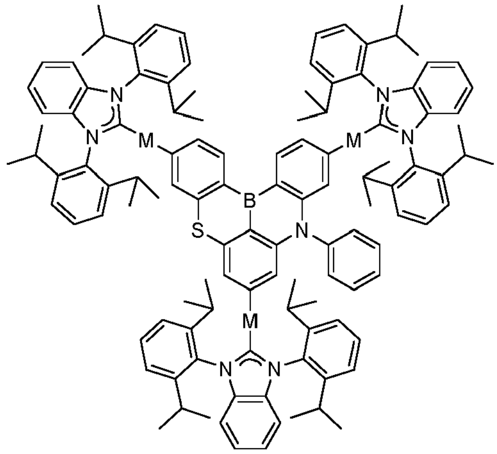

,

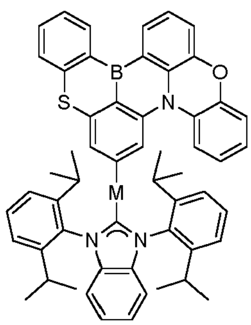

,

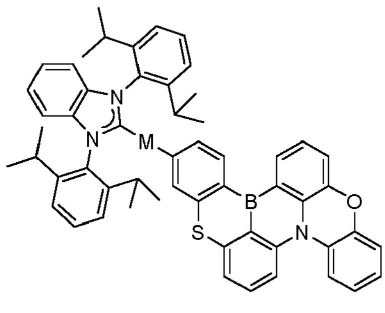

,

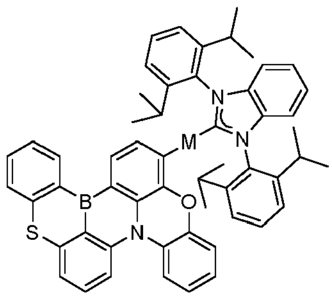

,

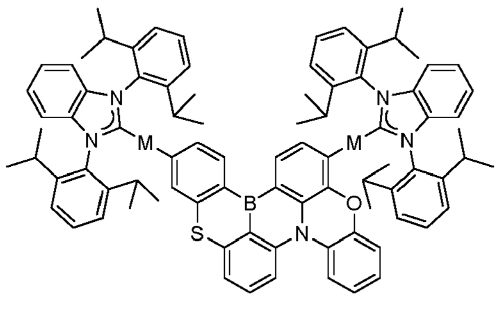

,

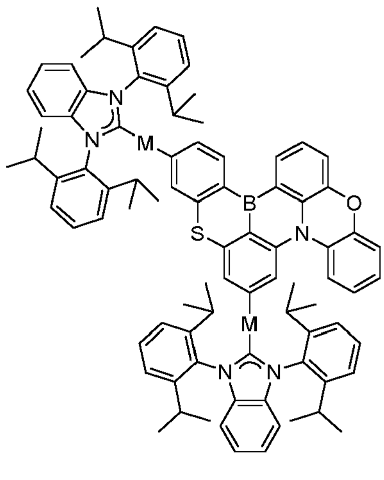

,

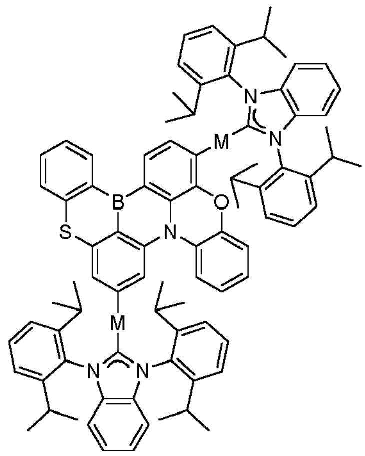 , 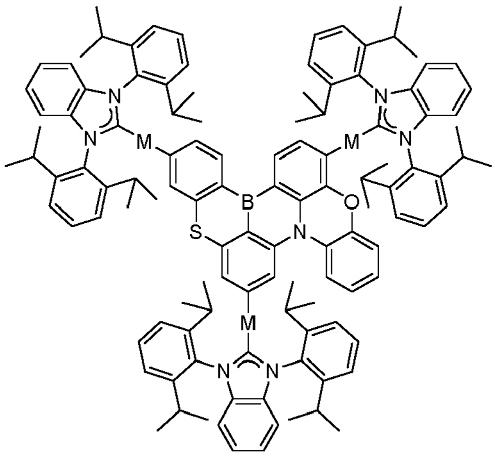 ,

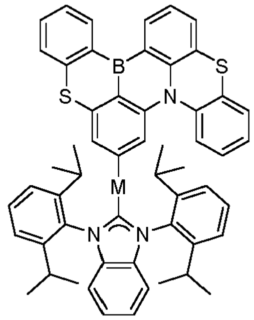 , 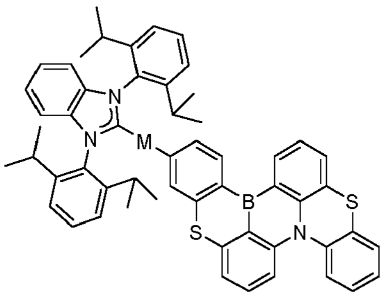 , 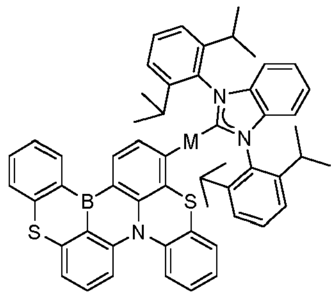 ,

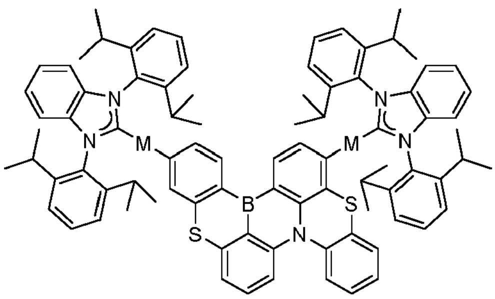 , 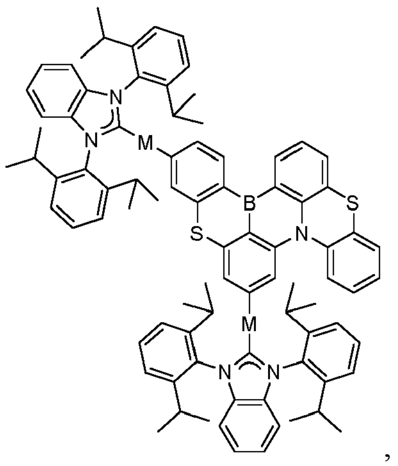 ,

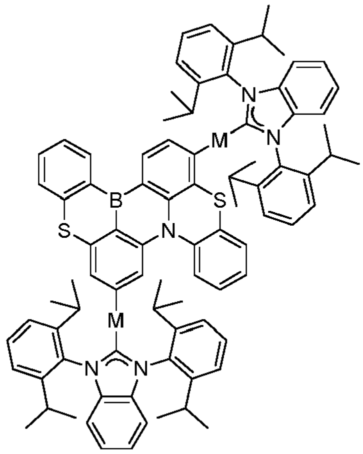

,

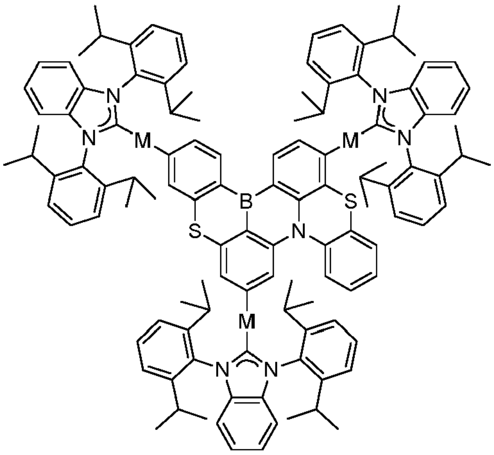

,

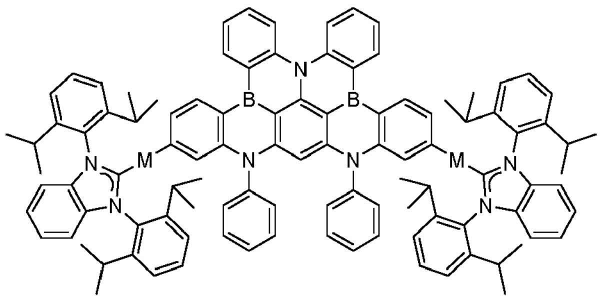

,

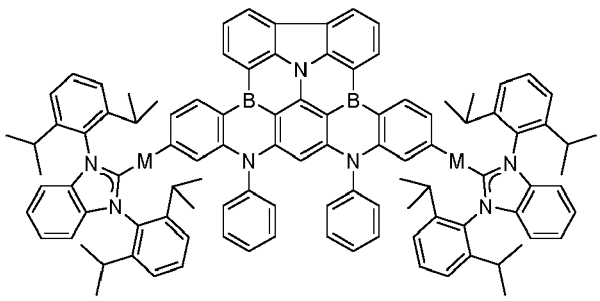

,

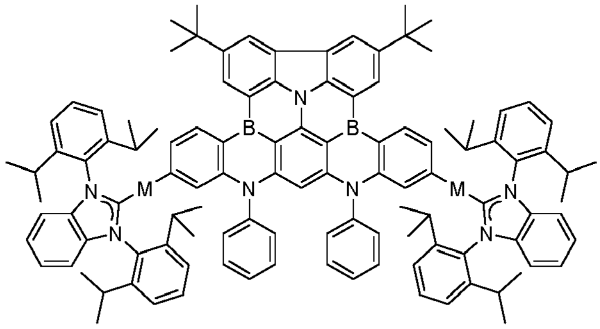

,

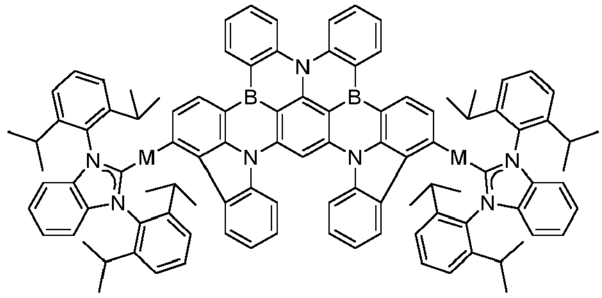

,

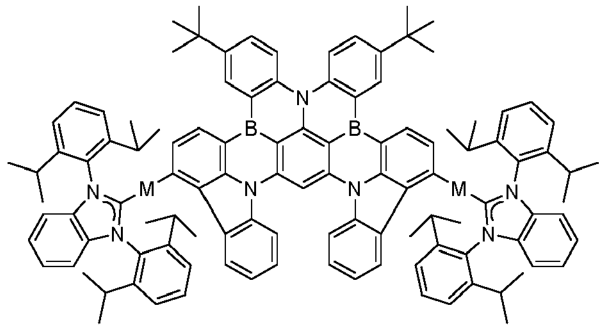

,

or

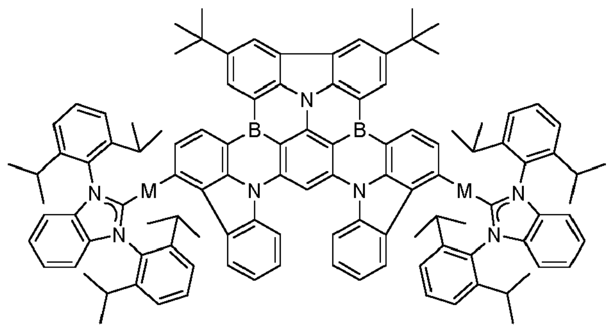

.

wherein M is gold, silver, or copper.

In some forms, M is gold. In some forms, M is silver. In some forms, M is copper.

## BRIEF DESCRIPTION OF THE DRAWINGS

**FIG. 1A** is a chemical representation of a boron-based organic MR-TADF emitter denoted **BN. FIG. 1B** is a chemical representation of a new MR-TADF emitter denoted **AuBN-1. FIG. 1C** is a chemical representation of a new MR-TADF emitter denoted **AuBN-2.**

**FIG. 2A** is a line graph of the normalized emission spectra of **BN, AuBN-1,** and **AuBN-2** in degassed THF (concentration = 2 $\times$ $10^{5}$ $_{M}$). **FIG. 2B** is a line graph of the normalized emission spectra of **BN** in 1 wt% PMMA thin film. **FIG. 2C** is a line graph of the normalized emission spectra of **AuBN-1** and **AuBN-2** in 2 wt% PMMA thin film.

**FIG. 3A** is a chemical representation of a new MR-TADF emitter denoted **AuBN-3. FIG. 3B** is a chemical representation of a new MR-TADF emitter denoted **AuBN-4. FIG. 3C** is a chemical representation of a boron-based organic MR-TADF emitter denoted **BN(O). FIG. 3D** is a chemical representation of a new MR-TADF emitter denoted **AuBN-5.**

**FIGs. 4A-4C** are line graphs showing the normalized electroluminescence (EL) spectra (**FIG. 4A**), external quantum efficiency (EQE)-luminance characteristics (**FIG. 4B**), and current density-voltage-Luminance (*J*-*V*-*L*) characteristics (**FIG. 4C**) of vacuum-deposited OLEDs doped with 0.5, 1, and 2 wt% **BN.** Device structure: ITO/HAT-CN (10 nm)/FSFA (120 nm)/FSF4A (5 nm)/emitter: DMIC-Cz: DMIC-Trz (2 wt%, 30 nm)/ANT-BIZ (5 nm)/ ANT-BIZ: Liq (1:1, 25 nm)/Liq (2 nm)/Al (100 nm).

**FIGs. 5A-5C** are line graphs showing the normalized EL spectra (**FIG. 5A**), EQE-luminance characteristics (**FIG. 5B**), and current density-voltage-Luminance (*J-V-L*) characteristics (**FIG. 5C**) of vacuum-deposited OLEDs doped with 0.5, 1, and 2 wt% **AuBN-1.** Device structure: ITO/HAT-CN (10 nm)/FSFA (120 nm)/FSF4A (5 nm)/AuBN-1 (0.5-2 wt%): DMIC-Cz: DMIC-Trz (2 wt%, 30 nm)/ANT-BIZ (5 nm)/ ANT-BIZ: Liq (1:1, 25 nm)/Liq (2 nm)/Al (100 nm).

**FIGs. 6A-6C** are line graphs showing the normalized EL spectra (**FIG. 6A**), EQE-luminance characteristics (**FIG. 6B**), and current density-voltage-Luminance *(J-V-L)* characteristics (**FIG. 6C**) of vacuum-deposited OLEDs doped with 0.5, 1, and 2 wt% **AuBN-2.** Device structure: ITO/HAT-CN (10 nm)/FSFA (120 nm)/FSF4A (5 nm)/AuBN-2 (0.5-2 wt%): DMIC-Cz: DMIC-Trz (2 wt%, 30 nm)/ANT-BIZ (5 nm)/ ANT-BIZ: Liq (1:1, 25 nm)/Liq (2 nm)/Al (100 nm).

**FIGs. 7A-7C** are line graphs showing the normalized EL spectra (**FIG. 7A**), EQE-luminance characteristics (**FIG. 7B**), and current density-voltage-Luminance (*J-V-L*) characteristics (**FIG. 7C**) of vacuum-deposited OLEDs doped with 0.5, 1, and 2 wt% **AuBN-3.** Device structure: ITO/HAT-CN (10 nm)/FSFA (120 nm)/FSF4A (5 nm)/AuBN-3 (0.5-2 wt%): DMIC-Cz: DMIC-Trz (2 wt%, 30 nm)/ANT-BIZ (5 nm)/ ANT-BIZ: Liq (1:1, 25 nm)/Liq (2 nm)/Al (100 nm).

**FIGs. 8A-8C** are line graphs showing the normalized EL spectra (**FIG. 8A**), EQE-luminance characteristics (**FIG. 8B**), and current density-voltage-Luminance (*J-V-L*) characteristics (**FIG. 8C**) of vacuum-deposited OLEDs doped with 1, 2, and 4 wt% **AuBN-4.** Device structure: ITO/HAT-CN (10 nm)/FSFA (120 nm)/FSF4A (5 nm)/AuBN-4 (1-4 wt%): DMIC-Cz: DMIC-Trz (2 wt%, 30 nm)/ANT-BIZ (5 nm)/ ANT-BIZ: Liq (1:1, 25 nm)/Liq (2 nm)/Al (100 nm).

**FIG. 9** shows a non-limiting example of an organic light-emitting diode device, **100**, having a multilayer architecture. The device contains (i) a cathode **110** including a first layer **120** and a second layer **130;** (ii) an electron transporting layer **140**; (iii) an optional carrier confinement layer **150**; (iv) a light-emitting layer **160**; (v) a hole-transporting layer **170**; and (vi) an anode **180.**

**FIGs. 10A-10C** are line graphs showing the normalized electroluminescence (EL) spectra (**FIG. 10A**), external quantum efficiency (EQE)-luminance characteristics (**FIG. 10B**), current density-voltage-Luminance (*J-V-L*) characteristics (**FIG. 10C**), and luminance (**FIG. 10D**) of vacuum-deposited OLEDs doped with 1, 2, and 4 wt% **AuBN-6.** Device structure: ITO/HAT-CN (10 nm)/FSFA (120 nm)/FSF4A (5 nm)/AuBN-6 (1-4 wt%): DMIC-Cz: DMIC-Trz (2 wt%, 30 nm)/ANT-BIZ (5 nm)/ ANT-BIZ: Liq (1:1, 25 nm)/Liq (2 nm)/Al (100 nm).

**FIGs. 11A** and **11B** line graphs of the UV/Vis absorption and emission spectra of BN and (BzIPr)AuBN (**AuBN-2**) (**FIG. 11A**) and BNO and (BzIPr)AuBNO (**AuBN-5**) (**FIG. 11B**) in THF ($2\times10^{-5}$ M). Insets show PL images of the degassed THF solutions of (BzIPr)AuBN (**AuBN-2**), green, and (BzIPr)AuBNO (**AuBN-5**), blue.

**FIGs. 12A-12F** are line graphs showing the temporal evolution of the early (**FIG. 12A**) and late (**FIG. 12B**) fs-TA spectra of (BzIPr)AuBN and its fs-TRF spectra (**FIG. 12C**) in MeCN. Respective early (**FIG. 12D**) and late (**FIG. 12E**) fs-TA spectra of BN in MeCN (late stage spectral evolution could not be fully captured due to the slow process). **FIG. 12F** shows prompt fluorescence intensity decay time profile of (BzIPr)AuBN (**AuBN-2**) in MeCN. Arrows indicate the direction of spectral evolution.

**FIGs. 13A** and **13B** are line graphs showing the emission spectra of BNO (1 wt %), (BzIPr)AuBNO (2 wt %) (**AuBN-5**), BN (1 wt %), and (BzIPr)AuBN (**AuBN-2**) (2 wt %) in PMMA film. b) Arrhenius plots (157-297 K) for (BzIPr)AuBNO (**AuBN-5**) (blue) and (BzIPr)AuBN (**AuBN-2**) (red).

**FIGs. 14A-14C** are line graphs showing the normalized EL spectra (**FIG. 14A**), EQE-luminance characteristics (**FIG. 14B**), and EQE-current density characteristics (**FIG. 14C**) of OLEDs with BN, (SIPr)AuBN (**AuBN-1**), (IPr)AuBN (**AuBN-3**), (BzIPr)AuBN (**AuBN-2**), (PzIPr)AuBN (**AuBN-4**) and (PyIPr)AuBN (**AuBN-6**).

## DETAILED DESCRIPTION OF THE INVENTION

### I. Definitions

"Substituted," as used herein, refers to all permissible substituents of the compounds or functional groups described herein. In the broadest sense, the permissible substituents include acyclic and cyclic, branched and unbranched, carbocyclic and heterocyclic, aromatic and nonaromatic substituents of organic compounds. Illustrative substituents include, but are not limited to, halogens, hydroxyl groups, or any other organic groupings containing any number of carbon atoms, preferably 1-14 carbon atoms, and optionally include one or more heteroatoms such as oxygen, sulfur, or nitrogen grouping in linear, branched, or cyclic structural formats. Representative substituents include a substituted or unsubstituted alkyl, a substituted or unsubstituted alkenyl, a substituted or unsubstituted alkynyl, a substituted or unsubstituted heterocyclyl, a substituted or unsubstituted phenyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a halogen, a hydroxyl, an alkoxy, a phenoxy, an aroxy, a silyl, a thiol, an alkylthio, a substituted alkylthio, a phenylthio, an arylthio, a cyano, an isocyano, a nitro, a substituted or unsubstituted carbonyl, a carboxyl, an amino, an amido, an oxo, a sulfinyl, a sulfonyl, a sulfonic acid, a phosphonium, a phosphanyl, a phosphoryl, a phosphonyl, an amino acid. Such a substituted or unsubstituted alkyl, a substituted or unsubstituted alkenyl, a substituted or unsubstituted alkynyl, a substituted or unsubstituted heterocyclyl, a substituted or unsubstituted phenyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a halogen, a hydroxyl, an alkoxy, a phenoxy, an aroxy, a silyl, a thiol, an alkylthio, a substituted alkylthio, a phenylthio, an arylthio, a cyano, an isocyano, a nitro, a substituted or unsubstituted carbonyl, a carboxyl, an amino, an amido, an oxo, a sulfinyl, a sulfonyl, a sulfonic acid, a phosphonium, a phosphanyl, a phosphoryl, a phosphonyl, and an amino acid can be further substituted.

Heteroatoms such as nitrogen may have hydrogen substituents and/or any permissible substituents of organic compounds described herein which satisfy the valences of the heteroatoms. It is understood that "substitution" or "substituted" includes the implicit proviso that such substitution is in accordance with permitted valence of the substituted atom and the substituent, and that the substitution results in a stable compound, *i.e.,* a compound that does not spontaneously undergo transformation such as by rearrangement, cyclization, elimination, etc.

"Alkyl," as used herein, refers to the radical of saturated aliphatic groups, including straight-chain alkyl groups, branched-chain alkyl, and cycloalkyl (alicyclic). In some forms, a straight chain or branched chain alkyl has 30 or fewer carbon atoms in its backbone (e.g., $C_1$-$C_{30}$ for straight chains, $C_3$-$C_{30}$ for branched chains), 20 or fewer, 15 or fewer, or 10 or fewer. Alkyl includes methyl, ethyl, *n*-propyl, isopropyl, *n*-butyl, isobutyl, *t*-butyl, pentyl, hexyl, heptyl, octyl, decyl, tetradecyl, hexadecyl, eicosyl, tetracosyl and the like. Likewise, a cycloalkyl is a non-aromatic carbon-based ring composed of at least three carbon atoms, such as a nonaromatic monocyclic or nonaromatic polycyclic ring containing 3-30 carbon atoms, 3-20 carbon atoms, or 3-10 carbon atoms in their ring structure, and have 5, 6 or 7 carbons in the ring structure. Cycloalkyls containing a polycyclic ring system can have two or more non-aromatic rings in which two or more carbons are common to two adjoining rings (i.e., "fused cycloalkyl rings"). Examples of cycloalkyl groups include, but are not limited to, cyclopropyl, cyclobutyl, cyclopentyl, cyclohexyl, cycloheptyl, cyclooctanyl, etc.

"Substituted alkyl" refers to alkyl moieties having one or more substituents replacing a hydrogen on one or more carbons of the hydrocarbon backbone. Such substituents can be any substituents described above, e.g., halogen (such as fluorine, chlorine, bromine, or iodine), hydroxyl, carbonyl (such as a carboxyl, alkoxycarbonyl, formyl, or an acyl), thiocarbonyl (such as a thioester, a thioacetate, or a thioformate), aryl, alkoxyl, aralkyl, phosphonium, phosphanyl, phosphonyl, phosphoryl, phosphate, phosphonate, a phosphinate, amino, amido, amidine, imine, cyano, nitro, azido, oxo, sulfhydryl, thiol, alkylthio, silyl, sulfinyl, sulfate, sulfonate, sulfamoyl, sulfonamido, sulfonyl, heterocyclyl, an aromatic or heteroaromatic moiety. -NRR', wherein Rand R' are independently hydrogen, alkyl, or aryl, and wherein the nitrogen atom is optionally quaternized; -SR, wherein R is a phosphonyl, a sulfinyl, a silyl a hydrogen, an alkyl, or an aryl; -CN; $-NO_2$; -COOH; carboxylate; -COR, -COOR, or $-CON(R)_2$, wherein R is hydrogen, alkyl, or aryl; imino, silyl, ether, haloalkyl (such as -CF3, $-CH_2-CF_3$, $-CCl_3$); -CN; $-NCOCOCH_2CH_2$; -NCOCOCHCH; and -NCS; and combinations thereof.

It will be understood by those skilled in the art that the moieties substituted on the hydrocarbon chain can themselves be substituted, if appropriate. For instance, the substituents of a substituted alkyl may include halogen, hydroxy, nitro, thiols, amino, aralkyl, azido, imino, amido, phosphonium, phosphanyl, phosphoryl (including phosphonate and phosphinate), oxo, sulfonyl (including sulfate, sulfonamido, sulfamoyl and sulfonate), and silyl groups, as well as ethers, alkylthios, carbonyls (including ketones, aldehydes, carboxylates, and esters), haloalkyls, -CN and the like. Cycloalkyls can be substituted in the same manner.

Unless the number of carbons is otherwise specified, "lower alkyl" as used herein means an alkyl group, as defined above, but having from one to ten carbons, more preferably from one to six carbon atoms in its backbone structure. Likewise, "lower alkenyl" and "lower alkynyl" have similar chain lengths.

"Heteroalkyl," as used herein, refers to straight or branched chain, or cyclic carbon-containing alkyl radicals, or combinations thereof, containing at least one heteroatom on the carbon backbone. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkyl group" is a cycloalkyl group as defined above where at least one of the carbon atoms of the ring is substituted with a heteroatom such as, but not limited to, nitrogen, oxygen, sulphur, or phosphorus.

The term "alkenyl" as used herein is a hydrocarbon group of from 2 to 24 carbon atoms and structural formula containing at least one carbon-carbon double bond. Alkenyl groups include straight-chain alkenyl groups, branched-chain alkenyl, and cycloalkenyl. A cycloalkenyl is a non-aromatic carbon-based ring composed of at least three carbon atoms and at least one carbon-carbon double bond, such as a nonaromatic monocyclic or nonaromatic polycyclic ring containing 3-30 carbon atoms and at least one carbon-carbon double bond, 3-20 carbon atoms and at least one carbon-carbon double bond, or 3-10 carbon atoms and at least one carbon-carbon double bond in their ring structure, and have 5, 6 or 7 carbons and at least one carbon-carbon double bond in the ring structure. Cycloalkenyls containing a polycyclic ring system can have two or more non-aromatic rings in which two or more carbons are common to two adjoining rings (i.e., "fused cycloalkenyl rings") and contain at least one carbon-carbon double bond. Asymmetric structures such as (AB)C=C(C'D) are intended to include both the *E* and *Z* isomers. This may be presumed in structural formulae herein wherein an asymmetric alkene is present, or it may be explicitly indicated by the bond symbol C. The term "alkenyl" as used throughout the specification, examples, and claims is intended to include both "unsubstituted alkenyls" and "substituted alkenyls," the latter of which refers to alkenyl moieties having one or more substituents replacing a hydrogen on

one or more carbons of the hydrocarbon backbone. The term "alkenyl" also includes "heteroalkenyl."

The term "substituted alkenyl" refers to alkenyl moieties having one or more substituents replacing one or more hydrogen atoms on one or more carbons of the hydrocarbon backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, oxo, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

"Heteroalkenyl," as used herein, refers to straight or branched chain, or cyclic carbon-containing alkenyl radicals, or combinations thereof, containing at least one heteroatom. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkenyl group" is a cycloalkenyl group where at least one of the carbon atoms of the ring is substituted with a heteroatom such as, but not limited to, nitrogen, oxygen, sulphur, or phosphorus.

The term "alkynyl group" as used herein is a hydrocarbon group of 2 to 24 carbon atoms and a structural formula containing at least one carbon-carbon triple bond. Alkynyl groups include straight-chain alkynyl groups, branched-chain alkynyl, and cycloalkynyl. A cycloalkynyl is a non-aromatic carbon-based ring composed of at least three carbon atoms and at least one carbon-carbon triple bond, such as a nonaromatic monocyclic or nonaromatic polycyclic ring containing 3-30 carbon atoms and at least one carbon-carbon triple bond, 3-20 carbon atoms and at least one carbon-carbon triple bond, or 3-10 carbon atoms and at least one carbon-carbon triple bond in their ring structure, and have 5, 6 or 7 carbons and at least one carbon-carbon triple bond in the ring structure. Cycloalkynyls containing a polycyclic ring system can have two or more non-aromatic rings in which two or more carbons are common to two adjoining rings (i.e., "fused cycloalkynyl rings") and contain at least one carbon-carbon triple bond. Asymmetric structures such as (AB)C≡C(C"D) are intended to include both the *E* and *Z* isomers. This may be presumed in structural formulae herein wherein an asymmetric alkyne is present, or it may be explicitly indicated by the bond symbol C. The term "alkynyl" as used throughout the specification, examples, and claims is intended to include both "unsubstituted alkynyls" and "substituted alkynyls," the latter of which refers to alkynyl moieties having one or more substituents replacing a hydrogen on one or more carbons of the hydrocarbon backbone. The term "alkynyl" also includes "heteroalkynyl."

The term "substituted alkynyl" refers to alkynyl moieties having one or more substituents replacing one or more hydrogen atoms on one or more carbons of the hydrocarbon backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

"Heteroalkynyl," as used herein, refers to straight or branched chain, or cyclic carbon-containing alkynyl radicals, or combinations thereof, containing at least one heteroatom. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkynyl group" is a cycloalkynyl group where at least one of the carbon atoms of the ring is substituted with a heteroatom such as, but not limited to, nitrogen, oxygen, sulphur, or phosphorus.

"Aryl," as used herein, refers to $C_5$-$C_{26}$-membered aromatic or fused aromatic ring systems. Examples of aromatic groups are benzene, naphthalene, anthracene, phenanthrene, chrysene, pyrene, corannulene, coronene, etc.

The term "substituted aryl" refers to an aryl group, wherein one or more hydrogen atoms on one or more aromatic rings are substituted with one or more substituents including, but not limited to, halogen, azide, alkyl, aralkyl, alkenyl, alkynyl, cycloalkyl, hydroxyl, alkoxy, carbonyl (such as a ketone, aldehyde, carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, imino, alkylthio, sulfate, sulfonate, sulfamoyl, sulfoxide, sulfonamido, sulfonyl, heterocyclyl, alkylaryl, haloalkyl (such as $CF_3$, $-CH_2-CF_3$, $-CCl_3$), -CN, aryl, heteroaryl, and combinations thereof.

"Heterocycle" and "heterocyclyl" are used interchangeably, and refer to a cyclic radical attached via a ring carbon or nitrogen atom of a non-aromatic monocyclic or polycyclic ring containing 3-30 ring atoms, 3-20 ring atoms, 3-10 ring atoms, or 5-6 ring atoms, where each ring contains carbon and one to four heteroatoms each selected from the group consisting of non-peroxide oxygen, sulfur, and N(Y) wherein Y is absent or is H, O, $C_1$-$C_{10}$ alkyl, phenyl or benzyl, and optionally containing 1-3 double bonds and optionally substituted with one or more substituents. Heterocyclyl are distinguished from heteroaryl by definition. Heterocycles can be a heterocycloalkyl, a heterocycloalkenyl, a heterocycloalkynyl, etc, such as piperazinyl, piperidinyl, piperidonyl, 4-piperidonyl, dihydrofuro[2,3-*b*]tetrahydrofuran, morpholinyl, piperazinyl, piperidinyl, piperidonyl, 4-piperidonyl, piperonyl, pyranyl, 2H-pyrrolyl, 4*H*-quinolizinyl, quinuclidinyl, tetrahydrofuranyl, 6*H*-1,2,5-thiadiazinyl. Heterocyclic groups can optionally be substituted with one or more substituents as defined above for alkyl and aryl.

The term "heteroaryl" refers to $C_5$-$C_{26}$-membered aromatic or fused aromatic ring systems, in which one or more carbon atoms on one or more aromatic ring structures have been substituted with a heteroatom. Suitable heteroatoms include, but are not limited to, oxygen, sulfur, and nitrogen. Examples of heteroaryl groups pyrrole, furan, thiophene, imidazole, oxazole, thiazole, triazole, tetrazole, pyrazole, pyridine, pyrazine, pyridazine and pyrimidine, and the like. Examples of heteroaryl rings include, but are not limited to, benzimidazolyl, benzofuranyl, benzothiofuranyl, benzothiophenyl, benzoxazolyl, benzoxazolinyl, benzthiazolyl, benztriazolyl, benztetrazolyl, benzisoxazolyl, benzisothiazolyl, benzimidazolinyl, carbazolyl, 4aH-carbazolyl, carbolinyl, chromanyl, chromenyl, cinnolinyl, decahydroquinolinyl, 2H,6H-1,5,2-dithiazinyl, furanyl, furazanyl, imidazolidinyl, imidazolinyl, imidazolyl, 1H-indazolyl, indolenyl, indolinyl, indolizinyl, indolyl, 3H-indolyl, isatinoyl, isobenzofuranyl, isochromanyl, isoindazolyl, isoindolinyl, isoindolyl, isoquinolinyl, isothiazolyl, isoxazolyl, methylenedioxyphenyl, naphthyridinyl, octahydroisoquinolinyl, 1,2,3-oxadiazolyl, 1,2,4-oxadiazolyl, 1,2,5-oxadiazolyl, 1,3,4-oxadiazolyl, oxazolidinyl, oxazolyl, oxindolyl, pyrimidinyl, phenanthridinyl, phenanthrolinyl, phenazinyl, phenothiazinyl, phenoxathinyl, phenoxazinyl, phthalazinyl, pteridinyl, purinyl, pyrazinyl, pyrazolidinyl, pyrazolinyl, pyrazolyl, pyridazinyl, pyridooxazole, pyridoimidazole, pyridothiazole, pyridinyl, pyridyl, pyrimidinyl, pyrrolidinyl, pyrrolinyl, pyrrolyl, quinazolinyl, quinolinyl, quinoxalinyl, tetrahydroisoquinolinyl, tetrahydroquinolinyl, tetrazolyl, 1,2,3-thiadiazolyl, 1,2,4-thiadiazolyl, 1,2,5-thiadiazolyl, 1,3,4-thiadiazolyl, thianthrenyl, thiazolyl, thienyl, thienothiazolyl, thienooxazolyl, thienoimidazolyl, thiophenyl and xanthenyl. One or more of the rings can be substituted as defined below for "substituted heteroaryl."

The term "substituted heteroaryl" refers to a heteroaryl group in which one or more hydrogen atoms on one or more heteroaromatic rings are substituted with one or more substituents including, but not limited to, halogen, azide, alkyl, aralkyl, alkenyl, alkynyl, cycloalkyl, hydroxyl, alkoxy, carbonyl (such as a ketone, aldehyde, carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, imino, alkylthio, sulfate, sulfonate, sulfamoyl, sulfoxide, sulfonamido, sulfonyl, heterocyclyl, alkylaryl, haloalkyl (such as $CF_3$, $-CH_2-CF_3$, $-CCl_3$), -CN, aryl, heteroaryl, and combinations thereof.

The term "polyaryl" refers to a chemical moiety that includes two or more fused aryl groups. When two or more fused heteroaryl groups are involved, the chemical moiety can be referred to as a "polyheteroaryl."

The term "substituted polyaryl" refers to a polyaryl in which one or more of the aryls are substituted, with one or more substituents including, but not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, alkylthio, sulfate, sulfonate, sulfamoyl, sulfoxide, sulfonamido, sulfonyl, heterocyclyl, alkylaryl, haloalkyl, -CN, aryl, heteroaryl, and combinations thereof. When a polyheteroaryl is involved, the chemical moiety can be referred to as a "substituted polyheteroaryl."

The term "cyclic ring" or "cyclic group" refers to a substituted or unsubstituted monocyclic ring or a substituted or unsubstituted polycyclic ring (such as those formed from single or fused ring systems), such as a substituted or unsubstituted cycloalkyl, a substituted or unsubstituted cycloalkenyl, a substituted or unsubstituted cycloalkynyl, or a substituted or unsubstituted heterocyclyl, that have from three to 30 carbon atoms, as geometric constraints permit. The substituted cycloalkyls, cycloalkenyls, cycloalkynyls, and heterocyclyls are substituted as defined above for the alkyls, alkenyls, alkynyls, and heterocyclyls, respectively.

The term "aralkyl" as used herein is an aryl group or a heteroaryl group having an alkyl, alkynyl, or alkenyl group as defined above attached to the aromatic group, such as an aryl, a heteroaryl, a polyaryl, or a polyheteroaryl. An example of an aralkyl group is a benzyl group.

The terms "alkoxyl" or "alkoxy," "aroxy" or "aryloxy," generally describe compounds represented by the formula $-OR^v$, wherein $R^v$ includes, but is not limited to, a substituted or unsubstituted alkyl, a substituted or unsubstituted alkenyl, a substituted or unsubstituted alkynyl, a substituted or unsubstituted cycloalkyl, a substituted or unsubstituted heterocyclyl, a substituted or unsubstituted cycloalkenyl, a substituted or unsubstituted heterocycloalkenyl, a substituted or unsubstituted aryl, a substituted or unsubstituted heteroaryl, a substituted or unsubstituted polyaryl, a substituted or unsubstituted polyheteroaryl, a substituted or unsubstituted arylalkyl, a substituted or unsubstituted heteroalkyl, a substituted or unsubstituted alkylaryl, a substituted or unsubstituted alkylheteroaryl, a substituted or unsubstituted aralkyl, a substituted or unsubstituted carbonyl, a phosphonium, a phosphanyl, a phosphonyl, a sulfinyl, a silyl, a thiol, an amido, and an amino. Exemplary alkoxyl groups include methoxy, ethoxy, propyloxy, tert-butoxy and the like. A "lower alkoxy" group is an alkoxy group containing from one to six carbon atoms. An "ether" is two functional groups covalently linked by an oxygen as defined below. Accordingly, the substituent of an alkyl that renders that alkyl an ether is or resembles an alkoxyl, such as can be represented by one of -O-alkyl, -O-alkenyl, -O-alkynyl, -O-arakyl, -O-aryl, -O-heteroaryl, -O-polyaryl, -O-polyheteroaryl, -O-heterocyclyl, etc.

The term "substituted alkoxy" refers to an alkoxy group having one or more substituents replacing one or more

hydrogen atoms on one or more carbons of the alkoxy backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, oxo, sulfate, sulfonate, sulfamoyl, sulfonamido, sulfonyl, heterocyclyl, alkylaryl, haloalkyl, -CN, aryl, heteroaryl, and combinations thereof.

The term "ether" as used herein is represented by the formula $A^2OA^1$, where $A^2$ and $A^1$ can be, independently, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl, a substituted or unsubstituted polyaryl, a substituted or unsubstituted polyheteroaryl, a phosphonium, a phosphanyl, a phosphonyl, a sulfinyl, a silyl, a thiol, a substituted or unsubstituted carbonyl, an alkoxy, an amido, or an amino, described above.

The term "polyether" as used herein is represented by the formula:

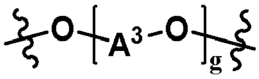

where $A^3$ can be, independently, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl, a substituted or unsubstituted polyaryl, a substituted or unsubstituted polyheteroaryl, a phosphonium, a phosphanyl, a substituted or unsubstituted carbonyl, an alkoxy, an amido, or an amino, described above; g can be a positive integer from 1 to 30.

The term "phenoxy" is art recognized and refers to a compound of the formula $-OR^v$ wherein $R^v$ is $C_6H_5$ (*i.e.,* $-O-C_6H_5$). One of skill in the art recognizes that a phenoxy is a species of the aroxy genus.

The term "substituted phenoxy" refers to a phenoxy group, as defined above, having one or more substituents replacing one or more hydrogen atoms on one or more carbons of the phenyl ring. Such substituents include, but are not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, and combinations thereof.

The terms "aroxy" and "aryloxy," as used interchangeably herein, are represented by -O-aryl or -O-heteroaryl, wherein aryl and heteroaryl are as defined herein.

The terms "substituted aroxy" and "substituted aryloxy," as used interchangeably herein, represent -O-aryl or -O-heteroaryl, having one or more substituents replacing one or more hydrogen atoms on one or more ring atoms of the aryl and heteroaryl, as defined herein. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

The term "amino" as used herein includes the group

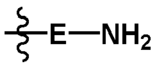 (primary amino), 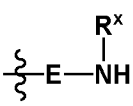 (secondary amino),

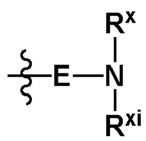 (tertiary amino), and 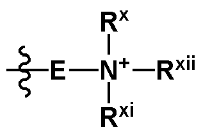 (quaternary amino),

wherein, E is absent, or E is substituted or unsubstituted alkyl, substituted or unsubstituted alkenyl, substituted or unsubstituted alkynyl, substituted or unsubstituted aralkyl, substituted or unsubstituted aryl, substituted or unsubstituted heteroaryl, a substituted or unsubstituted polyaryl, a substituted or unsubstituted polyheteroaryl, substituted or

unsubstituted heterocyclyl, wherein independently of E, $R^x$, $R^{xi}$, and $R^{xii}$ each independently represent a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$; $R'''$ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. The term "quaternary amino" also includes the groups where the nitrogen, $R^x$, $R^{xi}$, and $R^{xii}$ with the $N^+$ to which they are attached complete a heterocyclyl or heteroaryl having from 3 to 14 atoms in the ring structure. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The terms "amide" or "amido" are used interchangeably, refer to both "unsubstituted amido" and "substituted amido" and are represented by the general formula:

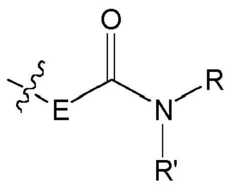

or

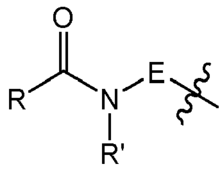

wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted aryl, substituted or unsubstituted heteroaryl, a substituted or unsubstituted polyaryl, a substituted or unsubstituted polyheteroaryl, or a substituted or unsubstituted heterocyclyl, wherein independently of E, R and R' each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or R and R' taken together with the N atom to which they are attached complete a heterocycle having from 3 to 14 atoms in the ring structure; $R'''$ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. In some forms, when E is oxygen, a carbamate is formed. It is understood by those of ordinary skill in the art, that the E groups listed above are divalent (e.g., methylene, ethane-1,2-diyl, ethene-1,2-diyl, 1,4-phenylene, cyclohexane-1,2-diyl).

"Carbonyl," as used herein, is art-recognized and includes such moieties as can be represented by the general formula:

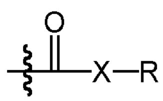

or

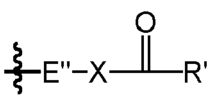

wherein X is a bond, or represents an oxygen or a sulfur, and R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R''$, or a pharmaceutical acceptable salt; E" is absent, or E" is a substituted or unsubstituted alkyl, a substituted or unsubstituted

alkenyl, a substituted or unsubstituted alkynyl, a substituted or unsubstituted aralkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl; R' represents a hydrogen, a substituted or unsubstituted alkyl, a substituted or unsubstituted alkenyl, a substituted or unsubstituted alkynyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R''$; R" represents a hydroxyl group, a substituted orunsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, and combinations thereof. It is understood by those of ordinary skill in the art, that the E" groups listed above are divalent (e.g., methylene, ethane-1,2-diyl, ethene-1,2-diyl, 1,4-phenylene, cyclohexane-1,2-diyl). Where X is oxygen and R is defined as above, the moiety is also referred to as a carboxyl group. When X is oxygen and R is hydrogen, the formula represents a "carboxylic acid." Where X is oxygen and R' is hydrogen, the formula represents a "formate." Where X is oxygen and R or R' is not hydrogen, the formula represents an "ester." In general, where the oxygen atom of the above formula is replaced by a sulfur atom, the formula represents a "thiocarbonyl" group. Where X is sulfur and R or R' is not hydrogen, the formula represents a "thioester." Where X is sulfur and R is hydrogen, the formula represents a "thiocarboxylic acid." Where X is sulfur and R' is hydrogen, the formula represents a "thioformate." Where X is a bond and R is not hydrogen, the above formula represents a "ketone." Where X is a bond and R is hydrogen, the above formula represents an "aldehyde."

The term "phosphanyl" is represented by the formula

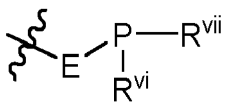

wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted cycloalkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, $R^{vi}$ and $R^{vii}$ each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or $R^{vi}$ and $R^{vii}$ taken together with the P atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphonium" is represented by the formula

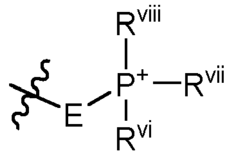

wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted cycloalkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, $R^{vi}$, $R^{vii}$, and $R^{viii}$ each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or $R^{vi}$, $R^{vii}$, and $R^{viii}$ taken together with the $P^+$ atom to which they are attached complete a heterocycle having from 3 to 14 atoms in the ring structure; $R'''$ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphonyl" is represented by the formula

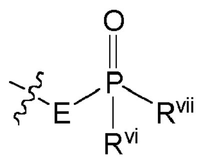

wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, oxygen, alkoxy, aroxy, or substituted alkoxy or substituted aroxy, wherein, independently of E, $R^{vi}$ and $R^{vii}$ are independently a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or $R^{vi}$ and $R^{vii}$ taken together with the P atom to which they are attached complete a heterocycle having from 3 to 14 atoms in the ring structure; $R'''$ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl,

polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphoryl" defines a phosphonyl in which E is absent, oxygen, alkoxy, aroxy, substituted alkoxy or substituted aroxy, as defined above, and independently of E, $R^{vi}$ and $R^{vii}$ are independently hydroxyl, alkoxy, aroxy, substituted alkoxy or substituted aroxy, as defined above. When E is oxygen, the phosphoryl cannot be attached to another chemical species, such as to form an oxygen-oxygen bond, or other unstable bonds, as understood by one of ordinary skill in the art. When E, $R^{vi}$ and $R^{vii}$ are substituted, the substituents include, but are not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfinyl" is represented by the formula

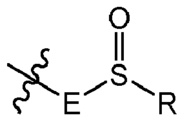

wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted heterocyclyl, a substituted or unsubstituted polyaryl, a substituted or unsubstituted polyheteroaryl, wherein independently of E, R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a silyl, a thiol, an amido, an amino, or $-(CH_2)_m-R'''$, or E and R taken together with the S atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonyl" is represented by the formula

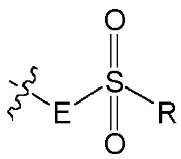

wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted heterocyclyl, a substituted or unsubstituted polyaryl, a substituted or unsubstituted polyheteroaryl, wherein independently of E, R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R'''$, or E and R taken together with the S atom to which they are attached complete a heterocycle having from 3 to 14 atoms in the ring structure; R''' represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonic acid" refers to a sulfonyl, as defined above, wherein R is hydroxyl, and E is absent, or E is substituted or unsubstituted cycloalkyl, substituted or unsubstituted heterocyclyl, substituted or unsubstituted alkylaryl, substituted or unsubstituted arylalkyl, substituted or unsubstituted aryl, a substituted or unsubstituted polyaryl, a substituted or unsubstituted polyheteroaryl, or substituted or unsubstituted heteroaryl. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfate" refers to a sulfonyl, as defined above, wherein E is absent, oxygen, alkoxy, aroxy, substituted alkoxy or substituted aroxy, as defined above, and R is independently hydroxyl, alkoxy, aroxy, substituted alkoxy or substituted aroxy, as defined above. When E is oxygen, the sulfate cannot be attached to another chemical species, such as to form an oxygen-oxygen bond, or other unstable bonds, as understood by one of ordinary skill in the art. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonate" refers to a sulfonyl, as defined above, wherein E is oxygen, alkoxy, aroxy, substituted alkoxy or substituted aroxy, as defined above, and R is independently hydrogen, substituted or unsubstituted alkyl, substituted or unsubstituted alkenyl, substituted or unsubstituted alkynyl, substituted or unsubstituted amino, substituted or unsubstituted cycloalkyl, substituted or unsubstituted heterocyclyl, substituted or unsubstituted aralkyl, substituted or unsubstituted alkylaryl, substituted or unsubstituted arylalkyl, substituted or unsubstituted aryl, substituted or unsubstituted heteroaryl, a substituted or unsubstituted polyaryl, a substituted or unsubstituted polyheteroaryl, $-(CH_2)_m-R'''$, R''' represents a hydroxy group, substituted or unsubstituted carbonyl group, an aryl, a cycloalkyl ring, a cycloalkenyl ring, a heterocycle, an amido, an amino, or a polycycle; and m is zero or an integer ranging from 1 to 8. When E is oxygen, sulfonate cannot be attached to another chemical species, such as to form an oxygen-oxygen bond, or other unstable bonds, as understood by one of ordinary skill in the art. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfamoyl" refers to a sulfonamide or sulfonamide represented by the formula

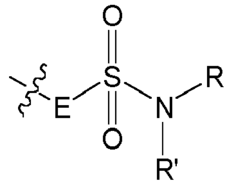

wherein E is absent, or E is substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted cycloalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, R and R' each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R'''$, or R and R' taken together with the N atom to which they are attached complete a heterocycle having from 3 to 14 atoms in the ring structure; R''' represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "silyl group" as used herein is represented by the formula -SiRR'R," where R, R', and R" can be, independently, a hydrogen, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl (e.g. a substituted or unsubstituted alkylaryl, a substituted or unsubstituted arylalkyl, etc.), a substituted or unsubstituted polyaryl, a substituted or unsubstituted polyheteroaryl, a substituted or unsubstituted carbonyl, a phosphonium, a phosphanyl, a phosphonyl, a sulfinyl, a thiol, an amido, an amino, an alkoxy, or an oxo, described above. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

The terms "thiol" are used interchangeably and are represented by -SR, where R can be a hydrogen, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl (e.g. a substituted or unsubstituted alkylaryl, a substituted or unsubstituted arylalkyl, etc.), a substituted or unsubstituted polyaryl, a substituted or unsubstituted polyheteroaryl, a substituted or unsubstituted carbonyl, a phosphonium, a phosphanyl, an amido, an amino, an alkoxy, an oxo, a phosphonyl, a sulfinyl, or a silyl, described above. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

The disclosed compounds and substituent groups, can, independently, possess two or more of the groups listed above. For example, if the compound or substituent group is a straight chain alkyl group, one of the hydrogen atoms of the alkyl group can be substituted with a hydroxyl group, an alkoxy group, etc. Depending upon the groups that are selected, a first group can be incorporated within second group or, alternatively, the first group can be pendant

(*i.e.,* attached) to the second group. For example, with the phrase "an alkyl group comprising an ester group," the ester group can be incorporated within the backbone of the alkyl group. Alternatively, the ester can be attached to the backbone of the alkyl group. The nature of the group(s) that is (are) selected will determine if the first group is embedded or attached to the second group.

The compounds and substituents can be substituted, independently, with the substituents described above in the definition of "substituted."

The numerical ranges disclose individually each possible number that such a range could reasonably encompass, as well as any sub-ranges and combinations of sub-ranges encompassed therein. For example, in a given range carbon range of $C_3$-$C_9$, the range also discloses $C_3$, $C_4$, $C_5$, $C_6$, $C_7$, $C_8$, and $C_9$, as well as any subrange between these numbers (for example, $C_4$ -$C_6$), and any possible combination of ranges possible between these values. In yet another example, a given temperature range may be from about 25 °C to 30 °C, where the range also discloses temperatures that can be selected independently from about 25, 26, 27, 28, 29, and 30 °C, as well as any range between these numbers (for example, 26 to 28 °C), and any possible combination of ranges between these values.

Use of the term "about" is intended to describe values either above or below the stated value, which the term "about" modifies, to be within a range of approximately +/- 10%. When the term "about" is used before a range of numbers (*i.e.,* about 1-5) or before a series of numbers (*i.e.,* about 1, 2, 3, 4, etc.) it is intended to modify both ends of the range of numbers and/or each of the numbers recited in the entire series, unless specified otherwise.

The disclosed compounds and substituent groups, can, independently, possess two or more of the groups listed above. For example, if the compound or substituent group is a straight chain alkyl group, one of the hydrogen atoms of the alkyl group can be substituted with a hydroxyl group, an alkoxy group, etc. Depending upon the groups that are selected, a first group can be incorporated within second group or, alternatively, the first group can be pendant (*i.e.,* attached) to the second group. For example, with the phrase "an alkyl group comprising an ester group," the ester group can be incorporated within the backbone of the alkyl group. Alternatively, the ester can be attached to the backbone of the alkyl group. The nature of the group(s) that is (are) selected will determine if the first group is embedded or attached to the second group.

The compounds and substituents can be substituted with, independently, with the substituents described above in the definition of "substituted."

### II. Compositions

Described are a class of MR-TADF complexes/compounds containing (i) a polycyclic aromatic/heteroaromatic ligand in which a plurality aromatic/heteroaromatic rings are linked by boron and nitrogen atoms and (ii) an N-heterocyclic carbene ligand, with both ligands coordinated to a metal atom/ion that has a high spin-orbit coupling, such as 3d-, 4d-, or 5d-transition metal atoms/ions. Without wishing to be bound by theory, it is believed that the use of the high spin-orbit coupling of metals and/or metal ions facilitates the intersystem crossing and/or reversed intersystem crossing processes of MR-TADF emitters, thereby largely accelerating the rate of TADF and substantially shortening the lifetime of deleterious triplet excitons. The radiative lifetime of the MR-TADF could be reduced by more than 20-folds which translates into (i) a marked delay of efficiency roll-off and/or (ii) practical device lifetimes.

The disclosed compounds have a structure:

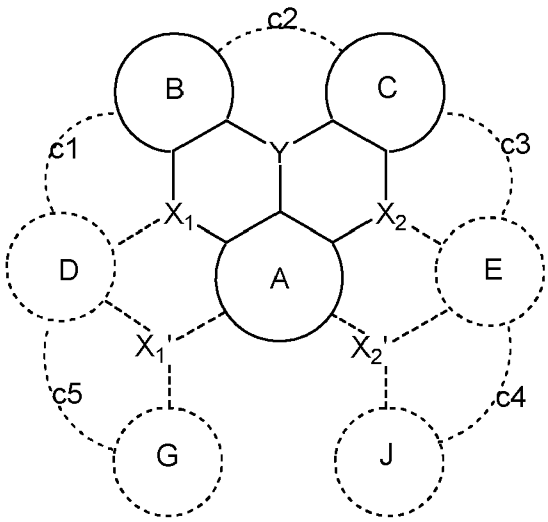

Formula I

wherein:

the compound has an overall neutral, negative, or positive charge,
the dashed linear lines in Formula I denote the presence or absence of a bond,
$X_1$, Y, and $X_2$ are, respectively: nitrogen, boron, and nitrogen; oxygen, boron, and oxygen; oxygen, boron, and nitrogen; sulfur, boron, and nitrogen; selenium, boron, and nitrogen; boron, nitrogen, and boron; sulfur, boron, and sulfur; selenium, boron, and selenium; selenium, boron, and oxygen; or sulfur, boron, and oxygen,
A, B, and C are independently substituted aryl, unsubstituted aryl, substituted heteroaryl, unsubstituted heteroaryl, substituted polyaryl, unsubstituted polyaryl, substituted polyheteroaryl, unsubstituted polyheteroaryl, or fused combinations thereof,
D, E, G, and J are independently absent, substituted aryl, unsubstituted aryl, substituted heteroaryl, unsubstituted heteroaryl, substituted polyaryl, unsubstituted polyaryl, substituted polyheteroaryl, unsubstituted polyheteroaryl, or fused combinations thereof; substituted alkyl, or unsubstituted alkyl,
preferably, substituted in Formula I means substituted with unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as $(4\text{-methylphenyl})_2N$-, or unsubstituted amine,
$X_1$' and $X_2$' are independently absent, nitrogen, oxygen, sulfur, selenium, substituted $C_1$-$C_5$ alkyl (such as $-C(Me)_2-$), or unsubstituted $C_1$-$C_5$ alkyl,
c1, c2, c3, c4, and c5 are independently absent, single bond, -O-, -S-, - Se-, substituted $C_1$-$C_5$ alkyl (such as $-C(Me)_2-$), unsubstituted $C_1$-$C_5$ alkyl, substituted amine, unsubstituted amine, substituted carbonyl, or unsubstituted carbonyl, and
at least one of A, B, C, D, E, G, and J is datively bonded to a moiety having a structure:

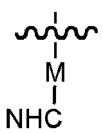

Formula II

wherein:

the dative bond involves M,
NHC has a structure:

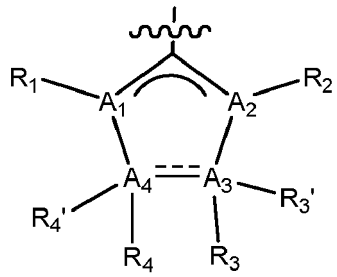

Formula IIa

M is a metal or metal ion with high spin-orbit coupling, such as metals or metal ions of 3d, 4d, and 5d transition metals, preferably gold, copper, silver, iridium, ruthenium, platinum, *etc.,*

$A_1$, $A_2$, $A_3$, and $A_4$ are independently carbon or nitrogen, preferably wherein at least one of $A_1$, $A_2$, $A_3$, and $A_4$ is nitrogen and at least one of the other of $A_1$, $A_2$, $A_3$, and $A_4$ is carbon, and $A_1$, $A_2$, $A_3$, and $A_4$ are bonded to none, one, or two hydrogen atoms according to valency,

$R_1$, $R_2$, $R_3$, $R_3$', $R_4$, and $R_4$' are independently hydrogen, substituted aryl, unsubstituted aryl, substituted heteroaryl, unsubstituted heteroaryl, substituted polyaryl, unsubstituted polyaryl, substituted polyheteroaryl, unsubstituted polyheteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, unsubstituted $C_1$-$C_{20}$ heterocyclyl, or fused combinations thereof; substituted alkyl, or unsubstituted alkyl (such as unsubstituted $C_1$-$C_5$ alkyl); or $A_2$ and $R_2$ together form a substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, or unsubstituted $C_1$-$C_{20}$ heterocyclyl; or $A_3$, $R_3$, $R_3$', $A_4$, $R_4$, and $R_4$', together form substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, unsubstituted $C_1$-$C_{20}$ heterocyclyl, or fused combinations thereof, preferably, substituted in Formula IIa means substituted with unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, *etc.*), substituted aryl (1,1'-biphenyl-2-yl, 1,1'-biphenyl-3-yl, 1,1'-biphenyl-4-yl, 2,6-dimethylphenyl), unsubstituted aryl (phenyl), and

when the dashed line between $A_3$ and $A_4$ is a single bond, $R_3$' and $R_4$' are absent.

In some forms, the compounds are as described above, except that M is a metal or metal ion of gold, silver, or copper.

In some forms, the compounds are as described above, except that least one of $A_1$, $A_2$, $A_3$, and $A_4$ is nitrogen and at least one of the other of $A_1$, $A_2$, $A_3$, and $A_4$ is carbon. In some forms, one of $A_1$, $A_2$, $A_3$, and $A_4$ is nitrogen, and the other three of $A_1$, $A_2$, $A_3$, and $A_4$ are carbon. In some forms, two of $A_1$, $A_2$, $A_3$, and $A_4$ are nitrogen, and the other two of $A_1$, $A_2$, $A_3$, and $A_4$ are carbon.

In some forms, the compounds are as described above, except that, for Formula IIa, $R_1$, $R_2$, $R_3$, $R_3$', $R_4$, and $R_4$' are independently hydrogen, substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), or fused combinations thereof; substituted alkyl, or unsubstituted alkyl (such as unsubstituted $C_1$-$C_5$ alkyl).

In some forms, the compounds are as described above, except that, for Formula IIa, $A_2$ and $R_2$ together form a substituted $C_3$-$C_{20}$ cycloalkyl (such as substituted $C_3$-$C_{10}$ cycloalkyl) or unsubstituted $C_3$-$C_{20}$ cycloalkyl (such as unsubstituted $C_3$-$C_{10}$ cycloalkyl).

In some forms, the compounds are as described above, except that, for Formula IIa, $A_3$, $R_3$, $R_3$', $A_4$, $R_4$, and $R_4$', together form substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, unsubstituted $C_1$-$C_{20}$ heterocyclyl, or fused combinations thereof. In some forms, $A_3$, $R_3$, $R_3$', $A_4$, $R_4$, and $R_4$', together form substituted aryl, unsubstituted aryl, substituted heteroaryl, or unsubstituted heteroaryl.

In some forms, the compounds are as described above, except that Formula IIa is selected from:

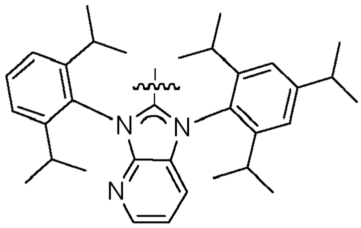, 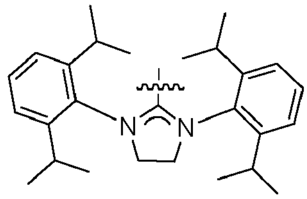, 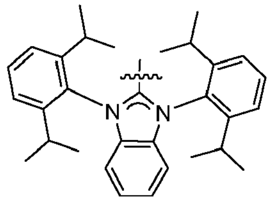,

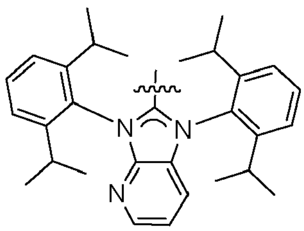, 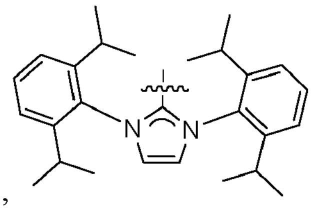, 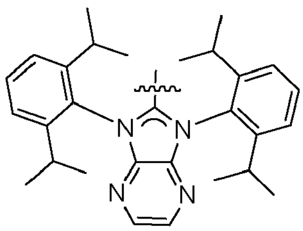,

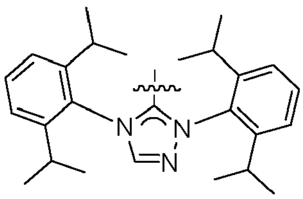, 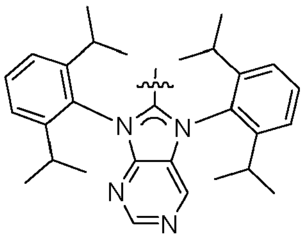, 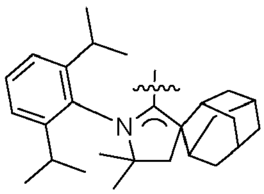,

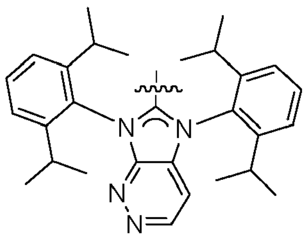, 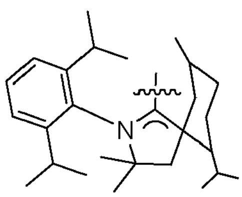,

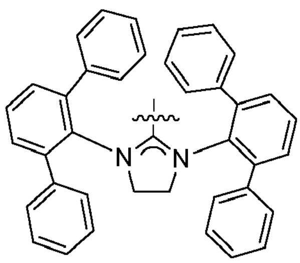, 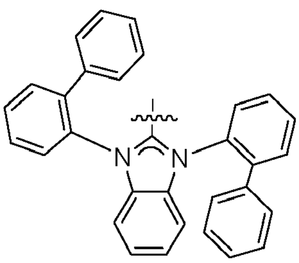, 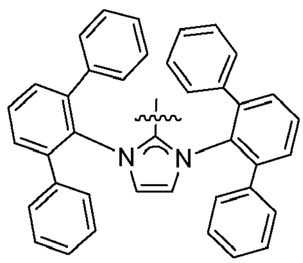,

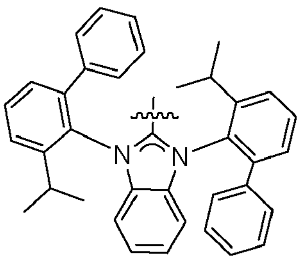, 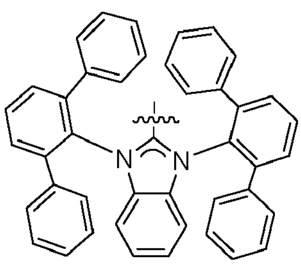, 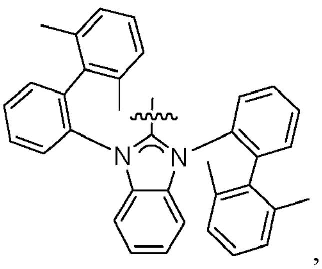,

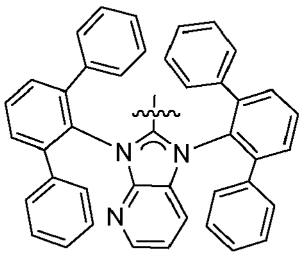
,
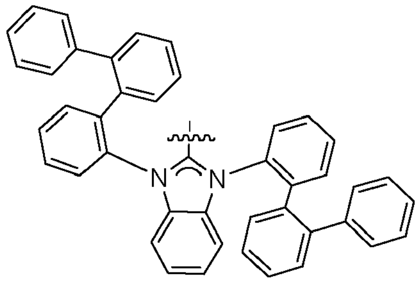
,

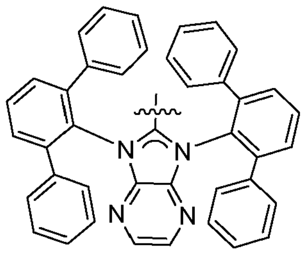
, or
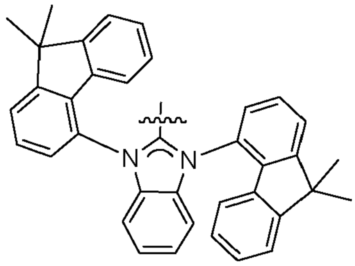
.

In some forms, the compounds are as described above, except that, for Formula I, $X_1$, Y, and $X_2$ are, respectively: nitrogen, boron, and nitrogen; oxygen, boron, and oxygen; oxygen, boron, and nitrogen; sulfur, boron, and nitrogen; selenium, boron, and nitrogen; or boron, nitrogen, and boron.

In some forms, the compounds are as described above, except that, for Formula I, A, B, and C are independently substituted aryl, unsubstituted aryl, substituted heteroaryl, unsubstituted heteroaryl, or fused combinations thereof.

In some forms, the compounds are as described above, except that, for Formula I, D, E, G, and J are independently absent, substituted aryl, or unsubstituted aryl, substituted heteroaryl, unsubstituted heteroaryl, or fused combinations thereof.

In some forms, the compounds are as described above, except that, for Formula I, $X_1$' and $X_2$' are independently absent or nitrogen. In some forms, $X_1$' and $X_2$' are both absent. In some forms, $X_1$' and $X_2$' are both nitrogen.

In some forms, the compounds are as described above, except that, for Formula I, c1, c2, c3, c4, and c5 are independently absent, single bond, -O-, -S-, -Se-, substituted $C_1$-$C_5$ alkyl (such as $-C(Me)_2-$), or unsubstituted $C_1$-$C_5$ alkyl.

In some forms, the compounds are as described above, except that Formula I is:

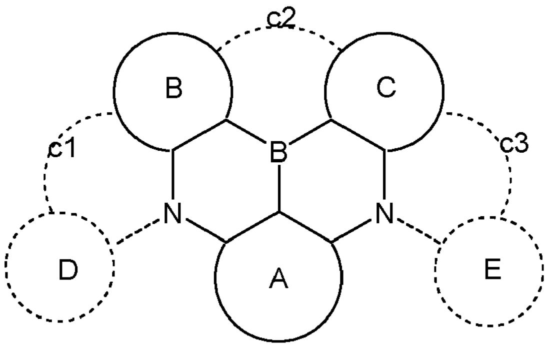

Formula III

wherein:

c2 is absent or present,
D and E are independently substituted aryl, unsubstituted aryl, substituted heteroaryl, unsubstituted heteroaryl, or fused combinations thereof; substituted alkyl, or unsubstituted alkyl. In some forms, c2 is absent. In some forms, c2 is present.

In some forms, the compounds are as described above, except that Formula I is:

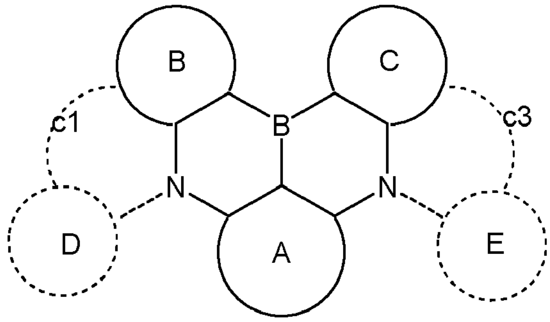

Formula IV

wherein:

pairs of c1 and c3 are: both single bonds; single bond and absent; single bond and substituted $C_1$-$C_5$ alkyl (such as -C(Me)$_2$-); single bond and unsubstituted $C_1$-$C_5$ alkyl; single bond and -O-; single bond and -S-; single bond and -Se-; absent and -S-; absent and -Se-; both substituted $C_1$-$C_5$ alkyl (such as - C(Me)$_2$-); substituted $C_1$-$C_5$ alkyl (such as -C(Me)$_2$-) and -O-; substituted $C_1$-$C_5$ alkyl (such as -C(Me)$_2$-) and -S-; substituted $C_1$-$C_5$ alkyl (such as -C(Me)$_2$-) and -Se-; absent and substituted $C_1$-$C_5$ alkyl (such as -C(Me)$_2$-); absent and -O-; -O- and -O-; -O- and -S-; -O- and -Se-; -S- and -S-; -Se- and -Se-; or both absent.

In some forms, the compounds are as described above, except that the compounds have a structure:

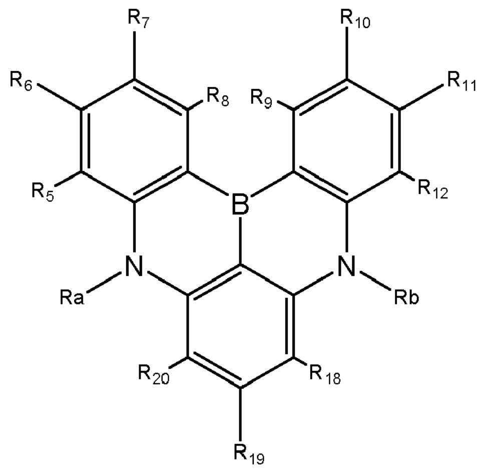

Formula V

wherein:

$R_a$ and $R_b$ are independently substituted aryl, unsubstituted aryl, substituted heteroaryl, unsubstituted heteroaryl, or fused combinations thereof; substituted alkyl, or unsubstituted alkyl,

$R_5$-$R_{12}$ and $R_{18}$-$R_{20}$ are preferably independently hydrogen, unsubstituted $C_1$-$C_5$ alkyl (such as methyl, ethyl, n-propyl, *etc.),* substituted $C_1$-$C_5$ alkyl (such as *iso*-propyl, *iso*-butyl, *tert*-butyl, trifluoromethyl, *etc.),* unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20.

In some forms, the compounds are as described above, except that the compounds have a structure:

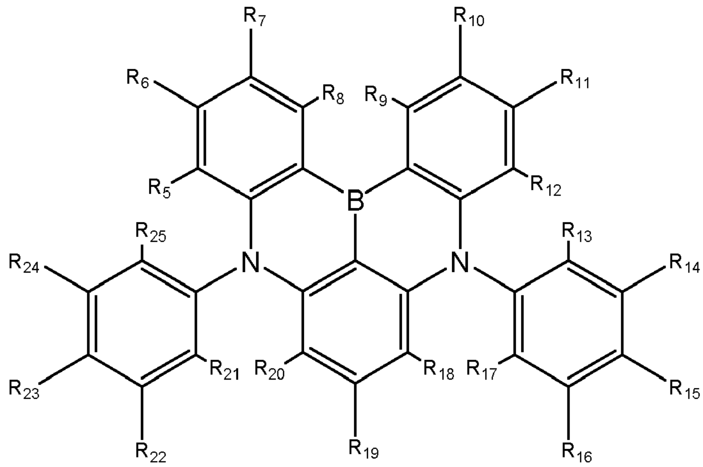

Formula VI

wherein:

$R_5$-$R_{25}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{25}$ is Formula II,
optionally $R_5$ and $R_{25}$ combine to form c1 and $R_{12}$ and $R_{13}$ combine to form c3,
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 25.

In some forms, the compounds are as described above, except that the compounds have a structure:

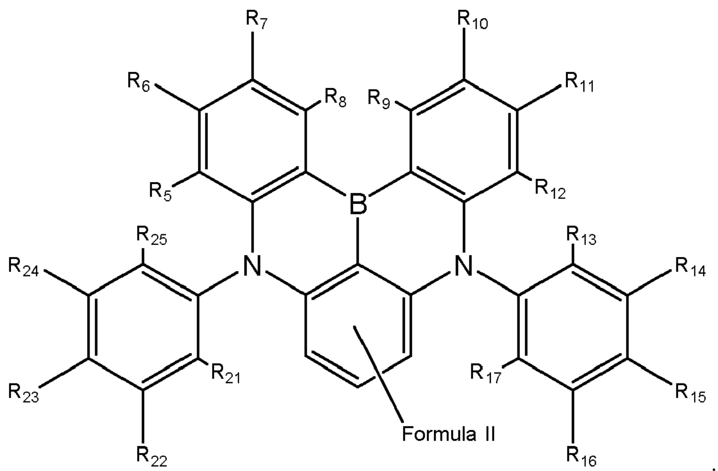

Formula VII

In some forms, the compounds have a structure selected from:

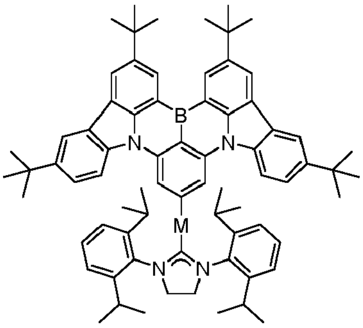 , 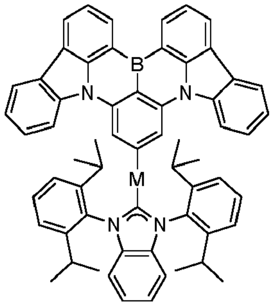 , 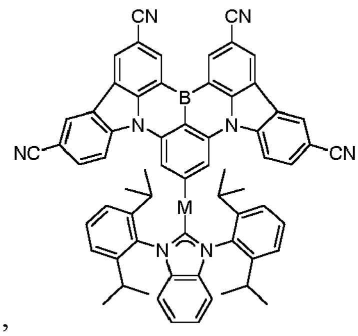 ,

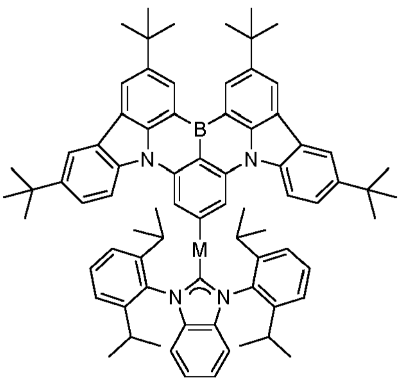 , 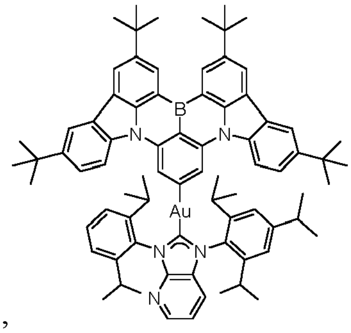 ,

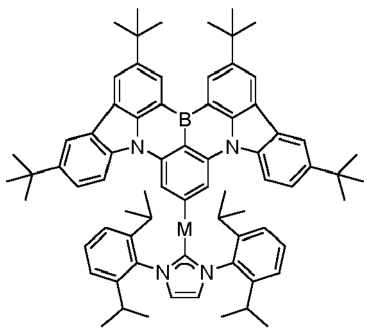 ,

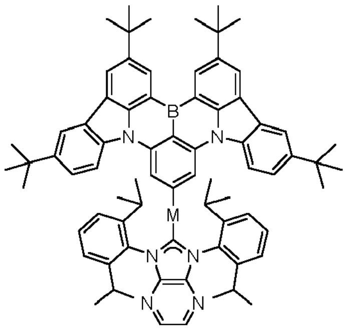 , 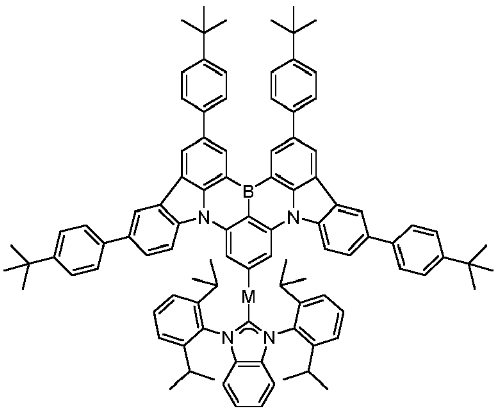 ,

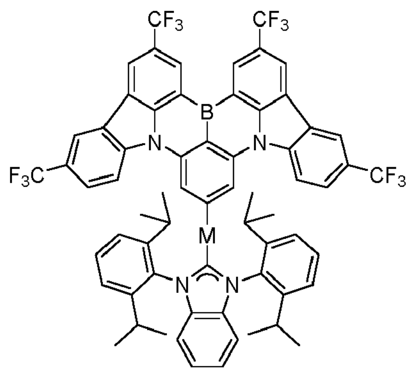

,

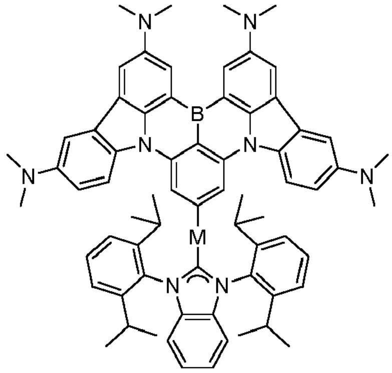

,

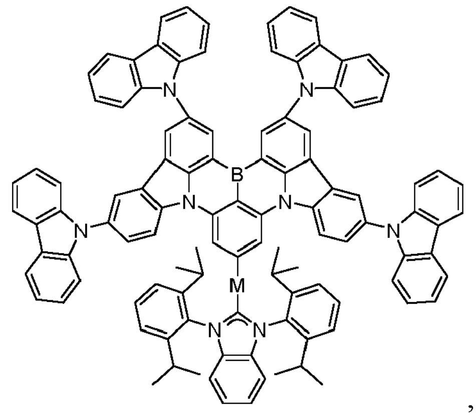

,

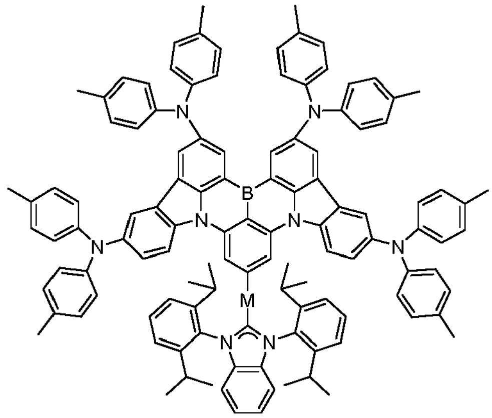

,

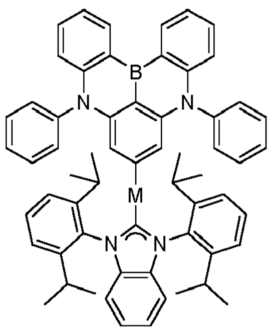

,

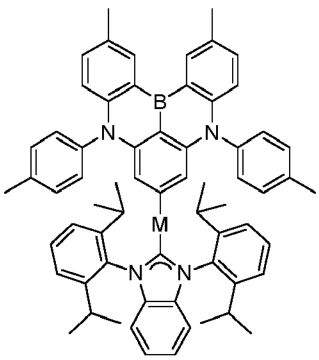

,

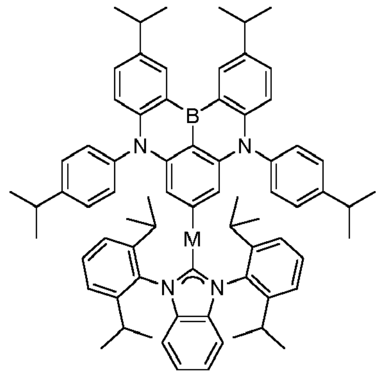

,

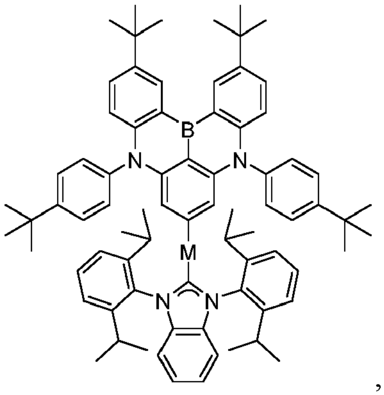

,

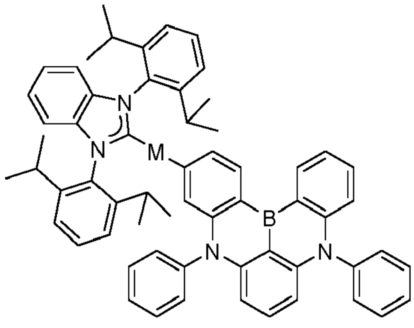

,

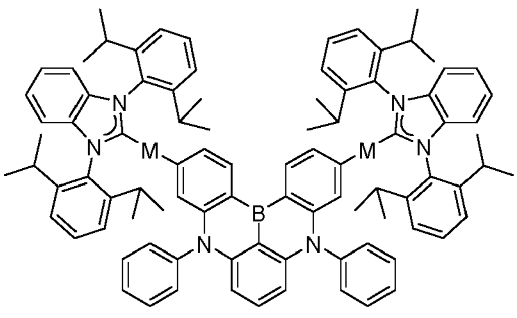

,

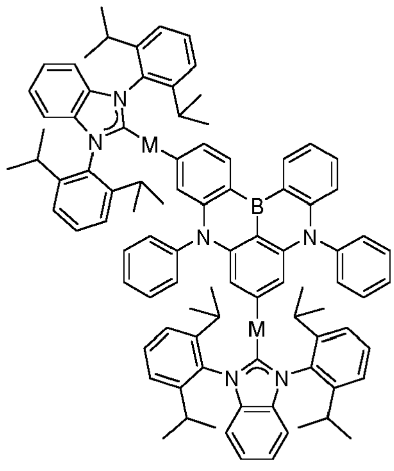

,

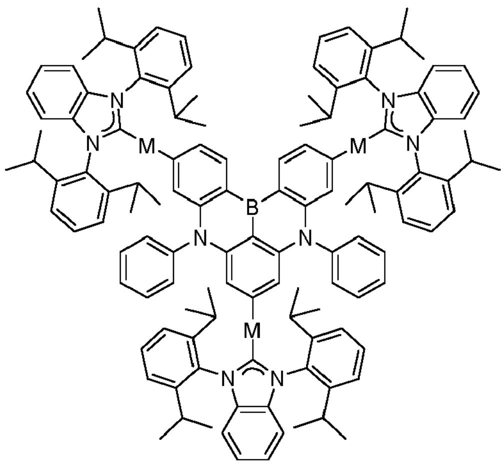

,

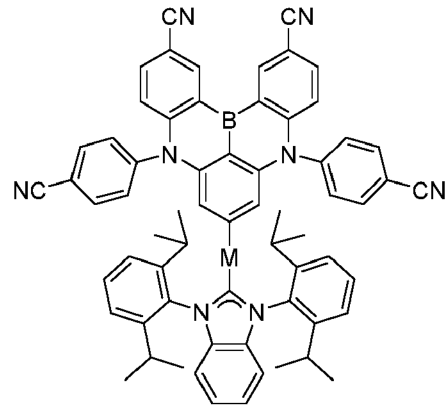

,

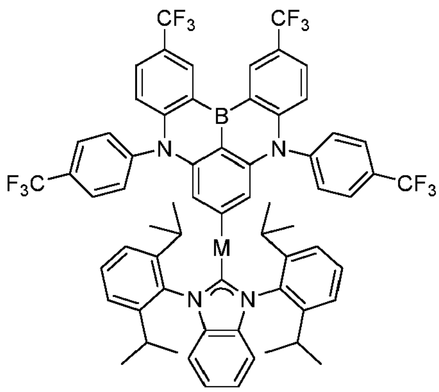

,

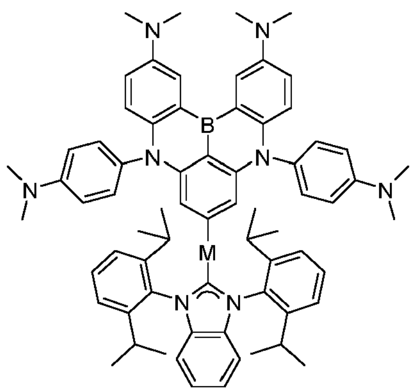

,

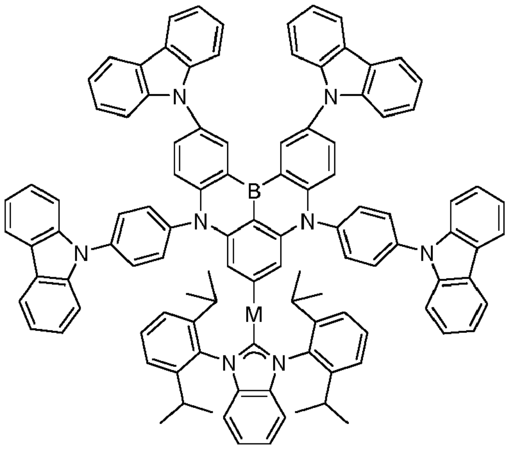,

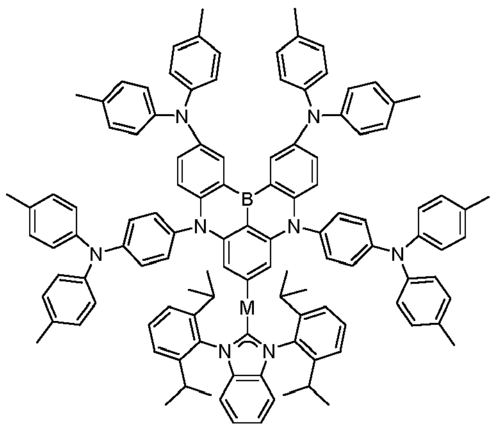,

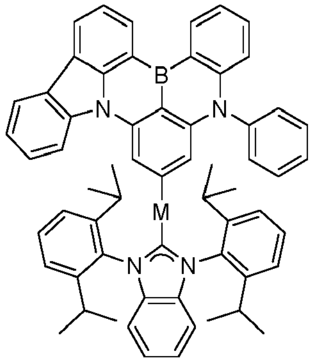,

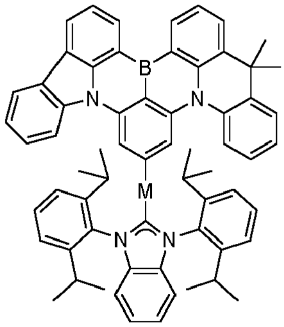,

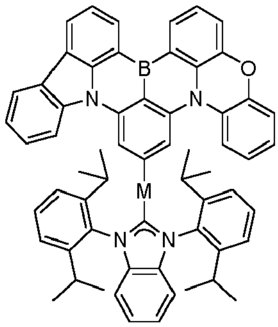,

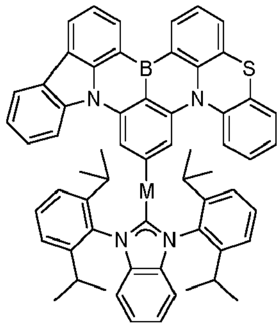,

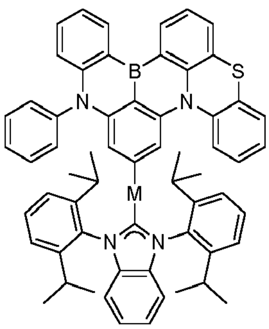,

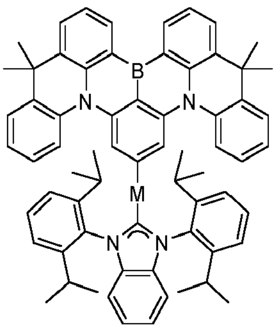,

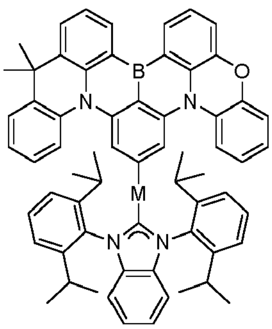,

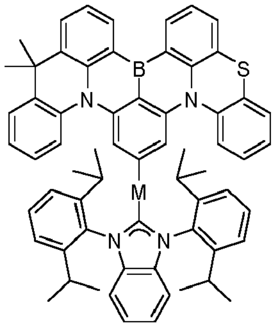,
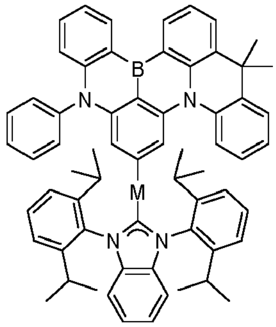,
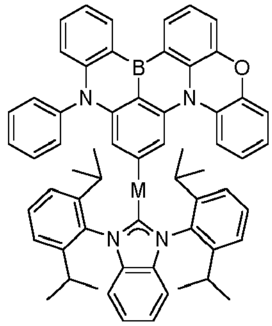,

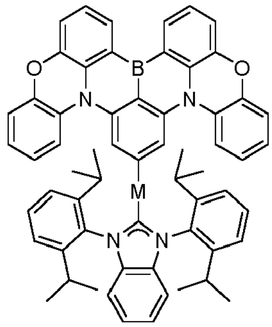,
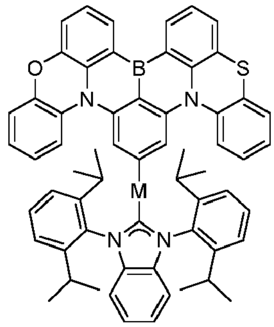, or
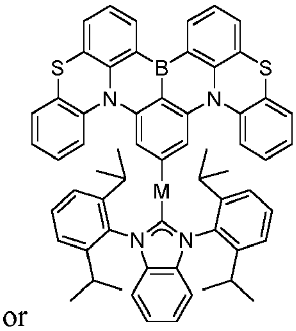.

In some forms, the compounds are as described above, except that Formula I is:

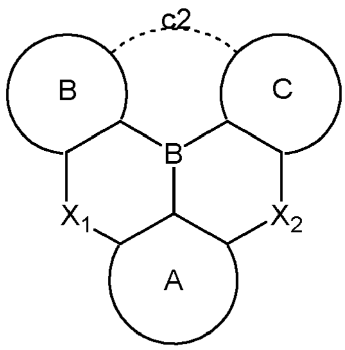

Formula VIII

wherein:

pairs of $X_1$ and $X_2$ are: both oxygen; sulfur and oxygen; selenium and oxygen; selenium and selenium; or sulfur and sulfur, preferably both oxygen,
preferably c2 is absent.

In some forms, the compounds are as described above, except that the compounds have a structure:

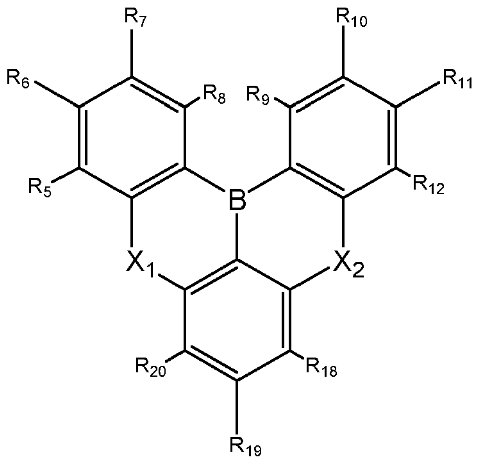

Formula IX

wherein:

pairs of $X_1$ and $X_2$ are: both oxygen; sulfur and oxygen; selenium and oxygen; selenium and selenium; or sulfur and sulfur, preferably both oxygen,

$R_5$-$R_{12}$ and $R_{18}$-$R_{20}$ are preferably independently hydrogen, unsubstituted $C_1$-$C_5$ alkyl (such as methyl, ethyl, n-propyl, *etc.),* substituted $C_1$-$C_5$ alkyl (such as *iso*-propyl, *iso*-butyl, *tert*-butyl, trifluoromethyl, *etc.*)*,* unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20.

In some forms, the compounds have a structure selected from:

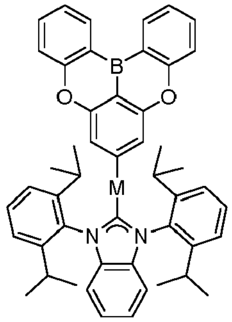

,

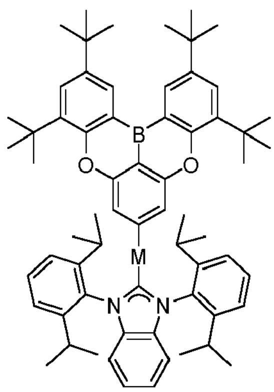

,

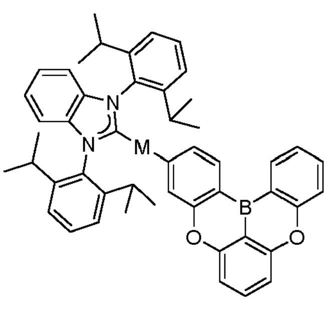

,

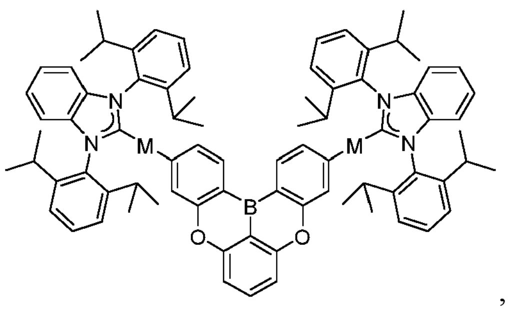

,

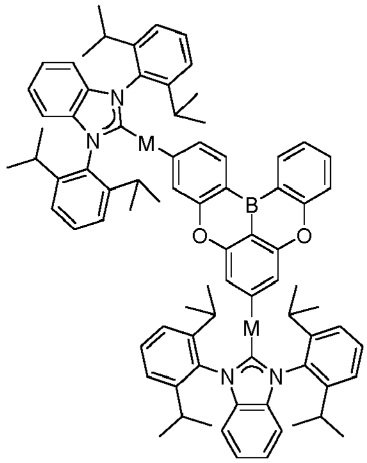

, or

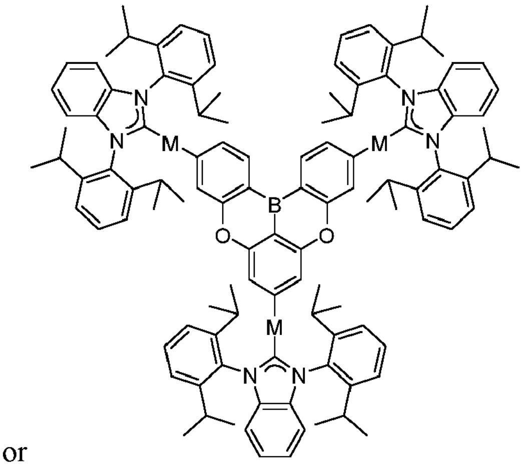

.

In some forms, the compounds are as described above, except that Formula I is:

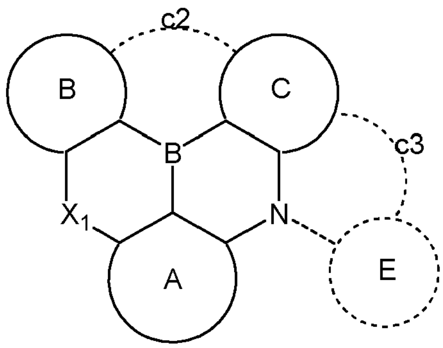

Formula X

wherein:

$X_1$ is oxygen, sulfur, or selenium,
c2 is preferably absent,
c3 is absent, single bond, -O-, -S-, -Se-, substituted $C_1$-$C_5$ alkyl (such as - C(Me)$_2$-), or unsubstituted $C_1$-$C_5$ alkyl, and
E is substituted aryl, unsubstituted aryl, substituted heteroaryl, unsubstituted heteroaryl, or fused combinations thereof; substituted alkyl, or unsubstituted alkyl.

In some forms, the compounds are as described above, except that the compounds have a structure:

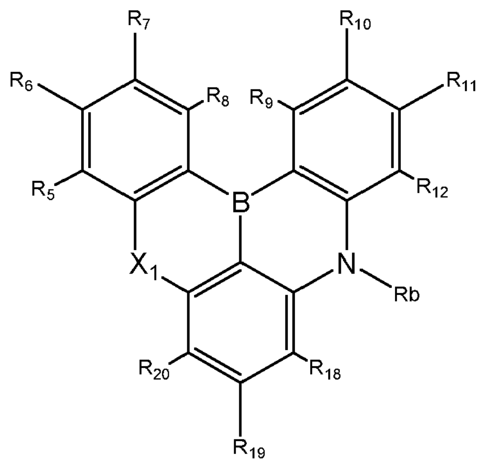

Formula XI

wherein:

$X_1$ is oxygen, sulfur, or selenium,

Rb is substituted aryl, unsubstituted aryl, substituted heteroaryl, unsubstituted heteroaryl, or fused combinations thereof; substituted alkyl, or unsubstituted alkyl,

$R_5$-$R_{12}$ and $R_{18}$-$R_{20}$ are preferably independently hydrogen, unsubstituted $C_1$-$C_5$ alkyl (such as methyl, ethyl, n-propyl, *etc.),* substituted $C_1$-$C_5$ alkyl (such as iso-propyl, iso-butyl, *tert*-butyl, trifluoromethyl, *etc.),* unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20.

In some forms, the compounds are as described above, except that the compounds have a structure:

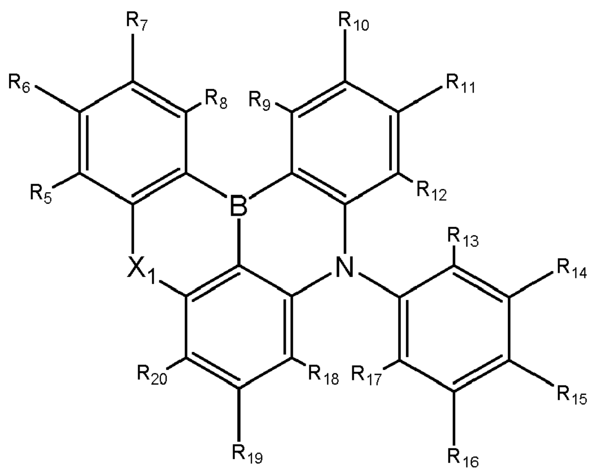

Formula XII

wherein:

$X_1$ is oxygen, sulfur, or selenium,

$R_5$-$R_{20}$ are preferably independently hydrogen, unsubstituted $C_1$-$C_5$ alkyl (such as methyl, ethyl, n-propyl, *etc*.), substituted $C_1$-$C_5$ alkyl (such as *iso*-propyl, *iso*-butyl, *tert*-butyl, trifluoromethyl, *etc*.), unsubstituted aryl (phenyl),

substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as $(4\text{-methylphenyl})_2N$-, unsubstituted amine, or Formula II, wherein at least one of $R_5$-$R_{20}$ is Formula II,

optionally $R_{12}$ and $R_{13}$ combine to form c3,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 20.

In some forms, the compounds have a structure selected from:

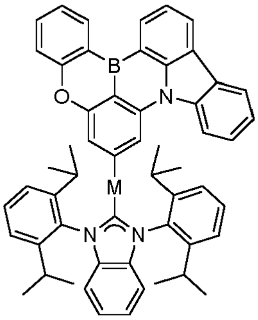
,
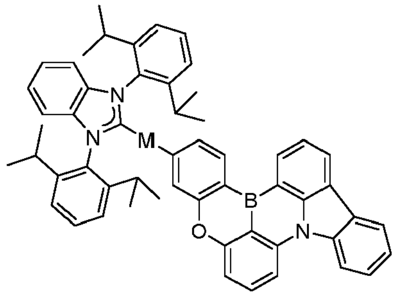
,

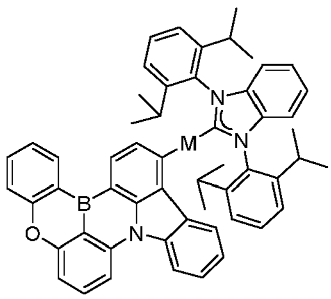
,
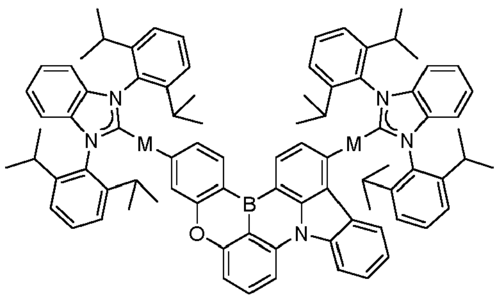
,

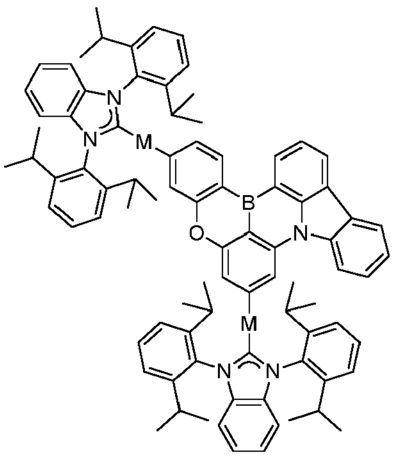
,
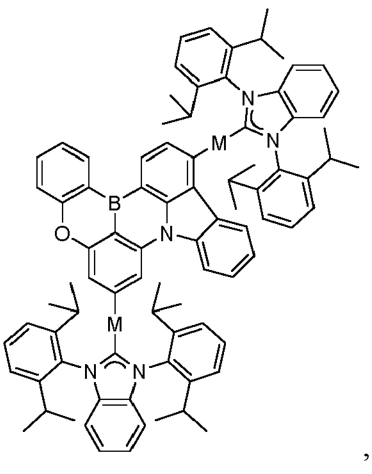
,

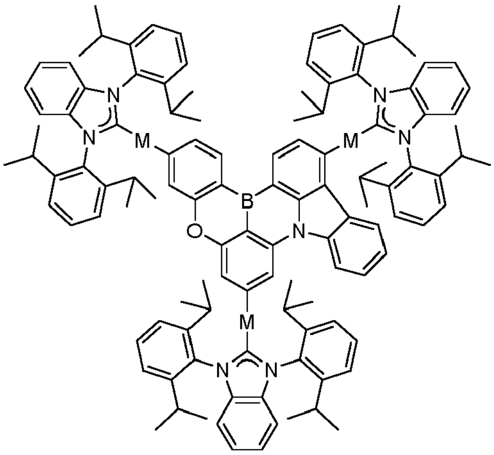
,
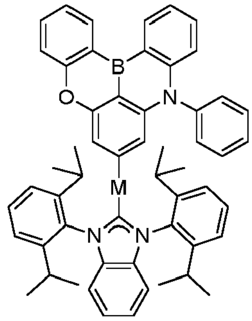
,

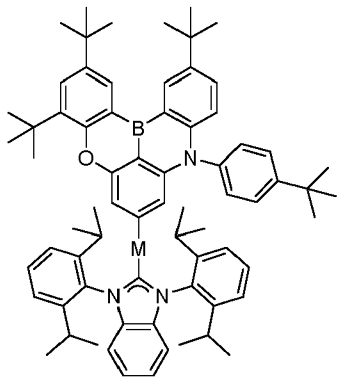
,
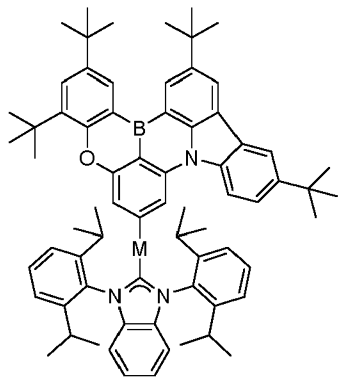
,

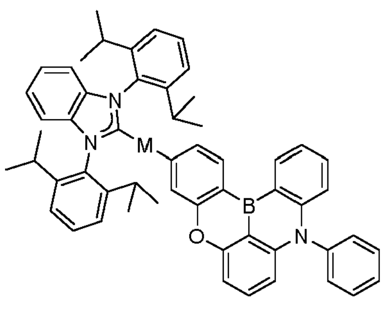
,
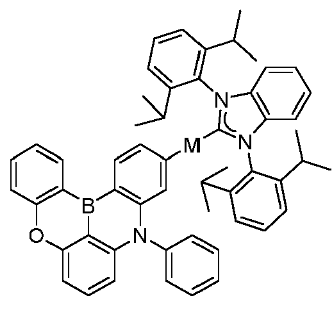
,

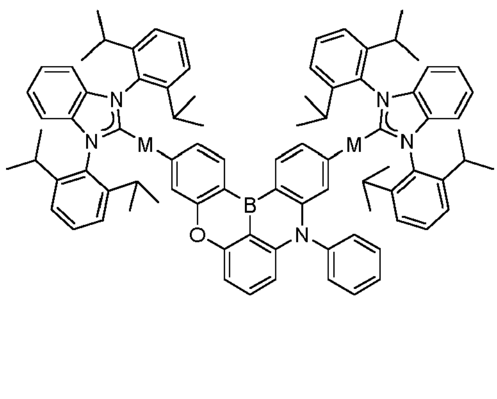
,
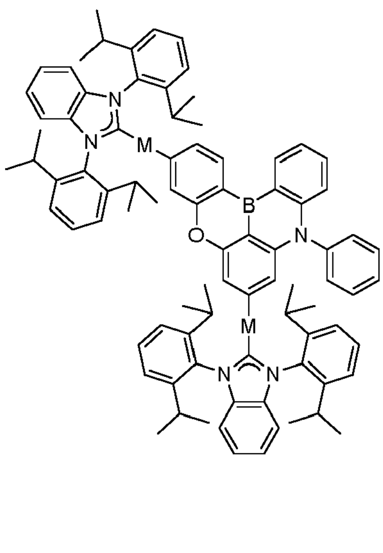
,

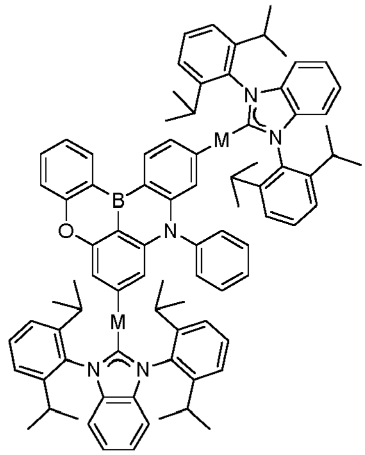
,
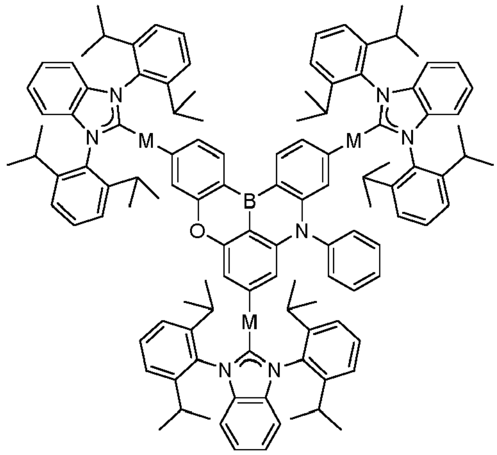
,

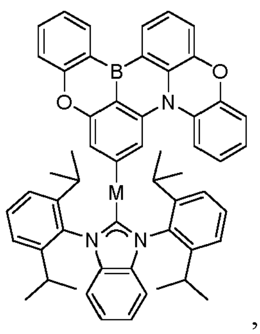
,
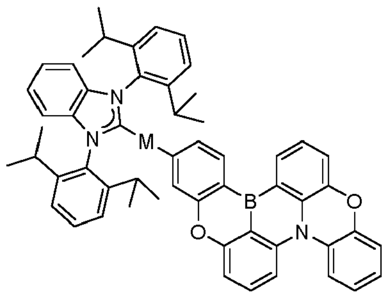
,
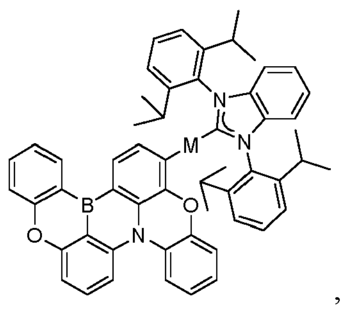
,

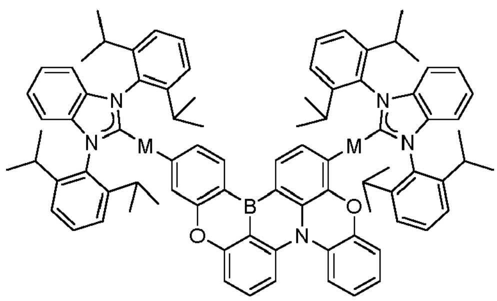
,
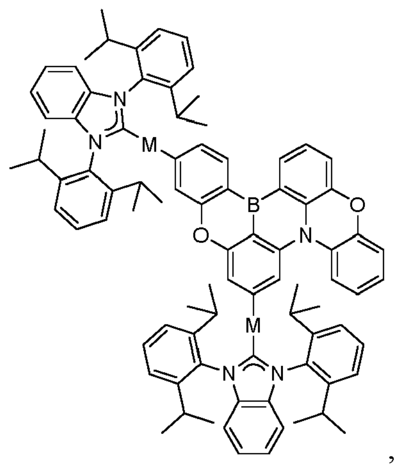
,

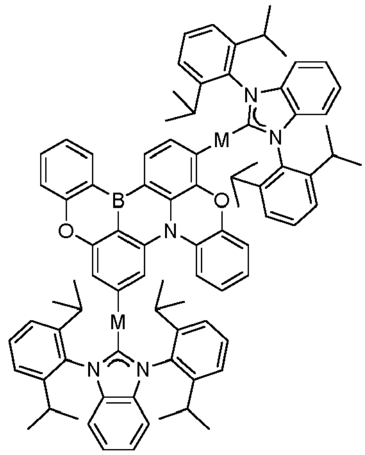

,

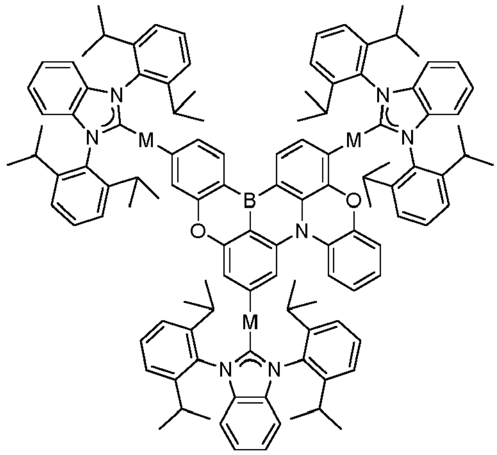

,

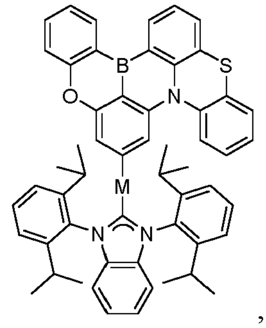

,

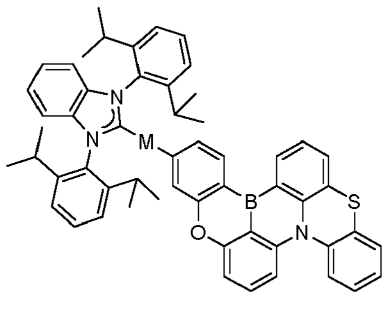

,

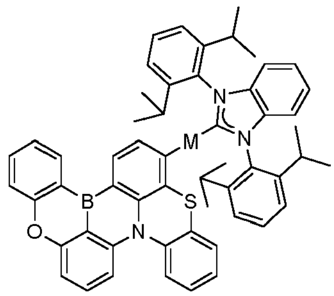

,

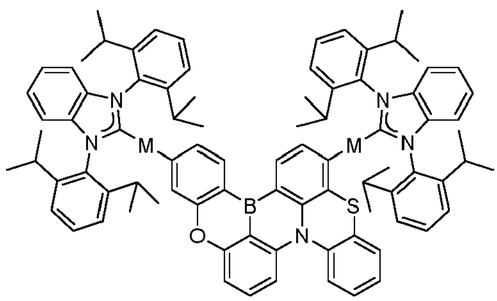

,

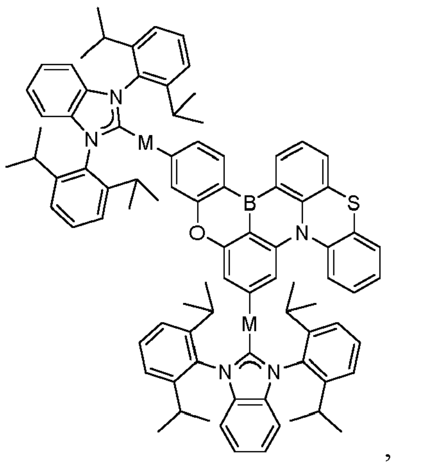

,

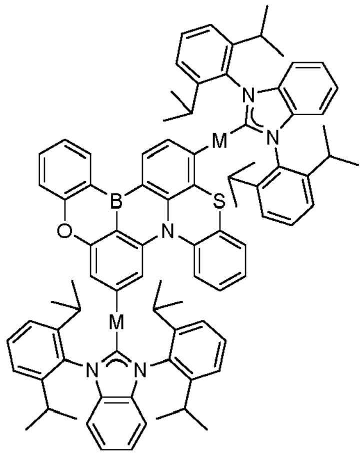

, or

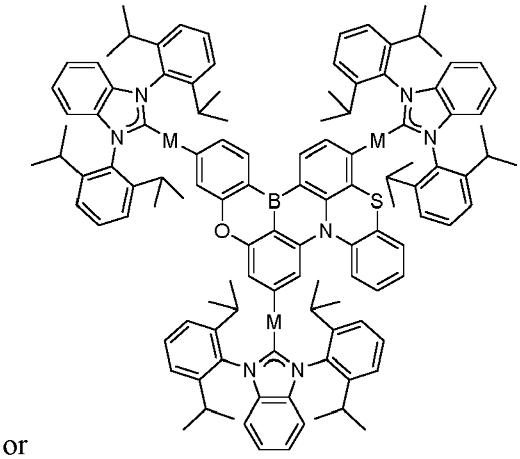

.

In some forms, the compounds have a structure selected from:

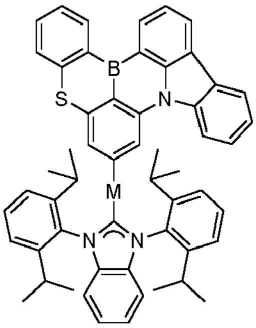

,

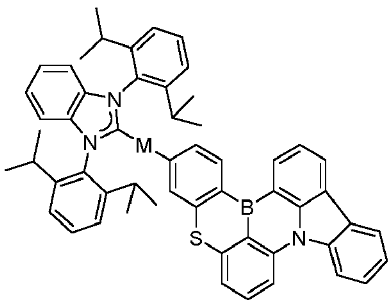

,

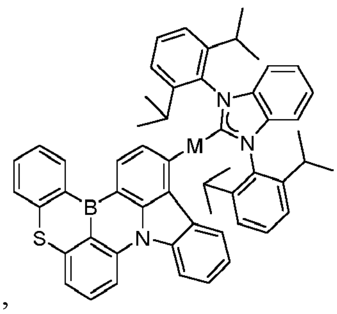

,

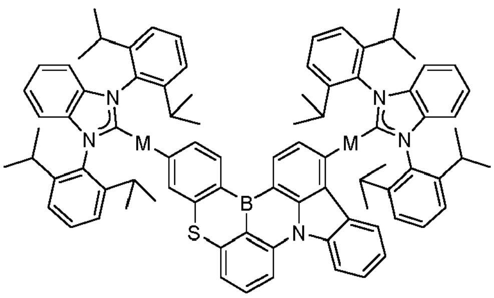

,

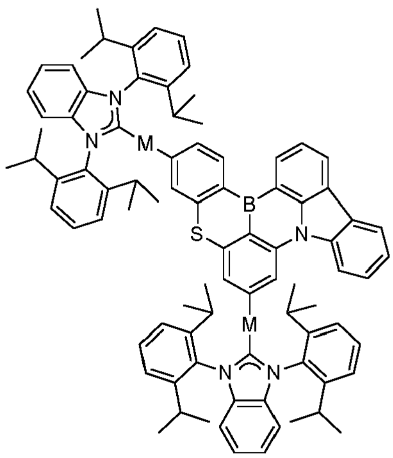

,

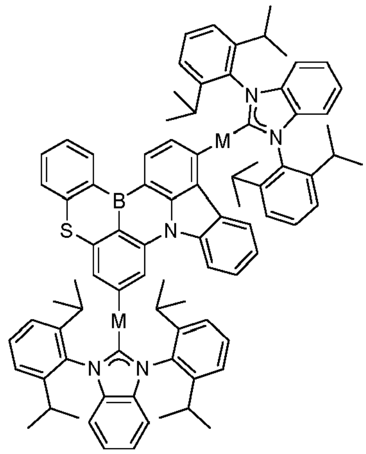,

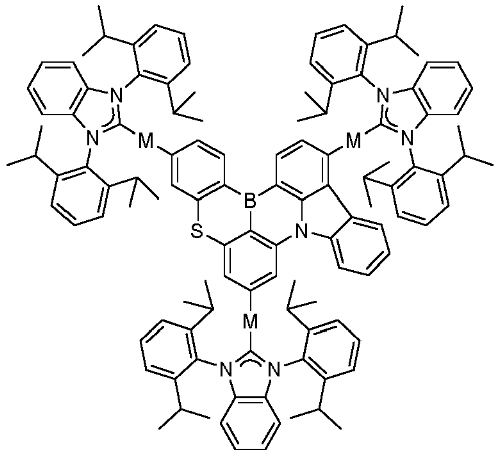,

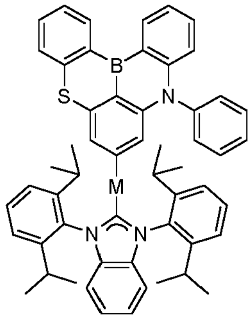,

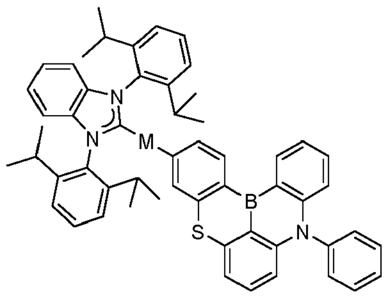,

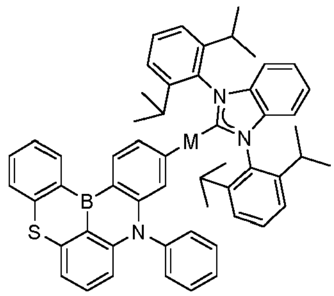,

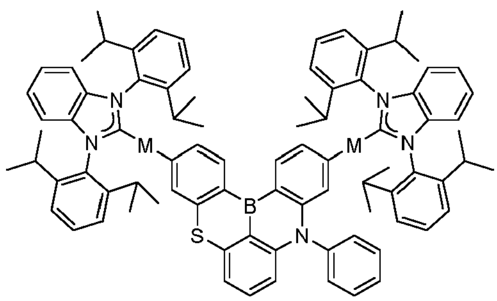,

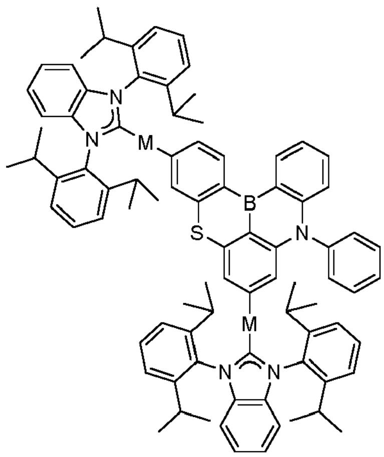,

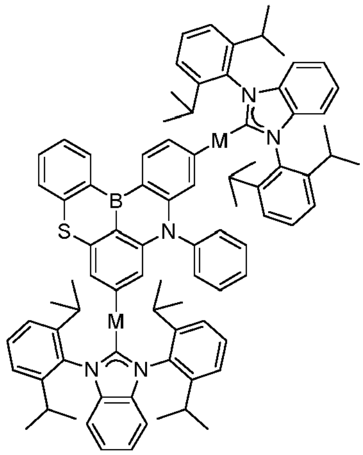

,

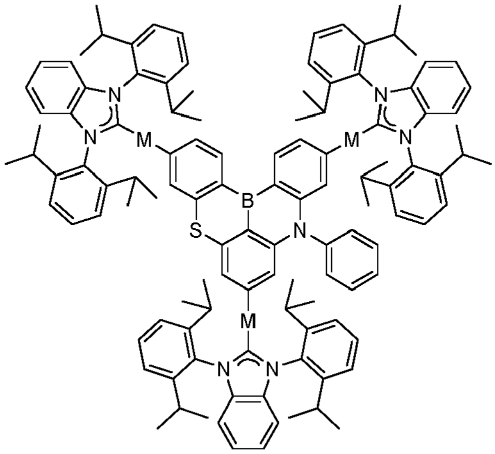

,

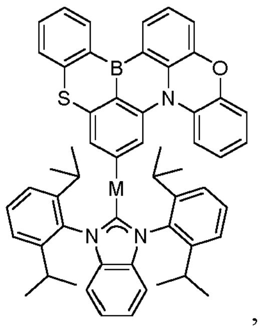

,

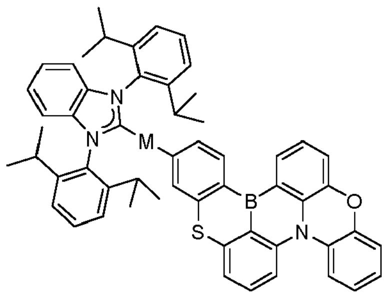

,

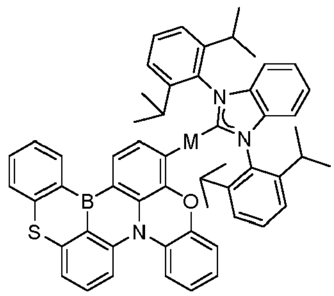

,

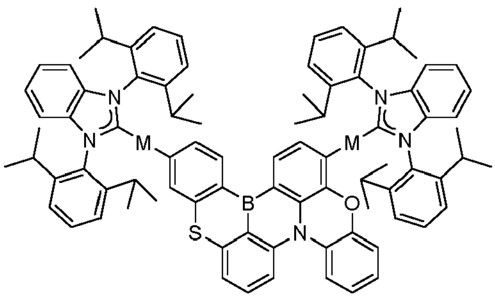

,

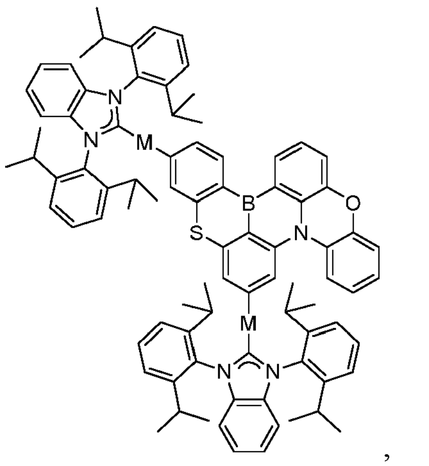

,

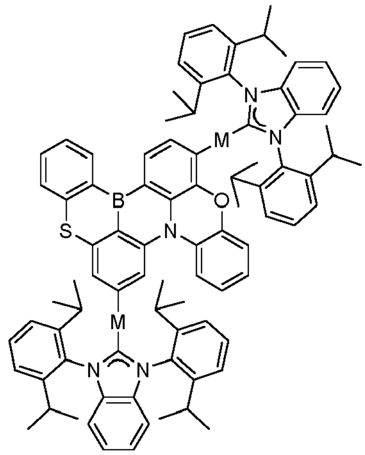,

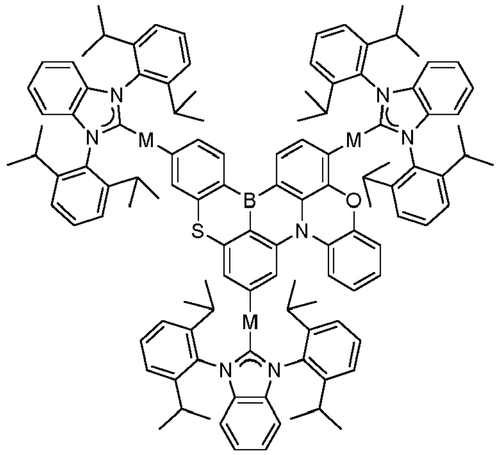,

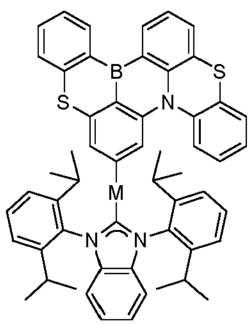,

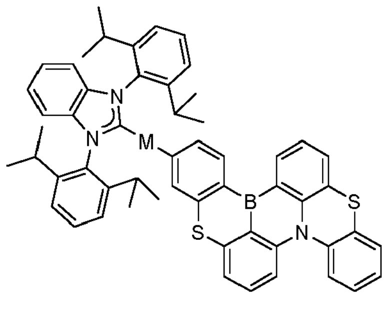,

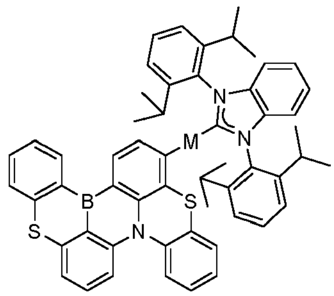,

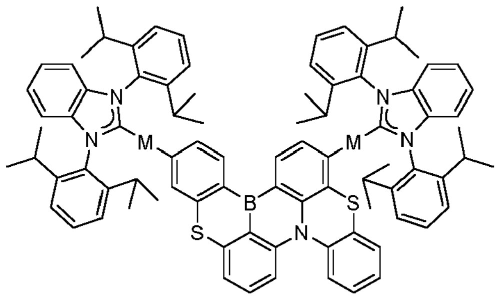,

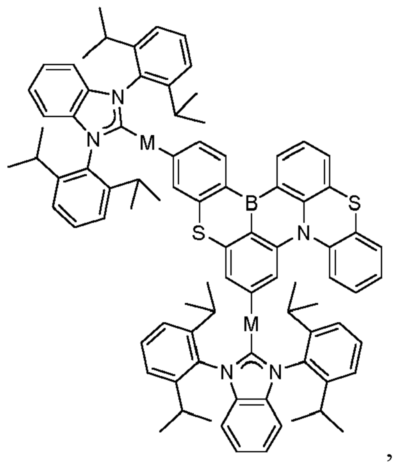,

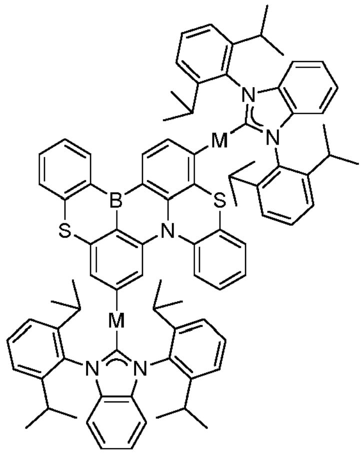

, or

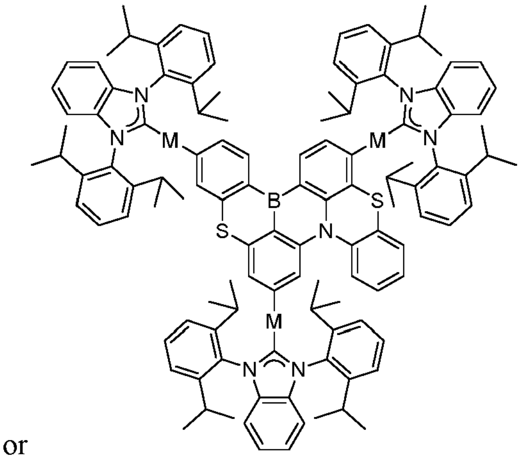

.

In some forms, the compounds are as described above, except that Formula I is:

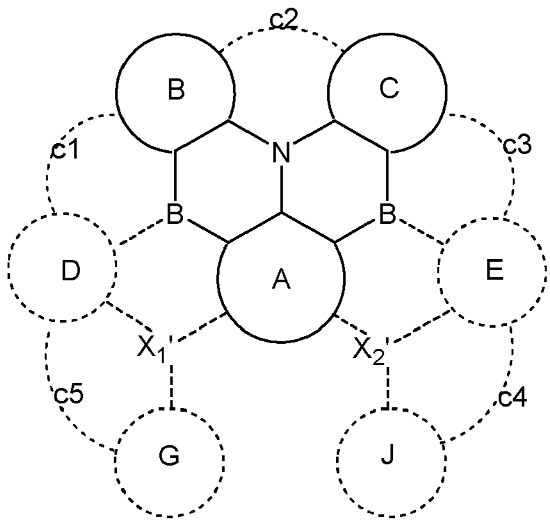

Formula XIII

wherein:

c2 is absent, single bond, -O-, -S-, -Se-, substituted $C_1$-$C_5$ alkyl (such as - C(Me)$_2$-), or unsubstituted $C_1$-$C_5$ alkyl, pairs of c1 and c3, and pairs of c4 and c5 are independently: both absent, both single bonds; single bond and absent; single bond and substituted $C_1$-$C_5$ alkyl (such as -C(Me)$_2$-); single bond and unsubstituted $C_1$-$C_5$ alkyl; single bond and -O-; single bond and -S-; single bond and -Se-; absent and -S-; absent and - Se-; both substituted $C_1$-$C_5$ alkyl (such as -C(Me)$_2$-); substituted $C_1$-$C_5$ alkyl (such as -C(Me)$_2$-) and -O-; substituted $C_1$-$C_5$ alkyl (such as -C(Me)$_2$-) and -S-; substituted $C_1$-$C_5$ alkyl (such as -C(Me)$_2$-) and -Se-; absent and substituted $C_1$-$C_5$ alkyl (such as -C(Me)$_2$-); absent and -O-; -O- and -O-; -O- and -S-; -O- and - Se-; -Se- and -Se- or -S- and -S-,

D, E, G, and J are independently substituted aryl, unsubstituted aryl, substituted heteroaryl, unsubstituted heteroaryl, or fused combinations thereof; substituted alkyl, or unsubstituted alkyl,

Formula II, described above, is datively bonded to at least one of B, C, D, E, G, and J, preferably B, C, D, and E, most preferably D, E, or both, and

preferably, substituted in Formula XIII means substituted with unsubstituted $C_1$-$C_5$ alkyl (such as methyl, ethyl, n-propyl, *etc.),* substituted $C_1$-$C_5$ alkyl (such as *iso*-propyl, iso-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, or unsubstituted amine.

In some forms, the compounds are as described above, except that $X_1$' and $X_2$' are nitrogen.

In some forms, the compounds are as described above, except that:

c2 is absent or a single bond,
pairs of c1 and c3 are both absent, and
pairs of c4 and c5 are: both absent; or both single bonds.

In some forms, the compounds are as described above, except that D, E, G, and J are independently substituted aryl, unsubstituted aryl, substituted heteroaryl, unsubstituted heteroaryl, or fused combinations thereof.

In some forms, the compounds are as described above, except that the compounds have a structure:

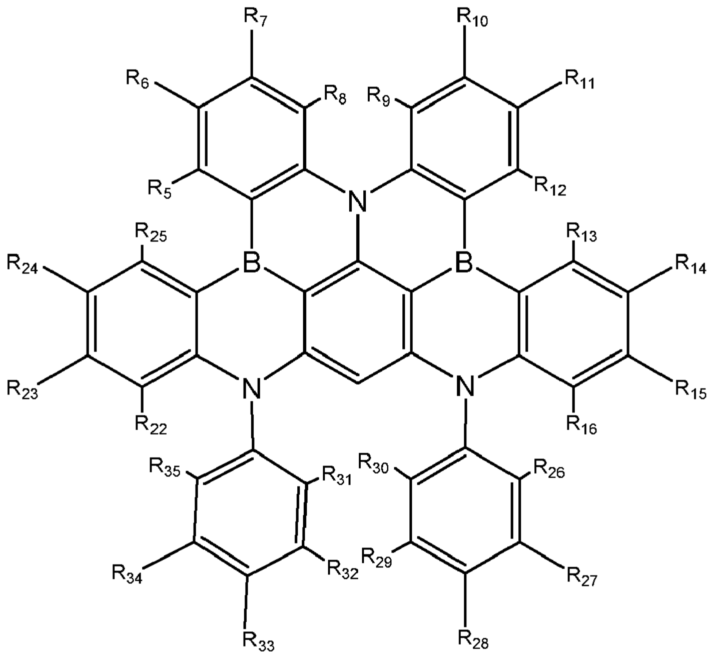

Formula XIV

$R_5$-$R_{16}$, $R_{22}$-$R_{25}$, and $R_{26}$-$R_{35}$, are preferably independently hydrogen, unsubstituted $C_1$-$C_5$ alkyl (such as methyl, ethyl, n-propyl, *etc.),* substituted $C_1$-$C_5$ alkyl (such as *iso*-propyl, *iso*-butyl, *tert*-butyl, trifluoromethyl, *etc.),* unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{16}$, $R_{22}$-$R_{25}$, and $R_{26}$-$R_{35}$ is Formula II, preferably at least one of $R_5$-$R_{16}$ and $R_{22}$-$R_{25}$ is Formula II, most preferably at least one of $R_{13}$-$R_{16}$ and $R_{22}$-$R_{25}$ is Formula II,
optionally $R_{25}$ and $R_5$ combine to form c1,
optionally $R_8$ and $R_9$ combine to form c2,
optionally $R_{12}$ and $R_{13}$ combine to form c3,
optionally $R_{16}$ and $R_{26}$ combine to form c4,
optionally $R_{35}$ and $R_{22}$ combine to form c5, or
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 16, and 22 to 35.

In some forms, the compounds are as described above, except that the compounds are selected from:

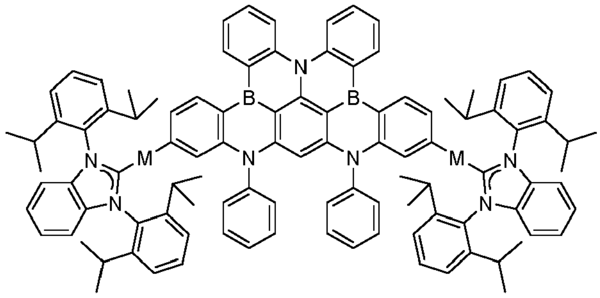

,

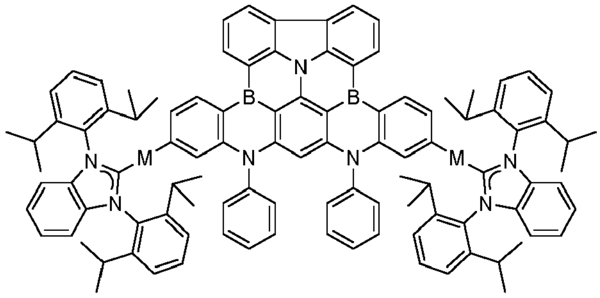

,

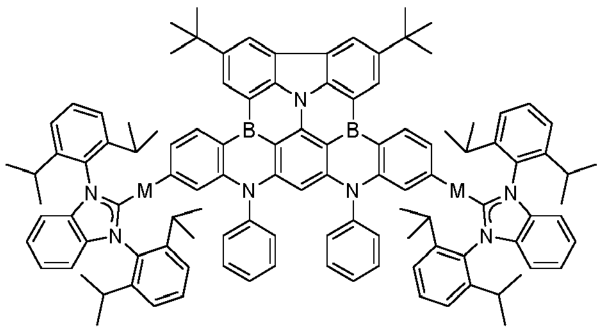

,

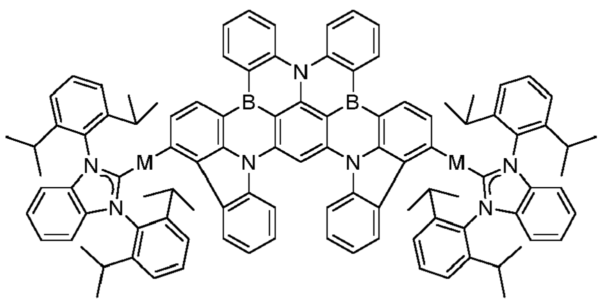

,

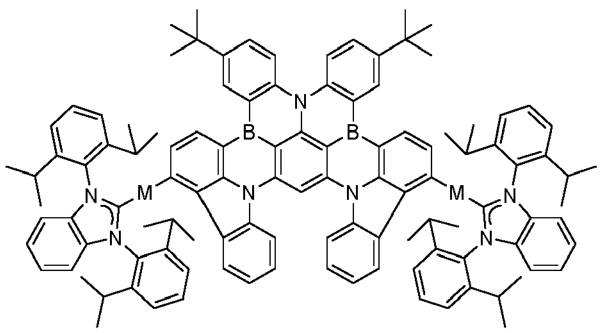

,

or

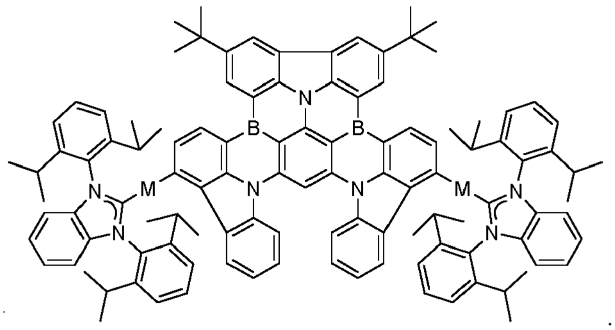

Boron-containing ligands are described in U.S. Patent Application Publication 2019/00581254 by Hatakeyama, et al., and U.S. Patent Application Publication 2018/0301629 by Hatakeyama, et al., the contents of which are herein incorporated by reference in their entirety.

**III. Methods of Making and Reagents therefor**

Also described are methods of making the MR-TADF compounds described herein. Exemplary and non-limiting syntheses of ligands and MR-TADF are discussed in the Examples below.

Also described are methods of making organic light-emitting devices, such as OLEDs, containing one or more MR-TADF compounds described herein. Methods of preparing OLEDs containing one or more MR-TADF compounds, as described above, are well-known in the art of organic electronics. The selection of suitable materials (anode, cathode, hole transport layer, electron transport layer, etc.) and fabrication parameters (such as deposition conditions or solvent selections) needed to fabricate OLEDs containing the MR-TADF described herein are known in the art. In some forms, preparation of the OLEDs can be via vacuum deposition or solution processing techniques such as spin-coating and ink printing (such as, ink-jet printing or roll-to-roll printing). An exemplary and nonlimiting method of making an OLED including MR-TADF compounds described herein is disclosed in the Examples.

**IV. Methods of Using**

The MR-TADF compounds described herein emit in the blue to green wavelength region of the visible spectrum, with color coordinates of (0.16-0.18, 0.67-0.70). Preferably, the MR-TADF compounds described herein are photo-stable, thermally stable, and/or are emissive at room temperatures, low temperatures, or a combination thereof. The MR-TADF compounds described are photoluminescent and/or electroluminescent. The MR-TADF compounds described may be in a solid, liquid, glassy, film, or solution state. The MR-TADF compounds described can emit light in response to (i) the passage of an electric current or (ii) to an electric field. In some forms, the MR-TADF compounds described may emit light independent of concentration. The emissive properties of the MR-TADF compounds described can be tuned by way of the selection of substituents. For example, the compounds can also be extended to emit in the yellow to red regions of the visible spectrum by modifying the chemical structures of the emitters. The MR-TADF compounds described may emit exclusively or predominantly in the blue to green wavelength range of the visible spectrum and may contain one or two emission maxima within.

Accordingly, the MR-TADF compounds described can be incorporated into organic electronic components including, but not limited to, OLEDs or a light-emitting electrochemical cell (LEEC). Such OLEDs can be used in commercial applications such smart phones, televisions, monitors, digital cameras, tablet computers, lighting fixtures that usually operate at room temperatures, a fixed visual display unit, mobile visual display unit, illumination unit, keyboard, clothes, ornaments, garment accessary, wearable devices, medical monitoring devices, wall paper, tablet PC, laptop, advertisement panel, panel display unit, household appliances, and office appliances.

In some forms of the organic electronic component, the compounds are in a light-emitting layer. In some forms, the organic electronic component contains an anode, a cathode, a hole transport region, and an electron transport region. In some forms, the hole transport region contains a hole injection layer and/or a hole transport layer, and optionally an electron blocking layer. In some forms, the electron transport region contains an electron transport layer and/or an electron injection layer, and optionally a hole blocking layer. In some forms, the light emitting layer is located in between the anode and the cathode. In some forms, the hole transport region is located between the anode and the light-emitting layer. In some forms, the electron transport region is located in between the cathode and the light-emitting layer.

In one non-limiting example, organic light-emitting devices can have an ordered structure containing at least an anode, a hole-transporting layer, a light-emitting layer, an electron-transporting layer, and a cathode, wherein the light-emitting layer contains an MR-TADF compound, as described above. Referring to **FIG. 9,** an organic light-emitting

device OLED 100 can include (i) a cathode **110** preferably including an aluminum layer **120** and a lithium layer **130;** (ii) optionally, an electron transporting layer **140;** (iii) optionally, a carrier confinement layer **150;** (iv) a light-emitting layer **160** containing an MR-TADF compound described herein; (v) optionally, a hole-transporting layer **170;** and (vi) an anode **180,** such as indium tin oxide-coated glass. Flexible substrates other than glass, such as on plastic are also known in the art. The above is a non-limiting illustration of an OLED device which may be fabricated. It is understood that various other OLED architectures are possible.

The light-emitting layer can be formed by doping the MR-TADF compounds, as a dopant, into a host compound and the luminescent compound has a percent composition between about 0.5 wt/wt% and about 20 wt/wt%, between about 0.5 wt/wt% and about 15 wt/wt%, between about 0.5 wt/wt% and about 10 wt/wt%, or between about 0.5 wt/wt% and about 5 wt/wt%, such as about 0.5 wt/wt%, about 1 wt/wt%, about 2 wt/wt%, about 3 wt/wt%, about 4 wt/wt%, or about 5 wt/wt% of the light-emitting layer. In some forms, the light-emitting layer has a thickness between about 5 nm and about 120 nm, between about 5 nm and about 60 nm, such as between about 10 nm and about 60 nm.

In some forms, the light-emitting layer contains a host compound. In some forms, the host compound has a percent composition between about 1 wt/wt% and about 30 wt/wt%, between about 1 wt/wt% and about 25 wt/wt%, between about 1 wt/wt% and about 20 wt/wt%, between about 1 wt/wt% and about 15 wt/wt%, between about 1 wt/wt% and about 10 wt/wt%, such as about 5 wt% of the light-emitting layer.

In some forms, the host compound is selected from, but is not limited to, 1,3-bis(N-carbazolyl)benzene (mCP), 4,4'-bis(carbazol-9-yl)biphenyl (CBP), 4,4',4"-tris(carbazol-9-yl)- triphenylamine (TCTA), 3-(4-biphenylyl)-4-phenyl-5-*tert*-butylphenyl-1,2,butylphenyl-1,2,4-triazole (TAZ), *p*-bis(triphenylsilyl)benzene (UGH2), 9-(4-tert-Butylphenyl)-3,6-bis(triphenylsilyl)-9H-carbazole (CzSi), Bis-4-(N-carbazolyl)phenyl)phenylphosphine oxide (BCPO), diphenyl-4-triphenylsilylphenyl-phosphine oxide (TSPO1), 2,8-bis(diphenylphosphoryl)dibenzo[b,d]furan (PPF), bis[2-(diphenylphosphino)phenyl]ether oxide (DPEPO), 3,3'-di(9H-carbazol-9-yl)-1,1'-biphenyl (mCBP), poly(methyl methacrylate) (PMMA), polystyrene (PS), and suitable combinations thereof. For example, two hosts, such as CzSi:TSPO1, BCPO:TSPO1, and BCPO:CzSi may be used in some forms at suitable relative ratios. Exemplary relative molar ratios of two respective hosts can range from between about 0.5: 1 to 2:1.

In some forms, the hole-transporting layer contains an organic compound that can be, but is not limited to, 4,4'-bis[*N*-(1-naphthyl)-*N*-phenylamino]biphenyl (NPB), 4,4'-bis[*N*-(3-methylphenyl)-*N*-phenylamino]biphenyl (TPD), 4,4',4"-tris[(3-methylphenyl)phenylamino] triphenylamine (MTDATA), and di-[4-(*N,N*-ditolyl-amino)phenyl]cyclohexane (TAPC). In addition, polymeric hole-transporting materials can be used including poly(N-vinylcarbazole) (PVK), polythiophene, polypyrrole, polyaniline, and copolymers including PEDOT:PSS. In some forms, the hole-transporting layer has a thickness between about 10 nm and 70 nm, such as 40 nm.

In some forms, the electron-transporting layer contains an organic compound that can be, but is not limited to, 1,3,5-tris(phenyl-2-benzimidazolyl)-benzene (TPBI), 1,3,5-tri[(3-pyridyl)-phen-3-yl] benzene (TmPyPB), bathocuproine (BCP), bathophenanthroline (BPhen) and bis(2-methyl-8-quinolinolate)-4-(phenylphenolate)-aluminum (BAlq), 1,3,5-tri[(3-pyridyl)-phen-3-yl]benzene (TmPyPB),1,3-bis[3,5-di(pyridin-3-yl)- phenyl]benzene (BmPyPhB) and 1,3,5-tris(6-(3-(pyridin-3-yl)phenyl)pyridin-2-yl)benzene (Tm3PyP26PyB). In some forms, the electron-transporting layer has a thickness between about 10 nm and 60 nm, such as 40 nm.

In some forms, the light-emitting device can contain a carrier confinement layer inserted between the hole-transporting layer and the light-emitting layer, or between the light-emitting layer and the electron-transporting layer. Preferably, the carrier confinement layer improves the performance of the light-emitting device. In some forms, the carrier confinement layer contains an organic compound that can be, but is not limited to, CBP, TCTA, 3TPYMB, BmPyPhB, and Tm3PyP26PyB. In some forms, the carrier confinement layer has a thickness between about 5 nm and about 50 nm, such as between about 10 nm and about 50 nm.

Preferably, the anode of the light-emitting device contains indium tin oxide-coated glass. Preferably, the cathode of the light-emitting device can contain lithium fluoride, aluminium, or a combination thereof. In some forms, the lithium fluoride forms a layer having a thickness between about 0.05 nm and 5 nm, such as 1 nm. In some forms, the aluminium forms a layer having a thickness between about 50 nm and about 250 nm, between about 50 nm and about 200 nm, such as 150 nm.

OLEDs fabricated with the MR-TADF emitters/compounds described herein can demonstrate maximum current efficiencies (CE) of up to 35 cd/A. In some forms, the CE can include, but is not limited to values of about 5 cd/A, 7.5 cd/A, 10 cd/A, 15 cd/A, 20 cd/A, 25 cd/A, 30 cd/A, or 35 cd/A. The CE values at luminances of 1000 cd/$m^2$ may be up to 30 cd/A. In some forms, the CE at luminances of 1000 cd/$m^2$ can include, but is not limited to values of about 2 cd/A, 2.5 cd/A, 5 cd/A, 10 cd/A, 15 cd/A, 20 cd/A, 25 cd/A, or 30 cd/A.

OLEDs fabricated with the MR-TADF emitters/compounds described herein can demonstrate maximum power efficiencies (PE) of up to 30 lumens per watt. In some forms, the PE can include, but is not limited to values of about 5 lm/W, 10 lm/W, 15 lm/W, 20 lm/W, 25 lm/W, or 30 lm/W. The PE values at luminances of 1000 cd/$m^2$ may be up to 25 lm/W. In some forms, the PE at luminances of 1000 cd/$m^2$ can include, but is not limited to values of about 5 lm/W, 5.5 lm/W, 6 lm/W, 6.5 lm/W, 10 lm/W, 15 lm/W, 20 lm/W, 25 lm/W.

OLEDs fabricated with the MR-TADF emitters/compounds described herein can demonstrate maximum external quantum efficiencies (EQE) of up to about 30%. In some forms, the EQE can include, but is not limited to values of about 10 to about 30%. The EQE values at luminances of 1000 cd/$m^2$ may be up to about 20%, about 25%, about 26%, about 27%, about 28%, about 29%, or about 30%. In some forms, the EQE at luminances of 1000 cd/$m^2$ can include, but is not limited to, values of about 1% to about 20%, about 1% to about 15%, about 1% to about 10%, or about 1% to about 5%.

The disclosed compositions and methods can be further understood through the following numbered paragraphs.

1. A compound having a structure:

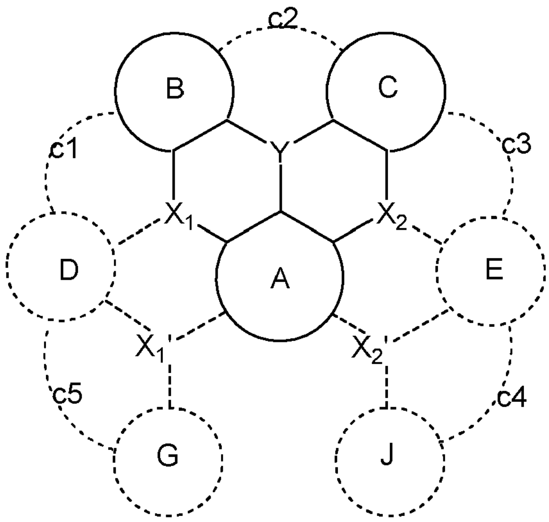

Formula I

wherein:

the compound has an overall neutral, negative, or positive charge,
the dashed linear lines in Formula I denote the presence or absence of a bond,
$X_1$, Y, and $X_2$ are, respectively: nitrogen, boron, and nitrogen; oxygen, boron, and oxygen; oxygen, boron, and nitrogen; sulfur, boron, and nitrogen; selenium, boron, and nitrogen; boron, nitrogen, and boron; sulfur, boron, and sulfur; selenium, boron, and selenium; selenium, boron, and oxygen; or sulfur, boron, and oxygen,
A, B, and C are independently substituted aryl, unsubstituted aryl, substituted heteroaryl, unsubstituted heteroaryl, substituted polyaryl, unsubstituted polyaryl, substituted polyheteroaryl, unsubstituted polyheteroaryl, or fused combinations thereof,
D, E, G, and J are independently absent, substituted aryl, unsubstituted aryl, substituted heteroaryl, unsubstituted heteroaryl, substituted polyaryl, unsubstituted polyaryl, substituted polyheteroaryl, unsubstituted polyheteroaryl, or fused combinations thereof; substituted alkyl, or unsubstituted alkyl,
preferably, substituted in Formula I means substituted with unsubstituted $C_1$-$C_5$ alkyl (such as methyl, ethyl, n-propyl, *etc.),* substituted $C_1$-$C_5$ alkyl (such as *iso*-propyl, *iso*-butyl, *tert*-butyl, trifluoromethyl, *etc.),* unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, or unsubstituted amine,
$X_1$' and $X_2$' are independently absent, nitrogen, oxygen, sulfur, selenium, substituted $C_1$-$C_5$ alkyl (such as -C(Me)$_2$-), or unsubstituted $C_1$-$C_5$ alkyl,
c1, c2, c3, c4, and c5 are independently absent, single bond, -O-, -S-, - Se-, substituted $C_1$-$C_5$ alkyl (such as -C(Me)$_2$-), unsubstituted $C_1$-$C_5$ alkyl, substituted amine, unsubstituted amine, substituted carbonyl, or unsubstituted carbonyl, and
at least one of A, B, C, D, E, G, and J is datively bonded to a moiety having a structure:

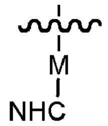

Formula II

wherein:

the dative bond involves M,
NHC has a structure:

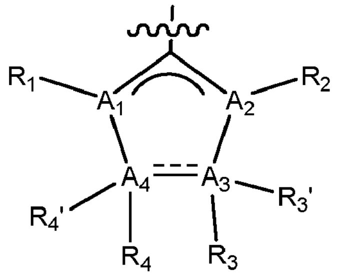

Formula IIa

M is a metal or metal ion with high spin-orbit coupling, such as metals or metal ions of 3d, 4d, and 5d transition metals, preferably gold, copper, silver, iridium, ruthenium, platinum, *etc.*,
$A_1$, $A_2$, $A_3$, and $A_4$ are independently carbon or nitrogen, preferably wherein at least one of $A_1$, $A_2$, $A_3$, and $A_4$ is nitrogen and at least one of the other of $A_1$, $A_2$, $A_3$, and $A_4$ is carbon, and $A_1$, $A_2$, $A_3$, and $A_4$ are bonded to none, one, or two hydrogen atoms according to valency,
$R_1$, $R_2$, $R_3$, $R_3$', $R_4$, and $R_4$' are independently hydrogen, substituted aryl, unsubstituted aryl, substituted heteroaryl, unsubstituted heteroaryl, substituted polyaryl, unsubstituted polyaryl, substituted polyheteroaryl, unsubstituted polyheteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, unsubstituted $C_1$-$C_{20}$heterocyclyl, or fused combinations thereof; substituted alkyl, or unsubstituted alkyl (such as unsubstituted $C_1$-$C_5$ alkyl); or $A_2$ and $R_2$ together form a substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, or unsubstituted $C_1$-$C_{20}$ heterocyclyl; or $A_3$, $R_3$, $R_3$', $A_4$, $R_4$, and $R_4$', together form substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, unsubstituted $C_1$-$C_{20}$ heterocyclyl, or fused combinations thereof, preferably, substituted in Formula IIa means substituted with unsubstituted $C_1$-$C_5$ alkyl (such as methyl, ethyl, n-propyl, *etc.*), substituted $C_1$-$C_5$ alkyl (such as iso-propyl, iso-butyl, *tert*-butyl, *etc.*), substituted aryl (1,1'-biphenyl-2-yl, 1,1'-biphenyl-3-yl, 1,1'-biphenyl-4-yl, 2,6-dimethylphenyl), unsubstituted aryl (phenyl), and
when the dashed line between $A_3$ and $A_4$ is a single bond, $R_3$' and $R_4$' are absent.

2. The compound of paragraph 1, wherein M is a metal or metal ion of gold, silver, or copper.
3. The compound of paragraph 1 or 2, wherein at least one of $A_1$, $A_2$, $A_3$, and $A_4$ is nitrogen and at least one of the other of $A_1$, $A_2$, $A_3$, and $A_4$ is carbon.
4. The compound of any one of paragraphs 1 to 3, wherein $R_1$, $R_2$, $R_3$, $R_3$', $R_4$, and $R_4$' are independently hydrogen, substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), or fused combinations thereof; substituted alkyl, or unsubstituted alkyl (such as unsubstituted $C_1$-$C_5$ alkyl).
5. The compound of any one of paragraphs 1 to 3, wherein $A_2$ and $R_2$ together form a substituted $C_3$-$C_{20}$ cycloalkyl (such as substituted $C_3$-$C_{10}$ cycloalkyl) or unsubstituted $C_3$-$C_{20}$ cycloalkyl (such as unsubstituted $C_3$-$C_{10}$ cycloalkyl).
6. The compound of any one of paragraphs 1 to 3, wherein $A_3$, $R_3$, $R_3$', $A_4$, $R_4$, and $R_4$', together form substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted

$C_1$-$C_{20}$ heterocyclyl, unsubstituted $C_1$-$C_{20}$ heterocyclyl, or fused combinations thereof.

7. The compound of any one of paragraphs 1 to 3, or 6, wherein $A_3$, $R_3$, $R_3$', $A_4$, $R_4$, and $R_4$', together form substituted aryl, unsubstituted aryl, substituted heteroaryl, or unsubstituted heteroaryl.

8. The compound of any one of paragraphs 1 to 7, wherein Formula IIa is selected from:

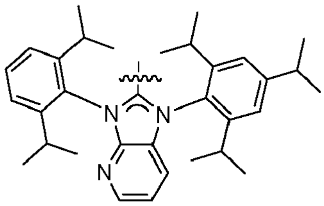
,
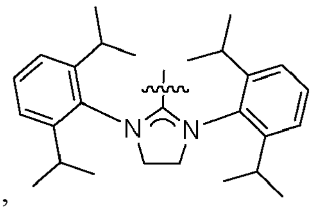
,
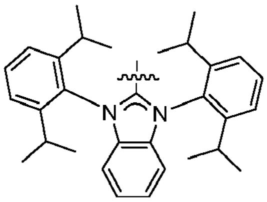
,
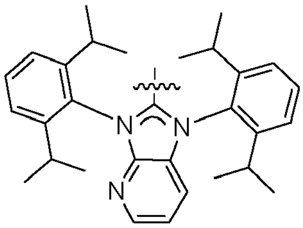
,
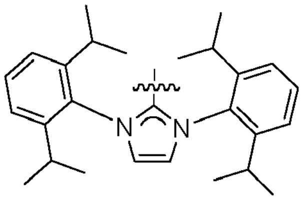
,
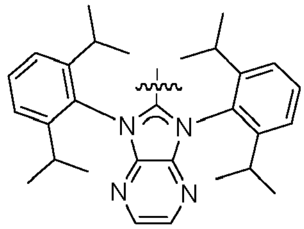
,
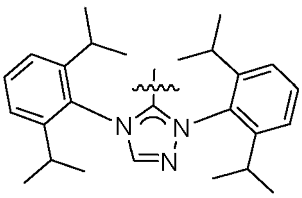
,
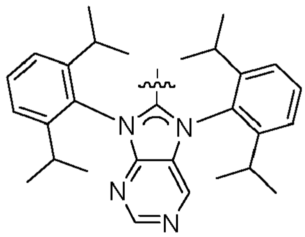
,
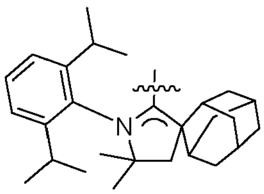
,
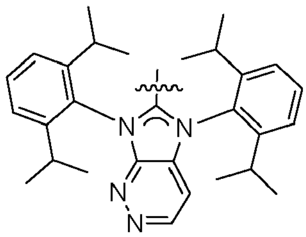
,
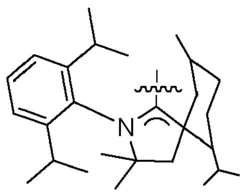
,
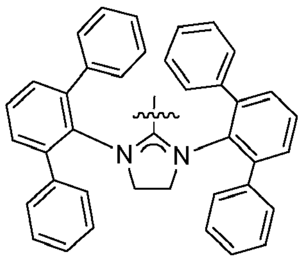
,
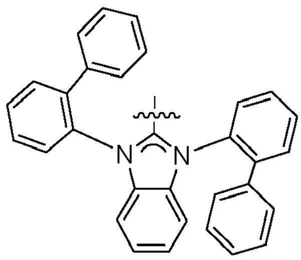
,
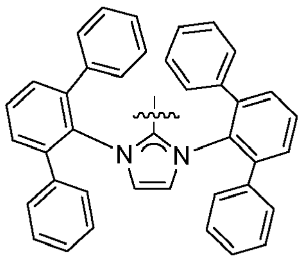
,

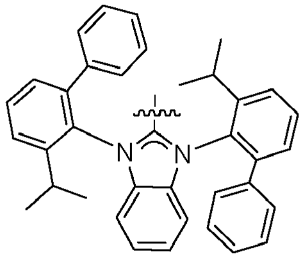, 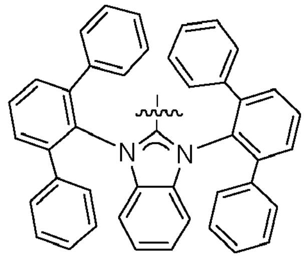, 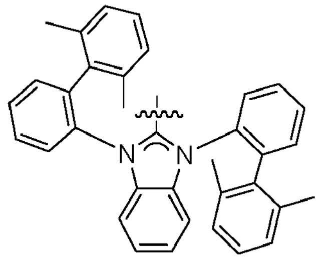,

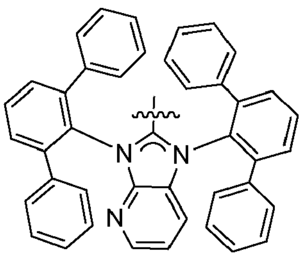, 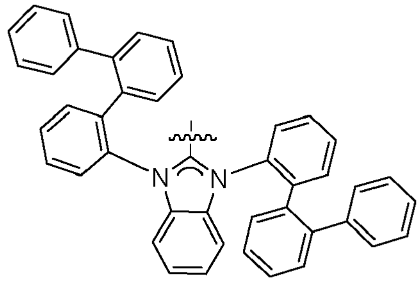,

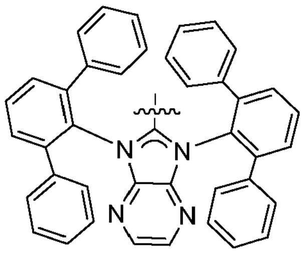, or 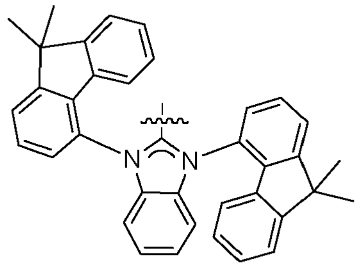.

9. The compound of any one of paragraphs 1 to 8, wherein $X_1$, Y, and $X_2$ are, respectively: nitrogen, boron, and nitrogen; oxygen, boron, and oxygen; oxygen, boron, and nitrogen; sulfur, boron, and nitrogen; selenium, boron, and nitrogen; or boron, nitrogen, and boron.

10. The compound of any one of paragraphs 1 to 9, wherein A, B, and C are independently substituted aryl, unsubstituted aryl, substituted heteroaryl, unsubstituted heteroaryl, or fused combinations thereof.

11. The compound of any one of paragraphs 1 to 10, wherein D, E, G, and J are independently absent, substituted aryl, or unsubstituted aryl, substituted heteroaryl, unsubstituted heteroaryl, or fused combinations thereof.

12. The compound of any one of paragraphs 1 to 11, wherein $X_1$' and $X_2$' are independently absent or nitrogen.

13. The compound of any one of paragraphs 1 to 12, wherein c1, c2, c3, c4, and c5 are independently absent, single bond, -O-, -S-, -Se-, substituted $C_1$-$C_5$ alkyl (such as $-C(Me)_2-$), or unsubstituted $C_1$-$C_5$ alkyl.

14. The compound of any one of paragraphs 1 to 13, wherein Formula I is:

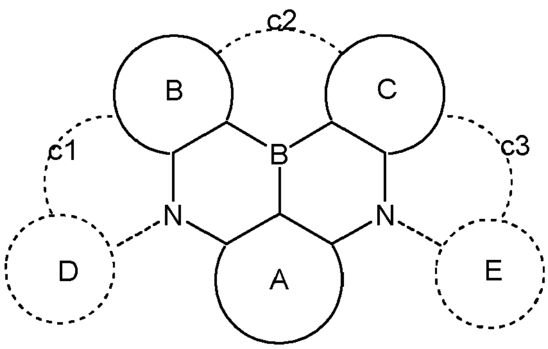

Formula III

wherein:

D and E are independently substituted aryl, unsubstituted aryl, substituted heteroaryl, unsubstituted heteroaryl, or fused combinations thereof; substituted alkyl, or unsubstituted alkyl.

15. The compound of any one of paragraphs 1 to 14, wherein Formula I is:

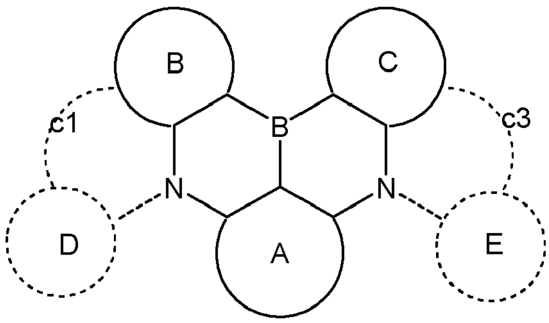

Formula IV

wherein:

pairs of c1 and c3 are: both single bonds; single bond and absent; single bond and substituted $C_1$-$C_5$ alkyl (such as -C(Me)$_2$-); single bond and unsubstituted $C_1$-$C_5$ alkyl; single bond and -O-; single bond and -S-; single bond and -Se-; absent and -S-; absent and -Se-; both substituted $C_1$-$C_5$ alkyl (such as - C(Me)$_2$-); substituted $C_1$-$C_5$ alkyl (such as -C(Me)$_2$-) and -O-; substituted $C_1$-$C_5$ alkyl (such as -C(Me)$_2$-) and -S-; substituted $C_1$-$C_5$ alkyl (such as -C(Me)$_2$-) and -Se-; absent and substituted $C_1$-$C_5$ alkyl (such as -C(Me)$_2$-); absent and -O-; -O- and -O-; -O- and -S-; -O- and -Se-; -Se- and -Se-; -S- and -S-; or both absent.

16. The compound of any one of paragraphs 1 to 15, having a structure:

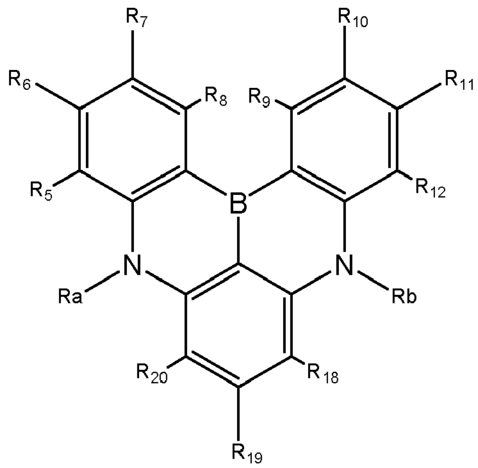

Formula V

wherein:

$R_a$ and $R_b$ are independently substituted aryl, unsubstituted aryl, substituted heteroaryl, unsubstituted heteroaryl, or fused combinations thereof; substituted alkyl, or unsubstituted alkyl,

$R_5$-$R_{12}$ and $R_{18}$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20.

17. The compound of any one of paragraphs 1 to 16, having a structure:

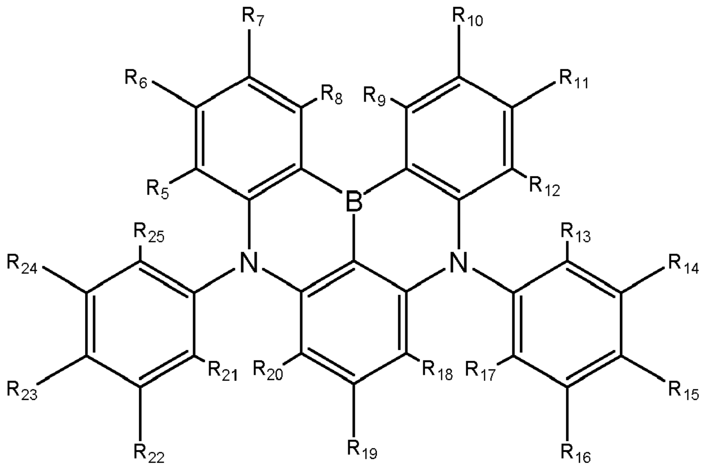

Formula VI

wherein:

$R_5$-$R_{25}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{25}$ is Formula II,
optionally $R_5$ and $R_{25}$ combine to form c1 and $R_{12}$ and $R_{13}$ combine to form c3,
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 25.

18. The compound of paragraph 16 or 17, having a structure:

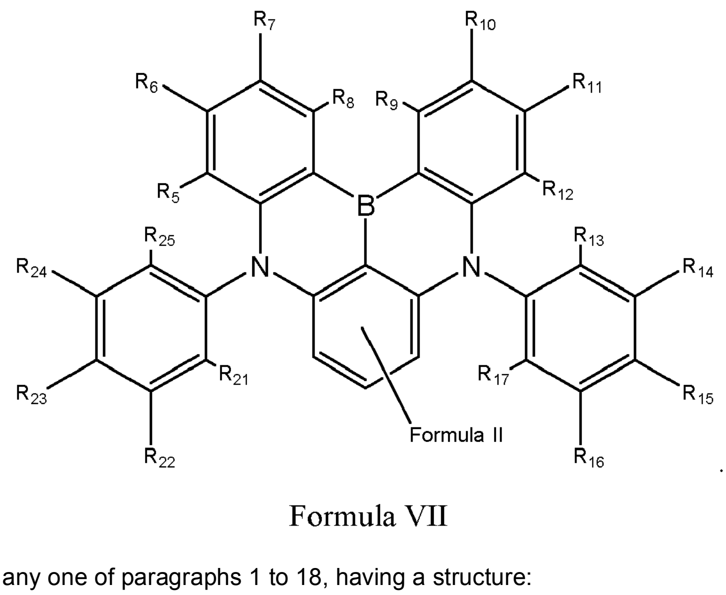

Formula VII

19. The compound of any one of paragraphs 1 to 18, having a structure:

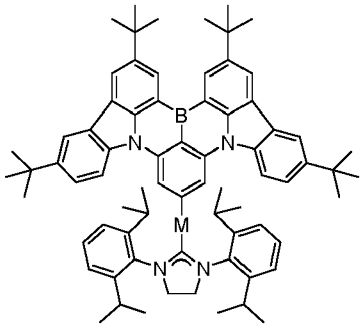
,
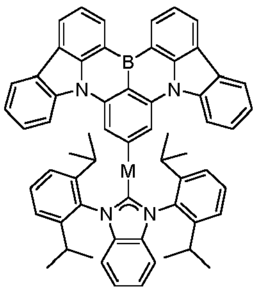
,
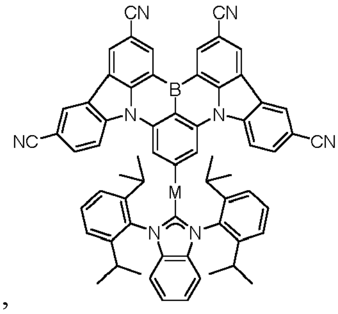
,

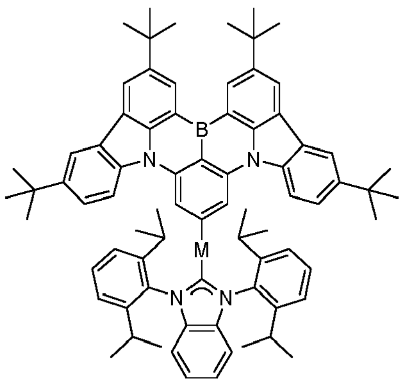
,
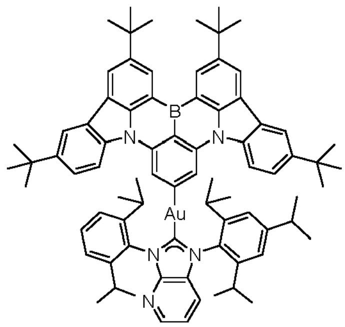
,

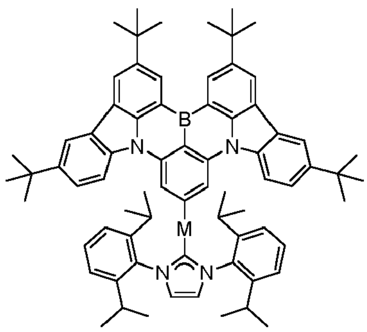
,

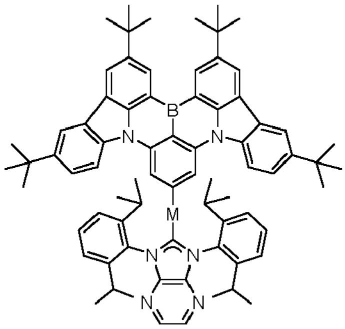
,
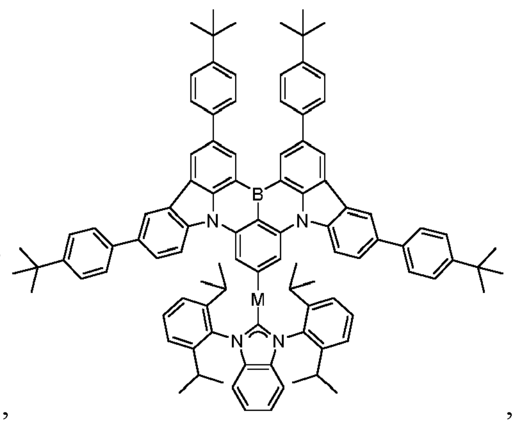
,

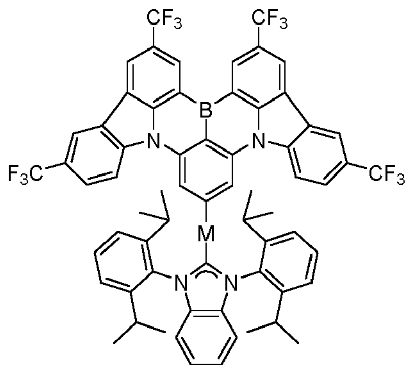
,
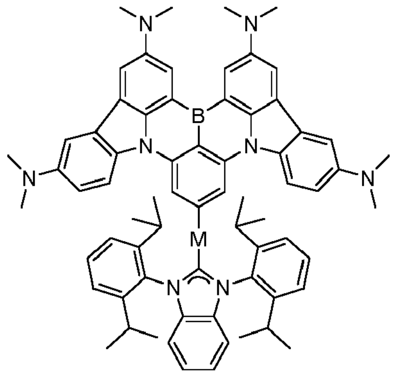
,

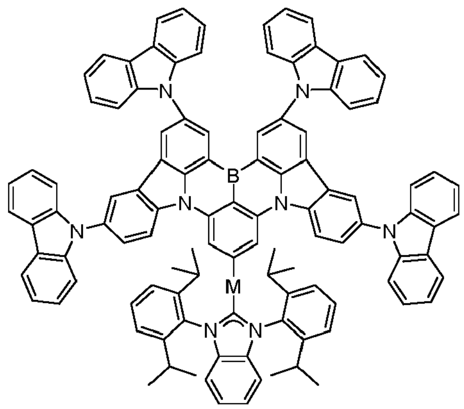
,
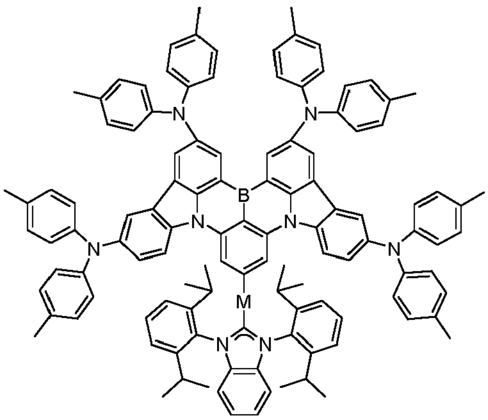
,

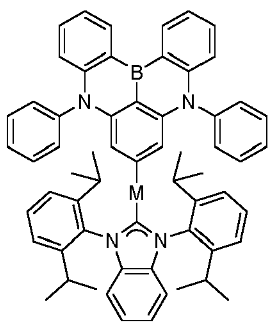
,
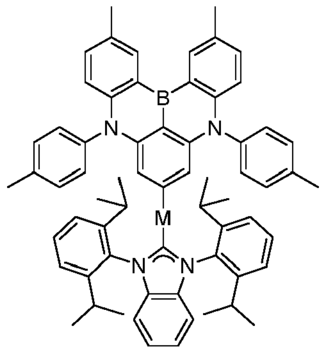
,
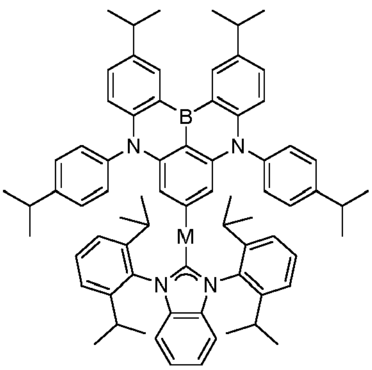
,

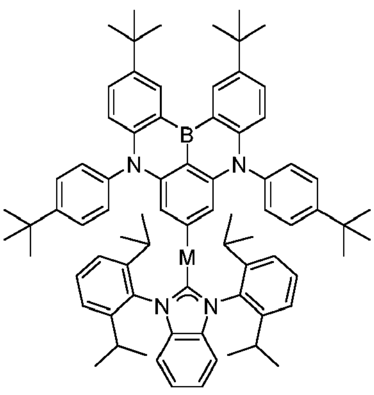
,
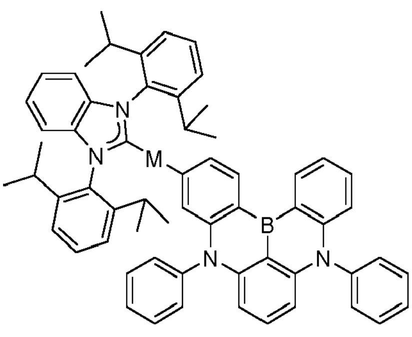
,

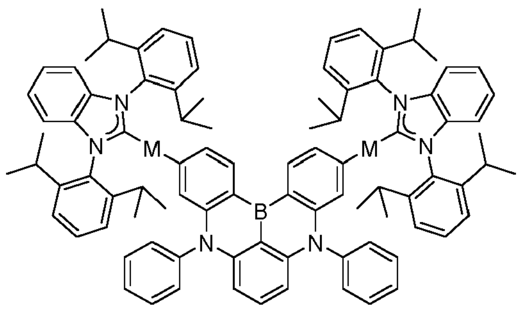
,
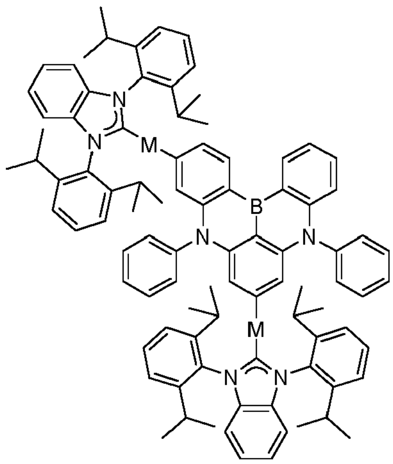
,

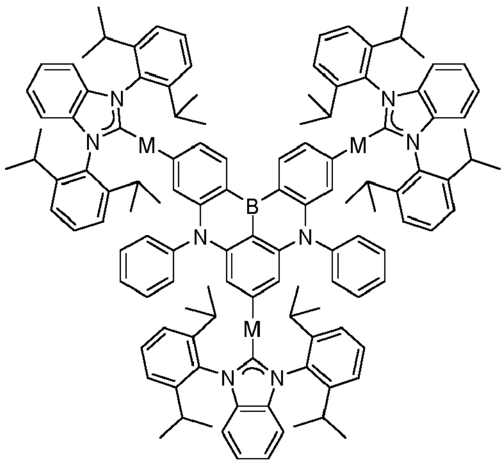
,
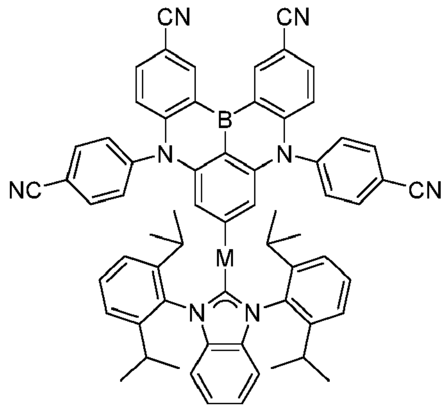
,

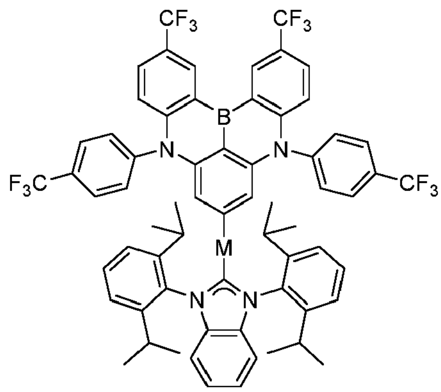
,
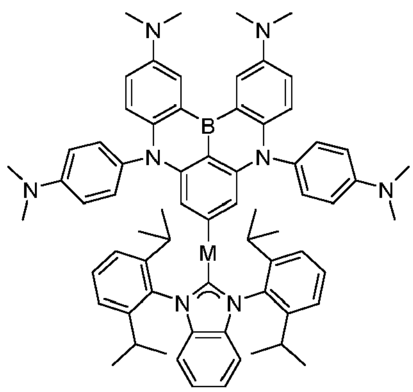
,

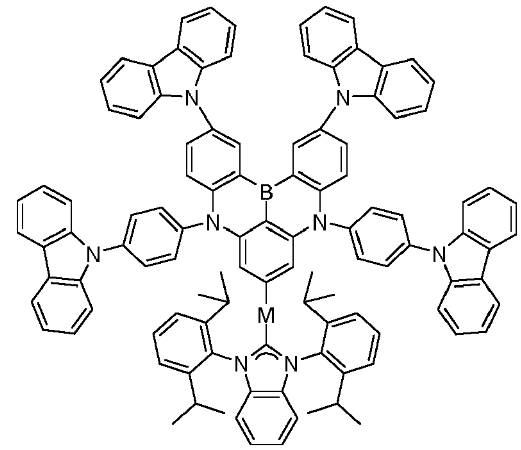

,

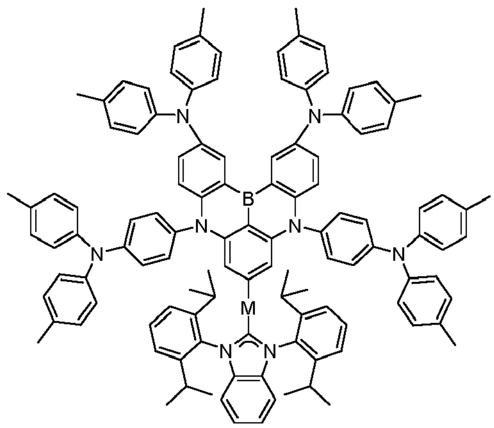

,

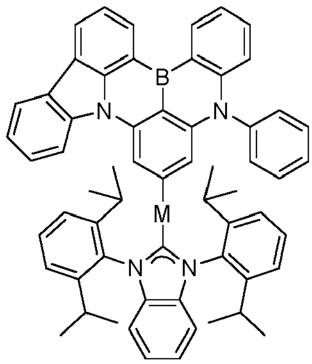

,

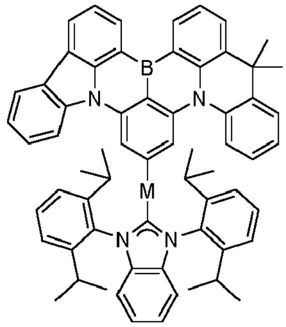

,

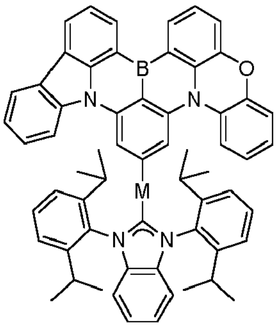

,

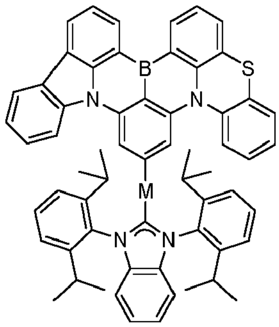

,

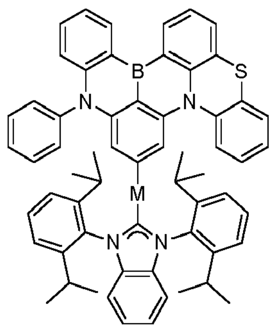

,

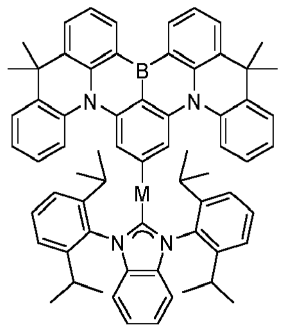

,

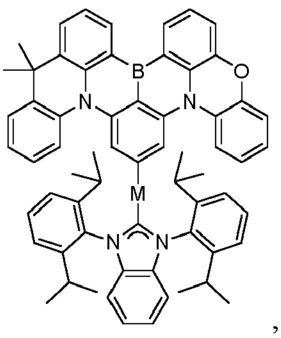

,

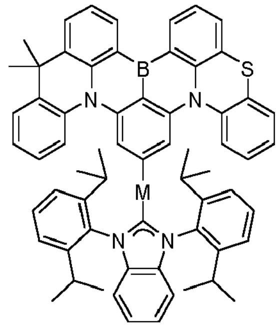,
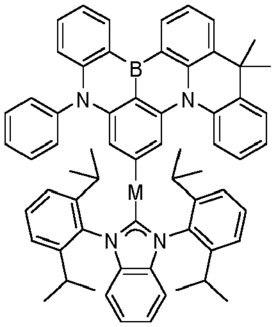,
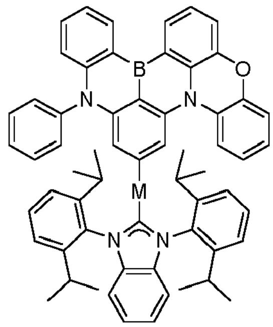,

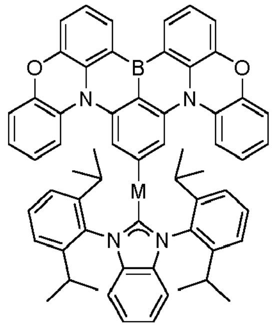,
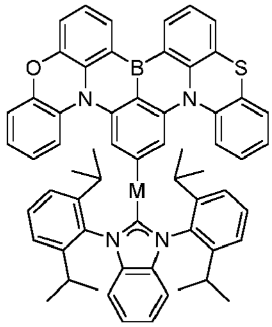, or
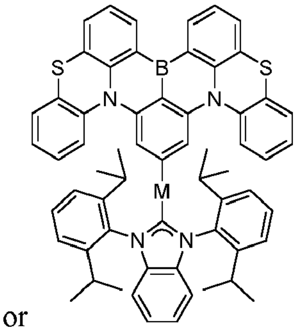.

20. The compound of any one of paragraphs 1 to 13, wherein Formula I is:

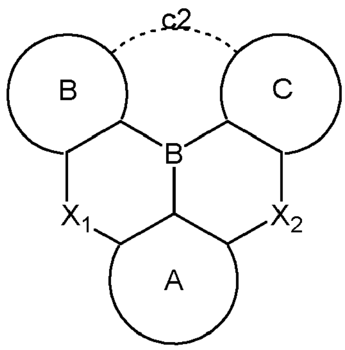

Formula VIII

wherein:

pairs of $X_1$ and $X_2$ are: both oxygen; sulfur and oxygen; selenium and oxygen; selenium and selenium; or sulfur and sulfur, preferably both oxygen,
preferably c2 is absent.

21. The compound of any one of paragraphs 1 to 13, or 20, having a structure:

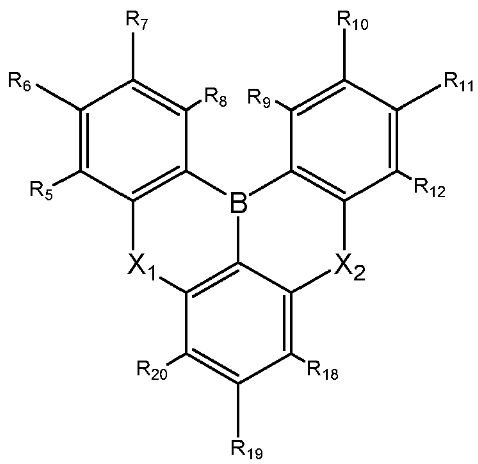

Formula IX

wherein:

pairs of $X_1$ and $X_2$ are: both oxygen; sulfur and oxygen; selenium and oxygen; selenium and selenium; or sulfur and sulfur, preferably both oxygen,

$R_5$-$R_{12}$ and $R_{18}$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as $(4\text{-methylphenyl})_2N$-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20.

22. The compound of any one of paragraphs 1 to 13, 20, or 21, having a structure:

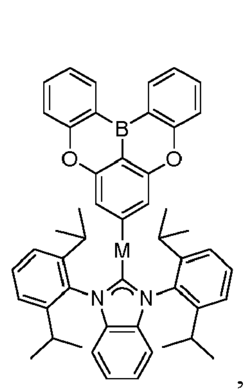
,
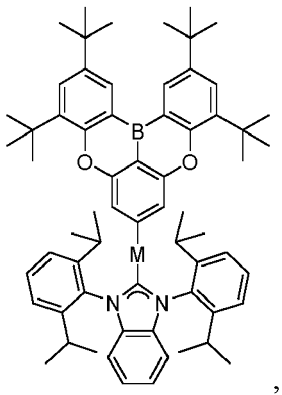
,

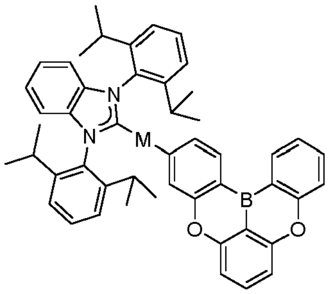
,
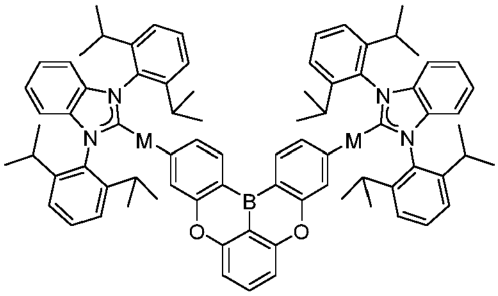
,

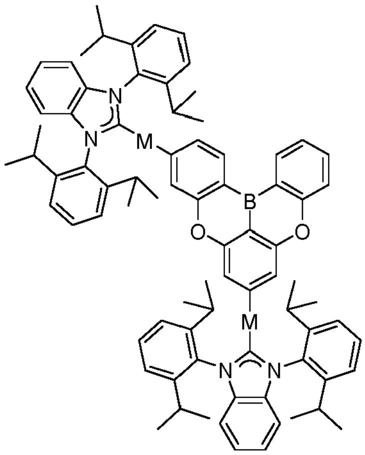

, or

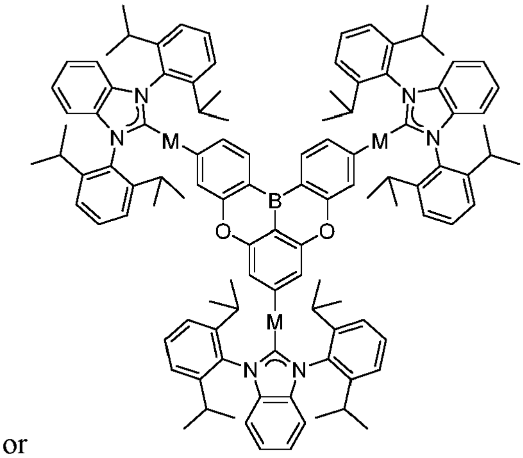

.

23. The compound of any one of paragraphs 1 to 13, wherein Formula I is:

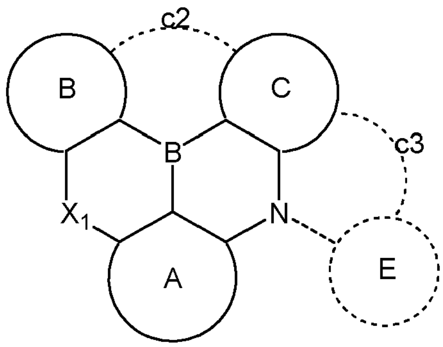

Formula X

wherein:

- $X_1$ is oxygen, sulfur, selenium,
- c2 is preferably absent,
- c3 is absent, single bond, -O-, -S-, -Se-, substituted $C_1$-$C_5$ alkyl (such as - $C(Me)_2$-), or unsubstituted $C_1$-$C_5$ alkyl, and
- E is substituted aryl, unsubstituted aryl, substituted heteroaryl, unsubstituted heteroaryl, or fused combinations thereof; substituted alkyl, or unsubstituted alkyl.

24. The compound of any one of paragraphs 1 to 13, or 23, having a structure:

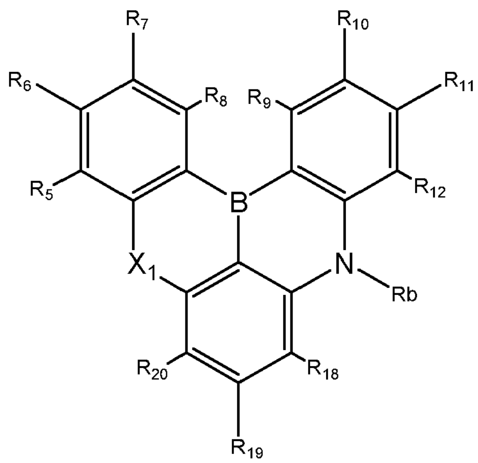

Formula XI

wherein:

$X_1$ is oxygen, sulfur, selenium,
Rb is substituted aryl, unsubstituted aryl, substituted heteroaryl, unsubstituted heteroaryl, or fused combinations thereof; substituted alkyl, or unsubstituted alkyl,
$R_5$-$R_{12}$ and $R_{18}$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{12}$ and $R_{18}$-$R_{20}$ is Formula II,
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20.

25. The compound of any one of paragraphs 1 to 13, 23, or 24, having a structure:

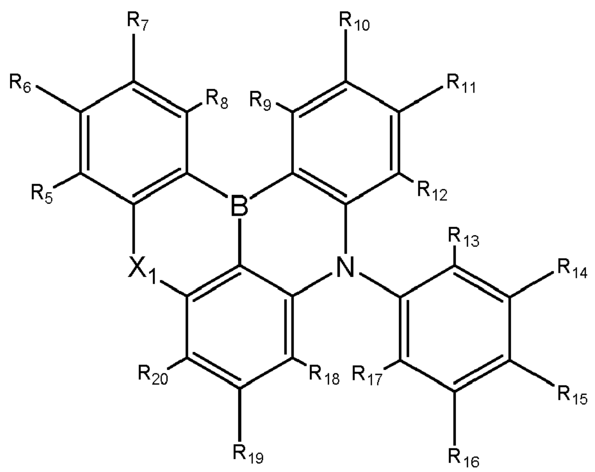

Formula XII

wherein:

$X_1$ is oxygen, sulfur, or selenium,
$R_5$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl),

substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{20}$ is Formula II,

optionally $R_{12}$ and $R_{13}$ combine to form c3,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 20.

26. The compound of any one of paragraphs 1 to 13, or 23 to 25, having a structure:

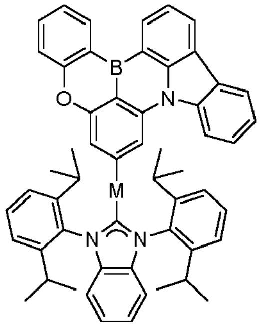
,
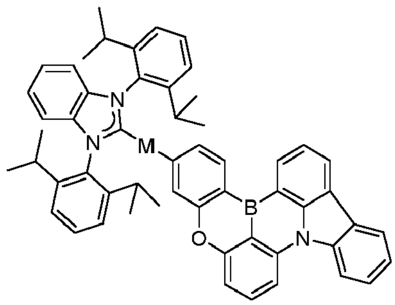
,
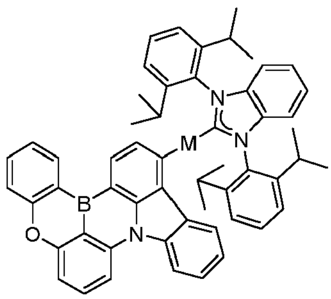
,
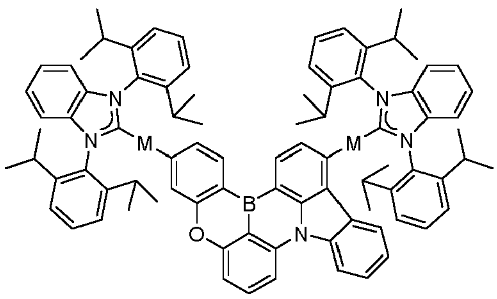
,
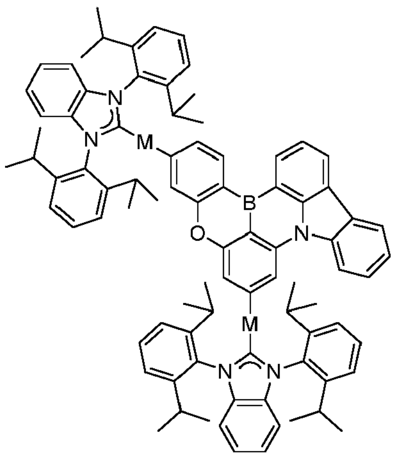
,
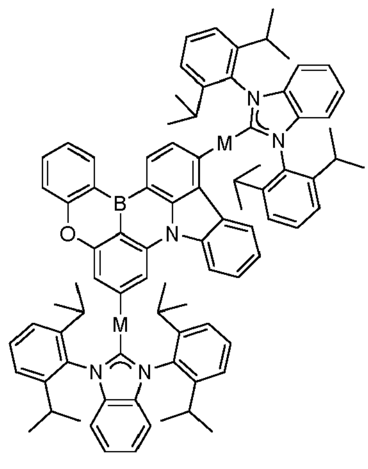
,

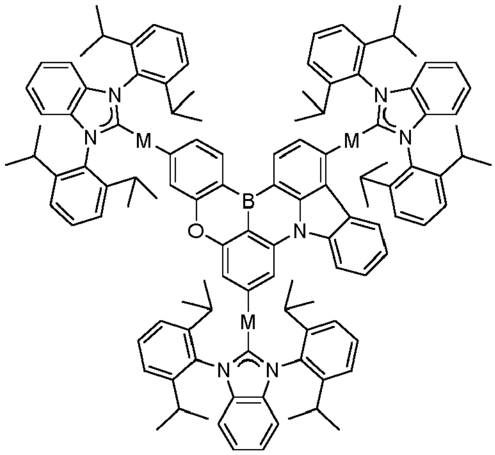,
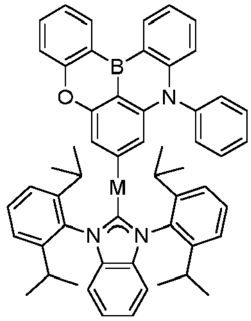,

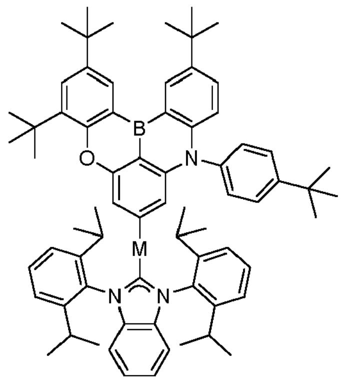,
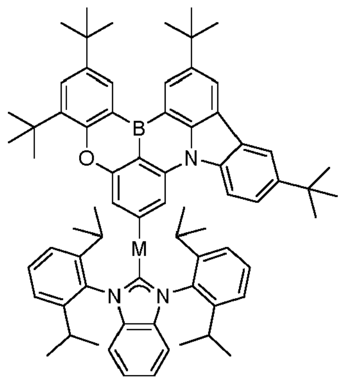,

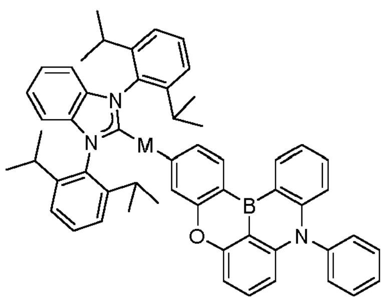,
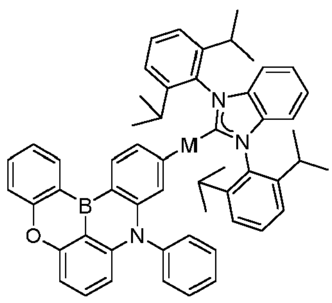,

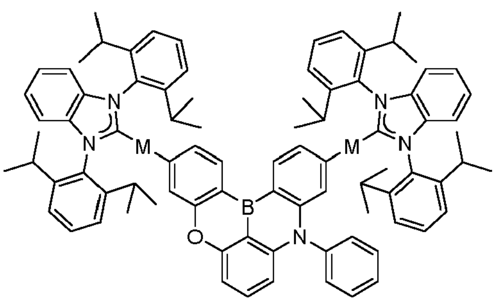,
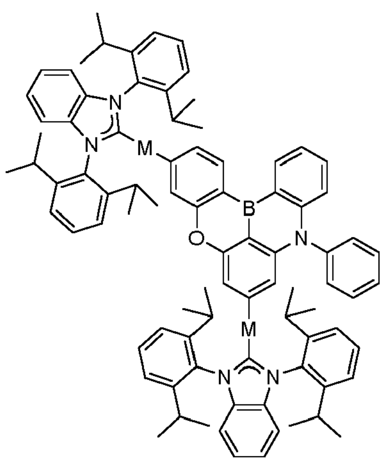,

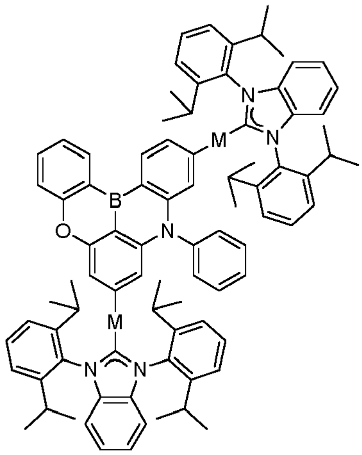
,
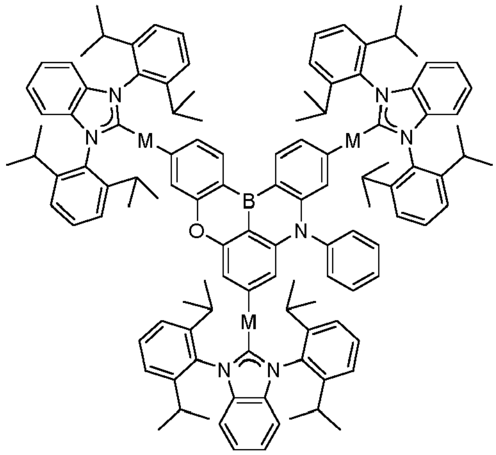
,

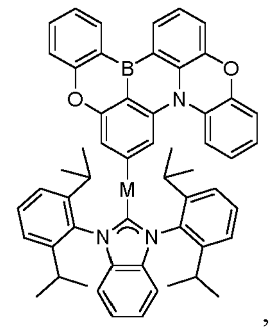
,
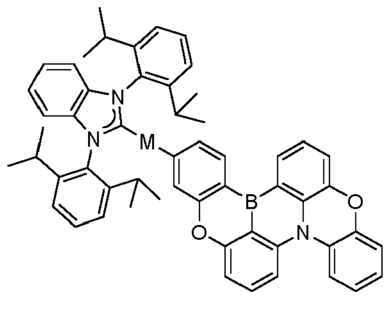
,
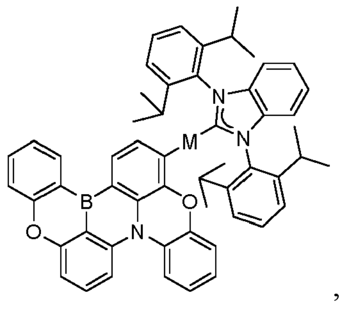
,

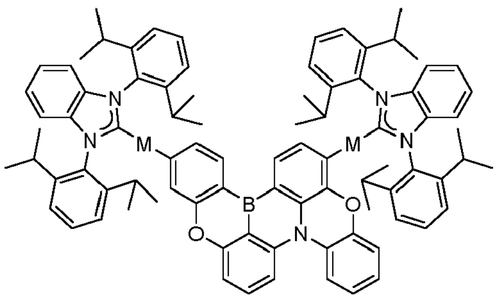
,
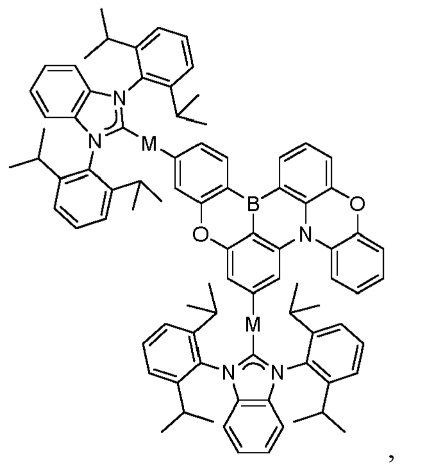
,

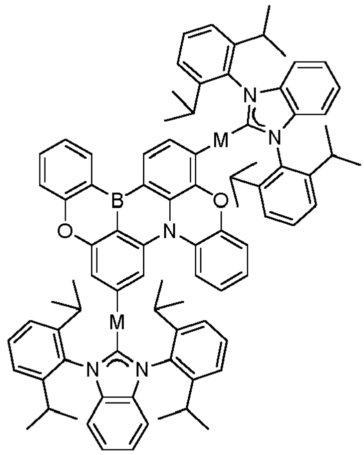

,

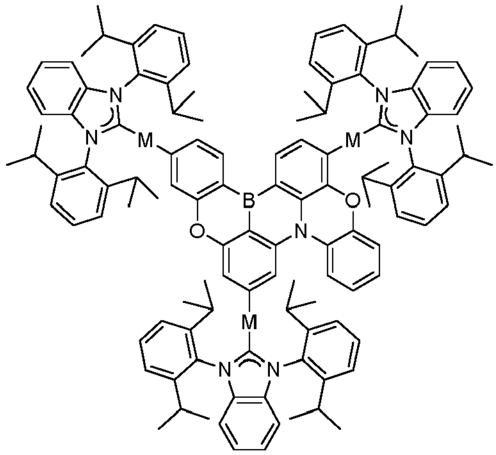

,

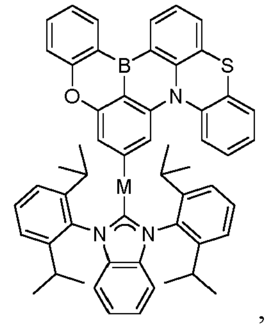

,

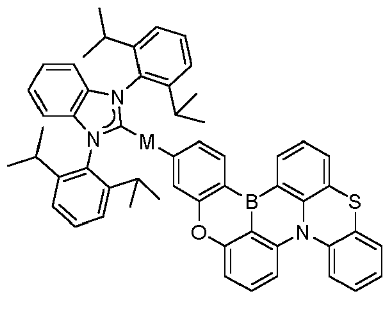

,

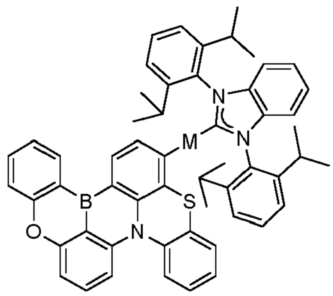

,

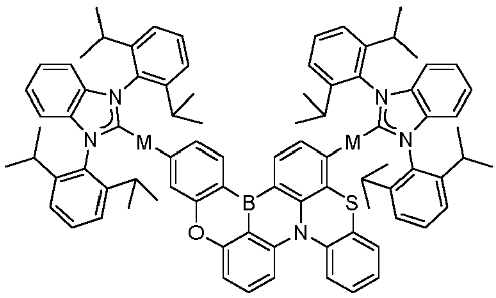

,

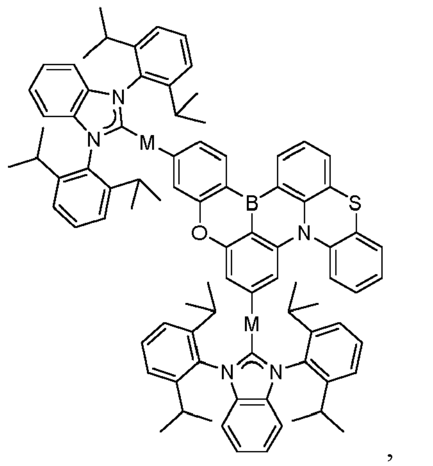

,

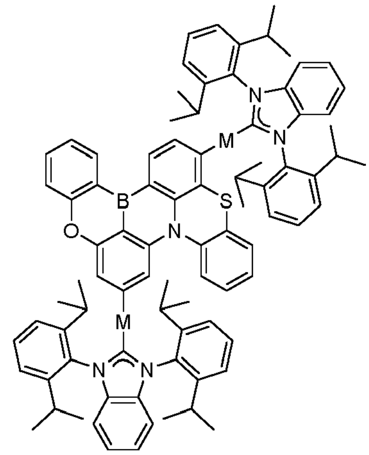
, or
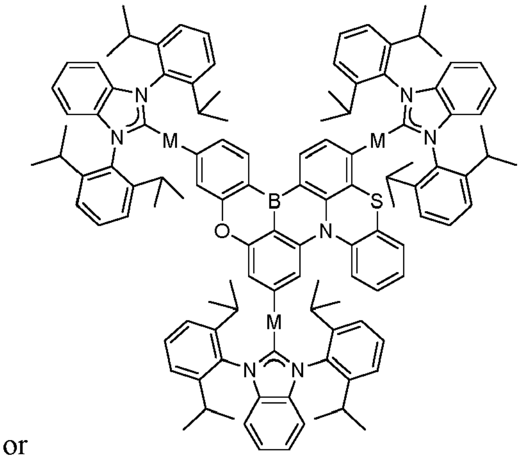
.

27. The compound of any one of paragraphs 1 to 13, or 23 to 25, having a structure:

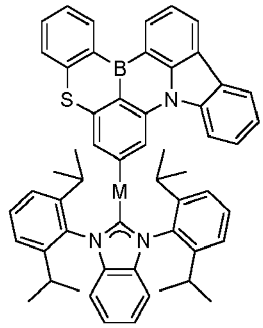
,
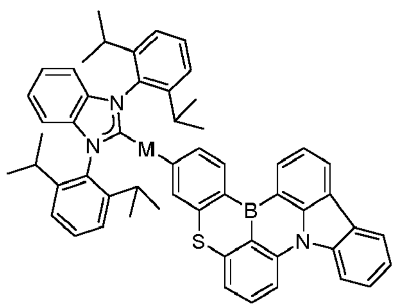
,

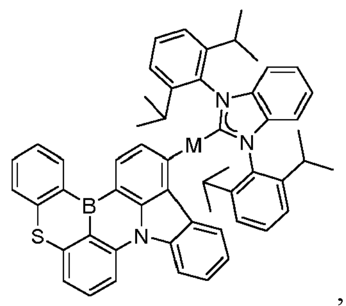
,
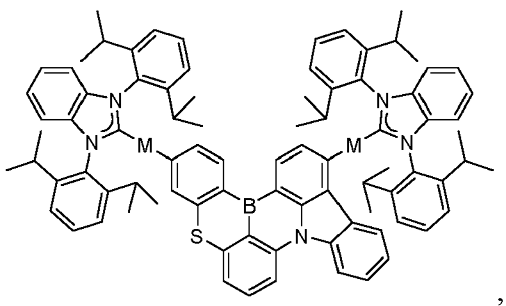
,

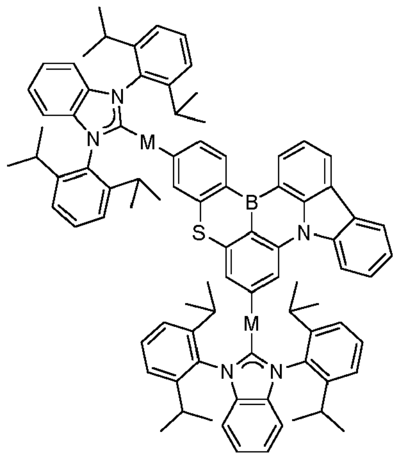
,
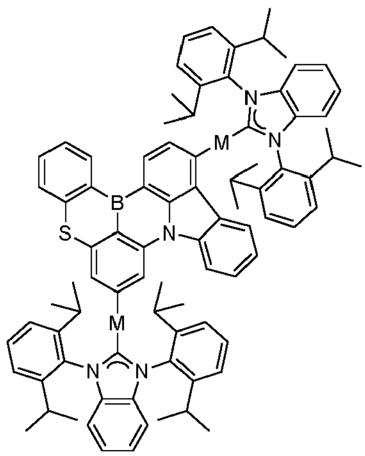
,

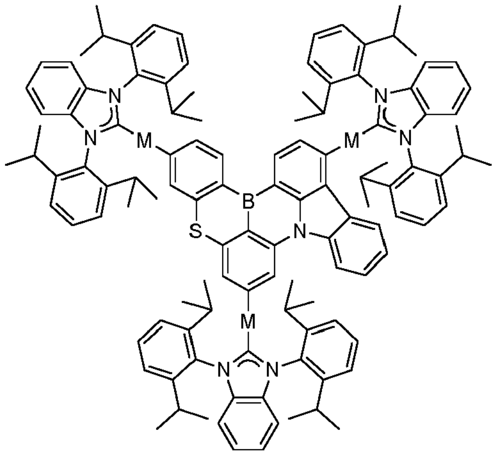

,

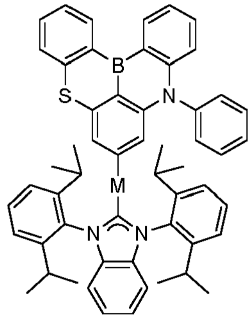

,

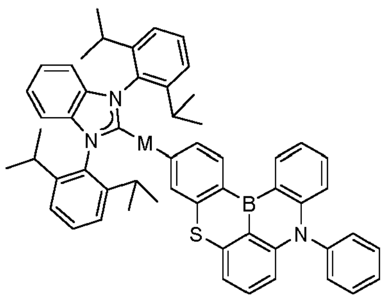

,

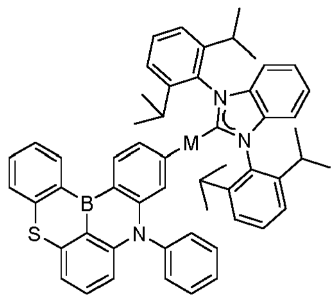

,

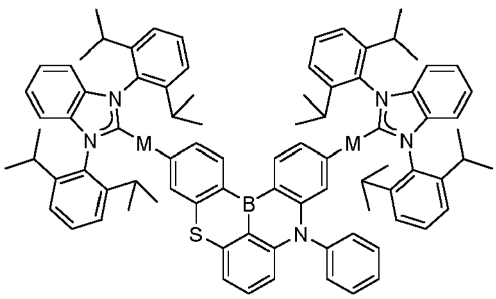

,

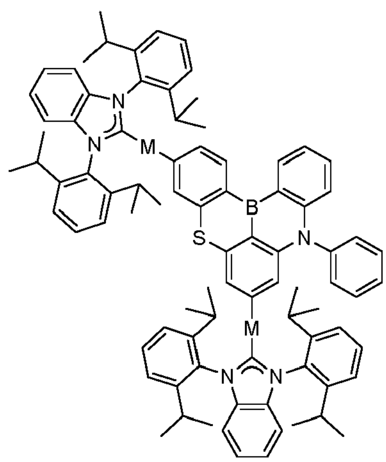

,

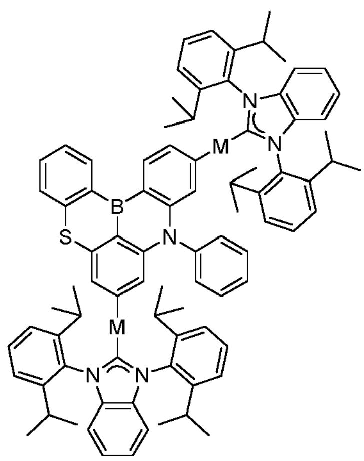

,

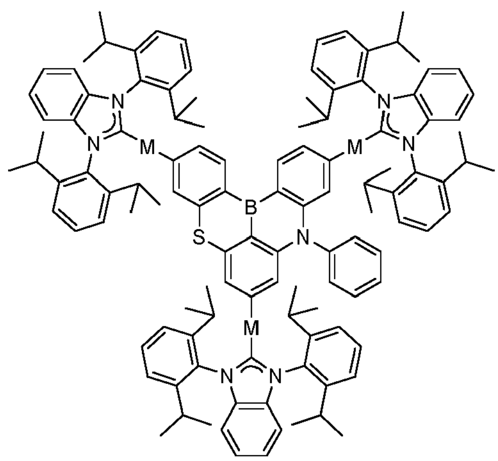

,

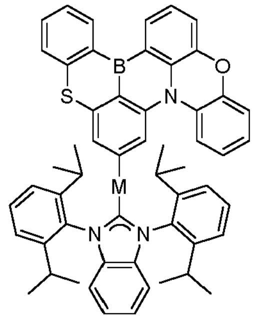,
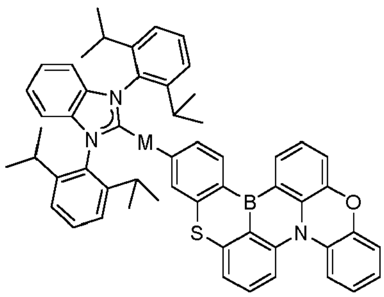,
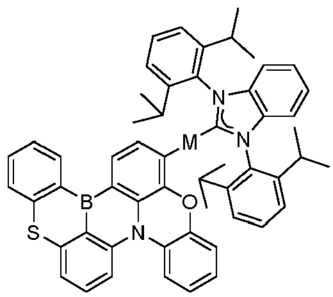,

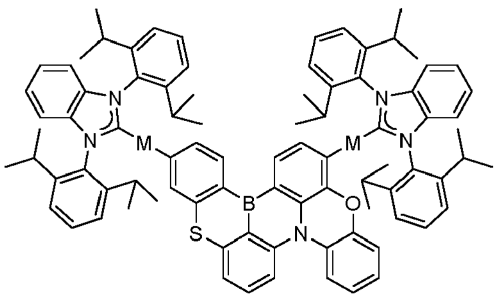,
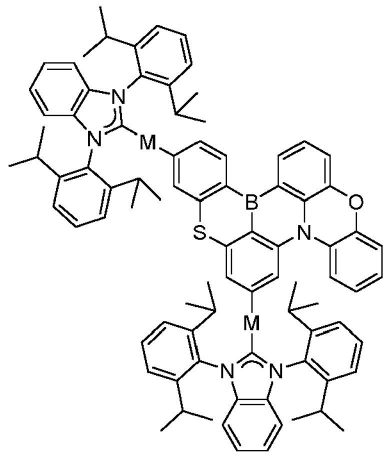,

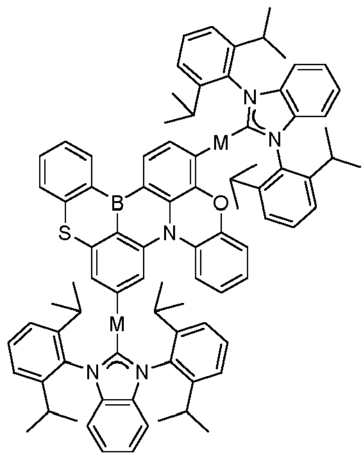,
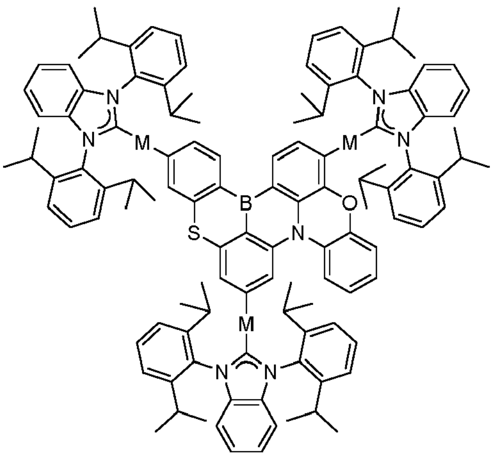,

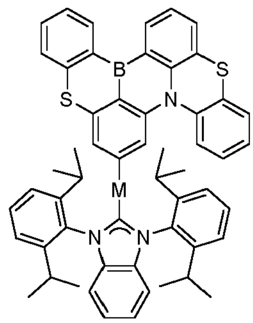,
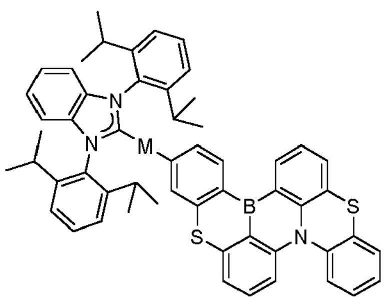,
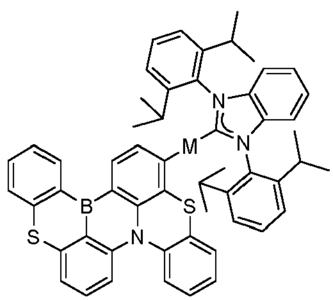,

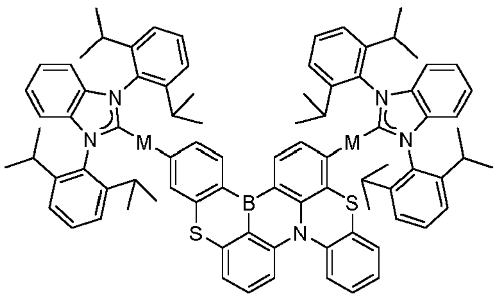

,

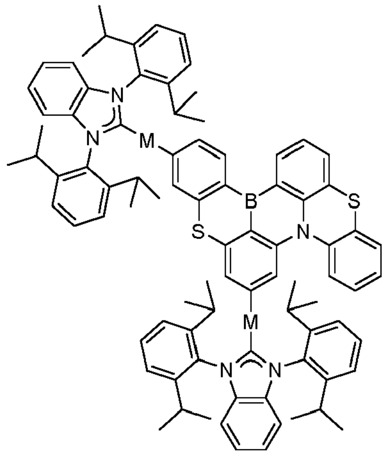

,

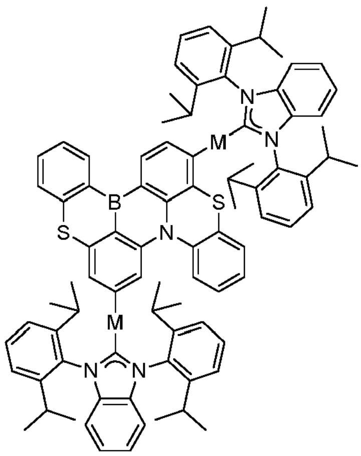

, or

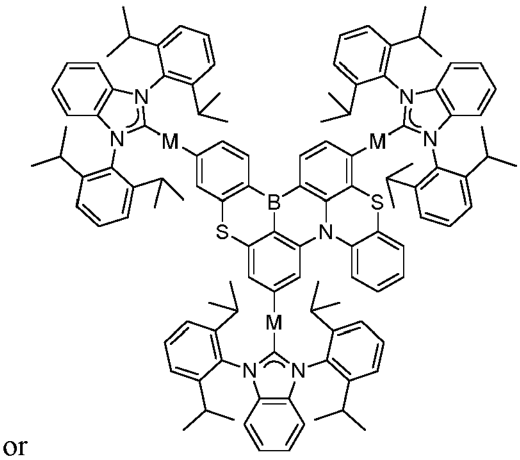

.

28. The compound of any one of paragraphs 1 to 13, wherein Formula I is:

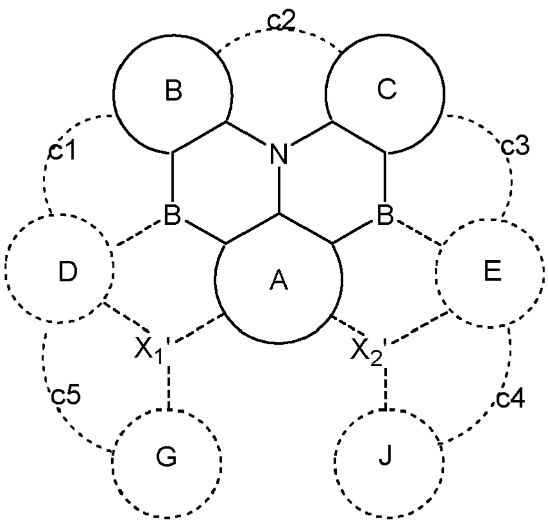


Formula XIII

wherein:

c2 is absent, single bond, -O-, -S-, -Se-, substituted $C_1$-$C_5$ alkyl (such as - $C(Me)_2$-), or unsubstituted $C_1$-$C_5$ alkyl, pairs of c1 and c3, and pairs of c4 and c5 are independently: both absent, both single bonds; single bond and

absent; single bond and substituted $C_1$-$C_5$ alkyl (such as -C(Me)$_2$-); single bond and unsubstituted $C_1$-$C_5$ alkyl; single bond and -O-; single bond and -S-; single bond and -Se-; absent and -S-; absent and - Se-; both substituted $C_1$-$C_5$ alkyl (such as -C(Me)$_2$-); substituted $C_1$-$C_5$ alkyl (such as -C(Me)$_2$-) and -O-; substituted $C_1$-$C_5$ alkyl (such as -C(Me)$_2$-) and -S-; substituted $C_1$-$C_5$ alkyl (such as -C(Me)$_2$-) and -Se-; absent and substituted $C_1$-$C_5$ alkyl (such as -C(Me)$_2$-); absent and -O-; -O- and -O-; -O- and -S-; -O- and - Se-; or -S- and -S-,
D, E, G, and J are independently substituted aryl, unsubstituted aryl, substituted heteroaryl, unsubstituted heteroaryl, or fused combinations thereof; substituted alkyl, or unsubstituted alkyl,
Formula II is datively bonded to at least one of B, C, D, E, G, and J, preferably B, C, D, and E, most preferably D, E, or both, and
preferably, substituted in Formula XIII means substituted with unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, or unsubstituted amine.

29. The compound of any one of paragraphs 1 to 13, or 28, wherein $X_1$' and $X_2$' are nitrogen.
30. The compound of any one of paragraphs 1 to 13, 28, or 29, wherein:

c2 is absent or a single bond,
pairs of c1 and c3 are both absent, and
pairs of c4 and c5 are: both absent; or both single bonds.

31. The compound of any one of paragraphs 1 to 13, or 28 to 30,
wherein D, E, G, and J are independently substituted aryl, unsubstituted aryl, substituted heteroaryl, unsubstituted heteroaryl, or fused combinations thereof.
32. The compound of any one of paragraphs 1 to 13, or 28 to 31, having a structure:

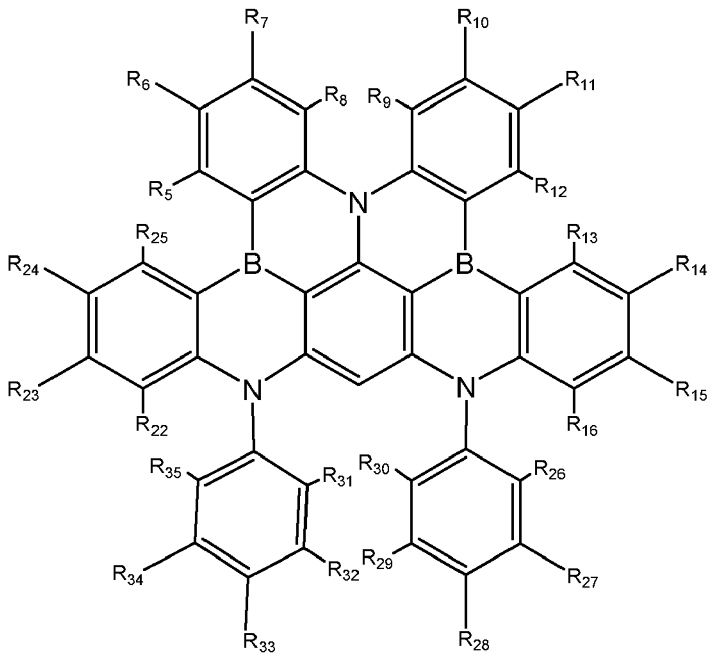

Formula XIV

$R_5$-$R_{16}$, $R_{22}$-$R_{25}$, and $R_{26}$-$R_{35}$, are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, unsubstituted amine, or Formula II, wherein at least one of $R_5$-$R_{16}$, $R_{22}$-$R_{25}$, and $R_{26}$-$R_{35}$ is Formula II, preferably at least one of $R_5$-$R_{16}$ and $R_{22}$-$R_{25}$ is Formula II, most preferably at least one of $R_{13}$-$R_{16}$ and $R_{22}$-$R_{25}$ is Formula II, optionally $R_{25}$ and $R_5$ combine to form c1,

optionally $R_8$ and $R_9$ combine to form c2,
optionally $R_{12}$ and $R_{13}$ combine to form c3,
optionally $R_{16}$ and $R_{26}$ combine to form c4,
optionally $R_{35}$ and $R_{22}$ combine to form c5, or
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 16, and 22 to 35.

33. The compound of any one of paragraphs 1 to 13, or 28 to 32, having a structure:

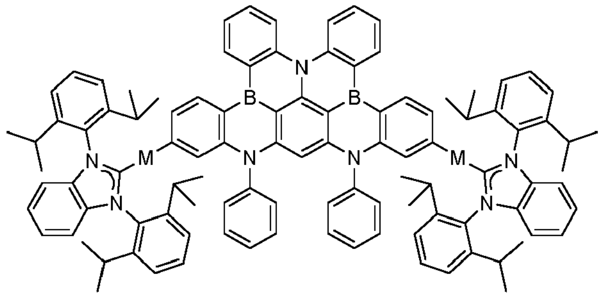

,

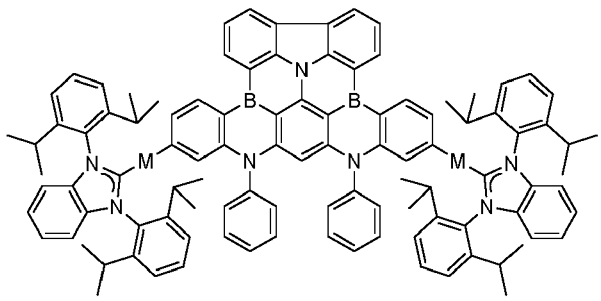

,

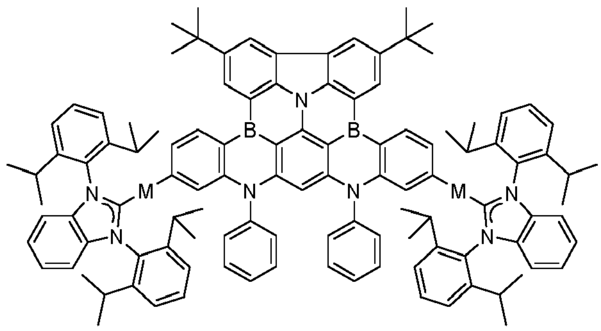

,

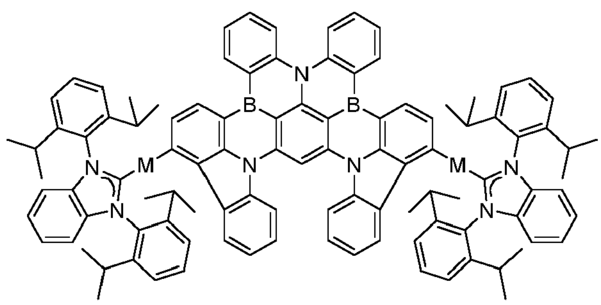

,

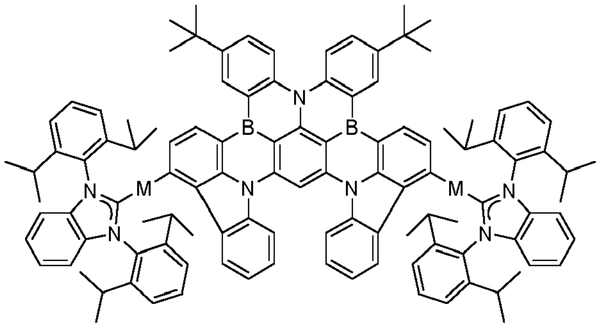

,

or

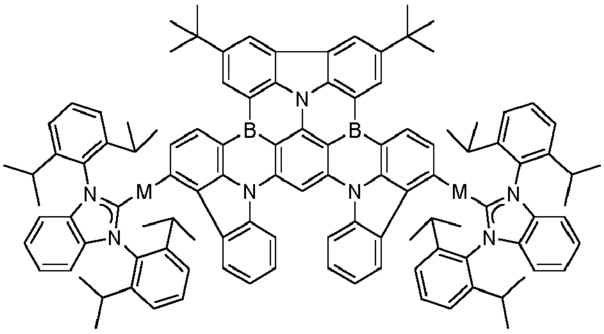

.

34. An organic electronic component containing the compound of any one of paragraphs 1 to 33.
35. The organic electronic component of paragraph 34, wherein the organic electronic component is an organic light-emitting diode (OLED) or a light-emitting electrochemical cell (LEEC).
36. The organic electronic component of paragraph 34 or 35, wherein the compounds are in a light-emitting layer.
37. The organic electronic component of any one of paragraphs 34 to 36, further containing an anode, a cathode, a hole transport region, and an electron transport region,

wherein the hole transport region contains a hole injection layer and/or a hole transport layer, and optionally an electron blocking layer,
wherein the electron transport region contains an electron transport layer and/or an electron injection layer, and optionally a hole blocking layer,
wherein the light emitting layer is located in between the anode and the cathode,
wherein the hole transport region is located between the anode and the light-emitting layer, and wherein the electron transport region is located in between the cathode and the light-emitting layer.

38. The organic electronic component of paragraph 36 or 37, wherein the light-emitting layer is fabricated by vacuum deposition, spin-coating or ink printing (such as, ink-jet printing or roll-to-roll printing).
39. A light-emitting layer containing the compound of any one of paragraphs 1 to 33.
40. An OLED, containing the light-emitting layer of paragraph 39.
41. A device, containing the OLED of paragraph 40, wherein the device is selected from stationary visual display units, mobile visual display units, illumination units, keyboards, clothes, ornaments, garment accessories, wearable devices, medical monitoring devices, wall papers, tablet computers, laptops, advertisement panels, panel display units, household appliances, or office appliances.

## Examples

Acceleration of singlet-triplet intersystem crossings (ISC) is instrumental in bolstering triplet exciton harvesting of multi-resonance thermally activated delayed fluorescent (MR-TADF) emitters. The non-limiting examples describe a gold(I) coordination strategy to enhance the spin-orbit coupling of green and blue BN(O)-based MR-TADF emitters, which results in a notable increase in rate constants of the spectroscopically observed ISC process to $3\times10^9$ $s^{-1}$ with nearly unitary ISC quantum yields. Accordingly, the resultant thermally-stable $Au^I$ emitters attained large values of delayed fluorescence radiative rate constant up to $1.3\times10^5$/$1.7\times10^5$ $s^{-1}$ in THF/PMMA film while preserving narrowband

emissions (FWHM=30-37 nm) and high emission quantum yields (ca. 0.9). The vapor-deposited ultrapure-green OLEDs fabricated with these $Au^I$ emitters delivered high luminance of up to $2.53\times10^5$ cd $m^{-2}$ as well as external quantum efficiencies of up to 30.3% with roll-offs as low as 0.8% and long device lifetimes ($LT_{60}$) of 1210 h at 1000 cd $m^{-2}$.

Multi-resonance thermally activated delayed fluorescent (MR-TADF) compounds based on rigid B- and N-(O-) doped polyaromatic hydrocarbons have rapidly ascended to an important class of organic light-emitting diode (OLED) emitters with practicality since their debut in 2015. [1] In addition to high thermal stability, near unity emission quantum yields and high horizontal transition dipole ratios, this class of emitters features exceptionally narrow emission bands with full-width-at-half-maximum (FWHM) of only 15-40 nm by virtue of the complementary resonance effects of the highest occupied molecular orbital (HOMO) and lowest unoccupied molecular orbital (LUMO) and the nonbonding character around the N-donor atoms (HOMO) and B-acceptor atoms (LUMO), which minimizes the excited state structural reorganization. [2] With the advance of facile color-tuning strategy, [3] high-performance ultrapure-blue, and, more recently, -green and -red MR-TADF-based OLEDs with external quantum efficiencies of 30-40% have been realized.[4]

A major fundamental challenge associated with most MR-TADF emitters is the rate-limiting endergonic reverse intersystem crossing (RISC) step in their excited state dynamics where the moderate singlet-triplet gap ($\Delta E_{ST}$) sizes of 0.1-0.2 eV may impede the efficiency of TADF. [2] For instance, the delayed fluorescence lifetimes ($\tau_{DF}$) of the blue MR-TADF emitters, DABNA-1 [1b] and DtBuCzB[5], were reported to be as long as 94 and 102 μs, respectively. Such long residence times of triplet excitons in MR-TADF emitters usually resulted in pronounced device efficiency roll-offs of over 20% even at a luminance of 100 cd $m^{-2}$ and poor operational stability. In this regard, a sensitization approach, referred to as "hyperfluorescence", has been commonly employed to promote triplet exciton harvesting of MR-TADF emitters. This is accomplished by efficient Förster resonance energy transfer between a highly emissive phosphorescent/TADF sensitizer and a MR-TADF molecule as a terminal emitter to increase the exciton recycling rates. A more direct way is to reduce the $\Delta E_{ST}$ gap of MR-TADF emitters. Recent works showed that extending the π-skeleton of MR-TADF compounds with increased B/N heteroatom doping could narrow the $\Delta E_{ST}$ gap without compromising the S1 oscillator strength, leading to $\tau_{DF}$ as short as 4.1 μs in the blue emitter v-DABNA. [6] Nonetheless, the synthesis of these π-extended polycyclic fused-ring scaffolds is non-trivial and further color-tuning in this endeavor might be hampered.

Besides reducing the $\Delta E_{ST}$ gap, in principle, increasing the spin-orbit coupling (SOC) strength between the singlet and triplet states could also speed up the ISC/RISC processes, which improves the TADF efficiency. The viability of this approach was recently demonstrated by Park and Yasuda et al. by doping heavier sulfur or selenium atom(s) in place of oxygen in the polycyclic BN-scaffold. [7] Although much accelerated ISC/RISC rates were achieved by the enhanced SOC, the $\tau_{DF}$ of non-n-extended mono S- and Se-doped MR-TADF emitters, though considerably reduced, are still unfavorably long (14-30 μs).

In the instant work, it was postulated that integration of MR-TADF emitters with $Au^I$ would enable fast ISC/RISC rate so as to potentially shorten the $\tau_{DF}$ further for highly efficient TADF: (i) the $d^{10}$ electronic configuration of $Au^I$ ensures the resulting complexes exempt from major emission quenching caused by ligand-field excited state(s), and (ii) $Au^I$ has a massive SOC constant of 5100 $cm^{-1}$,[8] which is much larger than its coinage metal congeners, $Cu^I$ (860 $cm^{-1}$) and $Ag^I$ (1760 $cm^{-1}$). Previously, it was shown that the coordination of arylacetylide to $Au^I$-phosphine moiety could effectively switch on organic phosphorescence of the former. [9]

In this non-limiting example, a panel of highly efficient, air- and thermally stable green and blue $Au^I$ MR-TADF emitters featuring a BN(O)-based luminogen covalently linked to the Au-NHC motif via a Au-$C_{aryl}$ bond is provided. Optically transparent (>350 nm) and sterically bulky NHC ancillary ligands were selected in this work to minimize perturbation to MR-TADF emission and to enhance thermal and electrochemical stabilities of the Au emitters. [10] The use of $Au^I$ is conceived to have a distinct, stability advantage over the $Ag^I$ and $Cu^I$ congeners: $Ag^I$-$C_{aryl}$ bond is less stable than $Au^I$-$C_{aryl}$ bond with regard to reductive decomposition to free metal and (NHC)Cu(Ar) complexes were reported to be highly air- and moisture sensitive even in solid state. [11] The amplified SOC brought about by the gold coordination strategy is manifested in the drastic increment of ISC rates of the newly developed $Au^I$ MR-TADF emitters with close-to-unity ISC quantum yields, which leads to remarkable TADF rate constants of up to $1.7\times10^5$ $s^{-1}$ with the retention of high thermal stability, high emission quantum yields (ca. 0.9), and excellent color purity. More importantly, the as-fabricated ultrapure-green $Au^I$ OLEDs attained a high $CIE_y$ coordinate of up to 0.70 and excellent electroluminescence (EL) performance with maximum EQEs reaching 30.3% and exceedingly small roll-offs down to 0.8% alongside long operational lifetimes ($LT_{60}$) of up to 1210 h at a practical luminance of 1000 cd $m^{-2}$.

**Example 1: Metal-assisted multi-resonance thermally-activated delayed fluorescence (MR-TADF) emitters**

*Materials and methods*

All reagents, unless otherwise noted, were used as supplied without further purification. All reagents were purchased from *J&K Scientific Ltd. Co., Tokyo Chemical Industry (TCI), Energy Ltd. Co., or Bide pharmatech Ltd.*

*(i) Synthesis and characterization*

All reactions were strictly performed in $N_2$ atmosphere with the Schlenk technology.

**Scheme 1** shows the synthesis of AuBN-1.

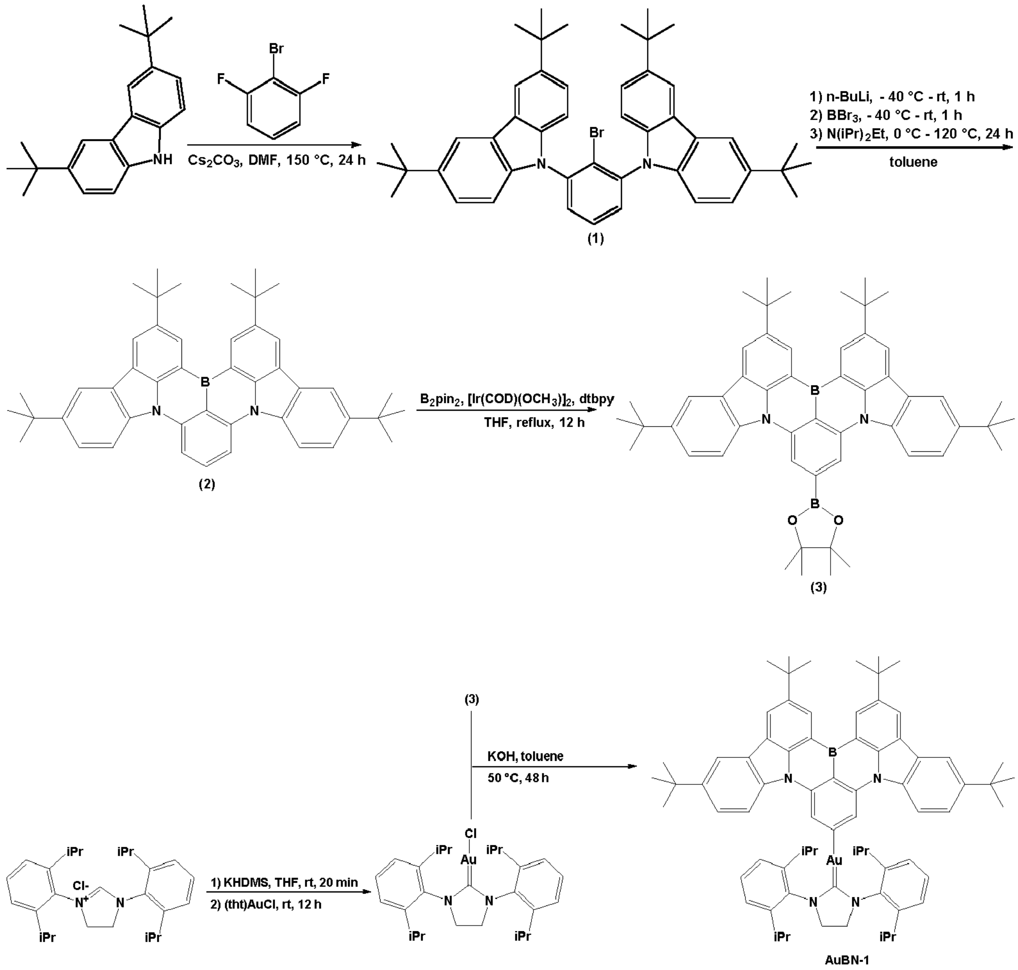


*(a) Synthesis of 9,9'-(2-bromo-1,3 phenylene)bis(3,6-di-tert butyl-9H-carbazole) (1):*

To an oven-dried 250 mL two neck round bottom flask equipped with reflux condenser, 3,6-di-tert-butyl-9H-carbazole (12.29 g, 44 mmol), cesium carbonate (39.10 g, 60 mmol), and 50 mL dry dimethyl formamide (DMF) were added. After stirring for 10 min at room temperature, 2-bromo-1,3-difluorobenzene (3.84 g, 20 mmol) was injected. The mixture was allowed to reflux for 24 hours and then cooled down, forming large amounts of white solid. The mixture was washed with 150 mL water in a sonicator and filtrated using vacuum filter. The crude product was purified by recrystallization in dichloromethane/methanol to afford white solid (14.04 g, 98.6%). $^1H$ NMR (500 MHz, $CDCl_3$) $\delta$/ppm: 8.17 (t, $J$ = 1.6 Hz, 4H), 7.71 - 7.66 (m, 1H), 7.62 (d, $J$ = 7.7 Hz, 2H), 7.52 (dt, $J$ = 8.6, 1.7 Hz, 4H), 7.13 (d, $J$ = 8.5 Hz, 4H), 1.48 (d, $J$ = 1.3 Hz, 36H).

*b) Synthesis of DtBuCzB (2) (*Yang, *et al.*, *J. Am. Chem. Soc.* **2020,** 142, 19468-19472; Xu, *et al., Adv. Mater.* **2021,** *33,* 2100652):

To a solution of **1** (7.12 g, 10 mmol) in 100 mL freshly distilled dry toluene was dropwise added n-BuLi (2.4 M in hexane, 5 mL, 12 mmol) at -40 °C. After stirring at room temperature for 1 hour, the mixture was cooled down to -40 °C again, and $BBr_3$ (2M in dichloromethane, 6 mL, 12 mmol) was slowly added. After the mixture was stirred at room temperature for 1 hour, N,N-diisopropylethylamine (N($i$Pr)$_2$Et) (2.58 g, 20 mmol) was added at 0 °C. The orange mixture was then heated to reflux for 24 hours. Cooled down the obtained yellow mixture to room temperature, carefully quenched by addition of water, and extracted with ethyl acetate three times. The combined organic layer was dried by anhydrous

sodium sulfate ($Na_2SO_4$), concentrated in vacuum, and purified by column chromatography on silica gel (eluent: dichloromethane/hexane) to obtain yellow solid (2.56 g, 40%). $^1$H NMR (500 MHz, $CDCl_3$) $\delta$/ppm: 9.13 (d, *J* = 1.8 Hz, 2H), 8.47 (d, *J* = 1.5 Hz, 2H), 8.39 (dd, *J* = 9.0, 3.3 Hz, 2H), 8.32 (d, *J*= 8.5 Hz, 2H), 8.26 (d, *J* = 1.5 Hz, 2H), 8.00 (t, *J* = 8.7 Hz, 1H), 7.65 (dd, *J* = 8.8, 1.6 Hz, 2H), 1.67 (d, *J* = 1.3 Hz, 18H), 1.53 (d, *J* = 1.3 Hz, 18H).

*(c) Synthesis of DtBuCzB-Bpin (3) (Xu, et al., Adv. Mater.* **2021,** *33,* 2100652*):*

An oven-dried 50 mL two neck round bottom flask was charged with **2** (0.42 g, 0.65 mmol), bis(pinacolato)diboron ($B_2pin_2$) (0.168 g, 0.66 mmol), and 10 mL freshly distilled dry tetrahydrofuran (THF). 4,4'-Di-tert-butyl-2,2'-bipyridine (dtbpy) (34.9 mg, 0.13 mmol) and (1,5-cyclooctadiene)(methoxy)iridium(I) dimer ([Ir(COD)($OCH_3$)]$_2$) (43.1 mg, 0.065 mmol) were added to the flask. The obtained black mixture was allowed to reflux for 12 hours. After cooling down to room temperature, the reaction mixture was concentrated in vacuum and purified by column chromatography on silica gel (eluent: ethyl acetate/hexane = 1/5 - 1/2) to afford yellow solid (0.40 g, 80%). $^1$H NMR (500 MHz, $CDCl_3$) $\delta$/ppm: 9.14 (s, 2H), 8.79 (s, 2H), 8.54 (d, *J* = 8.8 Hz, 2H), 8.48 (d, *J* = 1.8 Hz, 2H), 8.27 (t, *J* = 1.6 Hz, 2H), 7.74 (dt, *J* = 8.8, 1.7 Hz, 2H), 1.68 (s, 18H), 1.55 (s, 18H), 1.50 (s, 12H).

*(d) Synthesis of (1,3-bis(2, 6-diisopropylphenyl)imidazolidin-2-ylidene)gold(I) chloride (4):*

An oven-dried 50 mL two neck round bottom flask was charged with 1,3-bis(2,6-diisopropylphenyl)imidazolium chloride (0.43 g, 1 mmol) and 10 mL freshly distilled dry THF. Potassium bis(trimethylsilyl)amide (KHMDS) (1 M in THF, 1.2 mL, 1.2 mmol) was dropwise added at 0 °C. The mixture was warmed to room temperature and stirred for 20 minutes. Chloro(tetrahydrothiophene)gold(I) (0.384 g, 1.2 mmol) was then added to the flask and the mixture was stirred at room temperature for 12 hours. The mixture was directly concentrated in vacuum and then the residue was dissolved in dichloromethane. The mixture was filtrated to remove the black particles, followed by recrystallization in dichloromethane/methanol to obtain a white solid (0.23 g, 37%). $^1$H NMR (300 MHz, $CDCl_3$) $\delta$/ppm: 7.41 (t, *J* = 7.7 Hz, 2H), 7.23 (d, *J* = 7.7 Hz, 4H), 4.04 (s, 4H), 3.05 (p, *J* = 6.9 Hz, 4H), 1.42 (d, *J* = 6.8 Hz, 12H), 1.34 (d, *J* = 6.9 Hz, 12H).

*(e) Synthesis of AuBN-1:*

**3** (76.7 mg, 0.1 mmol), **4** (74.8 mg, 0.12 mmol), and potassium hydroxide (KOH) (8.4 mg, 0.15 mmol) were dissolved in 5 mL freshly distilled dry toluene in an oven-dried 20 mL Schlenk tube. The mixture was stirred at 50 °C for 48 hours. A yellow mixture was obtained, and was directly filtrated through a celite pad and washed with dichloromethane. The combined organic filtrate was concentrated in vacuum. Recrystallization in dichloromethane/hexane gave a yellow solid (76 mg, 62%) as product. $^1$H NMR (500 MHz, $CDCl_3$) $\delta$/ppm: 9.03 (d, *J* = 2.0 Hz, 2H), 8.37 (d, *J* = 1.9 Hz, 2H), 8.20 (d, *J* = 2.1 Hz, 2H), 8.15 (d, *J* = 8.8 Hz, 2H), 8.09 (s, 2H), 7.51 (d, *J* = 8.9 Hz, 2H), 7.47 (t, *J* = 7.7 Hz, 2H), 7.34 (d, *J* = 7.8 Hz, 4H), 4.13 (s, 4H), 3.29 (p, *J* = 6.8 Hz, 4H), 1.67 (d, *J* = 6.6 Hz, 12H), 1.62(s, 18H), 1.55 (s, 18H), 1.44(d, *J* = 7.0 Hz, 12H). $^{13}$C NMR (101 MHz, $CDCl_3$) $\delta$ 215.79, 177.74, 146.99, 144.05, 143.53, 142.25, 141.67, 138.68, 134.82, 129.79, 129.61, 126.86, 124.57, 123.52, 123.29, 120.33, 119.93, 116.93, 114.49, 54.01, 35.18, 34.81, 32.36, 32.08, 29.25, 25.46, 24.26. HRMS (ESI) for $C_{73}H_{86}AuBN_4$ [M+H]$^+$: calcd 1227.6684, found 1227.6680.

*(f) Photophysical measurements*

AuBN-2 to AuBN-6 were synthesized based on the method for AuBN-1. AuBN-2: $^1$H NMR (400 MHz, $CDCl_3$) $\delta$ 9.06 (d, *J* = 1.9 Hz, 2H), 8.39 (d, *J* = 1.8 Hz, 2H), 8.26 - 8.16 (m, 6H), 7.64 (t, *J* = 7.8 Hz, 2H), 7.54 (dd, *J* = 8.8, 2.1 Hz, 2H), 7.48 (d, *J* = 7.8 Hz, 4H), 7.45 (dd, *J* = 6.1, 3.1 Hz, 2H), 7.19 (dd, *J* = 6.0, 3.1 Hz, 2H), 2.63 (hept, *J* = 6.8 Hz, 4H), 1.64 (s, 18H), 1.58 (d, *J* = 8.0 Hz, 12H), 1.56 (s, 18H), 1.21 (d, *J* = 6.9 Hz, 12H). $^{13}$C NMR (101 MHz, $CDCl_3$) $\delta$/ppm: 202.29, 177.41, 146.86, 144.11, 143.60, 142.37, 141.70, 138.71, 135.31, 131.92, 130.85, 129.65, 126.91, 125.07, 124.62, 123.55, 123.32, 120.37, 119.98, 116.98, 114.50, 111.93, 35.20, 34.82, 32.37, 32.07, 29.21, 25.01, 24.07. HRMS (ESI) for $C_{77}H_{86}AuBN_4$ [M+H]$^+$: calcd 1275.6684, found 1275.6684.

AuBN-3: $^1$H NMR (400 MHz, $CDCl_3$) $\delta$ 9.06 (d, *J* = 1.9 Hz, 2H), 8.40 (d, *J* = 1.8 Hz, 2H), 8.26 - 8.16 (m, 6H), 7.60 - 7.49 (m, 4H), 7.40 (d, *J* = 7.8 Hz, 4H), 2.81 (hept, *J* = 6.9 Hz, 4H), 1.65 (s, 18H), 1.61 (d, *J* = 6.8 Hz, 12H), 1.57 (s, 18H), 1.34 (d, *J* = 6.9 Hz, 12H). $^{13}$C NMR (101 MHz, $CDCl_3$) $\delta$ 196.05, 177.49, 146.01, 144.07, 143.57, 142.35, 141.70, 138.72, 134.70, 130.52, 129.63, 126.89, 124.25, 123.54, 123.31, 123.12, 120.43, 119.94, 116.95, 114.50, 35.19, 34.82, 32.37, 32.08, 29.07, 24.90, 24.13. HRMS (ESI) for $C_{73}H_{84}AuBN_4$ [M+H]$^+$: calcd 1225.6528, found 1225.6532.

AuBN-4: $^1$H NMR (400 MHz, $CDCl_3$) $\delta$ 9.07 (d, *J* = 1.9 Hz, 2H), 8.59 (s, 2H), 8.41 (d, *J* = 1.8 Hz, 2H), 8.24 (d, *J* = 2.1 Hz, 2H), 8.22 (s, 2H), 8.17 (s, 2H), 7.72 (t, *J* = 7.8 Hz, 2H), 7.59 - 7.51 (m, 6H), 2.58 (hept, *J* = 6.9 Hz, 4H), 1.65 (s, 18H), 1.58 -1.60 (m, 30H), 1.24 (d, *J* = 6.9 Hz, 12H). $^{13}$C NMR (101 MHz, $CDCl_3$) $\delta$ 208.94, 175.97, 146.58, 144.24, 143.73, 142.42, 141.70, 141.06, 140.64, 138.67, 131.48, 130.54, 129.70, 126.97, 124.72, 123.56, 123.36, 120.18,

120.08, 117.05, 114.43, 35.21, 34.83, 32.37, 32.07, 29.75, 24.78, 23.95. HRMS (ESI) for $C_{75}H_{84}AuBN_6$ $[M+H]^+$: calcd 1277.6589, found 1277.6611.

AuBN-5: $^1$H NMR (400 MHz, $CDCl_3$) $\delta$/ppm: 8.92 (d, $J$ = 1.9 Hz, 1H), 8.71 (d, $J$ = 2.4 Hz, 1H), 8.38 (d, $J$ = 1.8 Hz, 1H), 8.21 (d, $J$ = 2.1 Hz, 1H), 8.13 (d, $J$ = 8.8 Hz, 1H), 8.01 (s, 1H), 7.69 (d, $J$ = 2.4 Hz, 1H), 7.63 (t, $J$ = 7.8 Hz, 2H), 7.58 (dd, $J$ = 8.8, 2.1 Hz, 1H), 7.46 (d, $J$ = 7.8 Hz, 4H), 7.43 (dd, $J$ = 6.1, 3.1 Hz, 2H), 7.22 - 7.10 (m, 3H), 2.60 (hept, $J$ = 6.8 Hz, 4H), 1.62 (s, 9H), 1.60 (s, 9H), 1.57 (s, 9H), 1.52 (d, $J$ = 6.8 Hz, 12H), 1.50 (s, 9H), 1.18 (d, $J$ = 6.9 Hz, 12H). $^{13}$C NMR(101 MHz, $CDCl_3$) $\delta$/ppm: 202.07, 178.73, 157.14, 156.32, 146.69, 143.90, 143.38, 142.80, 142.12, 140.23, 138.38, 137.24, 135.19, 131.82, 130.71, 129.37, 128.43, 127.56, 126.50, 124.90, 124.49, 123.53, 123.46, 120.15, 119.90, 119.11, 116.69, 114.14, 111.80, 35.33, 35.04, 34.71, 34.64, 32.21, 31.97, 31.72, 30.40, 29.06, 24.82, 23.92. HRMS (ESI) for $C_{71}H_{83}AuBN_3O$ $[M+H]^+$: calcd 1202.6367, found 1202.6388.

AuBN-6: $^1$H NMR (400 MHz, $CDCl_3$) $\delta$/ppm 9.06 (d, $J$ = 1.9 Hz, 2H), 8.59 (dd, $J$ = 4.8, 1.4 Hz, 1H), 8.40 (d, $J$ = 1.8 Hz, 2H), 8.25 - 8.16 (m, 6H), 7.70 (t, $J$ = 7.8 Hz, 1H), 7.60 (dd, $J$ = 8.1, 1.4 Hz, 1H), 7.58 - 7.51 (m, 4H), 7.43 (dd, $J$ = 8.1, 4.8 Hz, 1H), 7.32 (s, 2H), 3.06 (hept, $J$ = 7.0 Hz, 1H), 2.60 (dp, $J$ = 10.3, 6.8 Hz, 4H), 1.64 (s, 18H), 1.57 (d, $J$ = 2.3 Hz, 30H), 1.37 (d, $J$ = 6.9 Hz, 6H), 1.22 (t, $J$ = 7.4 Hz, 12H). $^{13}$C NMR (101 MHz, $CDCl_3$) $\delta$/ppm 205.15, 176.97, 151.67, 147.29, 146.69, 146.52, 146.31, 144.15, 143.65, 142.39, 141.70, 138.71, 131.20, 131.05, 129.66, 129.12, 128.01, 126.93, 124.53, 123.61, 123.35, 122.66, 120.31, 120.00, 116.98, 114.46, 35.20, 34.83, 34.66, 32.37, 32.07, 29.85, 29.59, 29.37, 25.09, 24.81, 24.21, 24.16, 23.90. HRMS-ESI: m/z calcd 1318.7106 $[M+H]^+$; found 1318.7127.

*(g) Photophysical measurements*

All solvents for photophysical measurements were of HPLC grade. Absorption spectra were recorded on a Hewlett-Packard 8453 diode array spectrophotometer at room temperature. Emission spectra were obtained on a Horiba Fluorolog-3 spectrophotometer. Emission quantum yields ($\Phi$) in solution and thin films were measured with Hamamatsu C11347 Quantaurus-QY Absolute PL quantum yields measurement system. For absorption and emission measurement, the concentration of the solution was $2\times10^{-5}$ mol $dm^{-3}$. Solutions for photophysical measurements were degassed by using a high vacuum line in a two-compartment cell with five freeze-pump-thaw cycles. The thin-film samples were prepared by drop-cast from a chlorobenzene solution containing 5 wt % of Au(I) complex with mCP or PPF as hosts.

*(h) OLED fabrication*

*(i) Materials*

HAT-CN, FSFA, FSF4A, DMIC-Cz, DMIC-TRz, ANT-BIZ, and Liq were purchased from Luminescence Technology Corp, Aluminum Pellets from Kurt J. Lesker. All of these materials were used as received.

*(ii) Device Fabrication and Characterization*

OLEDs were fabricated in a Kurt J. Lesker SPECTROS vacuum deposition system with a base pressure of $10^{-8}$ mbar. In the vacuum chamber, organic materials were thermally deposited in sequence at a rate of $\approx$0.1 nm $s^{-1}$. The doping process in the emitting layer was realized by co-deposition technology. Afterward, Liq (2 nm) and A1 (100 nm) were thermally deposited at rates of 0.03 and 0.2 nm $s^{-1}$, respectively. Film thicknesses were determined *in situ* using calibrated oscillating quartz crystal sensors.

EL spectra, luminance, CIE coordinates, EQE, and CE were measured using a Keithley 2400 source-meter and an absolute external quantum efficiency measurement system (C9920-12, Hamamatsu Photonics). All devices were characterized at room temperature after encapsulation in a 200-nm-thick $Al_2O_3$ thin film deposited by atomic layer deposition (ALD) in a Kurt J. Lesker SPECTROS ALD system.

*Results*

The photophysical properties of BN ligand and Au(I) MR-TADF emitters in solutions and films are characterized. These compounds have shown a narrow emission bandwidth with full width at half maximum (FWHM) of 22 to 41 nm at room temperature. Compared to BN ligand, AuBN-1 and AuBN-2 have shown shorter emission lifetimes, attributed to the coordination of metal ion which accelerates both intersystem crossing and reverse intersystem crossing processes between the singlet and triplet excited states.

*Photophysical characterization of the MR-TADF emitters*

**Table 1. Summary of photophysical data for BN.**

| Medium ($T^{a)}$ [K]) | $\lambda_{abs}$ [nm] ($\varepsilon_{max}$[$dm^3$ $mol^{-1}$ $cm^{-1}$]) | $\lambda_{em}$ [nm] ($\tau_{PF}$ [ns]/$\tau_{DF}$ [$\mu$s]) | FWHM [nm] | $\Phi$ |
|---|---|---|---|---|
| THF (298) | 264 (81.9), 278 (51.2), 324 (18.5), 375 (3.2), 466 (62.4) | 490 (5.5/152.1) | 26 | 0.86 |
| 1 wt% in (298) | | 505 (13.8/114.0) | 45 | 0.93 |

**Table 2. Summary of photophysical data for AuBN-1 and AuBN-2.**

| Emitter | Medium (T [K]) | $\lambda_{abs}$ [nm] ($\varepsilon_{max}$ [$dm^3$ $mol^{-1}$ $cm^{-1}$]) | $\lambda_{em}$ [nm] ($\tau_o$ [$\mu$s]) | FWHM [nm] | $\Phi$ |
|---|---|---|---|---|---|
| **AuBN-1 (SIPr) AuBN** | THF (298) | 288 (47.7), 316 (25.2), 359 (4.3), 378 (2.4), 483 (48.2) | 511 (7.9) | 30 | 0.88 |
| | 2 wt% in PMMA (298) | | 515 (5.5) | 37 | 0.92 |
| **AuBN-2 (BzIPr) AuBN** | THF (298) | 289 (47.1), 319 (26.6), 359 (4.7), 378 (2.6), 486 (45.6) | 511 (6.9) | 30 | 0.86 |
| | 2 wt% in PMMA (298) | | 513 (5.5) | 37 | 0.91 |

**Table 3.** Summary of photophysical data for **AuBN-3, AuBN-4, AuBN-5,** and **AuBN-6.**

| Emitter | Medium (T [K]) | $\lambda_{abs}$ [nm] ($\varepsilon_{max}$ [$dm^3$ $mol^{-1}$ $cm^{-1}$]) | $\lambda_{em}$ [nm] ($\tau_o$ [$\mu$s]) | FWHM [nm] | $\Phi$ |
|---|---|---|---|---|---|
| **AuBN-3 (IPr) AuBN** | THF (298) | 290 (53.5), 317 (28.3), 360 (4.3), 378 (2.4), 484 (38.7) | 511 (7.2) | 31 | 0.83 |
| | 2 wt% in PMMA (298) | | 514 (5.8) | 37 | 0.90 |
| **AuBN-4 (PzIPr) AuBN** | THF (298) | 290 (47.5), 321 (48.4), 362 (9.72), 379 (5.8), 486 (46.7) | 510 (6.5) | 30 | 0.78 |
| | 2 wt% in PMMA (298) | | 514 (5.6) | 37 | 0.87 |
| **AuBN-5 (BzIPr) AuBNO** | THF (298) | 288 (58.1), 316 (38.1), 333 (16.1), 346 (5.6), 448 (27.3) | 471 (27) | 31 | 0.89 |
| | 2 wt% in PMMA (298) | | 473 (22.8) | 37 | 0.84 |
| AuBN-6 **(PyIPr) AuBN** | THF (298) | 298 (52.1), 319 (35.4), 360 (4.81), 378 (2.3), 486 (44.1) | 511 (7.3) | 30 | 0.93 |
| | 2 wt% in PMMA (298) | | 514 (5.9) | 37 | 0.88 |

**Table 4.** Summary of performance of OLEDs based on **BN, AuBN-1, AuBN-2, AuBN-3, AuBN-4,** and **AuBN-6.**

| Emitter | $\lambda_{EL}$[a)] [nm] | FWH [nm] | CIE[c)] [(x, y)] | $L_{max}$[e)] [cd $m^{-2}$] | CE[f)] [cd $A^{-1}$] | PE[g)] [lm $W^{-1}$] | EQE[h)] [%] | EQE roll-[%] |
|---|---|---|---|---|---|---|---|---|
| 0.5 wt% **BN** | 488 | 30 | (0.12, 0.43) | 34500 | 24.4/15.3 /7.51 | 30.6/10.7 /2.21 | 11.9/7.43 /3.65 | 37.6/69.3 |
| 1 wt% **BN** | 489 | 30 | (0.12, 0.45) | 24500 | 28.5/16.2 /6.89 | 35.8/11.3 /1.95 | 13.6/7.75 /3.28 | 43.0/75.9 |

(continued)

| Emitter | $\lambda_{EL}$[a] [nm] | FWH [nm] | CIE[c] [(x, y)] | $L_{max}$[e] [cd $m^{-2}$] | CE[f] [cd $A^{-1}$] | PE[g] [lm $W^{-1}$] | EQE[h] [%] | EQE roll-[%] |
|---|---|---|---|---|---|---|---|---|
| 2 wt% **BN** | 490 | 31 | (0.11, 0.46) | 13800 | 9.79/6.81 /3.53 | 12.3/3.56 /0.88 | 4.59/3.19 /1.66 | 30.5/63.8 |
| wt%)[i] (1 | 488[i] | 29[i] | (0.10, 0.42)[i] | 6930[i] | 43.2/-/-[i] | | 21.6/5.3/ | 75.4/-[i] |
| 0.5 wt% **AuBN-1** | 511 | 40 | (0.20, 0.69) | 253000 | 86.1/84.4 /69.7 | 118.2/94. 6/49.8 | 24.8/24.3 /20.1 | 2.0/18.9 |
| 1 wt% **AuBN-1** | 514 | 40 | (0.21, 0.69) | 251000 | 83.3/81.4 /69.1 | 109.2/92. 5/49.3 | 23.6/23.0 /19.5 | 2.5/17.4 |
| 2 wt% **AuBN-1** | 517 | 41 | (0.22, 0.69) | 231000 | 80.1/77.6 /67.3 | 103.2/81. 2/41.6 | 21.9/21.2 /18.4 | 3.2/15.9 |
| 0.5 wt% **AuBN-2** | 506 | 32 | (0.16, 0.69) | 157000 | 71.9/61.1 /41.1 | - | 24.7/21.0 /14.1 | 14.9/42.9 |
| 1 wt% **AuBN-2** | 508 | 34 | (0.18, 0.70) | 172000 | 85.2/76.2 /52.9 | - | 28.3/25.2 /17.6 | 10.9/37.8 |
| 2 wt% **AuBN-2** | 510 | 34 | (0.18, 0.70) | 216000 | 97.1/89.9 /70.4 | - | 30.3/28.1 122.2 | 7.3/26.7 |
| 4 wt% **AuBN-2** | 513 | 34 | (0.18, 0.70) | 207000 | 82.7/82.0 /72.3 | - | 24.8/24.6 /21.7 | 0.8/12.5 |
| 0.5 wt% **AuBN-3** | 509 | 35 | (0.16, 0.66) | 117000 | 74.0/62.0 /42.1 | - | 24.0/20.2 /13.6 | 15.8/43.3 |
| 1 wt% **AuBN-3** | 509 | 35 | (0.16, 0.67) | 126000 | 73.8/69.1 /46.2 | - | 23.3/21.9 /14.6 | 6.0/37.3 |
| 2 wt% **AuBN-3** | 511 | 35 | (0.17, 0.69) | 180000 | 72.2/67.2 /56.2 | - | 21.8/20.4 /17.0 | 6.4/22.0 |
| 1 wt% **AuBN-4** | 511 | 38 | (0.20, 0.65) | 166000 | 75.8/71.3 /49.8 | - | 23.5/22.2 /15.4 | 5.5/34.5 |
| 2 wt% **AuBN-4** | 513 | 38 | (0.21, 0.67) | 170000 | 79.3/74.3 /54.1 | - | 23.8/22.2 /16.2 | 6.7/31.9 |
| 4 wt% **AuBN-4** | 515 | 39 | (0.22, 0.67) | 192000 | 82.8/79.7 /59.8 | - | 24.0/23.1 /17.2 | 3.8/28.3 |
| 1 wt% **AuBN-6** | 512 | 37 | (0.18, 0.69) | 151000 | 93.5/69.3 /56.7 | - | 27.6/20.5 /16.6 | 25.7/36.2 |
| 2 wt% **AuBN-6** | 516 | 38 | (0.19, 0.70) | 184000 | 96.1/83.9 /69.4 | - | 27.3/23.8 /19.7 | 12.8/27.8 |
| 4 wt% **AuBN-6** | 517 | 39 | (0.20, 0.70) | 173000 | 94.5/83.0 /71.2 | - | 26.2/23.9 /19.7 | 8.7/24.8 |

[a] EL wavelength; [b] Full width at half maximum; [c] Commission International de L'Eclairage (CIE) coordinate; [d] Maximum luminance; [e] Current efficiency maximum/at 1000 cd $m^{-2}$/at 10000 cd $m^{-2}$; [f] Power efficiency maximum/at 1000 cd $m^{-2}$/at 10000 cd $m^{-2}$; [g] External quantum efficiency maximum/at 1000 cd $m^{-2}$/at 10000 cd $m^{-2}$; [h] EQE roll-offs at 1000 cd $m^{-2}$/at 10000 cd $m^{-2}$; [i] Extracted from reference 5.

The devices based on AuBN-1 and AuBN-2 have shown better performance with superior brightness and efficiencies, than those based on BN ligand. The device stability is also significantly enhanced with $LT_{95}$ extended by more than 5-fold at 100 cd $m^{-2}$.

**Table 5.** Comparison of operational lifetimes of OLEDs doped with 1 wt% **BN, AuBN-1, AuBN-2.**

| Emitter | $L_0$ a) [cd $m^{-2}$] | $LT_{95}$ b) [hours] | | | $LT_{70}$ b) [hours] | | | $LT_{60}$ b) [hours] | | |
|---|---|---|---|---|---|---|---|---|---|---|
| | | at $L_0$ | at 1000 cd $m^{-2}$ | at 100 cd $m^{-2}$ | at $L_0$ | at 1000 cd $m^{-2}$ | at 100 cd $m^{-2}$ | at $L_0$ | at 1000 cd $m^{-2}$ | at 100 cd $m^{-2}$ |
| **BN** | 1400 | 10.5 | 17.6 | 595 | 201 | 336 | 11400 | | | |
| **AuBN-1** | 18500 | 0.248 | 47.4 | 2990 | 2.94 | 561 | 35400 | 5.17 | 987 | 62300 |
| **AuBN-2** | 29000 | 0.117 | 50.2 | 3170 | 1.52 | 652 | 41100 | 2.82 | 1210 | 76300 |

a) Initial luminance. b) $LT_{95}/LT_{70}/LT_{60}$ at luminance of 1000 cd $m^{-2}$ and 100 cd $m^{-2}$ were estimated by using the formula $LT(L_1) = LT(L_0)\times(L_0/L_1)^n$ where $L_0$ refers to initial luminance and $L_1$ refers to desired luminance; n is obtained by fitting $LT_{60}$ versus different $L_0$, where n = 1.53, 1.80, and 1.80 for **BN, AuBN-1,** and **AuBN-2,** respectively.

As illustrated by this non-limiting series of emitters, while high emission quantum yield and color purity are preserved, the coordination of Au(I)-NHC moiety to **BN,** as in **AuBN-1** and **AuBN-2,** results in a marked reduction of radiative lifetime of TADF by up to 20-folds at room temperature with the prompt fluorescence vanishing or significantly attenuated due to the significant acceleration of intersystem crossing and reversed intersystem crossing processes. With the same device structure, vapor-deposited OLEDs based on **AuBN-1** or **AuBN-2** showed superior device performances in terms of EQE, luminance and efficiency roll-off at 1000 cd $m^{-2}$, which respectively attained values of up/down to 26.1%, 240,000 cd $m^{-2}$ and 0.4%, *i.e.,* EQE and luminance are up to 26.1% and 240,000 cd $m^{-2}$, respectively, while efficiency roll-off is down to 0.4%, such as with an OLED containing AuBN-2. As noted above, both OLEDs based on AuBN-1 and AuBN2 showed superior device performances. More importantly, the device lifetimes of these metal-assisted MR-TADF emitters were extended by more than 5-folds compared to that of **BN** in the preliminary tests.

Compound BN was reported previously[5] while BNO is newly prepared in this work. Five bulky NHC ligands with N-substituted 2,6-di-isopropylphenyl (DIPP) and/or 2,4,6-triisopropylphenyl groups (TIPP), namely, SIPr; IPr; BzIPr; PyIPr; and PzIPr, were employed in this work as the ancillary ligand for $Au^I$ to generate **AuBN-1; AuBN-3; AuBN-2** and **AuBN-5; AuBN-6;** and **AuBN-4,** respectively. The (NHC)AuBN(O) complexes were synthesized by coupling reaction between pinacol ester-activated BN(O) precursor[12] and (NHC)AuCl complex and were obtained as pale yellow or yellow solids in high yields (81-87%). All these new $Au^I$ MR-TADF complexes were characterized by $^1H$ NMR, $^{13}C$ NMR, high-resolution mass spectrometry, elemental analysis, and single crystal X-ray diffraction[13].

All (NHC)AuBN complexes **(AuBN-1, AuBN-3, AuBN-2, AuBN-6,** and **AuBN-4)** and (BzIPr)AuBNO **(AuBN-5)** show a characteristic de-shielding $^{13}C$(Au-CBN(O)) NMR signal at 176.0-178.7 ppm (vs 133.2-134.0 ppm for BN and BNO) in $CDCl_3$, revealing a strong electron-inductive effect of the gold(I) ion. Depending on the electronic property of NHC ligands, the $^{13}C(Au-C_{NHC})$ resonances are located at 196.1- 215.8 ppm. For cyclic voltammetry (CV) in DMF, the complexes show an irreversible/quasi-reversible reduction with $E_{pc}$ or $E_{1/2}$ from 1.72 to 1.41 V (vs SCE) for (NHC)AuBN congeners and at 1.80 V for (BzIPr)AuBNO **(AuBN-5).** An irreversible oxidation wave was observed for all complexes with $E_{pa}$ of 0.85-0.95 V. In general, structural change of NHC ligand (except for PzIPr, in the **AuBN-4)** complex) only slightly modifies the reduction and oxidation potentials. As the redox profiles of $Au^I$ complexes resemble their organic counterparts BN and BNO, both oxidation and reduction are tentatively assigned to be BN(O)-centered. Overall, gold(NHC) coordination stabilizes the BN(O)-based HOMO and LUMO energy levels by 0.1-0.2 eV. All Au complexes show essentially a linear geometry with CBN(O) Au-$C_{NHC}$ angles of 173.40(9)°-177.70(8)°. The $C_{NHC}$-Au and $C_{BN(O)}$-Au distances are similar, being 2.015(5) Å-2.042(4) Å. The NHC and BN(O) ligands twist against each other with dihedral angles of 59.3(4)° and 53.6(1)° in (BzIPr)AuBN **(AuBN-2)** and (BzIPr)AuBNO **(AuBN-5),** respectively. Interestingly, such a dihedral angle could be modulated by the carbene ligand. (PyIPr)AuBN **(AuBN-6)** shows the smallest angle of 40.9(3)° while (SIPr)AuBN **(AuBN-1)** and (IPr)AuBN **(AuBN-3)** the largest angles of 90° with an orthogonal ligand arrangement. All complexes show high decomposition temperatures ($T_d$, 5% weight loss) of 334-399 °C in thermal gravimetric analysis, which are comparable to that of the BN (404 °C) and BNO (341 °C) parents.

As shown in **FIGs. 11A** and **11B,** ultraviolet-visible (UV/Vis) absorption spectra and photoluminescence (PL) spectra of (BzIPr)AuBN and (BzIPr)AuBNO, along with parental molecules, BN and BNO, were measured in THF solution ($2\times10^{-5}$ M). These $Au^I$ complexes display intense absorptions with molar absorptivity ($\varepsilon$) of $1.6\text{-}5.8\times10^4$ $M^{-1}$ $cm^{-1}$ at 270-350 nm, which originate from intraligand $\pi$-$\pi$* transitions localized in BN(O) and NHC ligands **(FIGs. 11A** and **11B).** A characteristic, strongly-allowed ($\varepsilon$=$2.7\text{-}4.7\times10^4$ $M^{-1}$ $cm^{-1}$) structured absorption is observed beyond 400 nm, which could be assigned to HOMO→LUMO shortrange charge-transfer transition (SRCT) within the BN(O) core, as is typical of MR-TADF compounds. [1-4] As the SRCT excitation merely involves the reshuffling of electron density within BN(O)

framework, the absorption band only undergoes minor (negative) solvatochromic shift ($\Delta\lambda_{abs}$= 7 nm) in solvents of varied polarity. Compared to BN and BNO, the $^1$SRCT bands of (BzIPr)AuBN and (BzIPr)AuBNO are 20 nm and 16 nm redshifted, respectively, together with 25-30% lower absorptivity, which indicates a reduced oscillator strength of the CT transition upon $Au^I$ coordination. Similar observations were also reported in S- and Se-doped MR-TADF emitters. [7] Photoexcitation of (BzIPr)AuBN **(AuBN-2)** and (BzIPr)AuBNO **(AuBN-5)** in degassed THF affords bright green ($\lambda_{max}$=511 nm) and blue ($\lambda_{max}$= 471 nm) emissions **(FIGs. 11A** and **11B),** which are characterized by narrow unstructured bands with FWHM of 30 and 31 nm and high absolute photoluminescence quantum yields (PLQY) of 0.86 and 0.89, respectively. The emission spectra of the other (NHC)AuBN emitters are nearly identical to that of (BzIPr)AuBN **(AuBN-2).** On the other hand, BN and BNO display blue-shifted emissions at 490 and 454 nm with total PLQY, contributed by (major) prompt and (minor) delayed fluorescence, of 0.86 and 0.83, respectively. Since the emission energies of these $Au^I$ emitters are almost invariant with NHC identities and their spectral profiles resemble their organic counterparts, BN and BNO, the emissive excited states of the $Au^I$ emitters are predominantly BN(O)-centered $^1$SRCT. Furthermore, there is a considerable spectral overlap between the emission and respective $^1$SRCT absorption band for (BzIPr)AuBN **(AuBN-2)** and (BzIPr)AuBNO **(AuBN-5),** leading to a small Stokes shift of 23-25 nm. This indicates the structural reorganization in the emissive excited state of $Au^I$ MR-TADF emitters is modest. Steady-state emissions of (BzIPr)AuBN **(AuBN-2)** and (BzIPr)AuBNO **(AuBN-5)** solely come from the $^1SRCT \rightarrow S_0$ radiative transitions, which decay monoexponentially with lifetimes of 6.9 and 27.0 $\mu$s, respectively. No trace of other long-lived emissive component(s) (i.e. phosphorescence) can be detected in the nanosecond time-resolved emission. In comparison, the delayed fluorescence lifetimes of BN (152.1 $\mu$s) and BNO (257.8 $\mu$s) are notably longer by 10- to 28-folds. Thus, it is evident that Au(NHC) ligation significantly accelerates the delayed fluorescence of the BN(O) luminogens, which gives large TADF rate constants ($k_{TADF}$) of 1.1-1.3$\times$10$^5$ s$^{-1}$, while retaining the favorable emission characteristics of high color purity and PLQY for MR-TADF emitters.

To examine the influence of gold coordination on the excited state dynamics, femtosecond transient absorption (fs-TA) and time-resolved fluorescence (fs-TRF) spectroscopies were performed on selected $Au^I$ complex, namely, (BzIPr)AuBN **(AuBN-2),** together with their organic counterparts, BN in MeCN **(FIGs. 12A-12F).** Taking (BzIPr)AuBN as a representative example, pulse excitation at 267 nm yielded an initial fs-TA spectrum (~1.3 ps; **FIG. 12A)** that gives a broad positive TA around 450 nm and 700 nm due to the excited state absorption (ESA), a prominent negative feature at 480 nm ascribed to ground state bleaching (GSB) of the $^1$SRCT band, as well as a negative shoulder band around 500 nm due to $S_1 \rightarrow S_0$ stimulated emission (SE).[14] Spectral evolution of (BzIPr)AuBN mainly occurs in two stages: one in the first 35 ps **(FIG. 12A)** and the other over the remaining 3000 ps **(FIG. 12B).** The early stage involves an indistinct ESA development, which should be associated with the vibrational cooling process from $S_{1hot}$ to $S_1$ excited states. This process was similarly observed in BN **(FIG. 12D)** and the structurally similar t-DABNA molecule[14] and is tentatively assigned to structural relaxation of the BN moiety in S1 state. For (BzIPr)AuBN, a modest ESA growth at 550-750 nm was observed in the later stage **(FIG. 12B)** and the negative TA at 500 nm by SE collapsed with kinetics coinciding with that of the TRF decay ($\tau$=317 ps; **FIGs. 12C** and **12F).** Accordingly, the second stage of TA evolution observed is assigned to S1 population transfer to triplet manifold by ISC. The analogous process occurs much more slowly in BN ($\tau$>3 ns; **FIG. 12E).** It should be noted that the intensity of the GSB band of (BzIPr)AuBN remained prominent in the course of ISC, whereas both the GSB and SE of BN and BNO decreased conspicuously within the 3 ns time window. This suggests that (i) for BN and BNO, there is a significant ground state recovery due to the competitive $S_1$ radiative and non-radiative decays during the ISC, and (ii) the $Au^I$ emitters have a much higher ISC efficiency. To quantitatively assess the ISC rate constants ($k_{ISC}$) and quantum yields ($\Phi_{ISC}$) of the Au complexes, $k_{S1}$ (sum of $k_r$ and $k_{nr}$ of $S_1$ state) that is derived from their PF quantum yields is required. The PF quantum yields of (IPr)AuBN, (BzIPr)AuBN, (PyIPr)AuBN and (BzIPr)AuBNO, respectively **AuBN-3, AuBN-2, AuBN-6,** and **AuBN-5,** in MeCN were determined to be as low as 0.023-0.033 as the $S_1$ excited state is predominantly depleted by fast ISC, while those of BN and BNO ranged between 0.60-0.64 due to sluggish ISC. Consequently, as summarized in **Table 6,** $k_{ISC}$ of (NHC)AuBN complexes and (BzIPr)AuBNO are estimated to be 3.0-3.2$\times$10$^9$ s$^{-1}$, which are about 70- to 80-fold higher than their organic counterparts, BN and BNO, with $\Phi_{ISC}$ approaching unity (0.95-0.97). Such $k_{ISC}$ and $\Phi_{ISC}$ values are among the highest in all reported MR-TADF emitters. At the same time, the $k_{RISC}$ values of (NHC)AuBN complexes and (BzIPr)AuBNO are greatly increased by about 30- to 170-fold compared to those of BN and BNO, being 3.2-5.0$\times$10$^6$ s$^{-1}$ and 1.1 $\times$ 10$^6$ s$^{-1}$, respectively.

**Table 6.** Excited state kinetic parameters of BN(O) and selected $Au^I$ emitters in MeCN.

| Emitter | $\tau_{PF}$[ps] | $k_{S1}$[a,b][$\times$10$^7$s$^{-1}$] | $k_{ISC}$[c][$\times$10$^7$s$^{-1}$] | $\Phi_{ISC}$[d] | $k_{RISC}$[a,e][$\times$10$^4$s$^{-1}$] |
|---|---|---|---|---|---|
| BN | 5600[f] | 14 | 4.3 | 0.24 | 2.9 |
| BNO | 6300[f] | 12 | 4.1 | 0.26 | 3.7 |
| (IPr)AuBN | 324[g] | 11 | 300 | 0.96 | 330 |
| (BzIPr)AuBN | 317[g] | 9.7[f] | 310 | 0.97 | 500 |

(continued)

| Emitter | $\tau_{PF}$[ps] | $k_{S1}$[a,b][$\times 10^7 s^{-1}$] | $k_{ISC}$[c][$\times 10^7 s^{-1}$] | $\Phi_{ISC}$[d] | $k_{RISC}$[a,e][$\times 10^4 s^{-1}$] |
|---|---|---|---|---|---|
| (PyIPr)AuBN | 303[g] | 17[f] | 310 | 0.95 | 320 |
| (BzIPr)AuBNO | 298[g] | 15[f] | 320 | 0.96 | 110 |

[a] $\Phi_{em}$(total) = $\Phi_{PF}+\Phi_{DF}$; $k_{r(S1)} = \Phi_{PF}/\tau_{PF}$; $\Phi_{em}$(total) = $k_{r(S1)}/[k_{r(S1)}+k_{IC(S1)}]$. [b] $k_{S1} = k_{r(S1)} + k_{IC(S1)}$. [c] $k_{ISC} = 1/\tau_{PF} - k_{S1}$. [d] $\Phi_{ISC} = k_{ISC}\tau_{PF}$. [e] $k_{RISC} = \Phi_{DF}/(k_{ISC}\ \tau_{PF}\ \tau_{DF}\Phi_{PF})$. [f] Measured by TCSPC. [g] Measured by fs-TRF.

In doped PMMA thin film (2 wt%) at RT, the emission of (NHC)AuBN emitters and (BzIPr)AuBNO are slightly redshifted from those in THF to 513-515 nm and 473 nm **(Tables 2-4),** respectively. In general, the (NHC)AuBN complexes exhibit higher PLQYs (0.87-0.92) and shorter emission lifetimes (5.5-5.9 μs) in PMMA film whereas (BzIPr)AuBNO displays slightly reduced PLQY (0.84) in PMMA with a shorter emission lifetime of 22.8 μs. Upon cooling to 77 K, the emissions are redshifted by 18-21 nm with lifetimes significantly elongated to 1400-3050 μs; this emission was tentatively assigned to phosphorescence from $^3$SRCT state. Based on the emission spectra at RT and 77 K, the $\Delta E_{ST}$ of the $^{1,3}$SRCT states were estimated to be 0.08-0.09 eV for (NHC)AuBN emitters and 0.11 eV for (BzIPr)AuBNO, which are comparable to or smaller than the values of their respective parents, BN (0.10 eV) and BNO 0.16 eV). Temperature dependence of emission lifetime of the $Au^I$ emitters in PMMA thin film was measured. As the intersystem crossing rate of Au emitters is much faster than their $S_1$ radiative and nonradiative decay rates (i.e. $k_{ISC}$>>$k_{S1}$; Table 2), and the triplet radiative lifetime is much longer (see above, the low temperature lifetime should be close to the radiative lifetime), by invoking the steady state approximation, the temperature-dependent TADF rate constant of the Au emitters could be expressed by Equation (1),[15] wherein b is a temperature-independent constant and kB is the Boltzmann constant, and $\Delta E_{ST}$ can be determined from the slope of the Arrhenius plots ($\ln(k_{TADF})$ versus 1/T).

$$\ln(k_{TADF}) = \ln(b) - (\Delta E_{ST}/k_B)*1/T \qquad \text{(eq. 1)}$$

The linear fits from Arrhenius plots give $\Delta E_{ST}$ of 0.15-0.16 eV for the (NHC)AuBN complexes, and 0.19 eV for (BzIPr)AuBNO **(FIGs. 13A** and **13B).** These values are appreciably larger (0.06-0.08 eV) than those obtained from the TADF (RT) and phosphorescence (77 K) spectra as aforementioned. The discrepancy of $\Delta E_{ST}$ could be suggestive of the presence of a higher-lying intermediate $T_2$ state in mediating the $^{1,3}$SRCT interconversion to give TADF. The operation of such a $S_1\leftarrow\rightarrow T_2\leftarrow\rightarrow T_1$ ISC/RISC channel, *via* spin vibronic mechanism, has been proposed and observed in other TADF and MR-TADF emitters. [6, 16-18]

(BzIPr)AuBN **(AuBN-2)** has been selected as a representative example for comparisons with BN. As the *k*ISC and *k*RISC are proportional to the SOC matrix elements between the $S_1$ and $T_1$ excited states ($k_{ISC}$, $k_{RISC} \propto <S_1|H_{SOC}|T_1>^2$), the geometries of the $S_1$ and $T_1$ excited states for both molecules have been optimized. From the TDDFT calculations, the $S_1$ and $T_1$ excited states of (BzIPr)AuBN **(AuBN-2)** are of the same nature as the respective excited states of BN with both excited states predominantly derived from the HOMO→LUMO transition (>97%); the HOMO and LUMO are localized on the aza-boron ligand but the gold(I) complex has very minute contributions of Au in the HOMO (1 %) and LUMO (5 %). SOC matrix element between the $S_1$ and $T_1$ excited states ($S_1|H_{SOC}|T_1$) has been computed at the respective optimized $S_1$ and $T_1$ excited states. For (BzIPr)AuBN **(AuBN-2),** $<S_1|H_{SOC}|T_1>$=1.67 $cm^{-1}$ (at optimized $S_1$ geometry) and 1.62 $cm^{-1}$ (at optimized $T_1$ geometry); for BN, $<S_1|H_{SOC}|T_1>$ is only 0.051 $cm^{-1}$, which is more than 30-fold smaller than that of (BzIPr)AuBN. As it has also been suggested that the ISC pathway of a classic MR-TADF emitter, DABNA-1, occured via a stepwise transition $S_1\rightarrow T_2\rightarrow T_1$,[16] the SOC matrix element between the $S_1$ and $T_2$ excited states has also been computed for BN. It is found that $<S_1|H_{SOC}|T_2>$=0.229 $cm^{-1}$, which is still more than 7-fold smaller than $<S_1|H_{SOC}|T_1>$ of (BzIPr)AuBN. This highlights the importance of involvement of $Au^I$ in the MR-TADF emitter which greatly accelerates $k_{ISC}$ and $k_{RISC}$ through enhanced SOC.

To assess the EL properties of (NHC)AuBN emitters, multilayer OLEDs were fabricated with the following optimized structure: ITO/HAT-CN (10 nm)/FSFA (120 nm)/ FSF4A (5 nm)/(NHC)AuBN: DMIC-Cz: DMIC-TRz (30 nm)/ANT-BIZ (5 nm)/ANT-BIZ: Liq (1 : 1, 25 nm)/Liq (2 nm)/Al (100 nm). Herein, 1,4,5,8,9,11-hexaazatriphenylenehexacarbonitrile (HAT-CN) was applied as a holeinjection layer; N-([1,1'-biphenyl]-2-yl)-N-(9,9-dimethyl-9*H*fluoren-2-yl)-9,9'-spirobi[fluoren]-2-amine (FSFA) was served as a holetransporting layer; N-([1,1'-biphenyl]-2-yl)-N-(9,9-dimethyl-9*H*-fluoren-2-yl)-9,9'-spirobi[fluoren]-4-amine (FSF4A) was used as an electron-blocking layer; the mixture of 7,7-dimetyl-5-phenyl-2-(9-phenyl-9*H*-carbazol-3-yl)-5,7-dihydroindeno[2,1-b]carbazole (DMIC-Cz) and 1,3-dihydro-1,1-dimethyl-3-(3-(4,6-diphenyl-1,3,5-triazin-2-yl)-phenyl)indeno[2,1-b]carbazole (DMIC-TRz) was adopted as the co-host in the emissive layer (EML) with weight ratio of 1: 1; a 5-nm-thick layer of pristine 1-(4-(10-([1,1'-biphenyl]-4-yl)anthracen-9-yl)phenyl)-2-ethyl-1H-benzo[d]imidazole (ANT-BIZ) and Liq, with a weight ratio of 1:1, was used as a buffer layer between the

EML and the electron-transporting layer (ETL); a 2 nm-thick Liq layer was inserted between the ETL and the Al cathode to facilitate electron injection. DMIC-TRz and DMIC-Cz were selected as hosts becasue of their equalized charge transporting abilities, well-matched HOMO/LUMO energy levels with those of the Au emitters, and high efficiency of triplet up-conversion. [19]

To better evaluate the EL performance of (NHC)AuBN emitters, OLEDs with BN were also fabricated in the same device structure. The key device performance data are summarized in **Table 4.** All (NHC)AuBN-based devices showed ultrapure-green EL with peak maxima at 508-517 nm and small FWHMs of 34-40 nm **(FIG. 14A),** retaining the typical feature of high color purity of MR-TADF based devices. Among these devices, the CIE coordinates of 1 wt% (SIPr)AuBN-doped **(AuBN-1-**doped) OLED are (0.21, 0.69) and 4 wt% (BzIPr)AuBN-doped (**AuBN-2**-doped) OLED are (0.18, 0.70), which are close to that of the National Television System Council (NTSC) standard green luminescence (0.21, 0.71). Remarkably, these Au-based devices all showed high EQE over 20 % **(FIGs. 14B** and **14C)** and the maximum EQE of (BzIPr)AuBN-based (**AuBN-2**-doped) device (2 wt%) reached 30.3% combined with a maximum current efficiency (CE) of 97.1 cd $A^{-1}$. Moreover, these Au-based devices showed exceptionally high brightness over $1\times10^5$ cd $m^{-2}$ with (SIPr)AuBN-based device (0.5 wt%) topping out at $2.53\times10^5$ cd $m^{-2}$. For comparison, the maxmium CE and luminance of the BN-based devices (0.5-2 wt%) are much lower, being 13.6%, 28.5 cd $A^{-1}$ and $3.45\times10^4$ cd $m^{-2}$, respectively.

Benefiting from the shortened triplet exciton lifetimes (5-8 μs) of (NHC)AuBN emitters and suitable device configuration, the Au-based OLEDs demonstrated diminished efficiency roll-offs; OLEDs based on 0.5 wt% (SIPr)AuBN **(AuBN-1),** 1 wt% (IPr)AuBN **(AuBN-3),** 4 wt % (BzIPr)AuBN **(AuBN-2),** and 4 wt% (PzIPr)AuBN **(AuBN-4)** exhibited efficiency roll-off of 2.0%, 6.0%, 0.8%, and 3.8% at 1000 cd $m^{-2}$, respectively, presumably due to suppressed triplet-triplet annihilation and/or triplet-polaron quenching. To the best of our knowledge, these roll-off data at 1000 cd $m^{-2}$ are the lowest among all reported green-emitting MR-TADF devices. Furthermore, a high EQE of 21.7% could be maintained at 10000 cd $m^{-2}$ for OLED doped with 4 wt% (BzIPr)AuBN, which corresponds to an efficiency roll-off of 12.5 %. On the other hand, the efficieny roll-offs at 1000 cd $m^{-2}$ for BNbased deivces fabricated in this work are remarkable (30.5-37.6%). Overall, the current density, EQE and efficiency roll-off data at 1000 cd $m^{-2}$ for the (NHC)AuBN devices are consistently much better when compared to the performance of optimized BN-based device reported in literature[5] **(Table 4)** and the BN devices fabricated in this work. The operational device lifetimes ($LT_{60}$) of 1 wt% doped (SIPr)AuBN and (BzIPr)AuBN devices with an initial luminance of 1000 cd $m^{-2}$ were estimated to be 987 h and 1210 h, respectively, using the experimentally determined acceleration factor of 1.80. Overall, the excellent device performance data and prolonged operational lifetimes at a practical luminance of 1000 cd $m^{-2}$ for $Au^I$ MR-TADF-based devices are underpinned by the much accelerated ISC and RISC rate constants of (NHC)AuBN emitters due to the enhanced SOC brought about by incorporation of $Au^I$ ion.

In summary, a new class of highly efficient $Au^I$-based MR-TADF emitters that exhibits high emission quantum yields (ca. 90%) with narrowband emissions (FWHM=30-37 nm) has been developed. Compared to the parental organic counterparts, the $Au^I$ emitters attained roughly two orders of magnitude faster ISC and RISC rates enabled by the enhanced SOC. This facilitation of the forbidden spinflipping processes greatly improves the TADF efficiency and gives record-high $k_{TADF}$ values of 1-$2\times10^5$ $s^{-1}$ and shortened triplet exciton lifetimes of 5-8 μs among reported MR-TADF emitters. Remarkably, ultrapure-green OLEDs doped with (BzIPr)AuBN exhibited maximum EQEs up to 30.3% and narrowband electroluminescence with FWHM of 34 nm as well as extremely low efficiency roll-off of 0.8% and long operational device lifetime ($LT_{60}$) of 1210 h at a practical luminance of 1000 cd $m^{-2}$. We conceive this simple and easy-to-implement metal coordination strategy to promote triplet exciton harvesting could be extended to diverse TADF compounds beyond MR-TADF emitters, opening up a new dimension to develop practical TADF OLEDs.

## References

[1] a) H. Hirai, K. Nakajima, S. Nakatsuka, K. Shiren, J. Ni, S. Nomura, T. Ikuta, T. Hatakeyama, Angew. Chem. Int. Ed. 2015, 54, 13581-13585; Angew. Chem. 2015, 127, 13785-13789; b) T. Hatakeyama, K. Shiren, K. Nakajima, S. Nomura, S. Nakatsuka, K. Kinoshita, J. Ni, Y. Ono, T. Ikuta, Adv. Mater. 2016, 28, 2777-2781.

[2] S. Madayanad Suresh, D. Hall, D. Beljonne, Y. Olivier, E. Zysman-Colman, Adv. Funct. Mater. 2020, 30, 1908677.

[3] a) M. Yang, I. S. Park, T. Yasuda, J. Am. Chem. Soc. 2020, 142, 19468-19472; b) M. Yang, S. Shikita, H. Min, I. S. Park, H. Shibata, N. Amanokura, T. Yasuda, Angew. Chem. Int. Ed. 2021, 60, 23142-23147; Angew. Chem. 2021, 133, 23326-23331.

[4] a) H. Tanaka, S. Oda, G. Ricci, H. Gotoh, K. Tabata, R. Kawasumi, D. Beljonne, Y. Olivier, T. Hatakeyama, Angew. Chem. Int. Ed. 2021, 60, 17910-17914; Angew. Chem. 2021, 133, 18054-18058; b) X. Cai, J. Xue, C. Li, B. Liang, A. Ying, Y. Tan, S. Gong, Y. Wang, Angew. Chem. Int. Ed. 2022, 61, e202200337; Angew. Chem. 2022, 134, e202200337; c) Y. Zou, J. Hu, M. Yu, J. Miao, Z. Xie, Y. Qiu, X. Cao, C. Yang, Adv. Mater. 2022, 34, 2201442.

[5] Y. Xu, Z. Cheng, Z. Li, B. Liang, J. Wang, J. Wei, Z. Zhang, Y. Wang, Adv. Opt. Mater. 2020, 8, 1902142.
[6] Y. Kondo, K. Yoshiura, S. Kitera, H. Nishi, S. Oda, H. Gotoh, Y. Sasada, M. Yanai, T. Hatakeyama, Nat. Photonics 2019, 13, 678-682.
[7] a) I. S. Park, M. Yang, H. Shibata, N. Amanokura, T. Yasuda, Adv. Mater. 2022, 34, 2107951; b) I. S. Park, H. Min, T. Yasuda, Angew. Chem. Int. Ed. 2022, 61, e202205684; Angew. Chem. 2022, 134, e202205684.
[8] M. Montalti, A. Credi, L. Prodi, M. T. Gandolfi, Handbook of Photochemistry, 3rd ed.; CRC, Boca Raton, 2006.
[9] a) H.-Y. Chao, W. Lu, Y. Li, M. C. W. Chan, C.-M. Che, K.-K. Cheung, N. Zhu, J. Am. Chem. Soc. 2002, 124, 14696-14706; b) W. Lu, W.-M. Kwok, C. Ma, C. T.-L. Chan, M.-X. Zhu, C.- M. Che, J. Am. Chem. Soc. 2011, 133, 14120-14135; c) C. Ma, C. T.-L. Chan, W.-M. Kwok, C.-M. Che, Chem. Sci. 2012, 3, 1883-1892.
[10] R. Tang, S. Xu, T.-L. Lam, G. Cheng, L. Du, Q. Wan, J. Yang, F.-F. Hung, K.-H. Low, D.-L. Phillips, C.-M. Che, Angew. Chem. Int. Ed. 2022, 61, e202203982; Angew. Chem. 2022, 134, e202203982.
[11] L. Kuehn, A. F. Eichhorn, D. Schmidt, T. B. Marder, U. Radius, J. Organomet. Chem. 2020, 919, 121249.
[12] D. Song, Y. Yu, L. Yue, D. Zhong, Y. Zhang, X. Yang, Y. Sun, G. Zhou, Z. Wu, J. Mater. Chem. C 2019, 7, 11953-11963.
[13] Y. Gao, Y. Wang, Z. Guo, Y. Wan, C. Li, B. Yang, W. Yang, X. Ma, J. Phys. Chem. B 2022, 126, 2729-2739.
[14] Deposition Numbers 2201832 (for BNO), 2201830 (for (SIPr)AuBN), 2201827 (for (IPr)AuBNm), 2201826 (for (BzIPr)AuBN), 2201828 (for (PyIPr)AuBN), 2201829 (for (PzIPr)AuBN), and 2201831 (for (BzIPr)AuBNO)) contain the supplementary crystallographic data. These data are provided free of charge by the joint Cambridge Crystallographic Data Centre and Fachinformationszentrum Karlsruhe Access Structures service.
[15] Y. Tsuchiya, S. Diesing, F. Bencheikh, Y. Wada, P. L. dos Santos, H. Kaji, E. Zysman-Colman, I. D. W. Samuel, C. Adachi, J. Phys. Chem. A 2021, 125, 8074-8089.
[16] K. Shizu, H. Kaji, Commun. Chem. 2022, 5, 53.
[17] M. K. Etherington, J. Gibson, H. F. Higginbotham, T. J. Penfold, A. P. Monkman, Nat. Commun. 2016, 7, 13680.
[18] N. Aizawa, Y. Harabuchi, S. Maeda, Y.-J. Pu, Nat. Commun. 2022, 11, 3909.
[19] D. Fang, Y. Sun, Y. Chen, T. Fu, M. U. Ali, Y. He, J. Miao, C. Yan, H. Meng, Dyes Pigm. 2020, 173, 107990

Unless defined otherwise, all technical and scientific terms used herein have the same meanings as commonly understood by one of skill in the art to which the disclosed invention belongs. Publications cited herein and the materials for which they are cited are specifically incorporated by reference. Further, unless otherwise indicated, use of the expression "wt%" refers to "wt/wt%."

Those skilled in the art will recognize, or be able to ascertain using no more than routine experimentation, many equivalents to the specific embodiments of the invention described herein. Such equivalents are intended to be encompassed by the following claims.

## Claims

1. A compound having a structure:

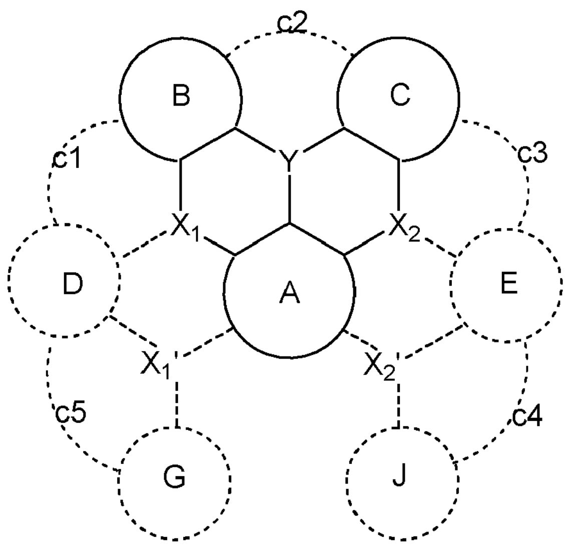

Formula I

wherein:

the compound has an overall neutral, negative, or positive charge,

the dashed linear lines in Formula I denote the presence or absence of a bond,

$X_1$, Y, and $X_2$ are, respectively: nitrogen, boron, and nitrogen; oxygen, boron, and oxygen; oxygen, boron, and nitrogen; sulfur, boron, and nitrogen; selenium, boron, and nitrogen; boron, nitrogen, and boron; sulfur, boron, and sulfur; selenium, boron, and selenium; selenium, boron, and oxygen; or sulfur, boron, and oxygen,

A, B, and C are independently substituted aryl, unsubstituted aryl, substituted heteroaryl, unsubstituted heteroaryl, substituted polyaryl, unsubstituted polyaryl, substituted polyheteroaryl, unsubstituted polyheteroaryl, or fused combinations thereof,

D, E, G, and J are independently absent, substituted aryl, unsubstituted aryl, substituted heteroaryl, unsubstituted heteroaryl, substituted polyaryl, unsubstituted polyaryl, substituted polyheteroaryl, unsubstituted polyheteroaryl, or fused combinations thereof; substituted alkyl, or unsubstituted alkyl,

preferably, substituted in Formula I means substituted with unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, or unsubstituted amine,

$X_1$' and $X_2$' are independently absent, nitrogen, oxygen, sulfur, selenium, substituted $C_1$-$C_5$ alkyl (such as -C(Me)$_2$-), or unsubstituted $C_1$-$C_5$ alkyl,

c1, c2, c3, c4, and c5 are independently absent, single bond, -O-, -S-, -Se-, substituted $C_1$-$C_5$ alkyl (such as -C(Me)$_2$-), unsubstituted $C_1$-$C_5$ alkyl, substituted amine, unsubstituted amine, substituted carbonyl, or unsubstituted carbonyl, and

at least one of A, B, C, D, E, G, and J is datively bonded to a moiety having a structure:

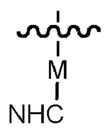

Formula II

wherein:

the dative bond involves M,

NHC has a structure:

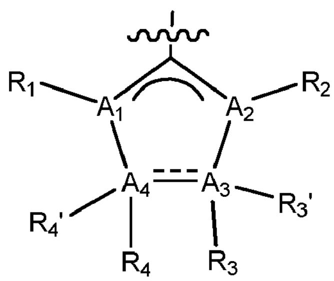

Formula IIa

M is a metal or metal ion with high spin-orbit coupling, such as metals or metal ions of 3d, 4d, and 5d transition metals, preferably gold, copper, silver, iridium, ruthenium, platinum, *etc.,*

$A_1$, $A_2$, $A_3$, and $A_4$ are independently carbon or nitrogen, preferably wherein at least one of $A_1$, $A_2$, $A_3$, and $A_4$ is nitrogen and at least one of the other of $A_1$, $A_2$, $A_3$, and $A_4$ is carbon, and $A_1$, $A_2$, $A_3$, and $A_4$ are bonded to none, one, or two hydrogen atoms according to valency,

$R_1$, $R_2$, $R_3$, $R_3$', $R_4$, and $R_4$' are independently hydrogen, substituted aryl, unsubstituted aryl, substituted heteroaryl, unsubstituted heteroaryl, substituted polyaryl, unsubstituted polyaryl, substituted polyheteroaryl, unsubstituted polyheteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, un-

substituted $C_1$-$C_{20}$ heterocyclyl, or fused combinations thereof; substituted alkyl, or unsubstituted alkyl (such as unsubstituted $C_1$-$C_5$ alkyl); or $A_2$ and $R_2$ together form a substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, or unsubstituted $C_1$-$C_{20}$ heterocyclyl; or $A_3$, $R_3$, $R_3$', $A_4$, $R_4$, and $R_4$', together form substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, unsubstituted $C_1$-$C_{20}$ heterocyclyl, or fused combinations thereof, preferably, substituted in Formula IIa means substituted with unsubstituted $C_1$-$C_5$ alkyl (such as methyl, ethyl, n-propyl, *etc.*), substituted $C_1$-$C_5$ alkyl (such as iso-propyl, iso-butyl, tert-butyl, *etc.*), substituted aryl (1,1'-biphenyl-2-yl, 1,1'-biphenyl-3-yl, 1,1'-biphenyl-4-yl, 2,6-dimethylphenyl), unsubstituted aryl (phenyl), and
when the dashed line between $A_3$ and $A_4$ is a single bond, $R_3$' and $R_4$' are absent.

**2.** The compound of claim 1, wherein M is a metal or metal ion of gold, silver, or copper, and/or

wherein at least one of $A_1$, $A_2$, $A_3$, and $A_4$ is nitrogen and at least one of the other of $A_1$, $A_2$, $A_3$, and $A_4$ is carbon, and/or
wherein:

(i) $R_1$, $R_2$, $R_3$, $R_3$', $R_4$, and $R_4$' are independently hydrogen, substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), or fused combinations thereof; substituted alkyl, or unsubstituted alkyl (such as unsubstituted $C_1$-$C_5$ alkyl); or
(ii) $A_2$ and $R_2$ together form a substituted $C_3$-$C_{20}$ cycloalkyl (such as substituted $C_3$-$C_{10}$ cycloalkyl) or unsubstituted $C_3$-$C_{20}$ cycloalkyl (such as unsubstituted $C_3$-$C_{10}$ cycloalkyl); or
(iii) wherein $A_3$, $R_3$, $R_3$', $A_4$, $R_4$, and $R_4$', together form substituted aryl, unsubstituted aryl, substituted heteroaryl, unsubstituted heteroaryl, substituted $C_3$-$C_{20}$ cycloalkyl (such as substituted $C_3$-$C_{10}$ cycloalkyl), unsubstituted $C_3$-$C_{20}$ cycloalkyl (such as unsubstituted $C_3$-$C_{10}$ cycloalkyl), substituted $C_1$-$C_{20}$ heterocyclyl, unsubstituted $C_1$-$C_{20}$ heterocyclyl, or fused combinations thereof, and/or

wherein $A_3$, $R_3$, $R_3$', $A_4$, $R_4$, and $R_4$', together form substituted aryl, unsubstituted aryl, substituted heteroaryl, or unsubstituted heteroaryl.

**3.** The compound of claim 1 or 2, wherein Formula IIa is selected from:

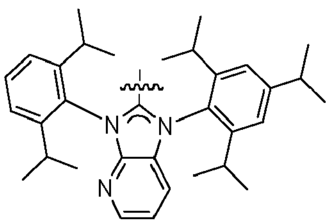
,
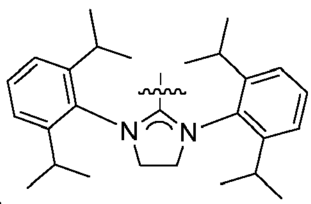
,
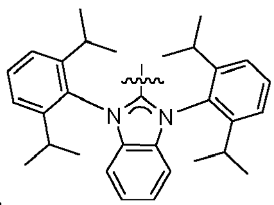
,

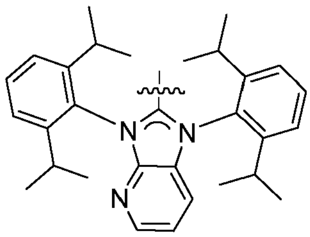
,
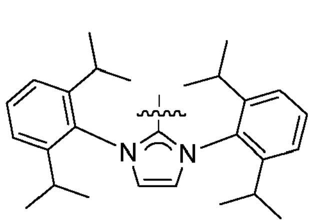
,
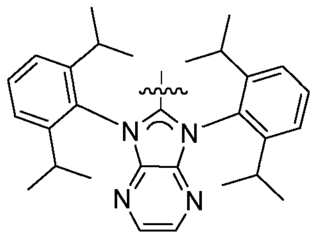
,

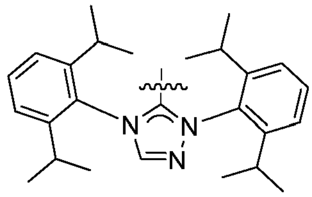,
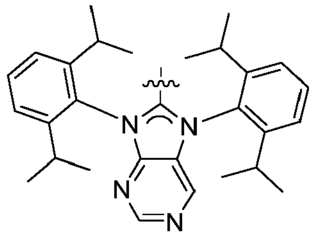,
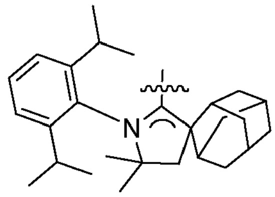,

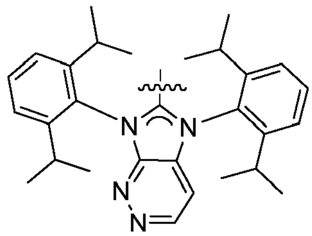,
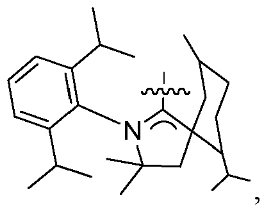,

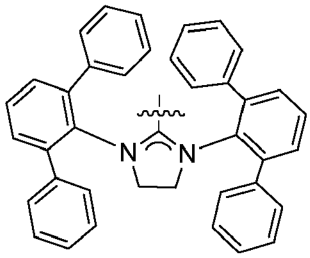,
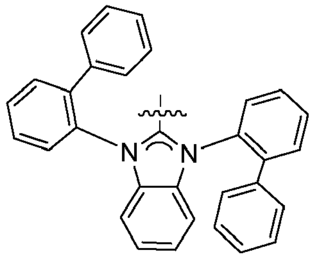,
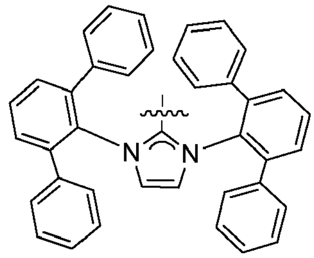,

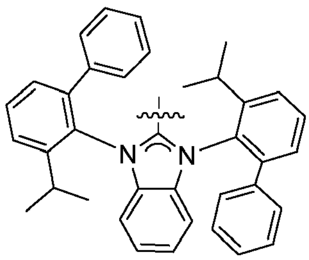,
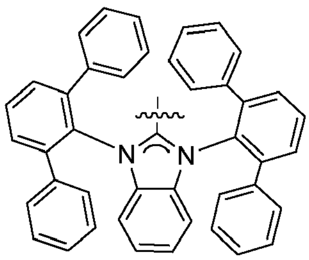,
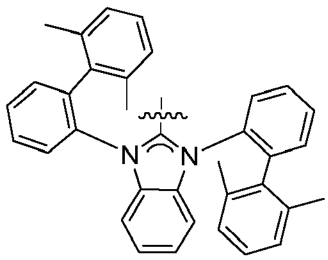,

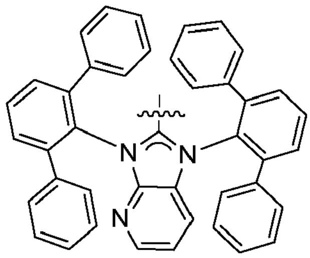,
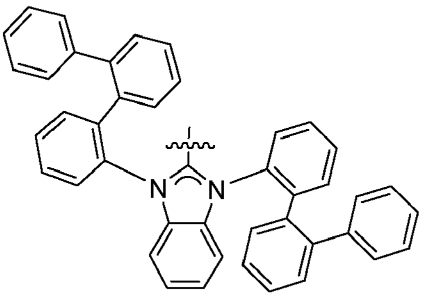,

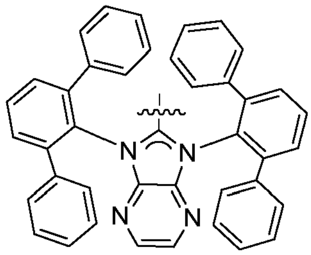

, or

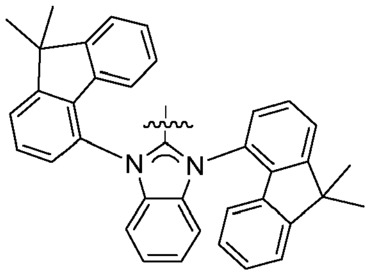

.

**4.** The compound of any one of claims 1 to 3, wherein $X_1$, Y, and $X_2$ are, respectively: nitrogen, boron, and nitrogen; oxygen, boron, and oxygen; oxygen, boron, and nitrogen; sulfur, boron, and nitrogen; selenium, boron, and nitrogen; or boron, nitrogen, and boron, and/or

wherein A, B, and C are independently substituted aryl, unsubstituted aryl, substituted heteroaryl, unsubstituted heteroaryl, or fused combinations thereof, and/or
wherein D, E, G, and J are independently absent, substituted aryl, or unsubstituted aryl, substituted heteroaryl, unsubstituted heteroaryl, or fused combinations thereof, and/or
wherein $X_1$' and $X_2$' are independently absent or nitrogen, and/or
wherein c1, c2, c3, c4, and c5 are independently absent, single bond, -O-, -S-, -Se-, substituted $C_1$-$C_5$ alkyl (such as $-C(Me)_2-$), or unsubstituted $C_1$-$C_5$ alkyl.

**5.** The compound of any one of claims 1 to 4, wherein Formula I is:

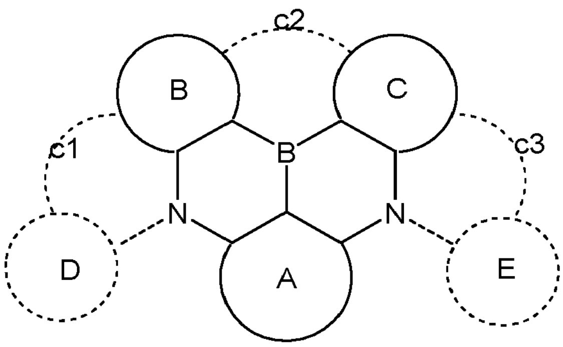

Formula III

wherein:
D and E are independently substituted aryl, unsubstituted aryl, substituted heteroaryl, unsubstituted heteroaryl, or fused combinations thereof; substituted alkyl, or unsubstituted alkyl, and/or
wherein Formula I is:

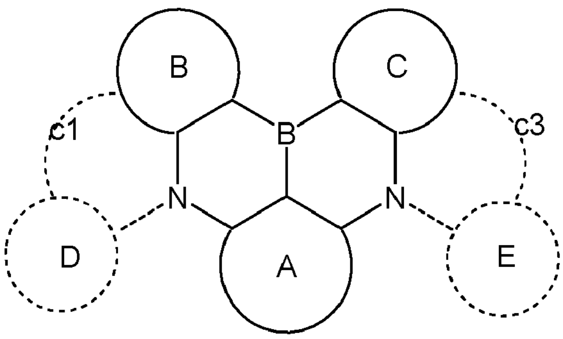

Formula IV

wherein:

pairs of c1 and c3 are: both single bonds; single bond and absent; single bond and substituted $C_1$-$C_5$ alkyl (such as -C(Me)$_2$-); single bond and unsubstituted $C_1$-$C_5$ alkyl; single bond and -O-; single bond and -S-; single bond and -Se-; absent and -S-; absent and -Se-; both substituted $C_1$-$C_5$ alkyl (such as -C(Me)$_2$-); substituted $C_1$-$C_5$ alkyl (such as -C(Me)$_2$-) and -O-; substituted $C_1$-$C_5$ alkyl (such as -C(Me)$_2$-) and -S-; substituted $C_1$-$C_5$ alkyl (such as -C(Me)$_2$-) and -Se-; absent and substituted $C_1$-$C_5$ alkyl (such as - C(Me)$_2$-); absent and -O-; -O- and -O-; -O- and -S-; -O- and -Se-; -Se- and - Se-; -S- and -S-; or both absent.

**6.** The compound of any one of claims 1 to 5, having a structure:

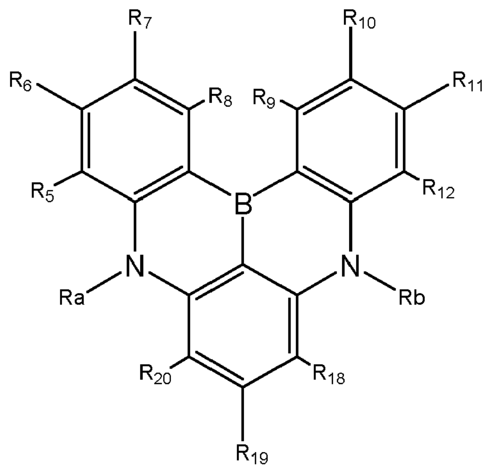

Formula V

wherein:

$R_a$ and $R_b$ are independently substituted aryl, unsubstituted aryl, substituted heteroaryl, unsubstituted heteroaryl, or fused combinations thereof; substituted alkyl, or unsubstituted alkyl,

$R_5$-$R_{12}$ and $R_{18}$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20, optionally

1. wherein the compound has the structure:

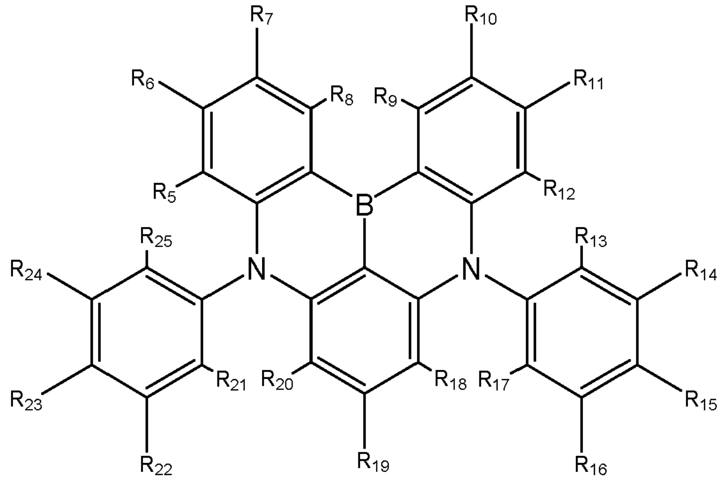

Formula VI

wherein:

$R_5$-$R_{25}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{25}$ is Formula II, optionally $R_5$ and $R_{25}$ combine to form c1 and $R_{12}$ and $R_{13}$ combine to form c3,
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 25, or
wherein the compound has the structure:

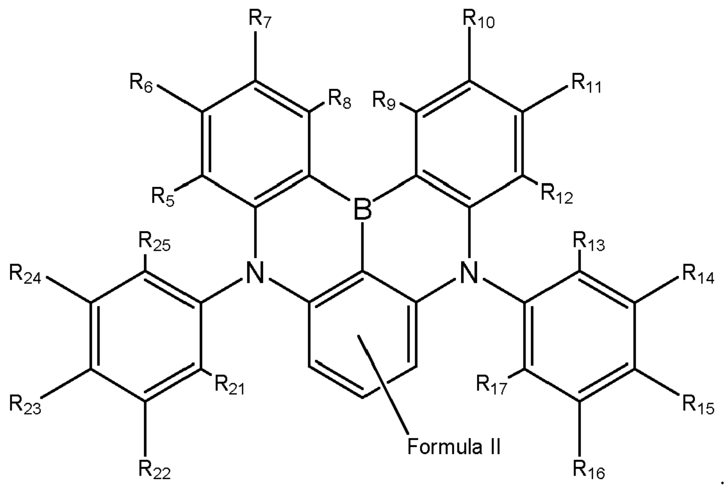

Formula VII

**7.** The compound of any one of claims 1 to 6, having a structure:

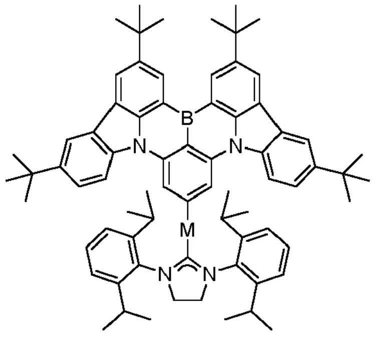
,
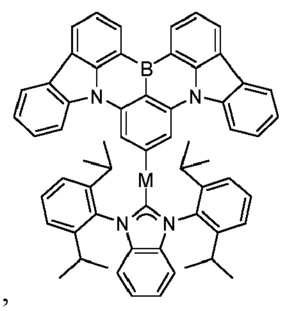
,

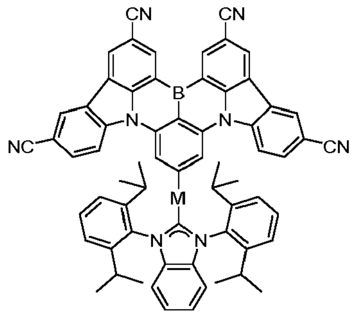
,

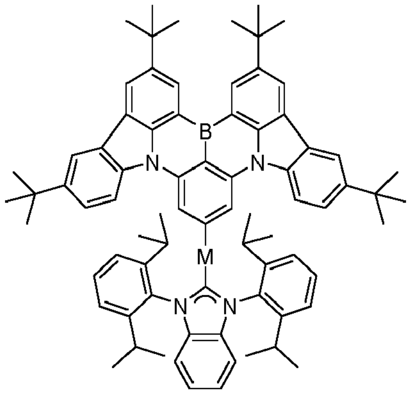
,
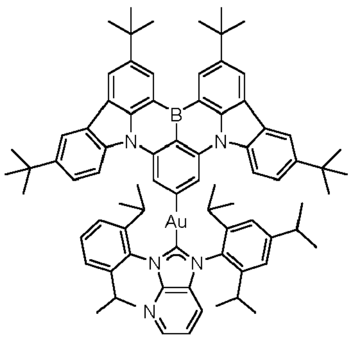
,

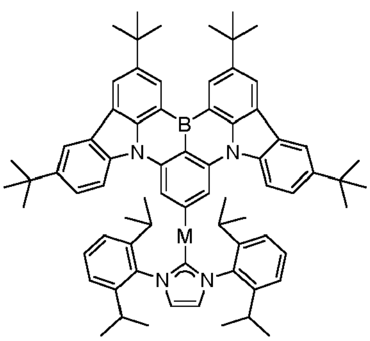
,
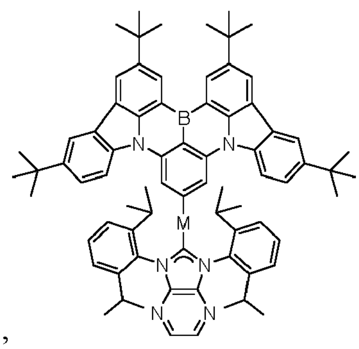
,

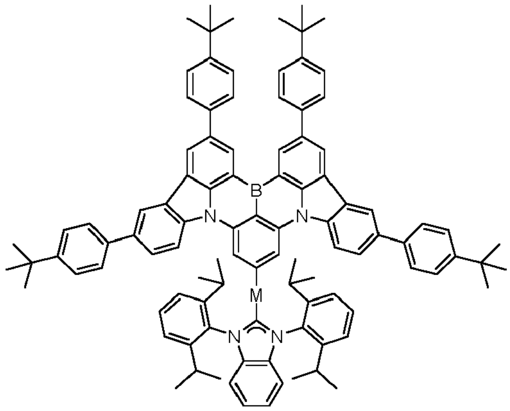

,

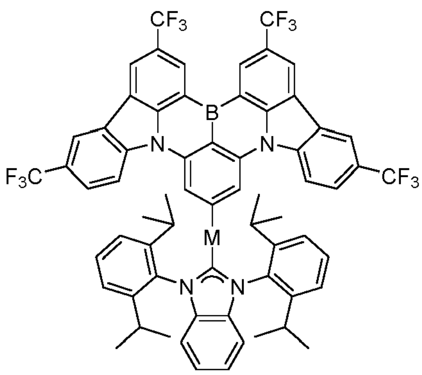

,

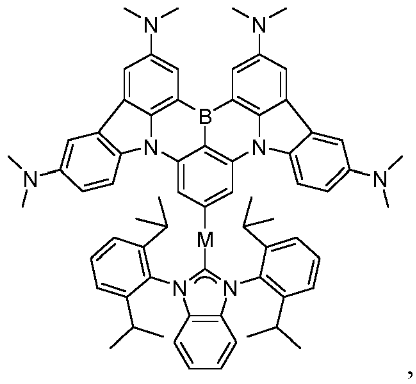

,

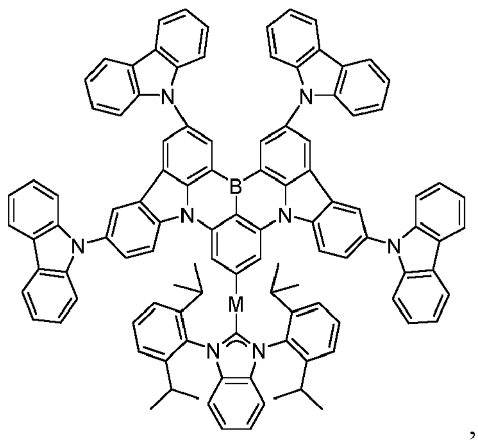

,

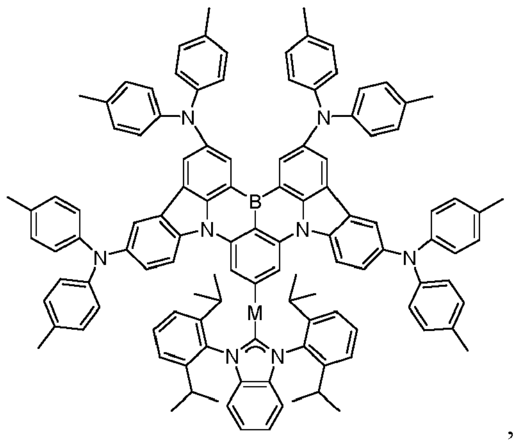

,

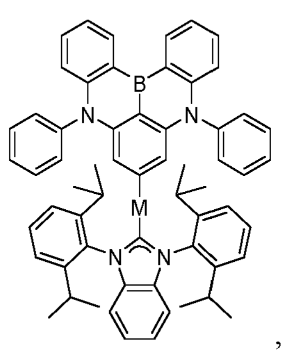

,

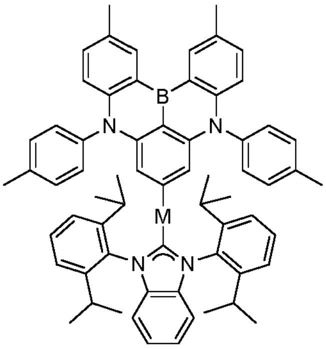

,

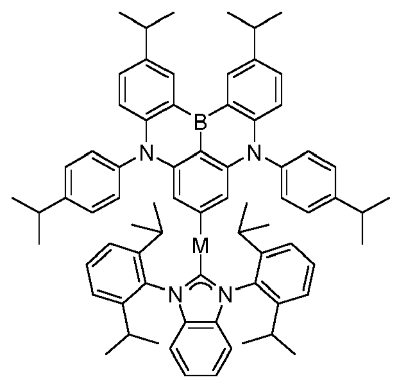
,
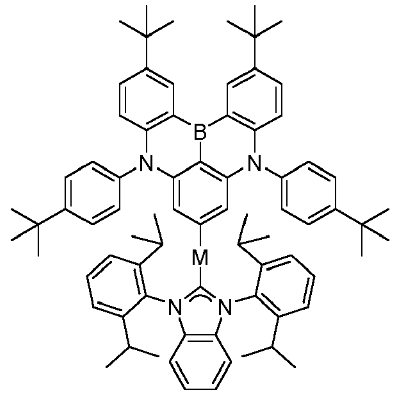
,

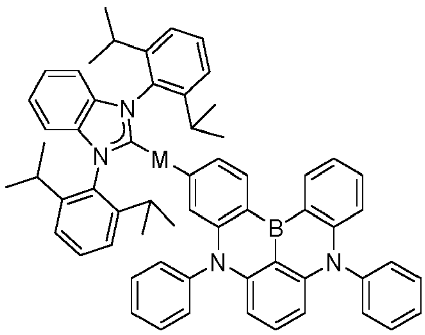
,
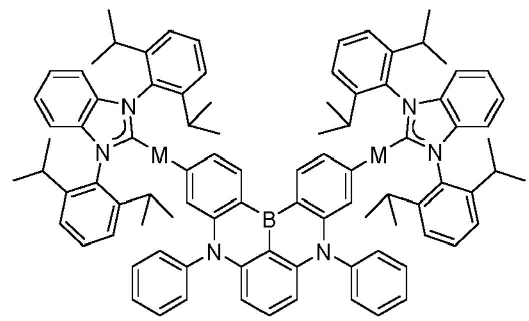
,

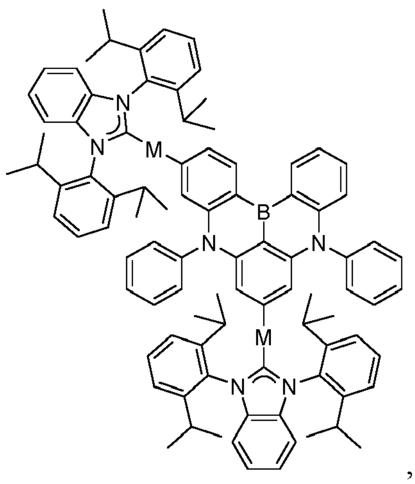
,
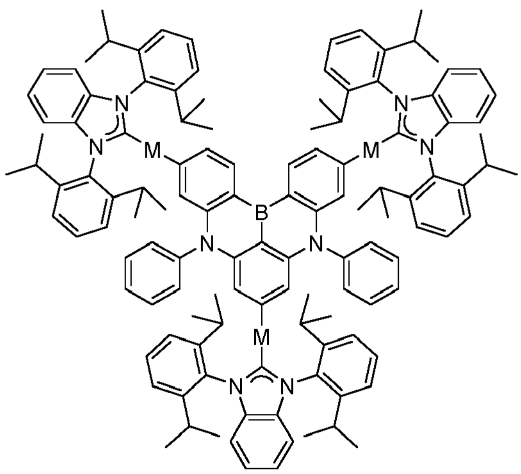
,

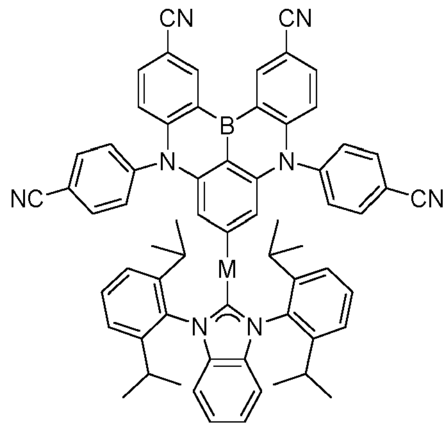
,
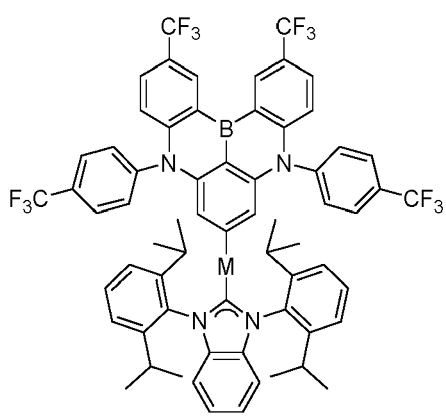
,

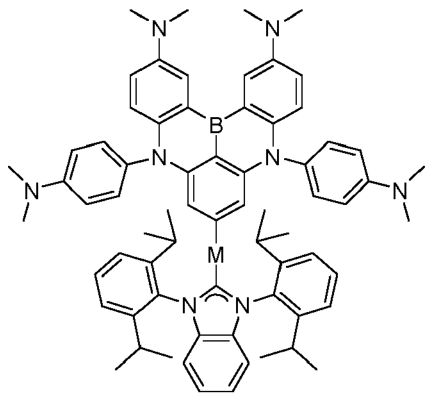,

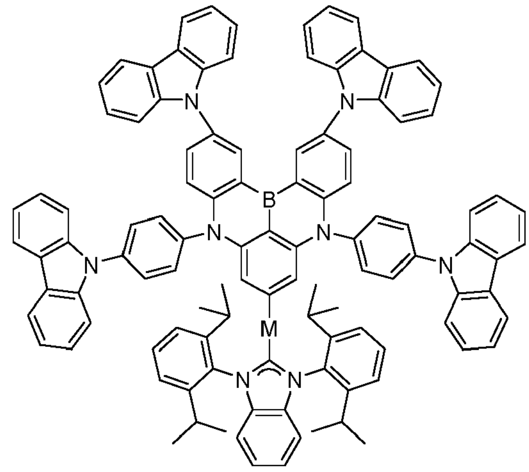,

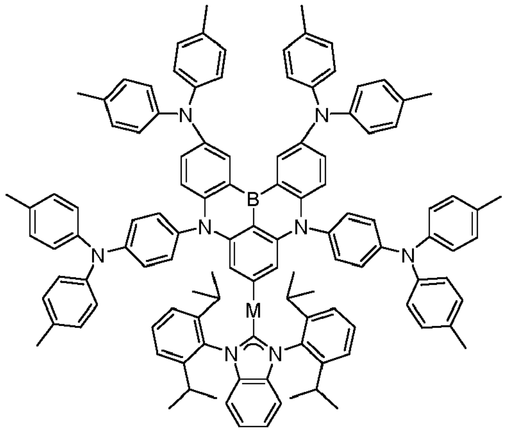,

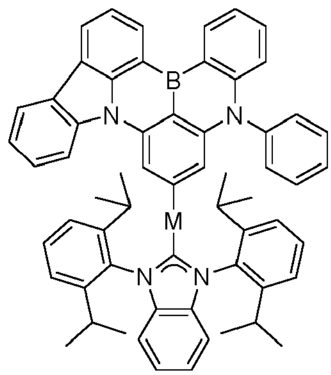,

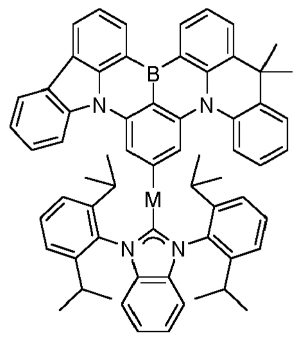,

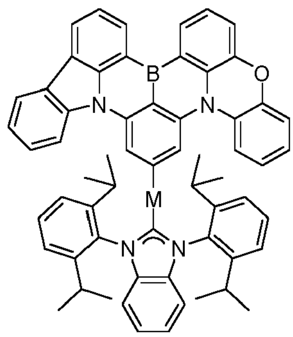,

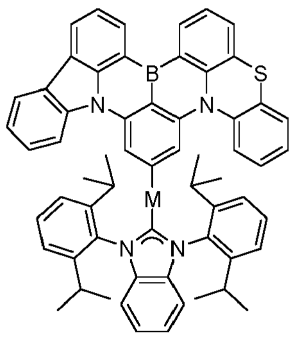,

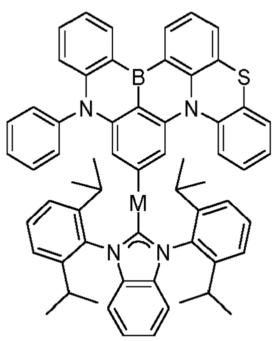,

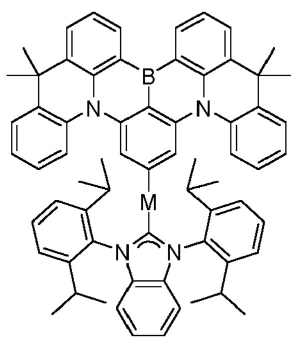,

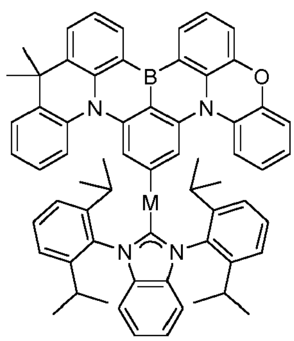,

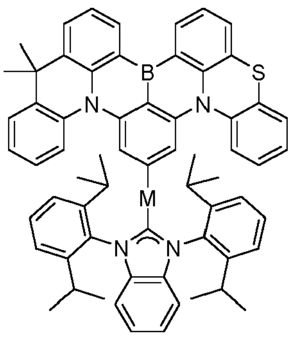 , 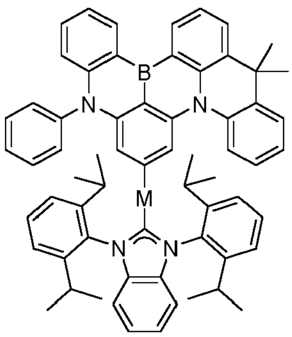 , 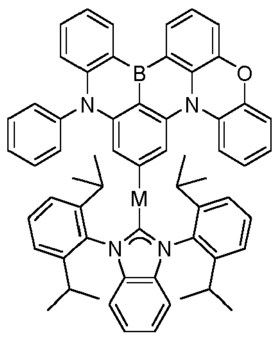 ,

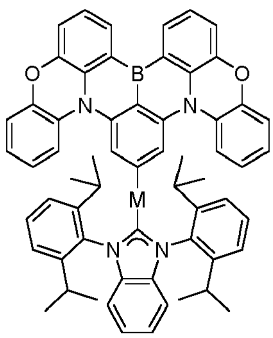 , 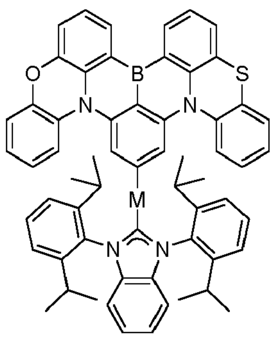 , or 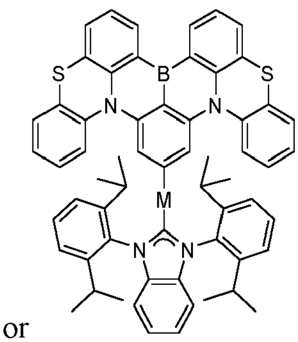 .

**8.** The compound of any one of claims 1 to 4, wherein Formula I is:

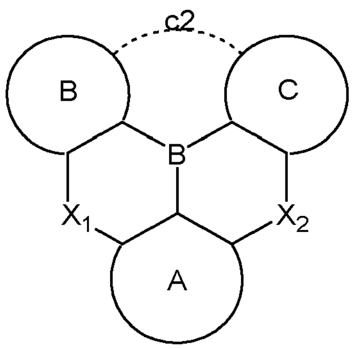

Formula VIII

wherein:

pairs of $X_1$ and $X_2$ are: both oxygen; sulfur and oxygen; selenium and oxygen; selenium and selenium; or sulfur and sulfur, preferably both oxygen,
preferably c2 is absent, optionally
wherein the compound has the structure:

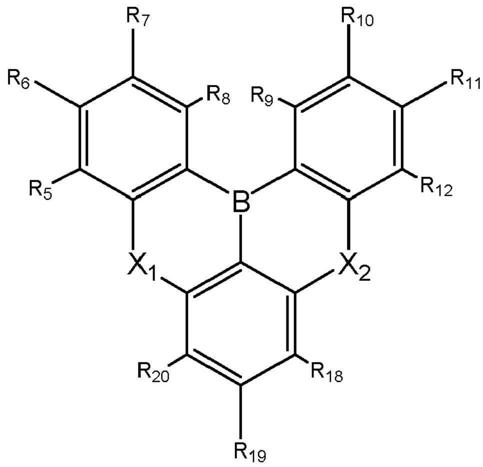

Formula IX

wherein:

pairs of $X_1$ and $X_2$ are: both oxygen; sulfur and oxygen; selenium and oxygen; selenium and selenium; or sulfur and sulfur, preferably both oxygen,

$R_5$-$R_{12}$ and $R_{18}$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20,

further optionally wherein the compound has a structure selected from:

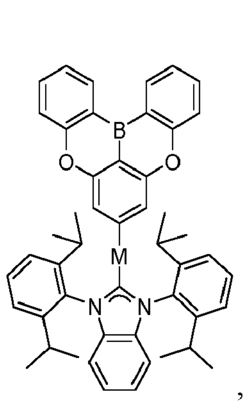

,

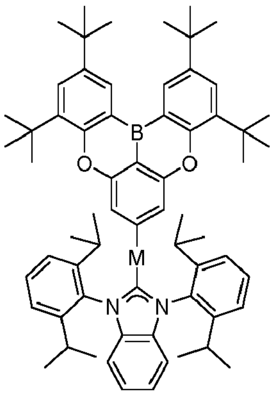

,

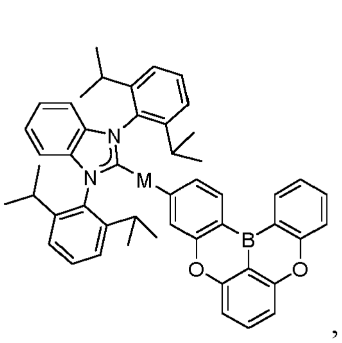

,

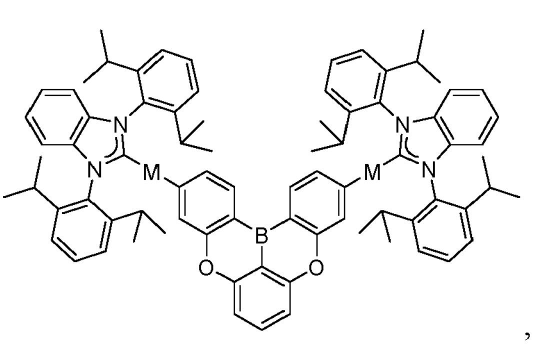

,

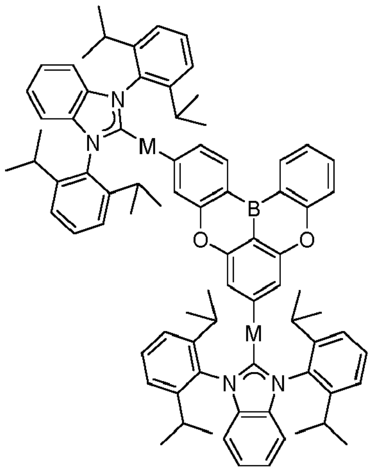

, or

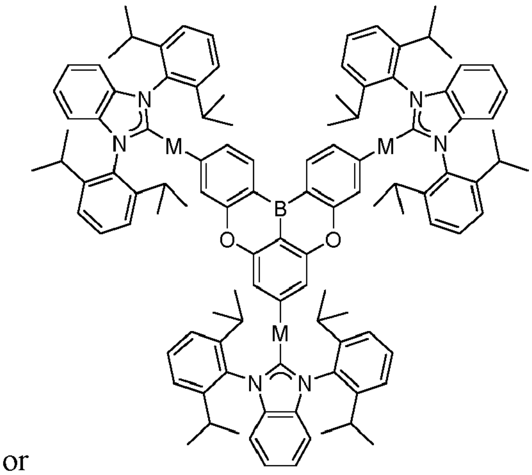

.

**9.** The compound of any one of claims 1 to 4, wherein Formula I is:

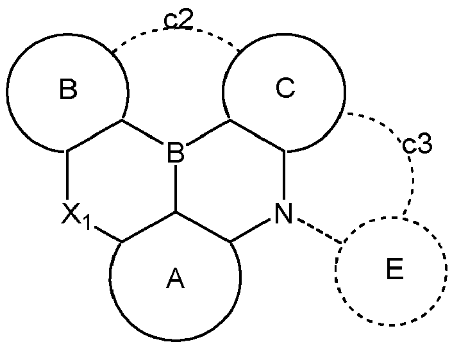

Formula X

wherein:

$X_1$ is oxygen, sulfur, or selenium,
c2 is preferably absent,
c3 is absent, single bond, -O-, -S-, -Se-, substituted $C_1$-$C_5$ alkyl (such as -C(Me)$_2$-), or unsubstituted $C_1$-$C_5$ alkyl, and
E is substituted aryl, unsubstituted aryl, substituted heteroaryl, unsubstituted heteroaryl, or fused combinations thereof; substituted alkyl, or unsubstituted alkyl, optionally
wherein the compound has the structure:

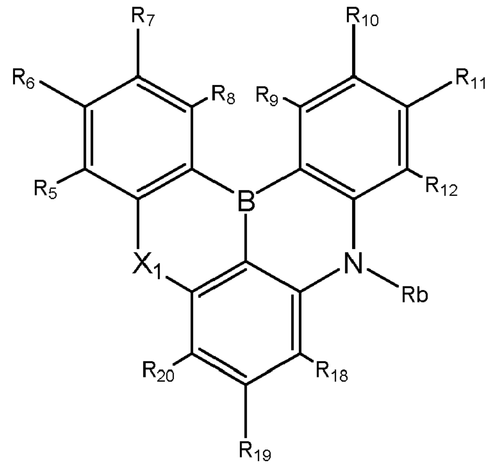

Formula XI

wherein:

$X_1$ is oxygen, sulfur, or selenium,

Rb is substituted aryl, unsubstituted aryl, substituted heteroaryl, unsubstituted heteroaryl, or fused combinations thereof; substituted alkyl, or unsubstituted alkyl,

$R_5$-$R_{12}$ and $R_{18}$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{12}$ and $R_{18}$-$R_{20}$ is Formula II,

optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 12 and 18-20, or wherein the compound has the structure:

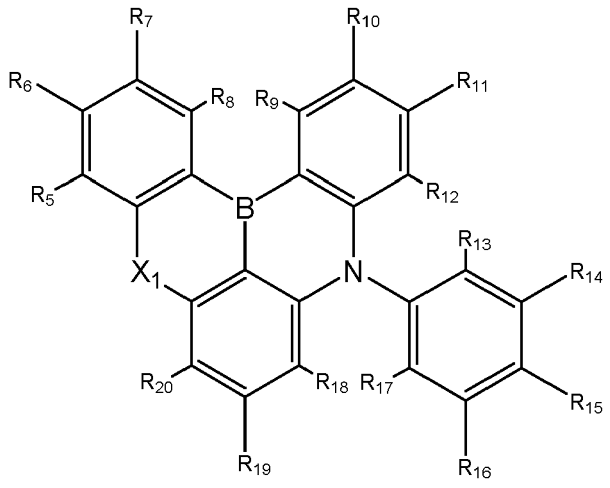

Formula XII

wherein:

$X_1$ is oxygen, sulfur, or selenium,

$R_5$-$R_{20}$ are preferably independently hydrogen, unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as $(Me)_2N$-; diarylamine, such as (4-methylphenyl)$_2$N-, unsubstituted amine, or Formula II, wherein at least one of $R_5$-$R_{20}$ is Formula II, optionally $R_{12}$ and $R_{13}$ combine to form c3,
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 20.

**10.** The compound of any one of claims 1 to 4, or 9, having a structure selected from Group A or Group B.

**Group A**:

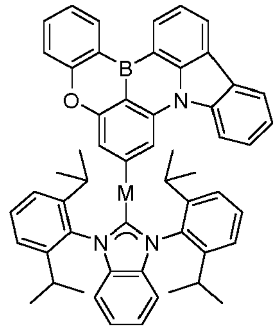,

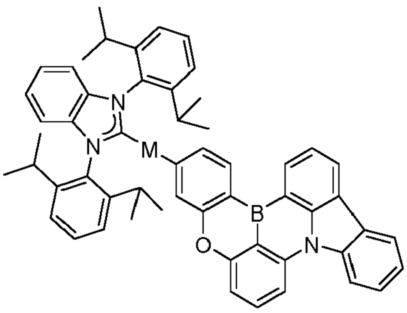,

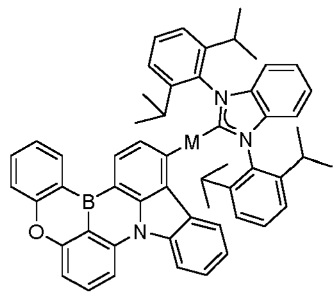,

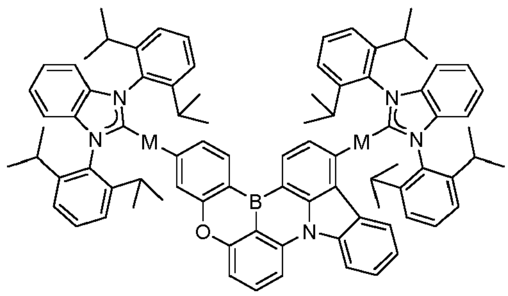,

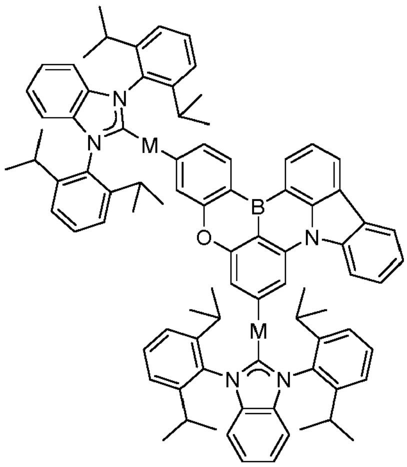,

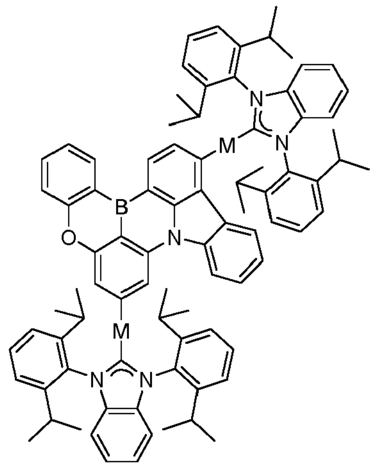,

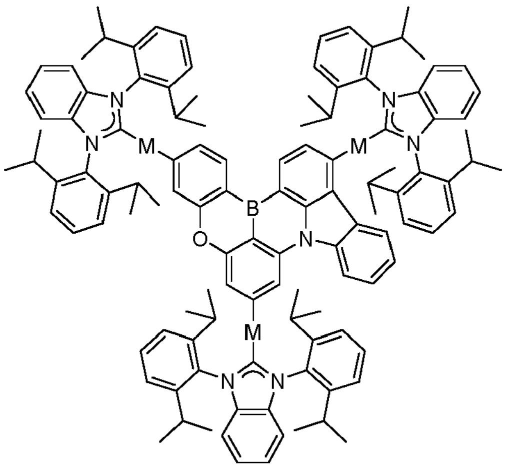,

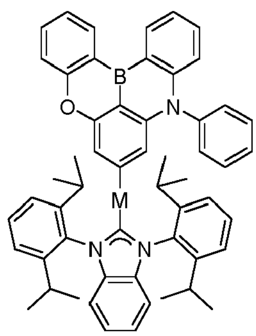,

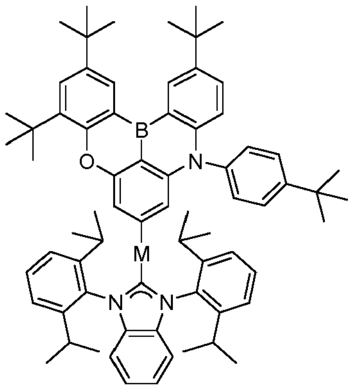

,

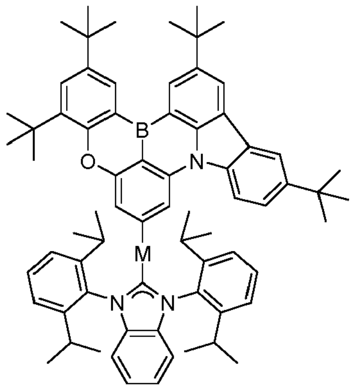

,

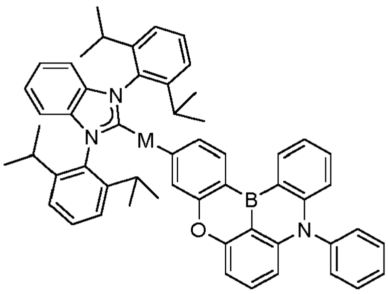

,

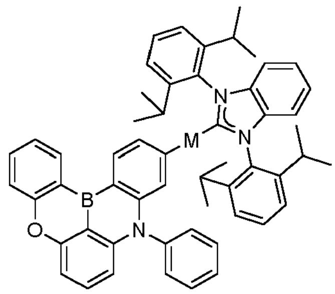

,

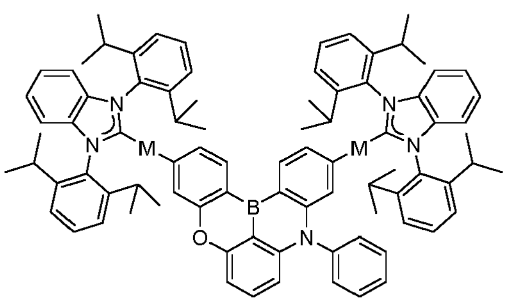

,

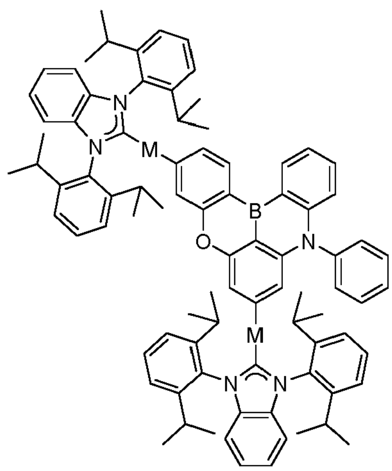

,

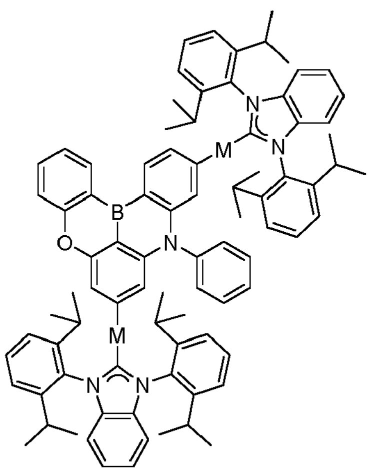

,

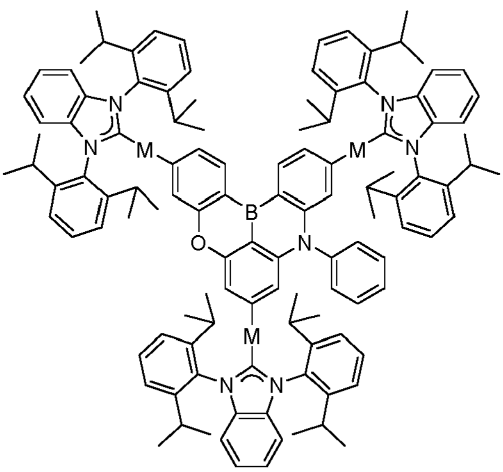

,

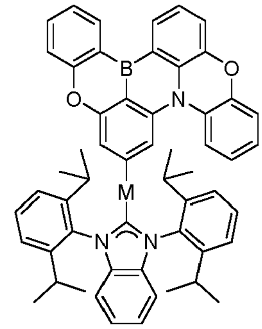
,
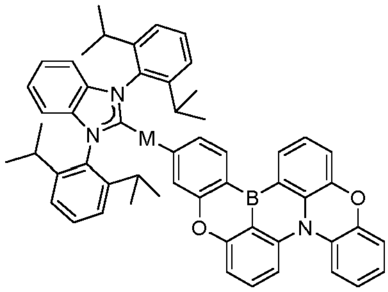
,

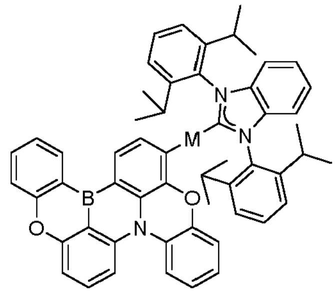
,
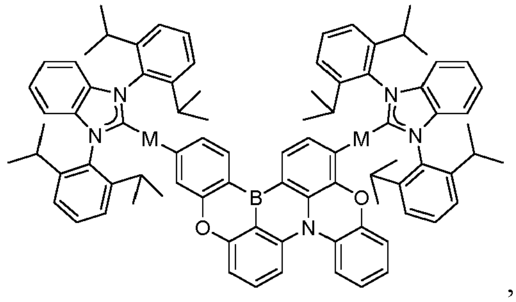
,

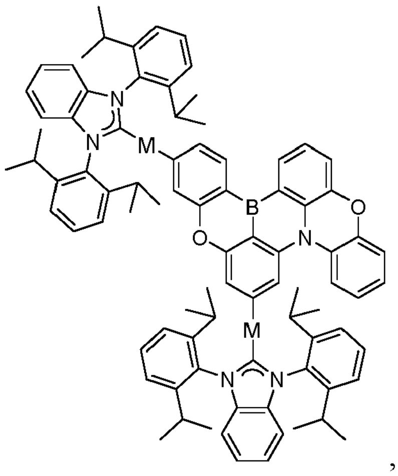
,
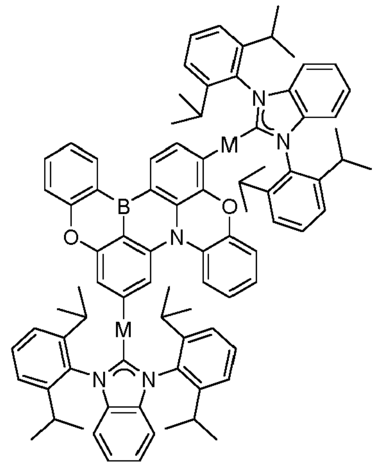
,

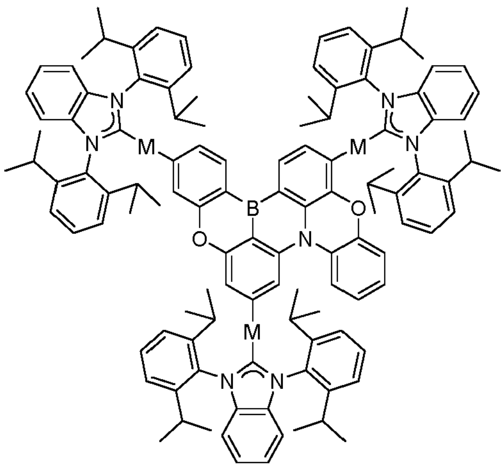
,
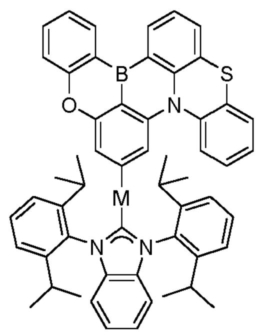
,

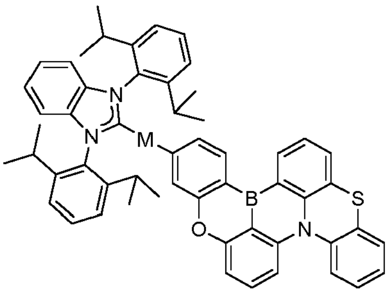
,
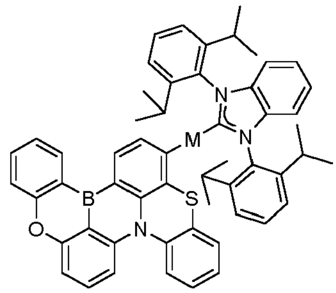
,

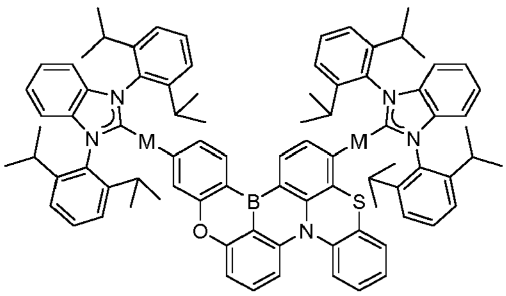
,
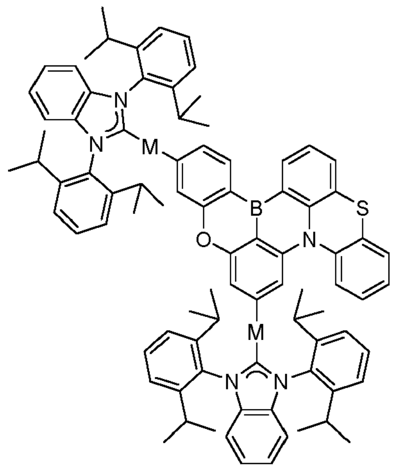
,

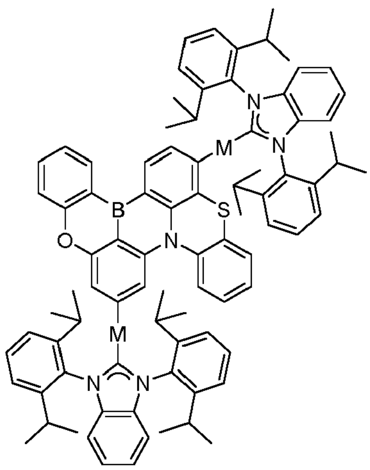
, or
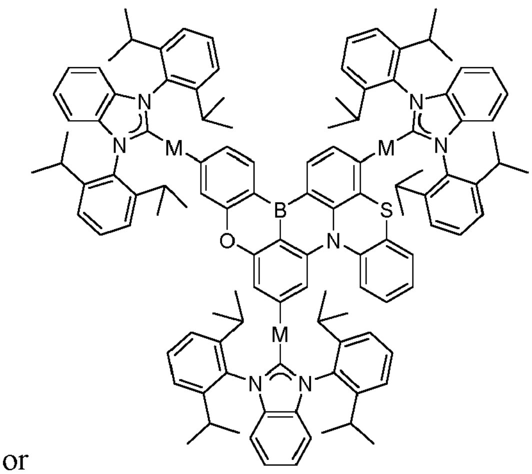
.

**Group B**:

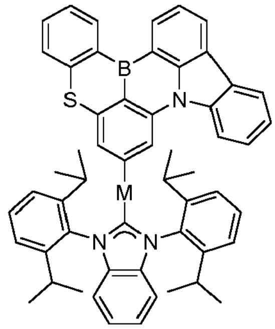,
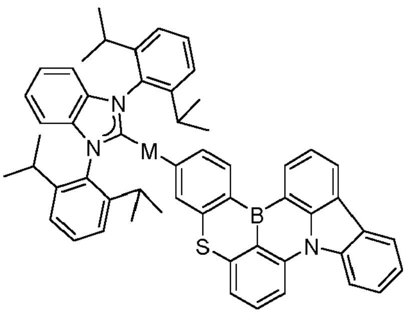,
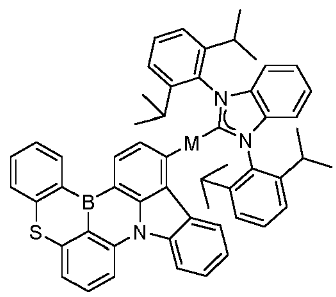,
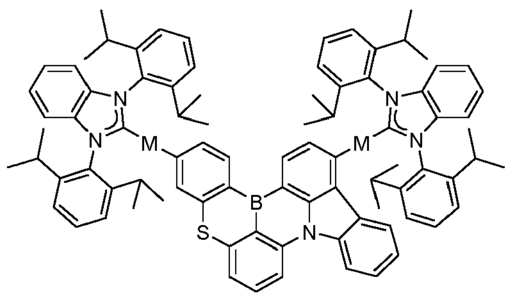,
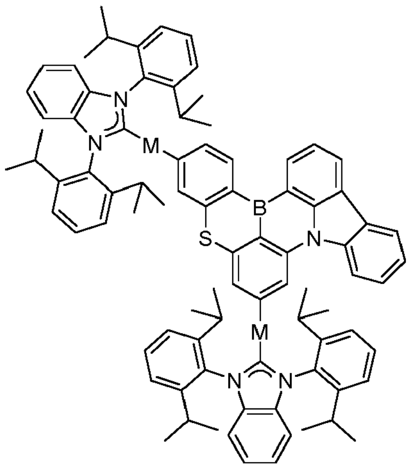,
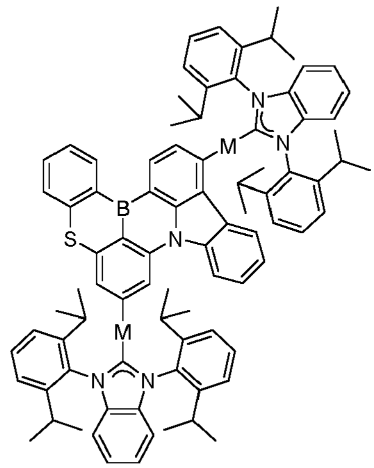,
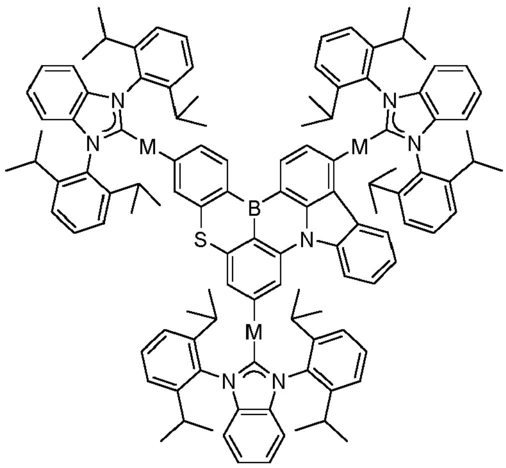,
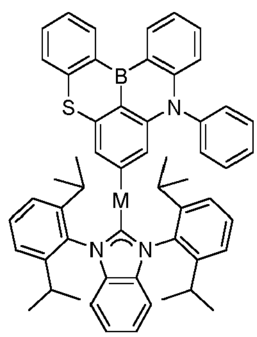,

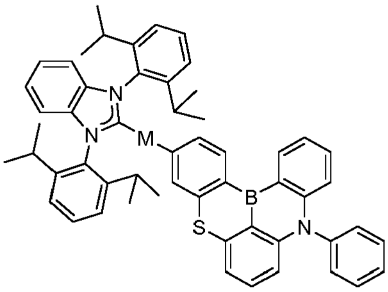

,

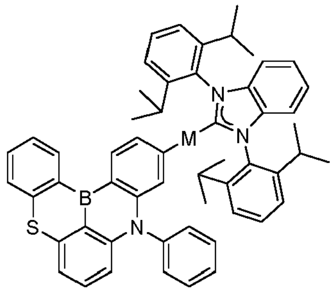

,

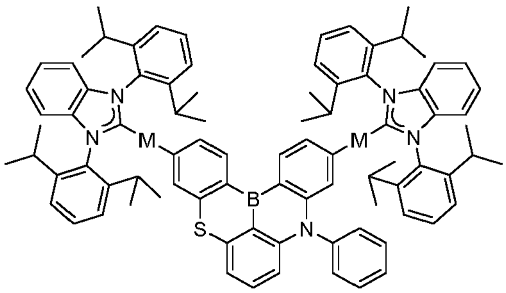

,

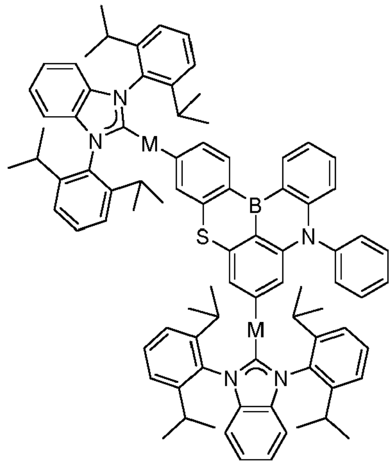

,

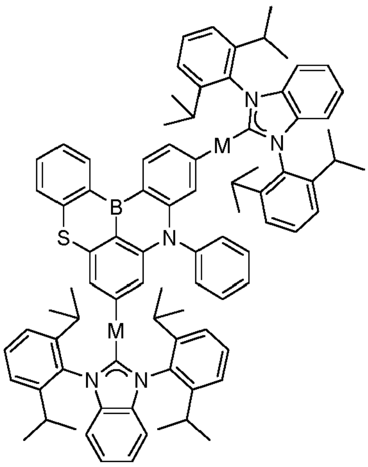

,

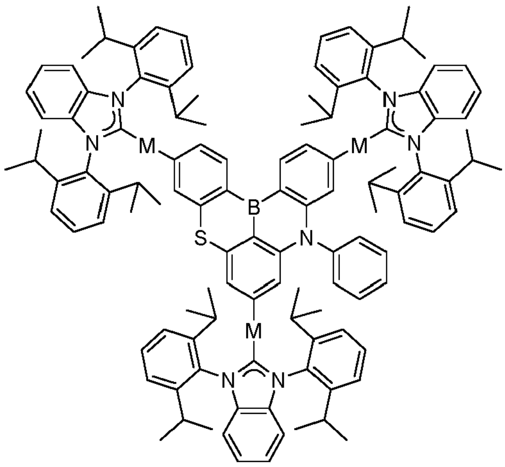

,

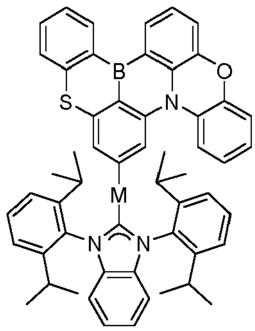

,

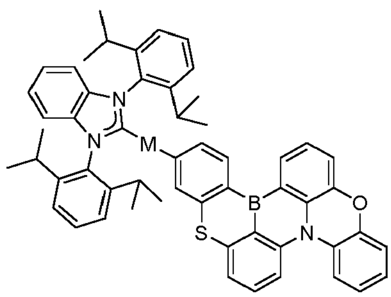

,

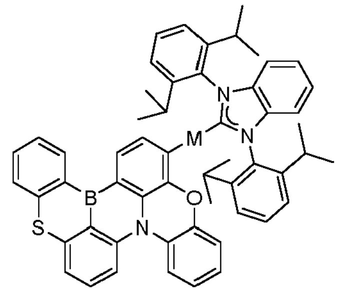
,
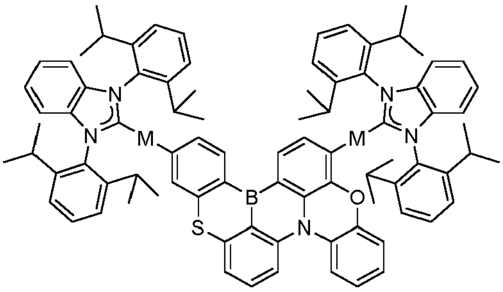
,
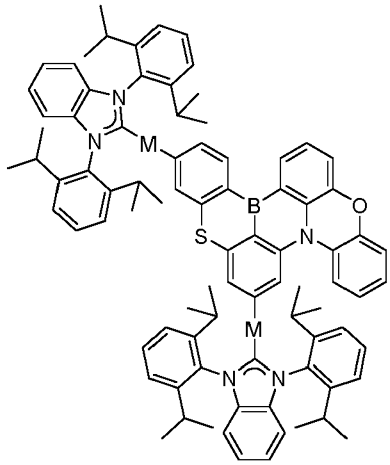
,
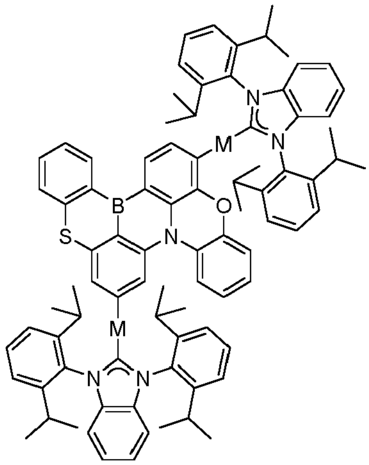
,
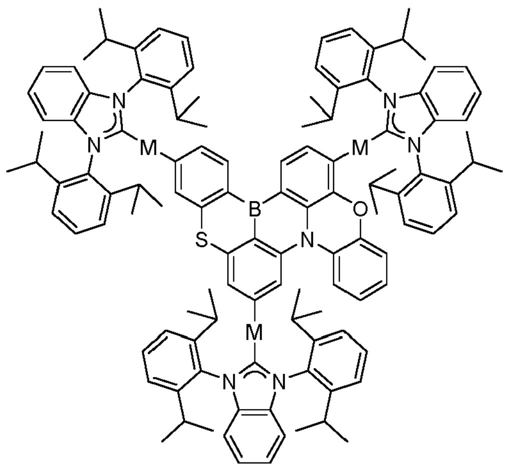
,
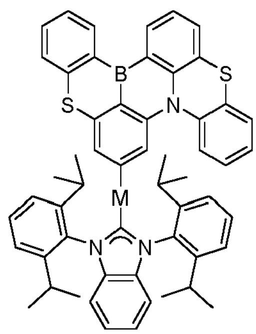
,
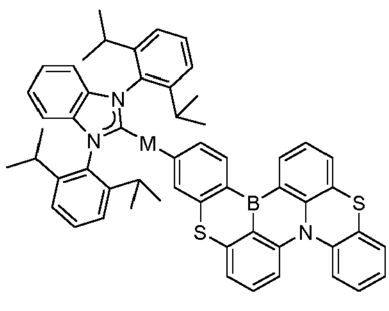
,
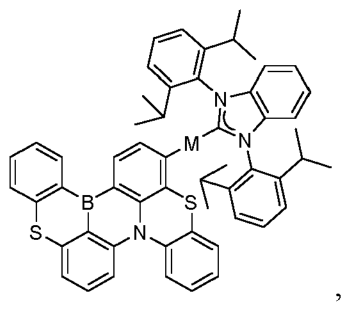
,

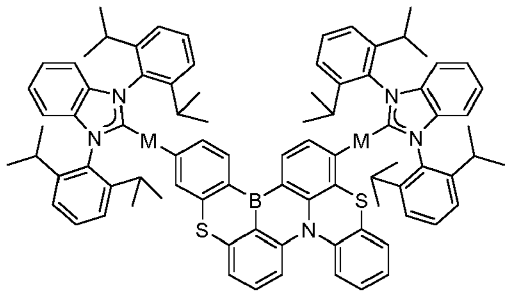

,

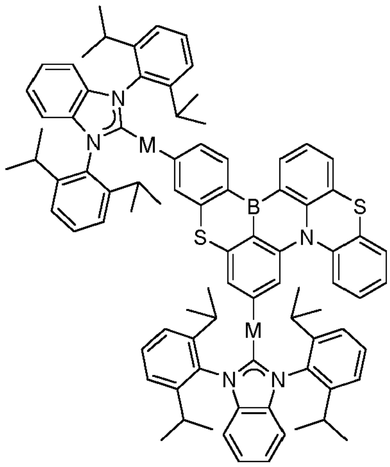

,

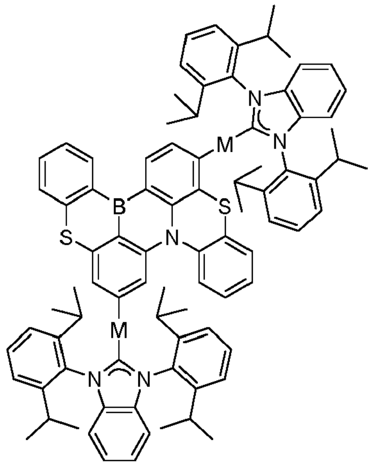

, or

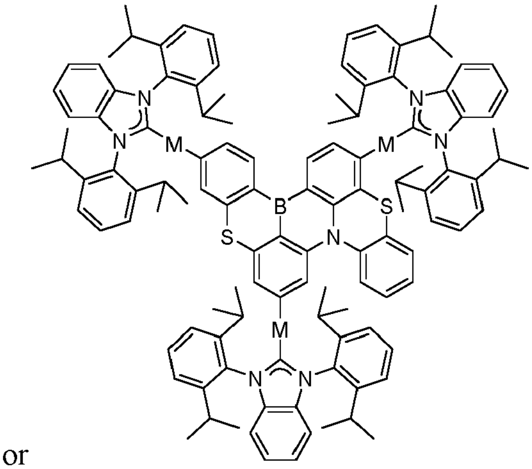

.

**11.** The compound of any one of claims 1 to 4, wherein Formula I is:

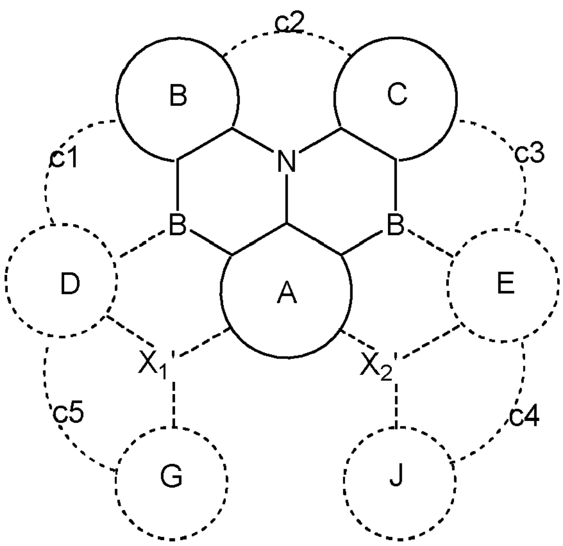

Formula XIII

wherein:

c2 is absent, single bond, -O-, -S-, -Se-, substituted $C_1$-$C_5$ alkyl (such as -$C(Me)_2$-), or unsubstituted $C_1$-$C_5$ alkyl, pairs of c1 and c3, and pairs of c4 and c5 are independently: both absent, both single bonds; single bond and

absent; single bond and substituted $C_1$-$C_5$ alkyl (such as -C(Me)$_2$-); single bond and unsubstituted $C_1$-$C_5$ alkyl; single bond and -O-; single bond and -S-; single bond and -Se-; absent and -S-; absent and -Se-; both substituted $C_1$-$C_5$ alkyl (such as - C(Me)$_2$-); substituted $C_1$-$C_5$ alkyl (such as -C(Me)$_2$-) and -O-; substituted $C_1$-$C_5$ alkyl (such as -C(Me)$_2$-) and -S-; substituted $C_1$-$C_5$ alkyl (such as - C(Me)$_2$-) and -Se-; absent and substituted $C_1$-$C_5$ alkyl (such as -C(Me)$_2$-); absent and -O-; -O- and -O-; -O- and -S-; -O- and -Se-; -Se- and -Se-; or -Sand -S-,
D, E, G, and J are independently substituted aryl, unsubstituted aryl, substituted heteroaryl, unsubstituted heteroaryl, or fused combinations thereof; substituted alkyl, or unsubstituted alkyl,
Formula II is datively bonded to at least one of B, C, D, E, G, and J, preferably B, C, D, and E, most preferably D, E, or both, and
preferably, substituted in Formula XIII means substituted with unsubstituted $C_1$-$C_5$ alkyl (such as methyl, ethyl, n-propyl, *etc.*), substituted $C_1$-$C_5$ alkyl (such as *iso*-propyl, *iso*-butyl, *tert*-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, or unsubstituted amine.

**12.** The compound of any one of claims 1 to 4 or 11, wherein $X_1$' and $X_2$' are nitrogen, and/or

wherein: c2 is absent or a single bond, pairs of c1 and c3 are both absent, and
pairs of c4 and c5 are: both absent; or both single bonds, and/or
wherein D, E, G, and J are independently substituted aryl, unsubstituted aryl, substituted heteroaryl, unsubstituted heteroaryl, or fused combinations thereof, and/or

2. wherein the compound has the structure:

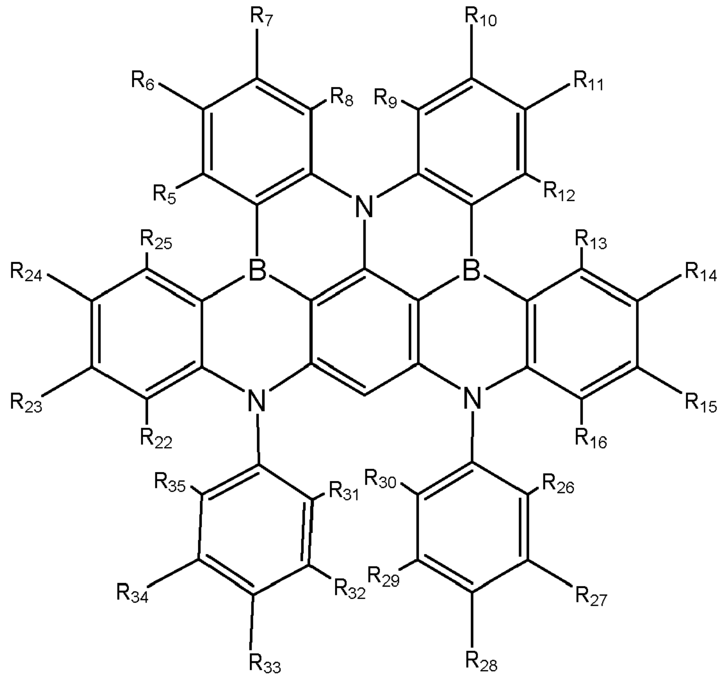

Formula XIV

$R_5$-$R_{16}$, $R_{22}$-$R_{25}$, and $R_{26}$-$R_{35}$, are preferably independently hydrogen, unsubstituted $C_1$-$C_5$ alkyl (such as methyl, ethyl, n-propyl, *etc.*), substituted $C_1$-$C_5$ alkyl (such as iso-propyl, iso-butyl, tert-butyl, trifluoromethyl, *etc.*), unsubstituted aryl (phenyl), substituted aryl, unsubstituted heteroaryl (N-carbazolyl), substituted heteroaryl, CN-, substituted amine (such as $C_1$-$C_5$ dialkylamine, such as (Me)$_2$N-; diarylamine, such as (4-methylphenyl)$_2$N-, unsubstituted amine, or Formula II, wherein at least one of $R_5$-$R_{16}$, $R_{22}$-$R_{25}$, and $R_{26}$-$R_{35}$ is Formula II, preferably at least one of $R_5$-$R_{16}$ and $R_{22}$-$R_{25}$ is Formula II, most preferably at least one of $R_{13}$-$R_{16}$ and $R_{22}$-$R_{25}$ is Formula II,
optionally $R_{25}$ and $R_5$ combine to form c1,
optionally $R_8$ and $R_9$ combine to form c2,

optionally $R_{12}$ and $R_{13}$ combine to form c3,
optionally $R_{16}$ and $R_{26}$ combine to form c4,
optionally $R_{35}$ and $R_{22}$ combine to form c5, or
optionally adjacent $R_x$ and $R_y$ groups together with the carbon atoms to which they are bonded form five- or six-membered substituted aryl, unsubstituted aryl, substituted heteroaryl, unsubstituted heteroaryl, substituted cycloalkyl, unsubstituted cycloalkyl, substituted heterocyclyl, unsubstituted heterocyclyl, or fused combinations thereof, wherein x and y in $R_x$ and $R_y$ are sequential pairs of integers from 5 to 16, and 22 to 35, or

3. wherein the compound has a structure selected from:

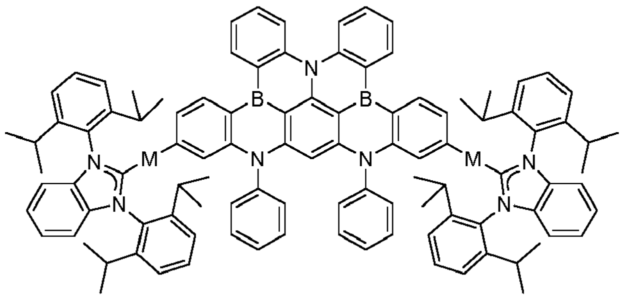

,

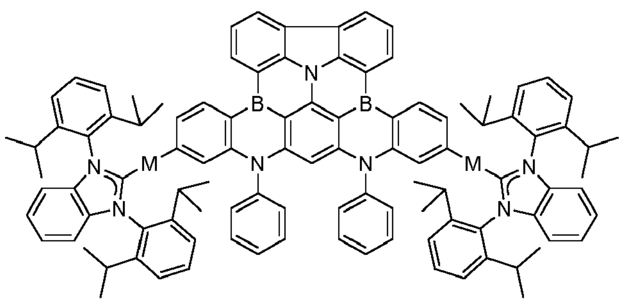

,

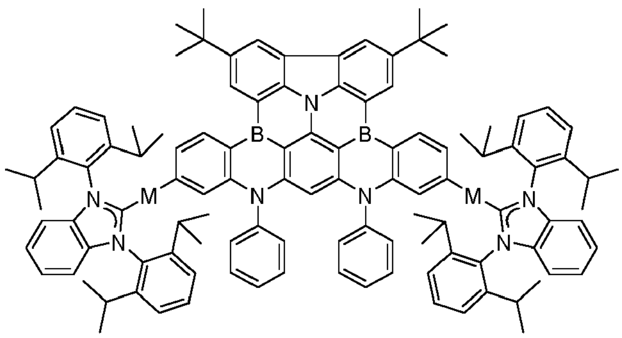

,

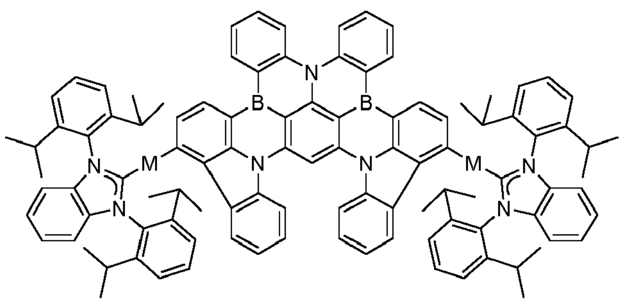

,

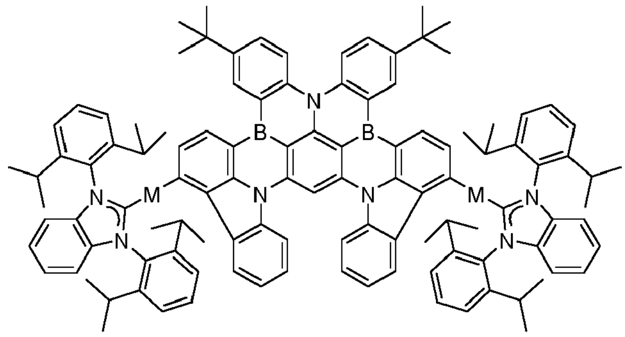

,

or

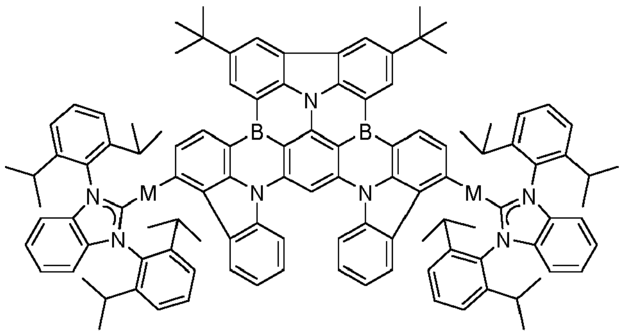

.

**13.** An organic electronic component comprising the compound of any one of claims 1 to 12, optionally

wherein the organic electronic component is an organic light-emitting diode (OLED) or a light-emitting electrochemical cell (LEEC), and/or
wherein the compounds are in a light-emitting layer, and/or
4. wherein the organic electronic component further comprises an anode, a cathode, a hole transport region, and an electron transport region,

wherein the hole transport region comprises a hole injection layer and/or a hole transport layer, and optionally an electron blocking layer,
wherein the electron transport region comprises an electron transport layer and/or an electron injection layer, and optionally a hole blocking layer,
wherein the light emitting layer is located in between the anode and the cathode,
wherein the hole transport region is located between the anode and the light-emitting layer, and wherein the electron transport region is located in between the cathode and the light-emitting layer, further optionally the light-emitting layer is fabricated by vacuum deposition, spin-coating or ink printing (such as, ink-jet printing or roll-to-roll printing).

**14.** A light-emitting layer comprising the compound of any one of claims 1 to 12.

**15.** An OLED, comprising the light-emitting layer of claim 14.

**16.** A device, comprising the OLED of claim 15, wherein the device is selected from stationary visual display units, mobile visual display units, illumination units, keyboards, clothes, ornaments, garment accessories, wearable devices, medical monitoring devices, wall papers, tablet computers, laptops, advertisement panels, panel display units, household appliances, or office appliances.

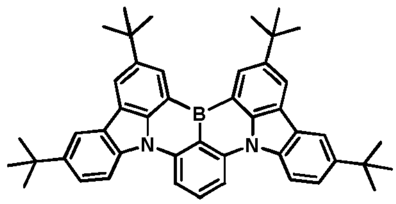

FIG. 1A

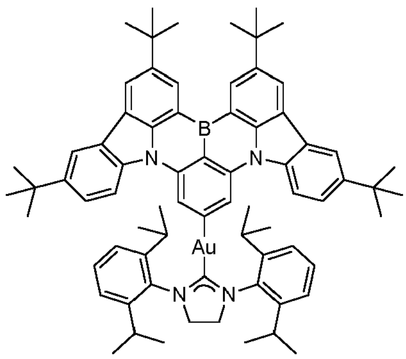

FIG. 1B

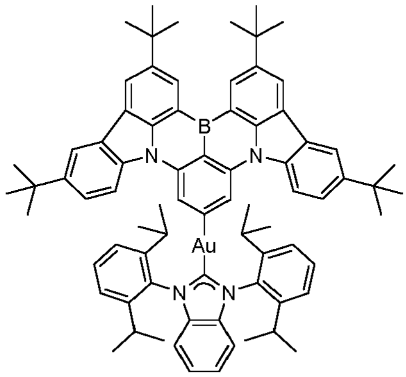

FIG. 1C

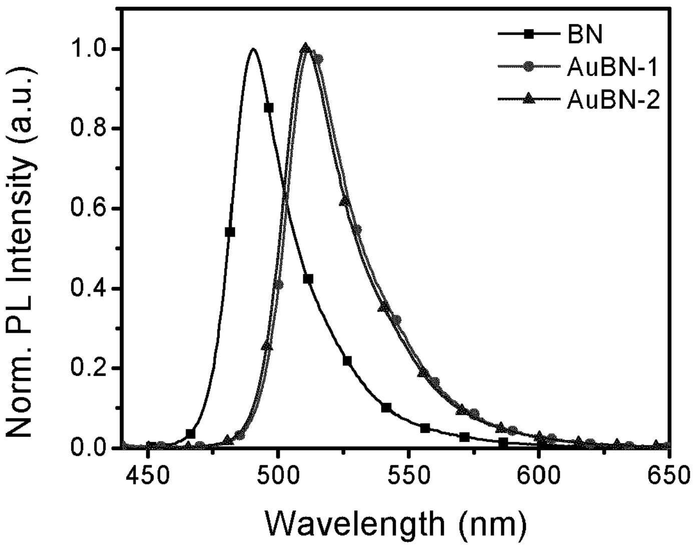
BN
AuBN-1
AuBN-2
Norm. PL Intensity (a.u.)
1.0
0.8
0.6
0.4
0.2
0.0
450
500
550
600
650
Wavelength (nm)

FIG. 2A

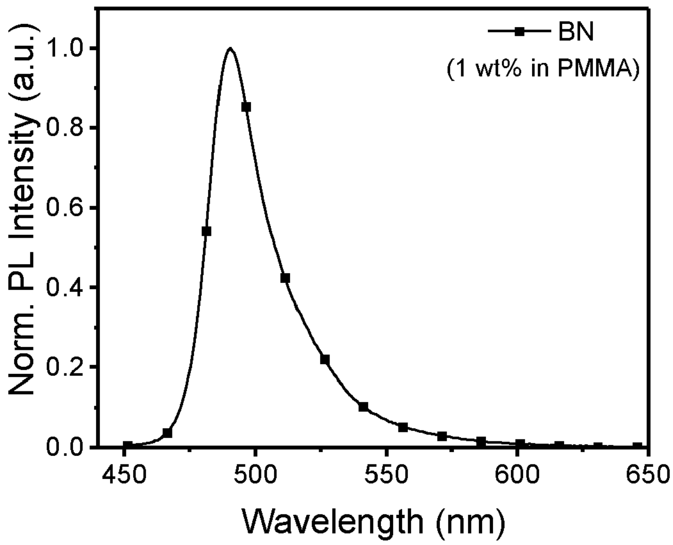
BN
(1 wt% in PMMA)
Norm. PL Intensity (a.u.)
1.0
0.8
0.6
0.4
0.2
0.0
450
500
550
600
650
Wavelength (nm)

FIG. 2B

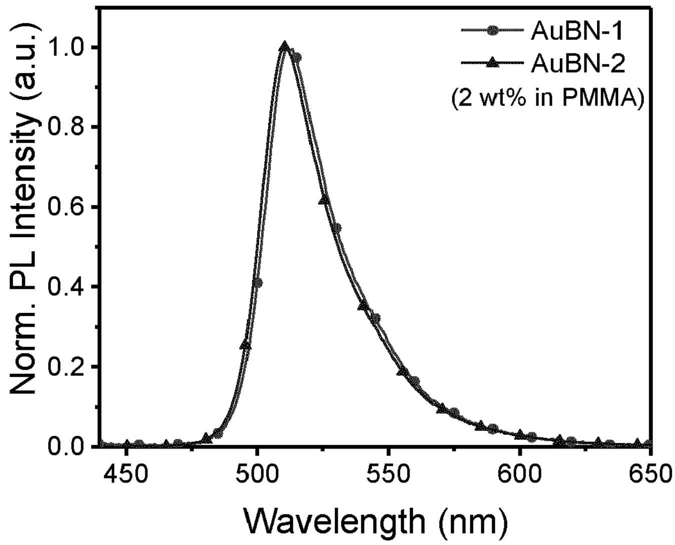


FIG. 2C

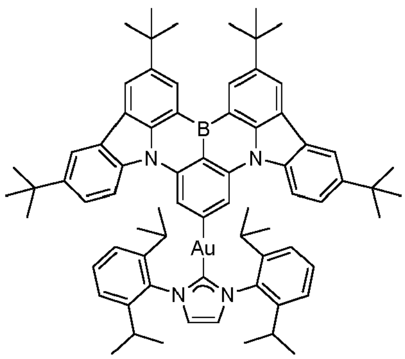

FIG. 3A

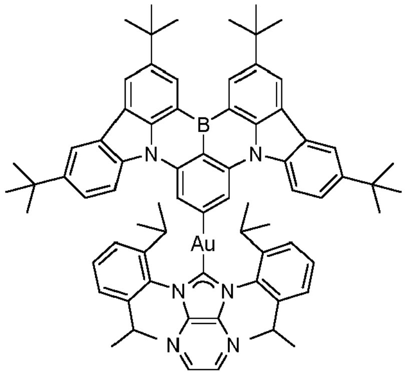

FIG. 3B

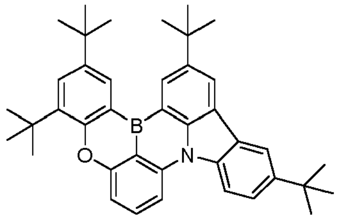

FIG. 3C

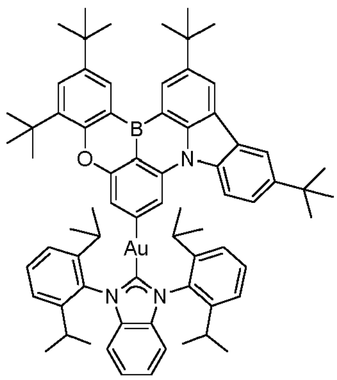

FIG. 3D

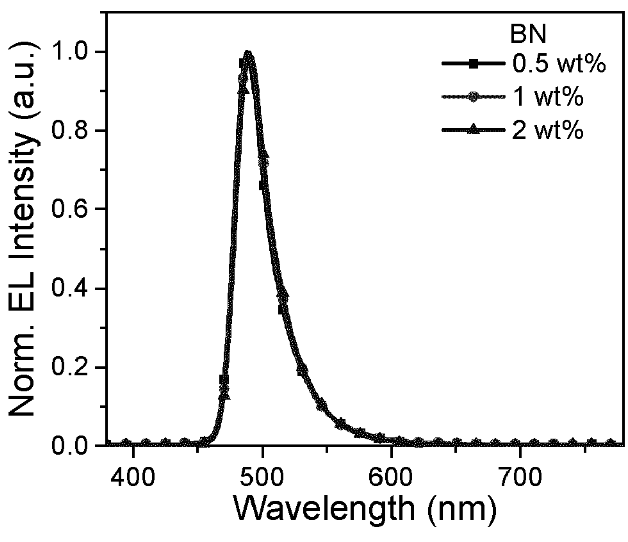


FIG. 4A

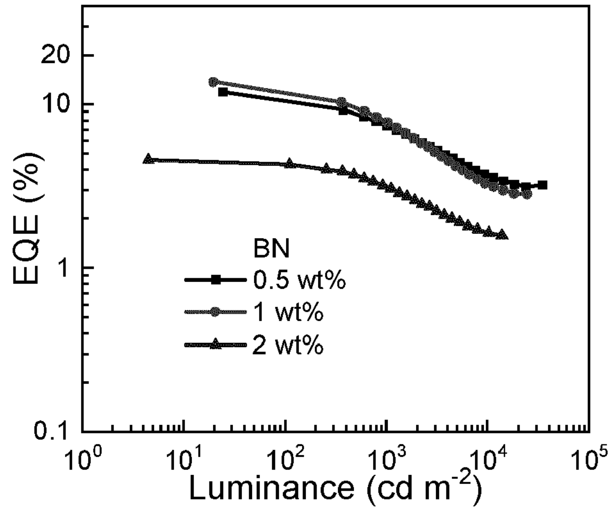

EQE (%)
20
10
1
0.1
BN
0.5 wt%
1 wt%
2 wt%
$10^0$ $10^1$ $10^2$ $10^3$ $10^4$ $10^5$
Luminance (cd $m^{-2}$)


**FIG. 4B**

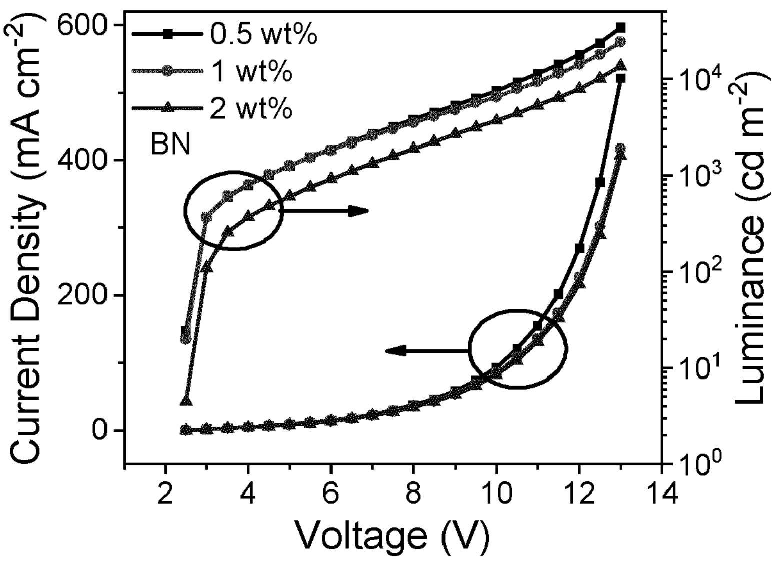

Current Density (mA $cm^{-2}$)
600
400
200
0
0.5 wt%
1 wt%
2 wt%
BN
Luminance (cd $m^{-2}$)
$10^4$ $10^3$ $10^2$ $10^1$ $10^0$
2 4 6 8 10 12 14
Voltage (V)


**FIG. 4C**

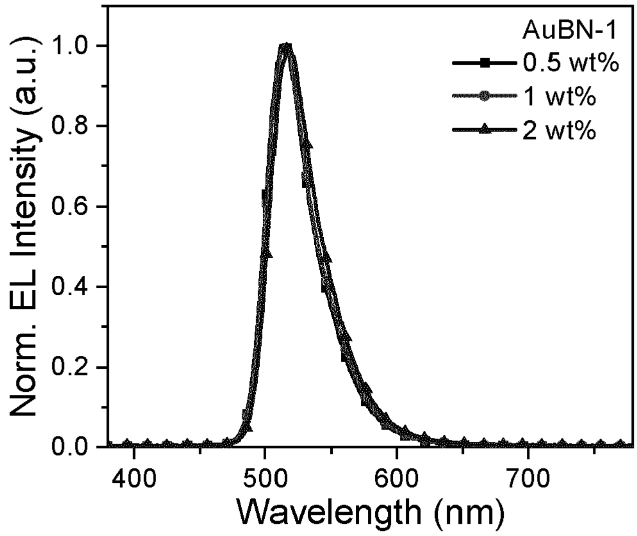
AuBN-1
0.5 wt%
1 wt%
2 wt%
Norm. EL Intensity (a.u.)
0.0
0.2
0.4
0.6
0.8
1.0
400
500
600
700
Wavelength (nm)

FIG. 5A

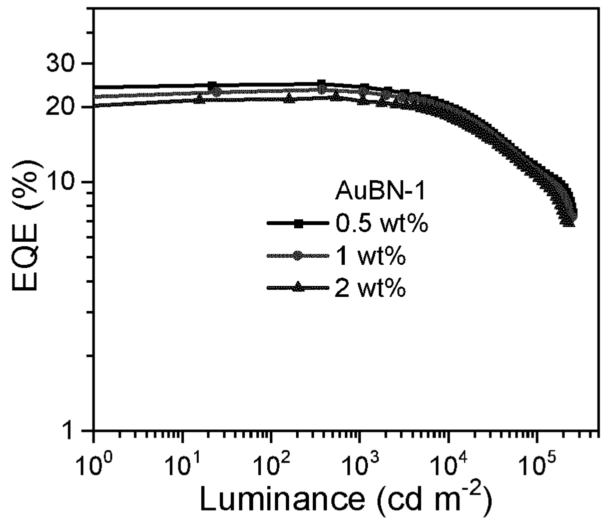
AuBN-1
0.5 wt%
1 wt%
2 wt%
EQE (%)
1
10
20
30
$10^0$
$10^1$
$10^2$
$10^3$
$10^4$
$10^5$
Luminance (cd $m^{-2}$)

FIG. 5B

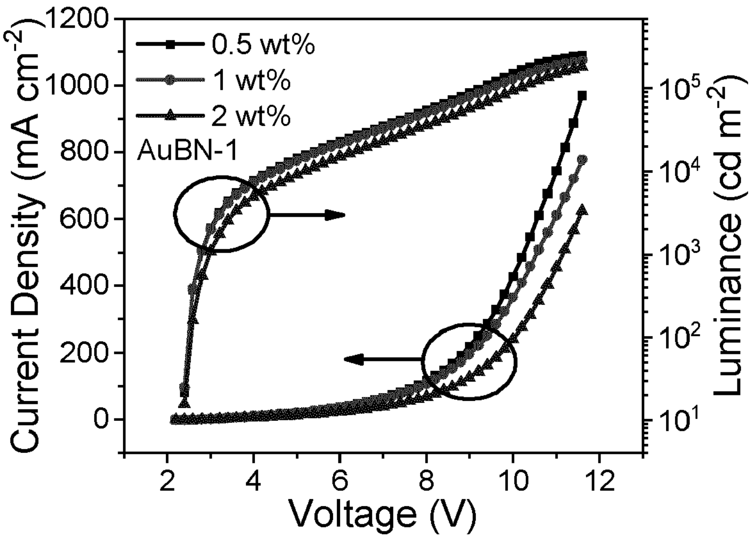

Current Density (mA cm-2)
1200
1000
800
600
400
200
0
0.5 wt%
1 wt%
2 wt%
AuBN-1
Luminance (cd m-2)
10^5
10^4
10^3
10^2
10^1
2
4
6
8
10
12
Voltage (V)


FIG. 5C

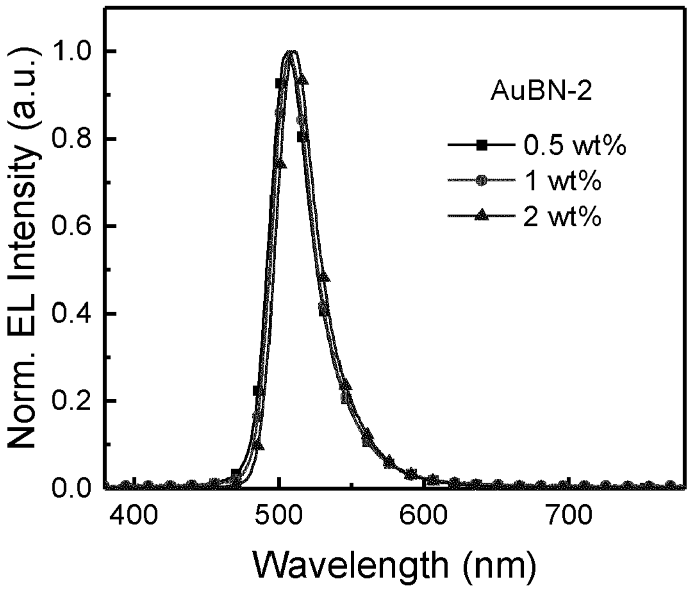

Norm. EL Intensity (a.u.)
1.0
0.8
0.6
0.4
0.2
0.0
AuBN-2
0.5 wt%
1 wt%
2 wt%
400
500
600
700
Wavelength (nm)


FIG. 6A

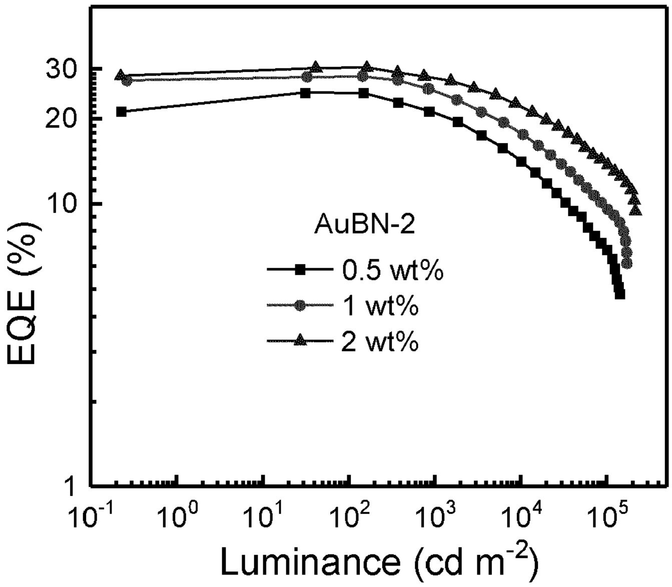
EQE (%)
30
20
10
1
AuBN-2
0.5 wt%
1 wt%
2 wt%
$10^{-1}$ $10^{0}$ $10^{1}$ $10^{2}$ $10^{3}$ $10^{4}$ $10^{5}$
Luminance (cd $m^{-2}$)

**FIG. 6B**

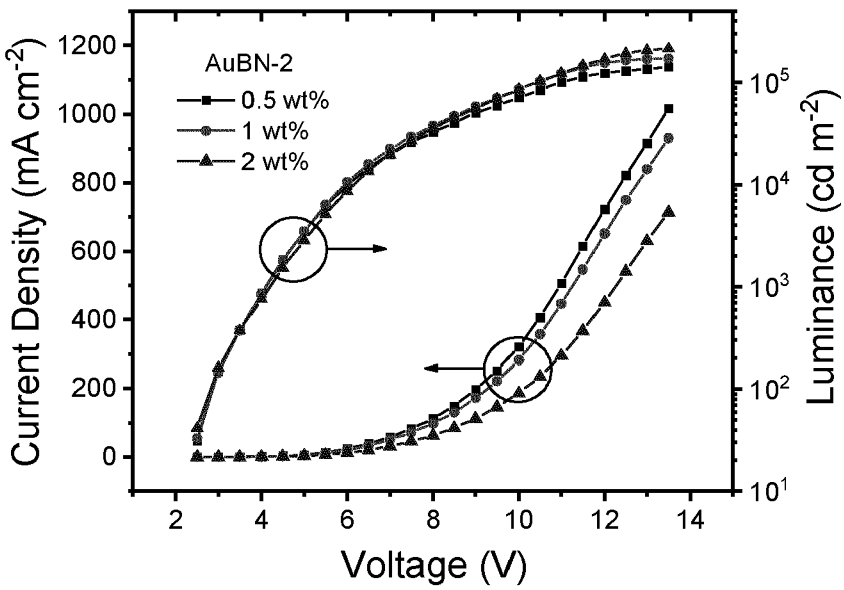
Current Density (mA $cm^{-2}$)
1200
1000
800
600
400
200
0
AuBN-2
0.5 wt%
1 wt%
2 wt%
2 4 6 8 10 12 14
Voltage (V)
Luminance (cd $m^{-2}$)
$10^{5}$
$10^{4}$
$10^{3}$
$10^{2}$
$10^{1}$

**FIG. 6C**

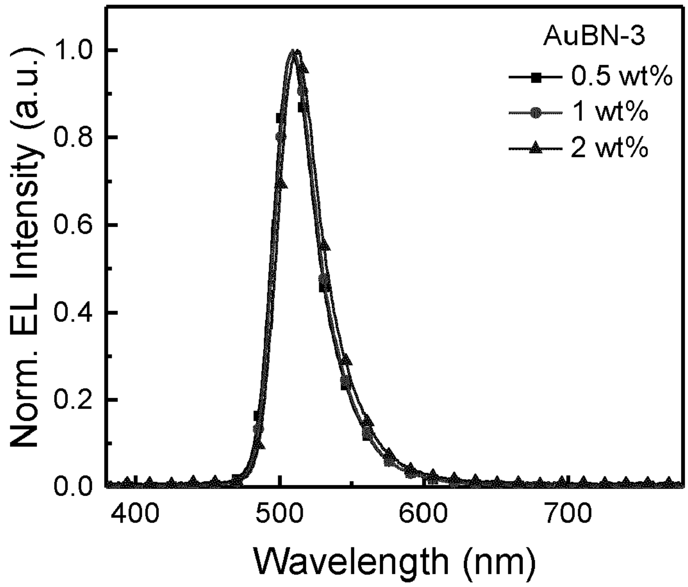
AuBN-3
0.5 wt%
1 wt%
2 wt%
Norm. EL Intensity (a.u.)
1.0
0.8
0.6
0.4
0.2
0.0
400
500
600
700
Wavelength (nm)

FIG. 7A

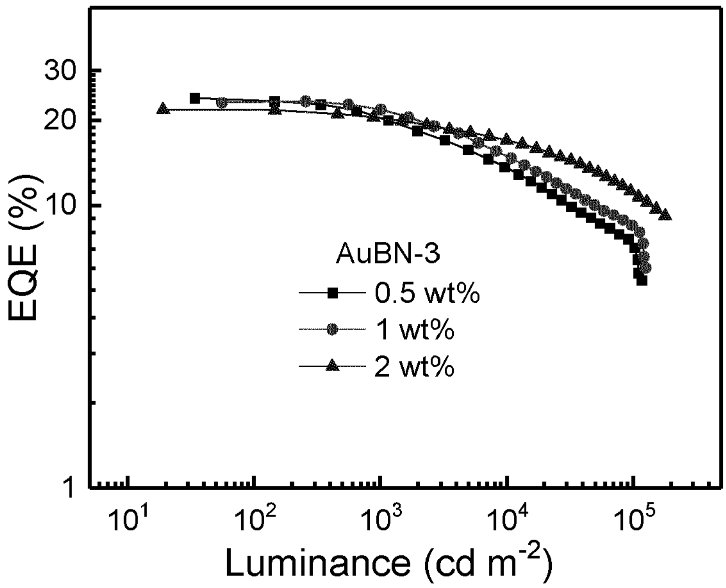
EQE (%)
30
20
10
1
AuBN-3
0.5 wt%
1 wt%
2 wt%
$10^1$
$10^2$
$10^3$
$10^4$
$10^5$
Luminance (cd $m^{-2}$)

FIG. 7B

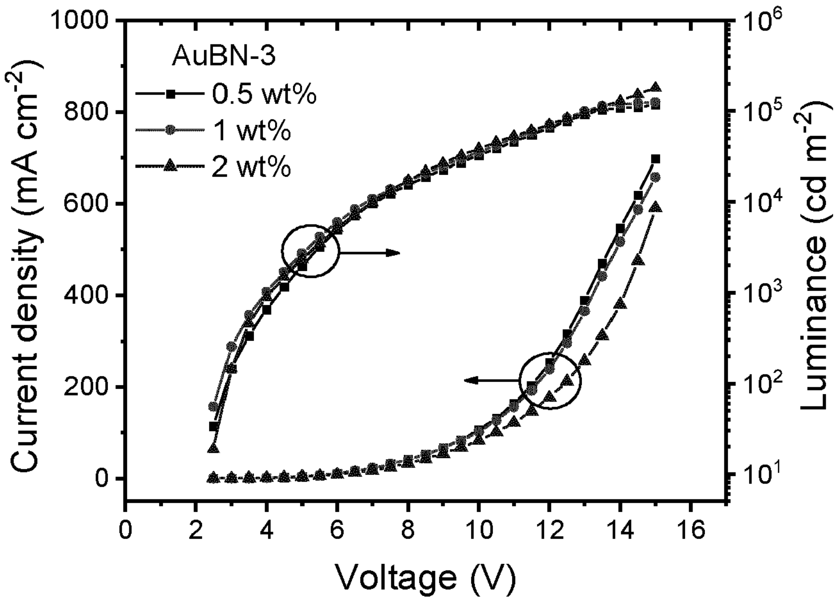
AuBN-3
0.5 wt%
1 wt%
2 wt%
Current density (mA cm-2)
Luminance (cd m-2)
Voltage (V)
1000
800
600
400
200
0
0
2
4
6
8
10
12
14
16
10^6
10^5
10^4
10^3
10^2
10^1

FIG. 7C

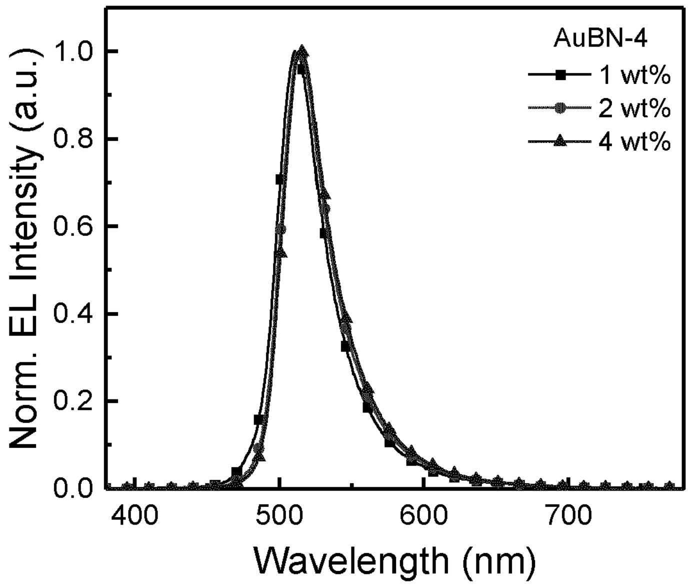
AuBN-4
1 wt%
2 wt%
4 wt%
Norm. EL Intensity (a.u.)
Wavelength (nm)
1.0
0.8
0.6
0.4
0.2
0.0
400
500
600
700

FIG. 8A

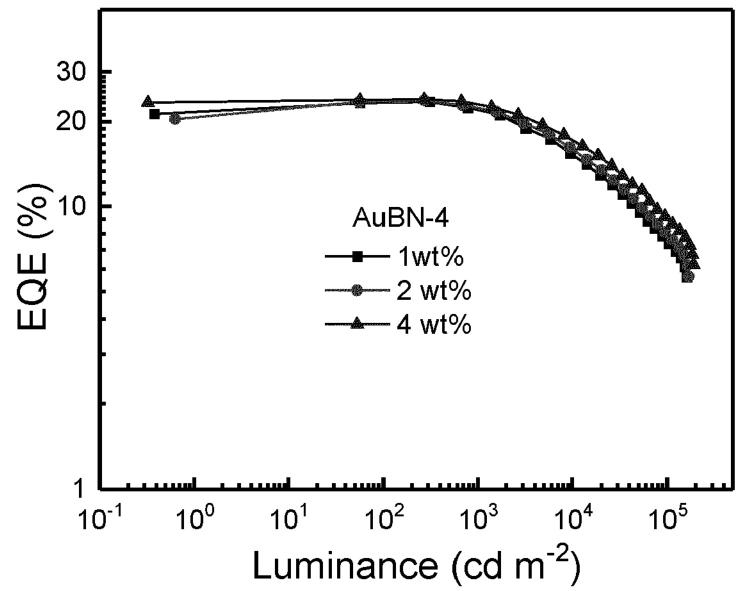

EQE (%)
30
20
10
1
AuBN-4
1wt%
2 wt%
4 wt%
$10^{-1}$ $10^{0}$ $10^{1}$ $10^{2}$ $10^{3}$ $10^{4}$ $10^{5}$
Luminance (cd $m^{-2}$)


**FIG. 8B**

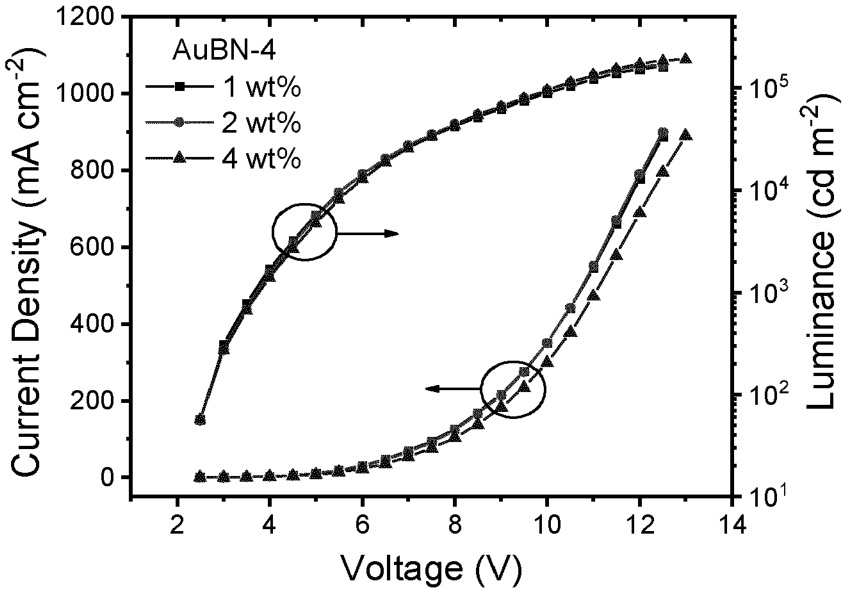

Current Density (mA $cm^{-2}$)
1200
1000
800
600
400
200
0
AuBN-4
1 wt%
2 wt%
4 wt%
Luminance (cd $m^{-2}$)
$10^{5}$
$10^{4}$
$10^{3}$
$10^{2}$
$10^{1}$
2 4 6 8 10 12 14
Voltage (V)


**FIG. 8C**

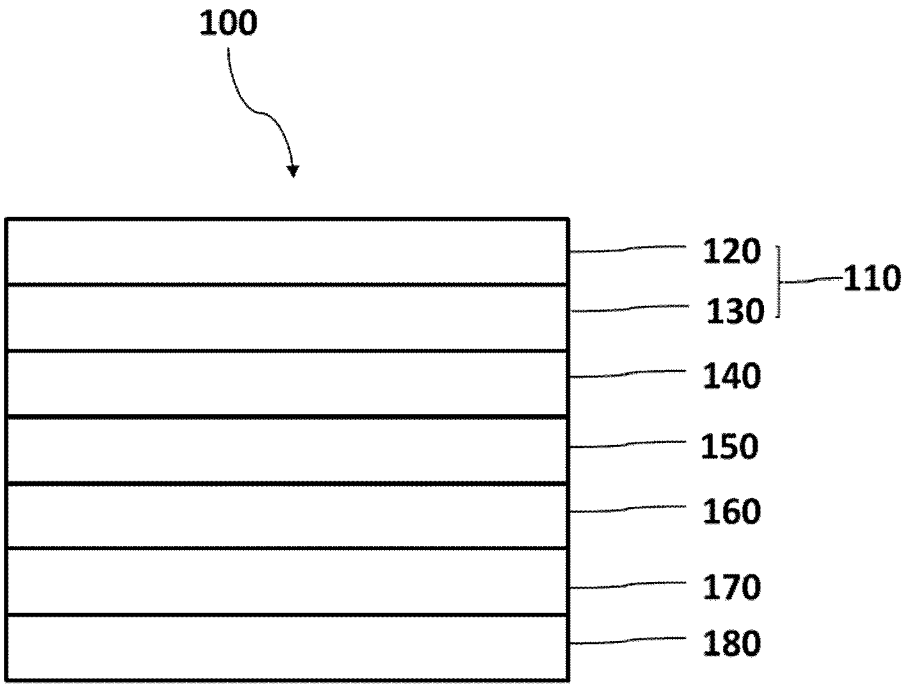


FIG. 9

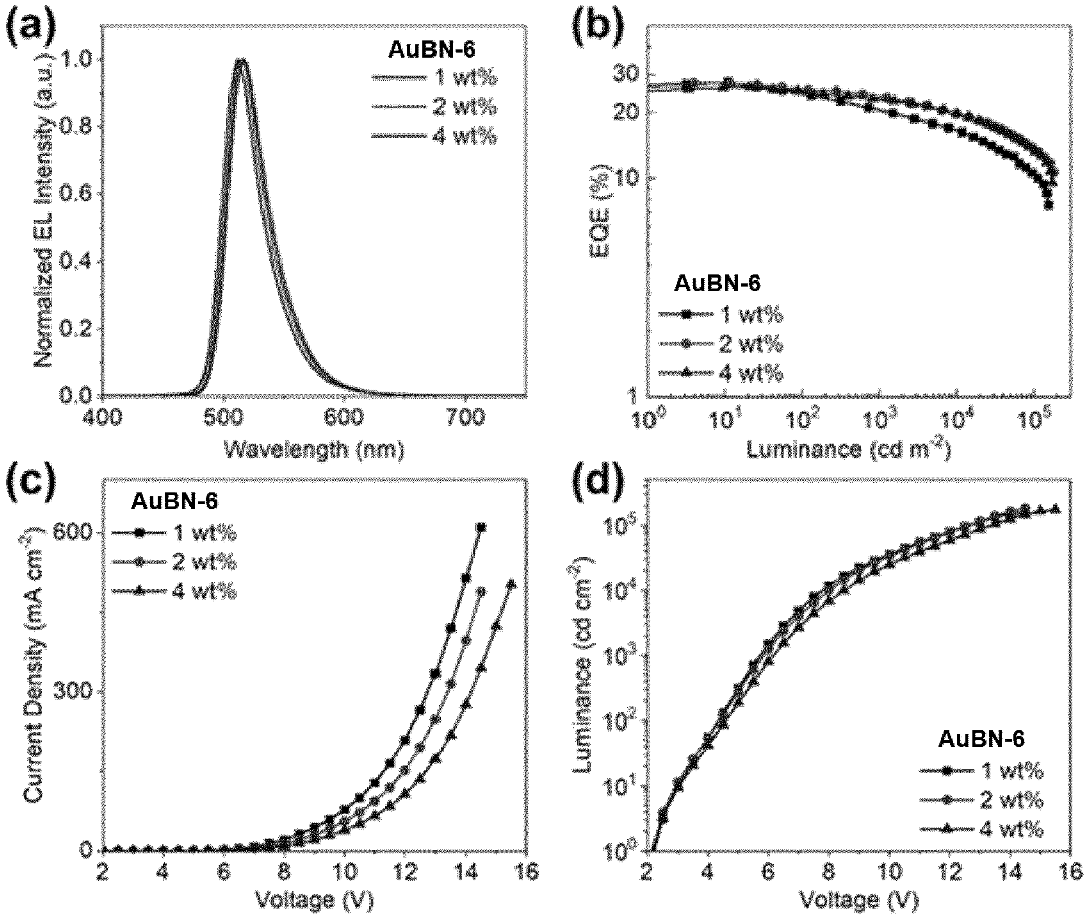
(a)
AuBN-6
1 wt%
2 wt%
4 wt%
Normalized EL Intensity (a.u.)
Wavelength (nm)
(b)
EQE (%)
Luminance (cd m-2)
AuBN-6
1 wt%
2 wt%
4 wt%
(c)
AuBN-6
1 wt%
2 wt%
4 wt%
Current Density (mA cm-2)
Voltage (V)
(d)
Luminance (cd cm-2)
Voltage (V)
AuBN-6
1 wt%
2 wt%
4 wt%

FIGs. 10A-10D

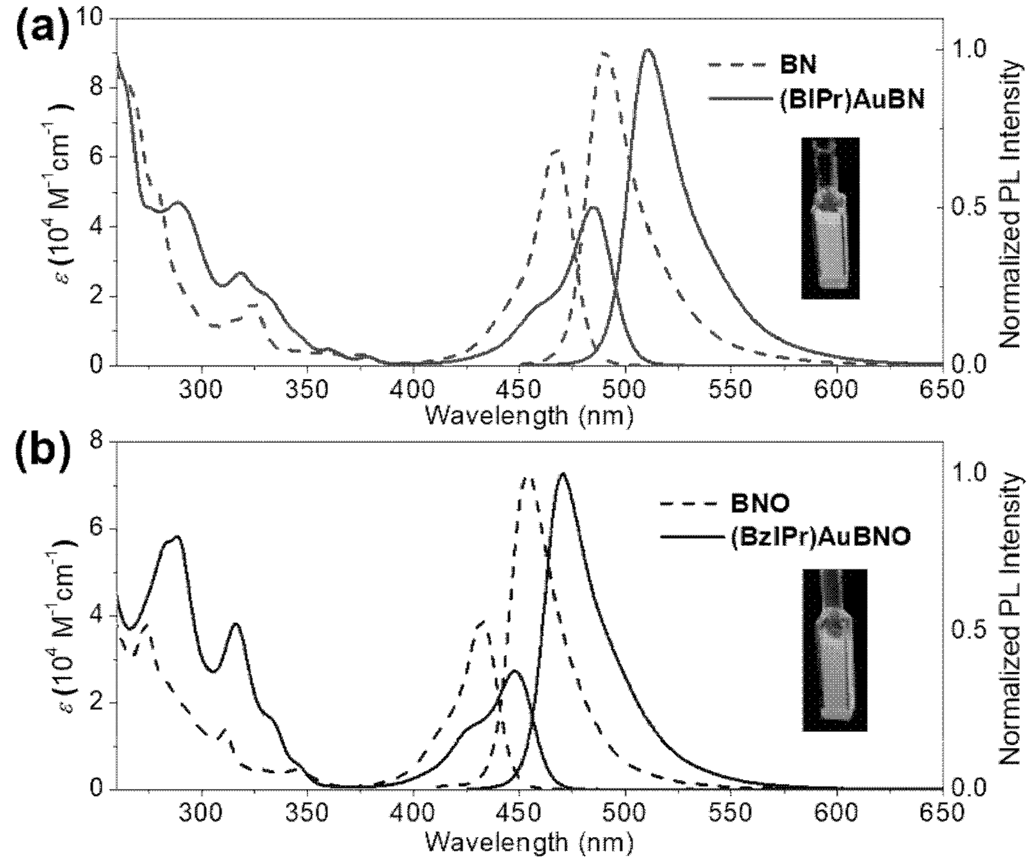


FIGs. 11A and 11B

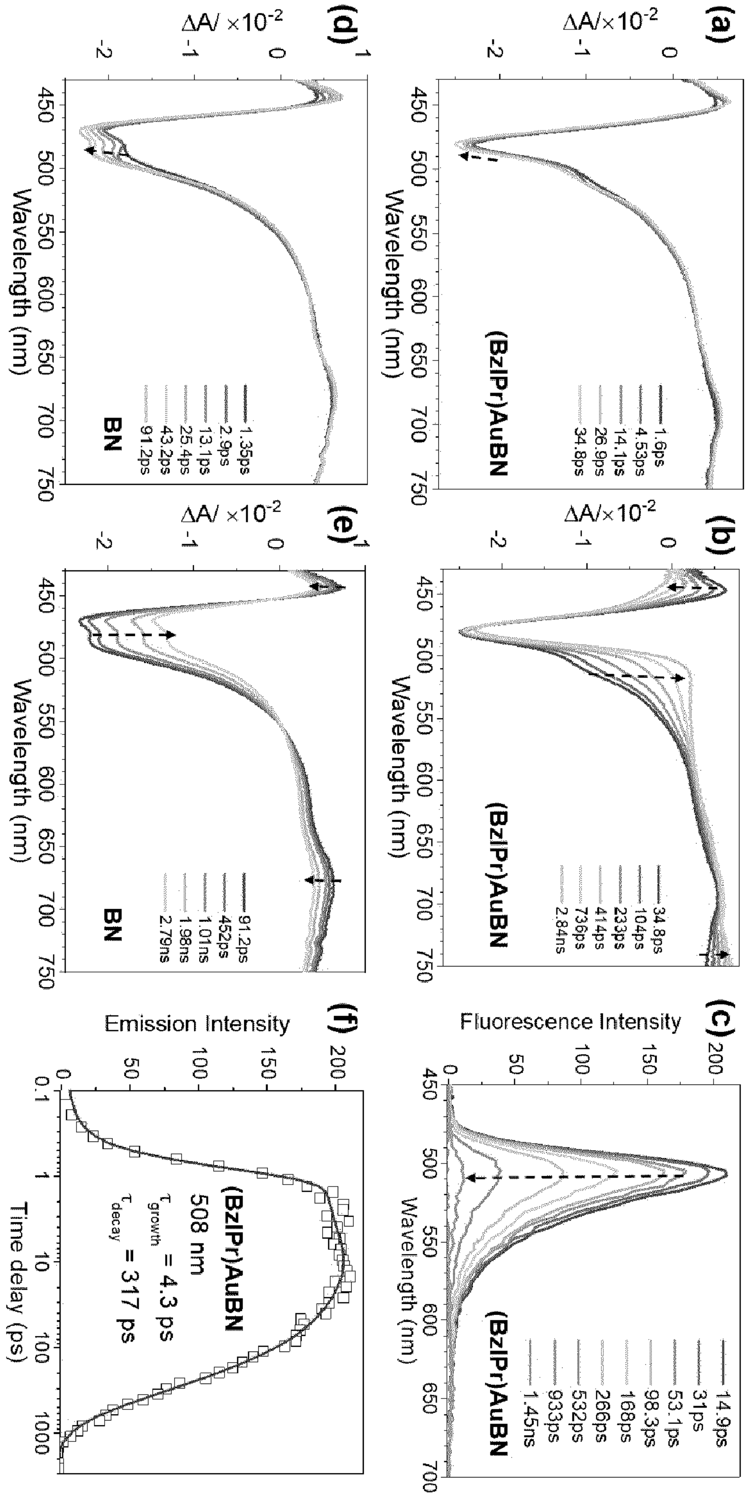
(a)
ΔA/×10-2
Wavelength (nm)
1.6ps
4.53ps
14.1ps
26.9ps
34.8ps
(BzIPr)AuBN
(b)
ΔA/×10-2
Wavelength (nm)
34.8ps
104ps
233ps
414ps
736ps
2.84ns
(BzIPr)AuBN
(c)
Fluorescence Intensity
Wavelength (nm)
14.9ps
31ps
53.1ps
98.3ps
168ps
266ps
532ps
933ps
1.45ns
(BzIPr)AuBN
(d)
ΔA/ ×10-2
Wavelength (nm)
1.35ps
2.9ps
13.1ps
25.4ps
43.2ps
91.2ps
BN
(e)
ΔA/ ×10-2
Wavelength (nm)
91.2ps
452ps
1.01ns
1.98ns
2.79ns
BN
(f)
Emission Intensity
Time delay (ps)
(BzIPr)AuBN
508 nm
τgrowth = 4.3 ps
τdecay = 317 ps

FIGs. 12A-12F

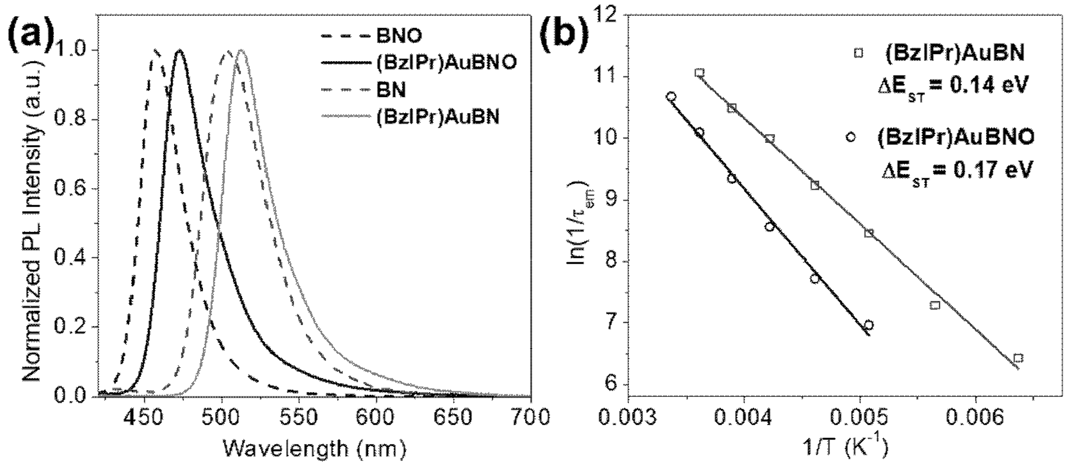


**FIGs. 13A** and **13B**

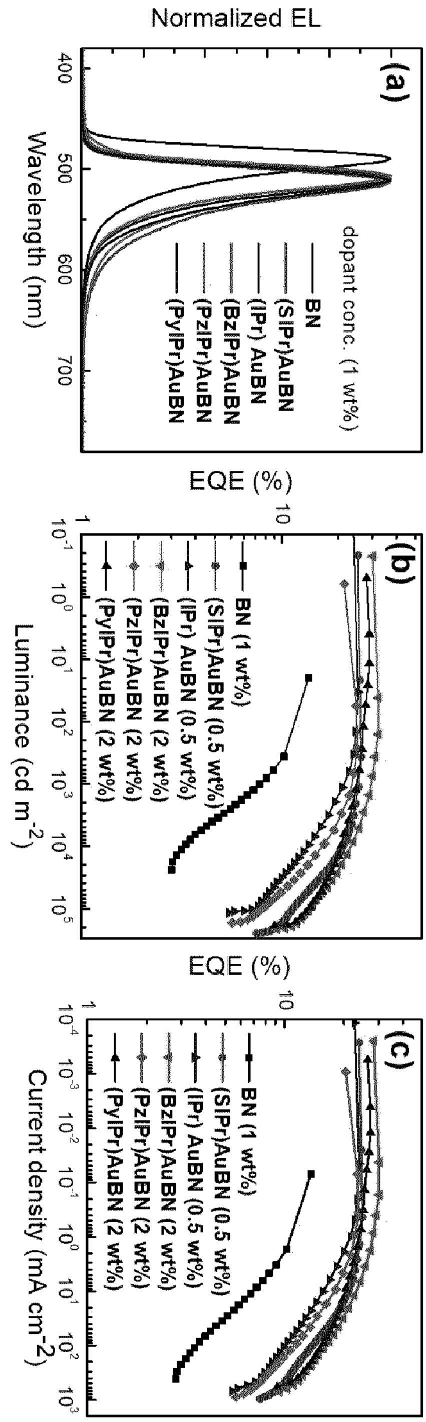


**FIGs. 14A, 14B,** and **14C**

Europäisches Patentamt
European Patent Office
Office européen des brevets

# EUROPEAN SEARCH REPORT

Application Number
EP 23 19 5511

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y<br><br>A | CN 113 292 579 A (UNIVERSAL DISPLAY CORP) 24 August 2021 (2021-08-24)<br>* pages 65,70, paragraph 82-92; claims * | 1-6, 13-16<br>8,9,11, 12<br>7,10 | INV.<br>C09K11/06<br>C07F5/02<br>C07F1/12<br>H10K85/30 |
| Y | US 2021/122765 A1 (WOLOHAN PETER [US] ET AL) 29 April 2021 (2021-04-29)<br>* paragraphs [0093] - [0096]; claims * | 8,9,11, 12 | |

| TECHNICAL FIELDS SEARCHED (IPC) |
|---|
| C07F<br>H05B<br>C09K<br>H10K |

The present search report has been drawn up for all claims

| Place of search | Date of completion of the search | Examiner |
|---|---|---|
| The Hague | 8 February 2024 | Schoenhentz, Jérôme |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 19 5511

This annex lists the patent family members relating to the patent documents cited in the above-mentioned European search report. The members are as contained in the European Patent Office EDP file on The European Patent Office is in no way liable for these particulars which are merely given for the purpose of information.

08-02-2024

| Patent document cited in search report | | Publication date | Patent family member(s) | | Publication date |
|---|---|---|---|---|---|
| CN 113292579 | A | 24-08-2021 | NONE | | |
| US 2021122765 | A1 | 29-04-2021 | KR 20210052280 | A | 10-05-2021 |
| | | | US 2021122765 | A1 | 29-04-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 63407263
- US 201900581254, Hatakeyama
- US 20180301629, Hatakeyama,


### Non-patent literature cited in the description


- **H. HIRAI ; K. NAKAJIMA ; S. NAKATSUKA ; K. SHIREN ; J. NI ; S. NOMURA ; T. IKUTA ; T. HATAKEYAMA.** *Angew. Chem. Int. Ed.,* 2015, vol. 54, 13581-13585
- *Angew. Chem.,* 2015, vol. 127, 13785-13789
- **T. HATAKEYAMA ; K. SHIREN ; K. NAKAJIMA ; S. NOMURA ; S. NAKATSUKA ; K. KINOSHITA ; J. NI ; Y. ONO ; T. IKUTA.** *Adv. Mater.,* 2016, vol. 28, 2777-2781
- **S. MADAYANAD SURESH ; D. HALL ; D. BELJONNE ; Y. OLIVIER ; E. ZYSMAN-COLMAN.** *Adv. Funct. Mater.,* 2020, vol. 30, 1908677
- **M. YANG ; I. S. PARK ; T. YASUDA.** *J. Am. Chem. Soc.,* 2020, vol. 142, 19468-19472
- **M. YANG ; S. SHIKITA ; H. MIN ; I. S. PARK ; H. SHIBATA ; N. AMANOKURA ; T. YASUDA.** *Angew. Chem. Int. Ed.,* 2021, vol. 60, 23142-23147
- *Angew. Chem.,* 2021, vol. 133, 23326-23331
- **H. TANAKA ; S. ODA ; G. RICCI ; H. GOTOH ; K. TABATA ; R. KAWASUMI ; D. BELJONNE ; Y. OLIVIER ; T. HATAKEYAMA.** *Angew. Chem. Int. Ed.,* 2021, vol. 60, 17910-17914
- *Angew. Chem.,* 2021, vol. 133, 18054-18058
- **X. CAI ; J. XUE ; C. LI ; B. LIANG ; A. YING ; Y. TAN ; S. GONG ; Y. WANG.** *Angew. Chem. Int. Ed.,* 2022, vol. 61, e202200337
- *Angew. Chem.,* 2022, vol. 134, e202200337
- **Y. ZOU ; J. HU ; M. YU ; J. MIAO ; Z. XIE ; Y. QIU ; X. CAO ; C. YANG.** *Adv. Mater.,* 2022, vol. 34, 2201442
- **Y. XU ; Z. CHENG ; Z. LI ; B. LIANG ; J. WANG ; J. WEI ; Z. ZHANG ; Y. WANG.** *Adv. Opt. Mater.,* 2020, vol. 8, 1902142
- **Y. KONDO ; K. YOSHIURA ; S. KITERA ; H. NISHI ; S. ODA ; H. GOTOH ; Y. SASADA ; M. YANAI ; T. HATAKEYAMA.** *Nat. Photonics,* 2019, vol. 13, 678-682
- **I. S. PARK ; M. YANG ; H. SHIBATA ; N. AMANOKURA ; T. YASUDA.** *Adv. Mater.,* 2022, vol. 34, 2107951
- **I. S. PARK ; H. MIN ; T. YASUDA.** *Angew. Chem. Int. Ed.,* 2022, vol. 61, e202205684
- *Angew. Chem.,* 2022, vol. 134, e202205684
- **M. MONTALTI ; A. CREDI ; L. PRODI ; M. T. GANDOLFI.** Handbook of Photochemistry. CRC, 2006
- **H.-Y. CHAO ; W. LU ; Y. LI ; M. C. W. CHAN ; C.-M. CHE ; K.-K. CHEUNG ; N. ZHU.** *J. Am. Chem. Soc.,* 2002, vol. 124, 14696-14706
- **W. LU ; W.-M. KWOK ; C. MA ; C. T.-L. CHAN ; M.-X. ZHU ; C.- M. CHE.** *J. Am. Chem. Soc.,* 2011, vol. 133, 14120-14135
- **C. MA ; C. T.-L. CHAN ; W.-M. KWOK ; C.-M. CHE.** *Chem. Sci.,* 2012, vol. 3, 1883-1892
- **R. TANG ; S. XU ; T.-L. LAM ; G. CHENG ; L. DU ; Q. WAN ; J. YANG ; F.-F. HUNG ; K.-H. LOW ; D.-L. PHILLIPS.** *Angew. Chem. Int. Ed.,* 2022, vol. 61, e202203982
- *Angew. Chem.,* 2022, vol. 134, e202203982
- **L. KUEHN ; A. F. EICHHORN ; D. SCHMIDT ; T. B. MARDER ; U. RADIUS.** *J. Organomet. Chem.,* 2020, vol. 919, 121249
- **D. SONG ; Y. YU ; L. YUE ; D. ZHONG ; Y. ZHANG ; X. YANG ; Y. SUN ; G. ZHOU ; Z. WU.** *J. Mater. Chem. C,* 2019, vol. 7, 11953-11963
- **Y. GAO ; Y. WANG ; Z. GUO ; Y. WAN ; C. LI ; B. YANG ; W. YANG ; X. MA.** *J. Phys. Chem. B,* 2022, vol. 126, 2729-2739
- **Y. TSUCHIYA ; S. DIESING ; F. BENCHEIKH ; Y. WADA ; P. L. DOS SANTOS ; H. KAJI ; E. ZYSMAN-COLMAN ; I. D. W. SAMUEL ; C. ADACHI.** *J. Phys. Chem. A,* 2021, vol. 125, 8074-8089
- **K. SHIZU ; H. KAJI.** *Commun. Chem.,* 2022, vol. 5, 53
- **M. K. ETHERINGTON ; J. GIBSON ; H. F. HIGGINBOTHAM ; T. J. PENFOLD ; A. P. MONKMAN.** *Nat. Commun.,* 2016, vol. 7, 13680
- **N. AIZAWA ; Y. HARABUCHI ; S. MAEDA ; Y.-J. PU.** *Nat. Commun.,* 2022, vol. 11, 3909
- **D. FANG ; Y. SUN ; Y. CHEN ; T. FU ; M. U. ALI ; Y. HE ; J. MIAO ; C. YAN ; H. MENG.** *Dyes Pigm.,* 2020, vol. 173, 107990